# EUROPEAN PATENT APPLICATION

(11) **EP 2 202 283 A1**
(43) Date of publication of application: **30.06.2010**
(21) Application number: 09156605.9
(22) Date of filing: 30.03.2009
(51) Int. Cl.: C09K 11/06

(54) **Novel organic electroluminescent compounds and organic electroluminescent device using the same**

(30) Priority: 05.12.2008 KR 20080123276
(71) Applicant: Gracel Display Inc., Seoul 133-833 (KR)
(72) Inventor: Kim, Chi-Sik, 156-825 Seoul (KR); Shin, Hyo Nim, 136-060 Seoul (KR); Cho, Young Jun, 136-060 Seoul (KR); Kwon, Hyuck Joo, 130-100 Seoul (KR); Kim, Bong Ok, 135-090 Seoul (KR); Kim, Sung Min, 157-886 Seoul (KR); Yoon, Seung Soo, 135-884 Seoul (KR)
(74) Representative: Kent, Venetia Katherine

(57) **Abstract**

Provided are novel organic electroluminescent compounds, and organic electroluminescent devices and organic solar cells including the same. The organic electroluminescent compound is represented by Chemical Formula 1: 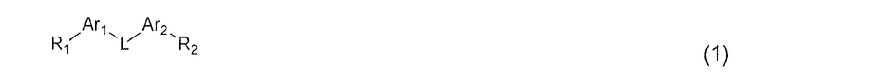 wherein
L is a substituent represented by the following structural formula: 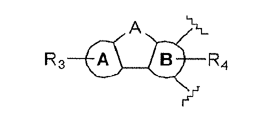 ring A represents a monocyclic or polycyclic (C6-C60)aromatic ring; and
ring B represents anthracene.

The organic electroluminescent compound provides superior luminous efficiency and excellent color purity of the material and life property. Therefore, it may be used to manufacture OLEDs having very good operation life.

## Description

### CROSS-REFERENCE TO RELATED APPLICATION

This application claims priority to Korean Patent Application No. 10-2008-0123276, filed on December 5, 2008, and all the benefits accruing therefrom under 35 U.S.C. §119.

### BACKGROUND

### 1. Field

The present invention relates to novel organic electroluminescent compounds, and organic electroluminescent devices and organic solar cells comprising the same. Specifically, the organic electroluminescent compounds according to the present invention are **characterized in that** they are represented by Chemical Formula 1: 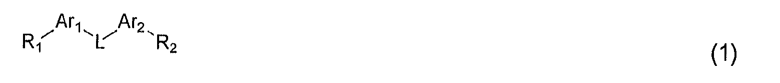 wherein
L is a substituent represented by the following structural formula: 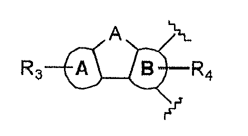 wherein
ring A represents a monocyclic or polycyclic (C6-C60)aromatic ring; and
ring B represents anthracene.

### 2. Description of the Related Art

In order to create a full-color organic light-emitting diode (OLED) display, electroluminescent materials of red, green and blue (RGB) colors are used. The development of RGB electroluminescent materials with high efficiency and long operation life is the most important task in improving the overall organic electroluminescence (EL) characteristics. Electroluminescent materials can be classified into host materials and dopant materials depending on their functions. In general, it is known that an electroluminescent layer created by doping a dopant into a host has the most superior EL characteristics. Recently, the development of organic EL devices having high efficiency and long operation life is emerging as an imminent task. Especially, considering the EL characteristics required by medium-to-large sized OLED panels, the development materials having much superior characteristics as compared to existing electroluminescent materials is highly required.

For green fluorescent materials, a system of doping a dopant such as a coumarin derivative (Compound a, C545T), a quinacridone derivative (Compound b), DPT (Compound c), etc. to the Alq host to several to dozen % has been developed and is widely used. Although these existing electroluminescent materials exhibit high initial luminous efficiency as to be commercially applicable, the efficiency decreases markedly with time and operation life is severely problematic. As a result, they are limited in use for large-sized, high-performance panels.

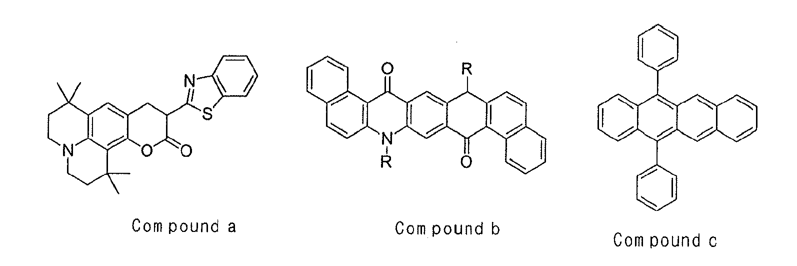

For blue fluorescent materials, a lot of materials have been commercialized following Idemitsu Kosan's DPVBi (Compound d). Idemitsu Kosan's blue material system and Kodak's dinaphthylanthracene (Compound e) and tetra(t-butyl)perylene (Compound f) are known, but much more research and development are demanded. Until now, Idemitsu Kosan's distyryl compound system is known to have the best efficiency. It exhibits a power efficiency of 6 Im/W and operation life of 30,000 hours or more. However, its color is sky-blue, which is inadequate for full-color displays. In general, blue electroluminescence is advantageous in luminous efficiency if the electroluminescence wavelength shifts a little toward the longer wavelength. But, it is not applicable to high-quality displays because pure blue color is not attained. Therefore, researches and developments to improve color purity, efficiency and thermal stability are highly required.

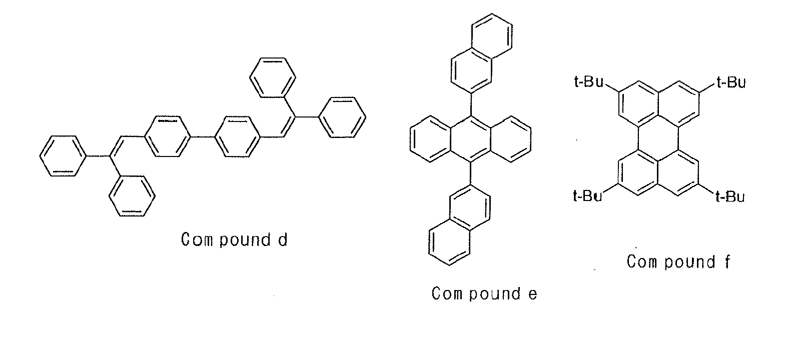

### SUMMARY

The present invention relates to an organic electroluminescent compound represented by Chemical Formula 1 and an organic electroluminescent device comprising the same. The organic electroluminescent compound according to the present invention has good luminous efficiency and excellent color purity and life property. Therefore, OLEDs having very good operation life can be manufactured therefrom. 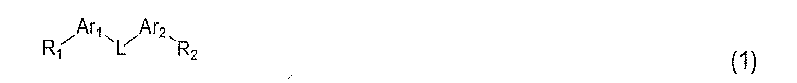 In Chemical Formula 1,
L is a substituent represented by the following structural formula: 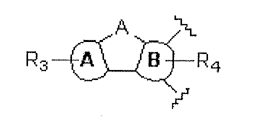 wherein
A represents -N(R₇₁)-, -S-, -O-, -Si(R₇₂)(R₇₃)-, -P(R₇₄)-, -C(=O)-, -B(R₇₅)-, -In(R₇₆)-, -Se-, -Ge(R₇₇)(R₇₈)-, -Sn(R₇₉)(R₈₀)- or -Ga(R₈₁)-;
ring A represents a monocyclic or polycyclic (C6-C60)aromatic ring;
ring B represents anthracene;
Ar₁ and Ar₂ independently represent a chemical bond, (C6-C60)arylene, (C3-C60)heteroarylene containing one or more heteroatom(s) selected from N, O and S, 5- or 6-membered heterocycloalkylene containing one or more heteroatom(s) selected from N, O and S, (C3-C60)cycloalkylene, (C2-C60)alkenylene, (C2-C60)alkynylene, (C1-C60)alkylenoxy, (C6-C60)arylenoxy or (C6-C60)arylenethio;
R₁ and R₂ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylearbonyl, (C6-C60)arylcarbonyl, carboxyl, nitro or hydroxyl, or a substituent selected from the following structures: 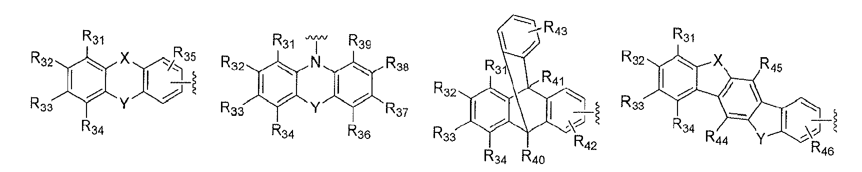 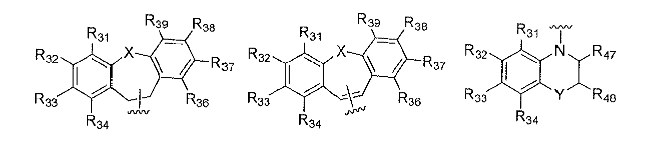 wherein
X and Y independently represent a chemical bond, -(CR₅₁R₅₂)ₘ-, -N(R₅₃)-, -S-, -O-, -Si(R₅₄)(R₅₅)-, -P(R₅₆)-, -C(=O)-, -B(R₅₇)-, -In(R₅₈)-, -Se-, -Ge(R₅₉)(R₆₀)-, -Sn(R₆₁)(R₆₂)-, -Ga(R₆₃)- or -(R₆₄)C=C(R₆₅)-, excluding the case where both X and Y are chemical bonds at the same time;
R₃, R₄ and R₃₁ through R₄₈ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₃₁ through R₄₃ may be linked to an adjacent substituent via (C3-C60)alkylene or (C3-C60)alkenylene with or without a fused ring to form an alicyclic ring or a monocyclic or polycyclic aromatic ring;
R₅₁ through R₆₅ and R₇₁ through R₈₁ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₅₁ and R₅₂, R₅₄ and R₅₅, R₅₉ and R₆₀, R₆₁ and R₆₂, R₆₄ and R₆₅, R₇₂ and R₇₃, R₇₇ and R₇₈ and R₇₉ and R₈₀ may be linked via (C3-C60)alkylene or (C3-C60)alkenylene with or without a fused ring to form an alicyclic ring or a monocyclic or polycyclic aromatic ring;
the arylene, heteroarylene, heterocycloalkylene, cycloalkylene or alkenylene of Ar₁ and Ar₂ or the alkyl, aryl, heteroaryl, heterocycloalkyl, cycloalkyl, trialkylsilyl, dialkylarylsilyl, triarylsilyl, adamantyl, alkenyl, alkynyl, amino, alkylamino or arylamino of R₁, R₂, R₃, R₄, R₃₁ through R₄₈, R₅₁ through R₆₅ and R₇₁ through R₈₁ may be further substituted by one or more substituent(s) selected from deuterium, halogen, halo(C1-C60)alkyl, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
m represents an integer from 1 to 4.

In the present invention, "alkyl", "alkoxy" and other substituents including "alkyl" moiety may be either linear or branched.

In the present invention, "aryl" means an organic radical derived from an aromatic hydrocarbon by the removal of one hydrogen, and may include a 4- to 7-membered, particularly 5- or 6-membered, single ring or fused ring. Specific examples include phenyl, naphthyl, biphenyl, anthryl, indenyl, fluorenyl, phenanthryl, triphenylenyl, pyrenyl, perylenyl, chrysenyl, naphthacenyl, fluoranthenyl, etc., but not limited thereto. The naphthyl includes 1-naphthyl and 2-naphthyl, the anthryl includes 1-anthryl, 2-anthryl and 9-anthryl, and the fluorenyl includes all of 1-fluorenyl, 2-fluorenyl, 3-fluorenyl, 4-fluorenyl and 9-fluorenyl.

In the present invention, "heteroaryl" means aryl group containing 1 to 4 heteroatom(s) selected from N, O, S and Si as aromatic ring backbone atom(s), remaining aromatic ring backbone atoms being carbon. It may be 5- or 6-membered monocyclic heteroaryl or polycyclic heteroaryl resulting from condensation with a benzene ring, and may be partially saturated. The heteroaryl includes a divalent aryl group wherein the heteroatom(s) in the ring may be oxidized or quaternized to form, for example, N-oxide or quaternary salt. Specific examples include monocyclic heteroaryl such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl, etc., polycyclic heteroaryl such as benzofuranyl, benzothiophenyl, isobenzofuranyl, benzoimidazolyl, benzothiazolyl, benzoisothiazolyl, benzoisoxazolyl, benzoxazolyl, isoindolyl, indolyl, indazolyl, benzothiadiazolyl, quinolyl, isoquinolyl, cinnolinyl, quinazolinyl, quinoxalinyl, carbazolyl, phenanthridinyl, benzodioxolyl, etc., N-oxide thereof (e.g., pyridyl N-oxide, quinolyl N-oxide, etc.), quaternary salt thereof, etc., but not limited thereto.

And, in the present invention, the substituents including "(C1-C60)alkyl" moiety may have 1 to 60 carbon atoms, 1 to 20 carbon atoms, or 1 to 10 carbon atoms. The substituents including "(C6-C60)aryl" moiety may have 6 to 60 carbon atoms, 6 to 20 carbon atoms, or 6 to 12 carbon atoms. The substituents including "(C3-C60)heteroaryl" moiety may have 3 to 60 carbon atoms, 4 to 20 carbon atoms, or 4 to 12 carbon atoms. The substituents including "(C3-C60)cycloalkyl" moiety may have 3 to 60 carbon atoms, 3 to 20 carbon atoms, or 3 to 7 carbon atoms. The substituents including "(C2-C60)alkenyl or alkynyl" moiety may have 2 to 60 carbon atoms, 2 to 20 carbon atoms, or 2 to 10 carbon atoms.

In Chemical Formula 1, L may be selected from the following structures, but not limited thereto: 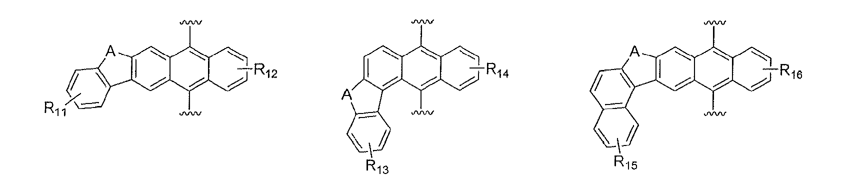 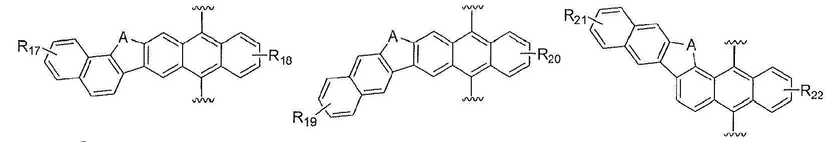 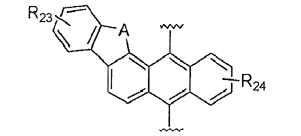 wherein
A is the same as defined in Chemical Formula 1;
R₁₁ through R₂₄ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl; and
the alkyl, aryl, heteroaryl, heterocycloalkyl, cycloalkyl, trialkylsilyl, dialkylarylsilyl, triarylsilyl, adamantyl, alkenyl, alkynyl, amino, alkylamino or arylamino of R₁₁ through R₂₄ may be further substituted by one or more substituent(s) selected from deuterium, halogen, halo(C1-C60)alkyl, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

In Chemical Formula 1, L may be selected from the following structures, but not limited thereto: 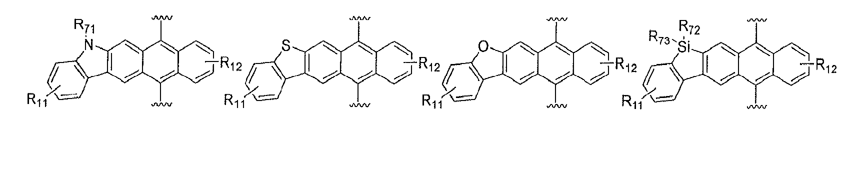 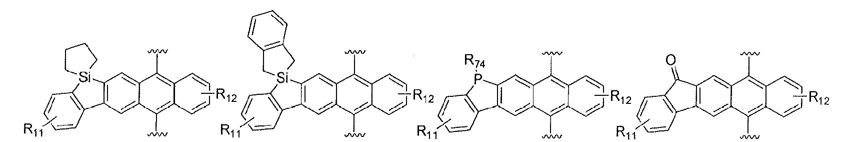 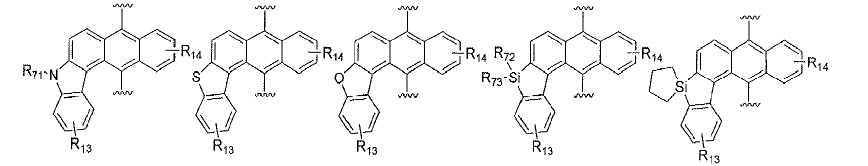 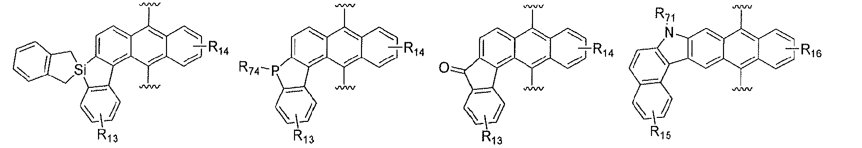 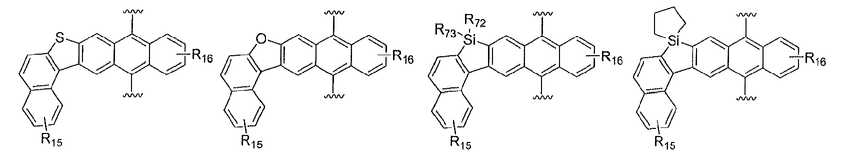 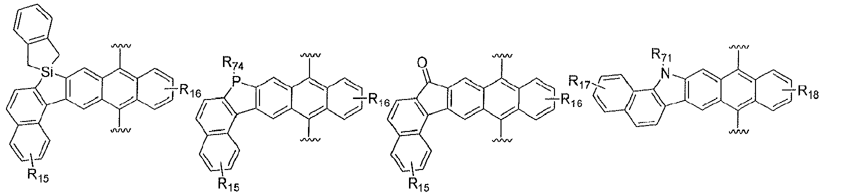 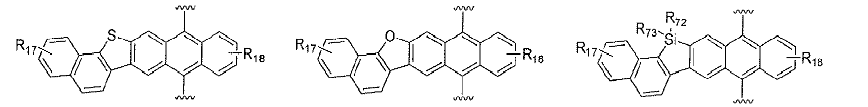 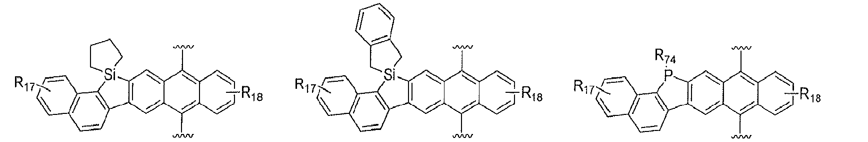 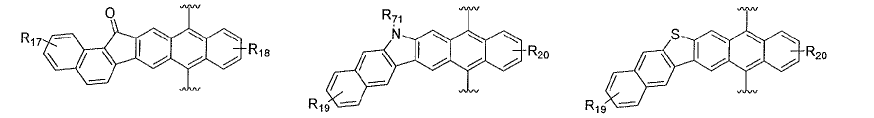 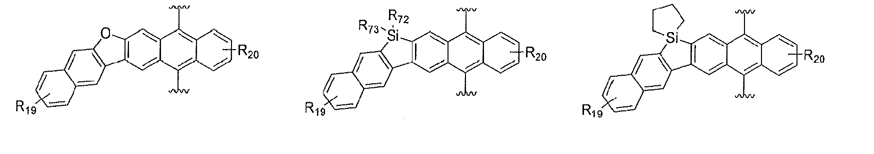 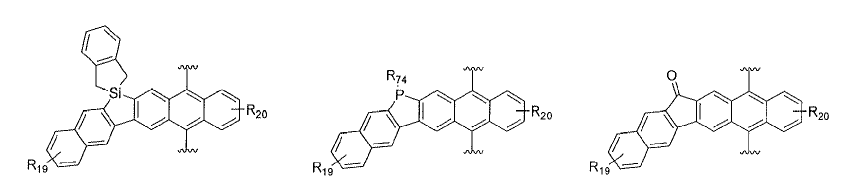 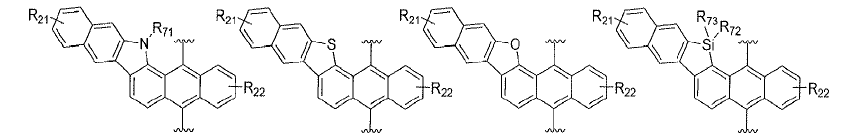 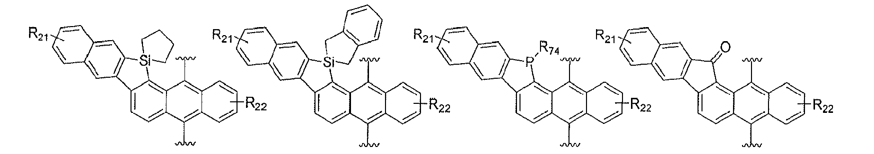 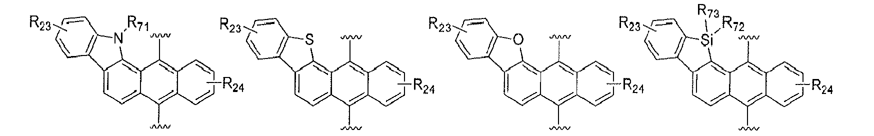 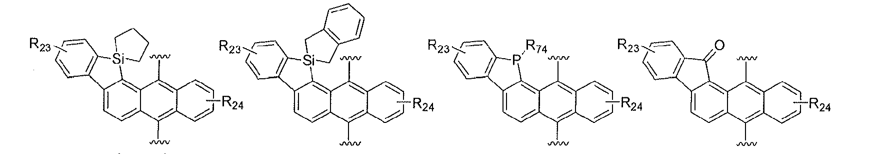 wherein
R₁₁ through R₂₄ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
R₇₁ through R₇₄ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, adamantyl, (C7-C60)bicycloalkyl, cyano, amino, (C6-C60)ar(C1-C60)alkyl, (C1-C60)alkoxycarbonyl, (C1-C60)alkylcarbonyl, (C6-C60)arylcarbonyl, carboxyl or hydroxyl; and
the alkyl, aryl heteroaryl, heterocycloalkyl, cycloalkyl or adamantyl of R₁₁ through R₂₄ and R₇₁ through R₇₄ may be further substituted by one or more substituent(s) selected from deuterium, halogen, halo(C1-C60)alkyl, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl. 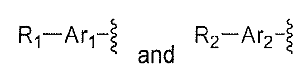 independently may be selected from the
following structure, but not limited thereto: 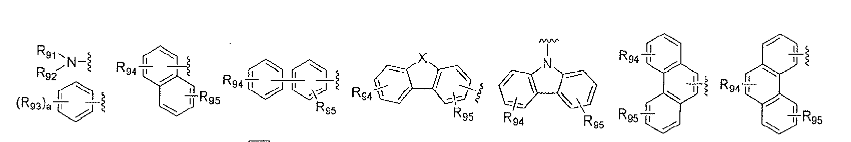 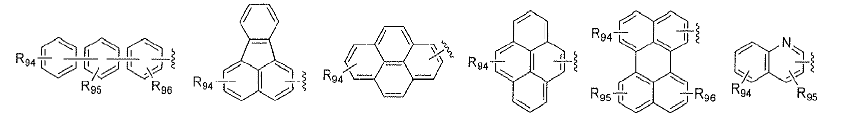 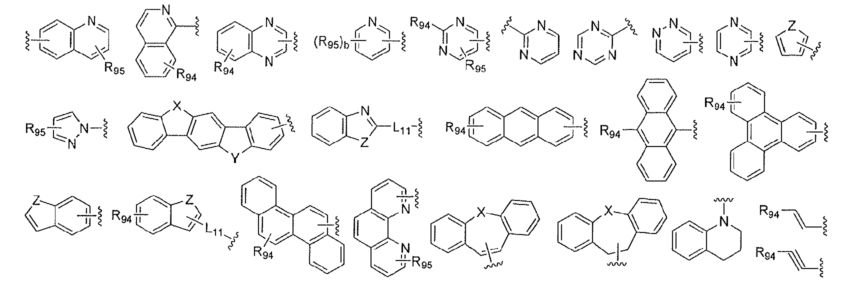 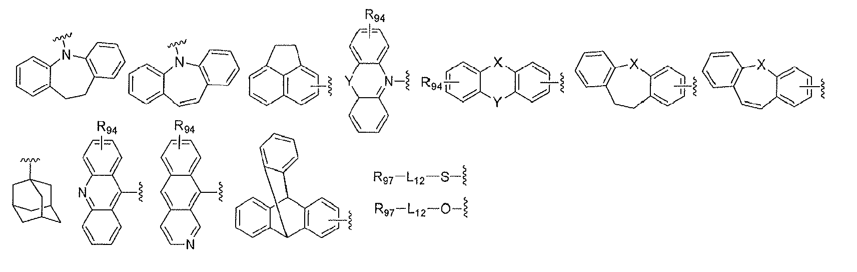 wherein
R₉₁ and R₉₂ independently represent hydrogen, (C1-C60)alkyl, (C3-C60)cycloalkyl, (C6-C60)aryl or (C3-C60)heteroaryl, or may be linked to an adjacent substituent via (C3-C60)alkylene or (C3-C60)alkenylene with or without a fused ring to form an alicyclic ring or a monocyclic or polycyclic aromatic ring;
R₉₃ through R₉₅ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, carbazolyl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
R₉₆ and R₉₇ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl;
L₁₁ and L₁₂ independently represent a chemical bond, (C1-C60)alkylene, (C6-C60)arylene, (C3-C60)heteroarylene, 5- or 6-membered heterocycloalkylene containing one or more heteroatom(s) selected from N, O, S and Si, (C3-C60)cycloalkylene, adamantylene, (C7-C60)bicycloalkylene, (C2-C60)alkenylene, (C2-C60)alkynylene, (C6-C60)ar(C1-C60)alkylene, (C1-C60)alkylenethio, (C1-C60)alkylenoxy, (C6-C60)arylenoxy or (C6-C60)arylenethio;
the arylene, heteroarylene, heterocycloalkylene, cycloalkylene, adamantylene, bicycloalkylene, alkenylene, alkynylene, arylenoxy or arylenethio of L₁₁ and L₁₂ may be further substituted by one or more substituent(s) selected from deuterium, halogen, (C1-C60)alkyl, halo(C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl;
X and Y independently represent -C(R₅₁)(R₅₂)-, -N(R₅₃)-, -S-, -O-, -Si(R₅₄)(R₅₅)-, -P(R₅₆)-, -C(=O)-, -B(R₅₇)-, -In(R₅₈)-, -Se-, -Ge(R₅₉)(R₆₀)-, -Sn(R₆₁)(R₆₂)-, -Ga(R₆₃)- or -(R₆₄)C=C(R₆₅)-;
R₅₁ through R₆₅ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₅₁ and R₅₂, R₅₄ and R₅₅, R₅₉ and R₆₀, R₆₁ and R₆₂ and R₆₄ and R₆₅ may be linked via (C3-C60)alkylene or (C3-C60)alkenylene with or without a fused ring to form an alicyclic ring or a monocyclic or polycyclic aromatic ring;
Z represents O, S or NR₉₈;
R₉₈ represents hydrogen, deuterium, halogen, (C1-C60)alkyl, (C3-C60)cycloalkyl or (C6-C60)aryl;
the alkyl, aryl, heteroaryl, heterocycloalkyl, cycloalkyl, trialkylsilyl, dialkylarylsilyl, triarylsilyl, adamantyl, alkenyl, alkynyl, amino, alkylamino or arylamino of R₅₁ through R₆₅ and R₉₁ through R₉₈ may be further substituted by one or more substituent(s) selected from deuterium, halogen, halo(C1-C60)alkyl, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl;
a represents an integer form 1 to 5; and
b represents an integer form 1 to 4.

More specifically, 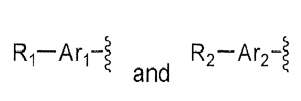 may be independently selected from the following structures, but not limited thereto:

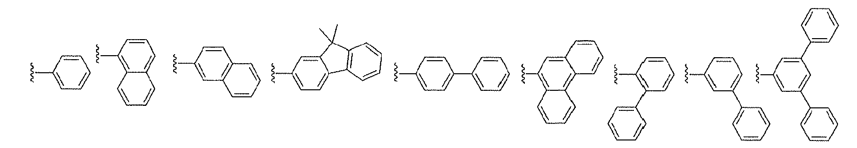

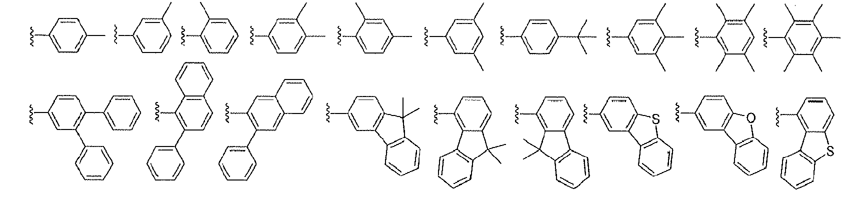

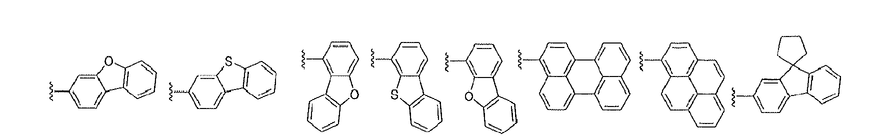

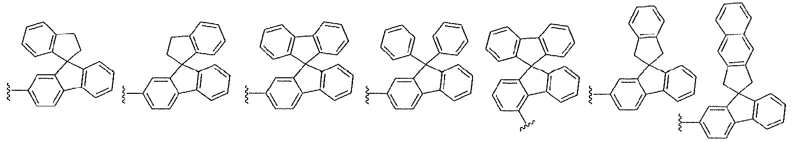

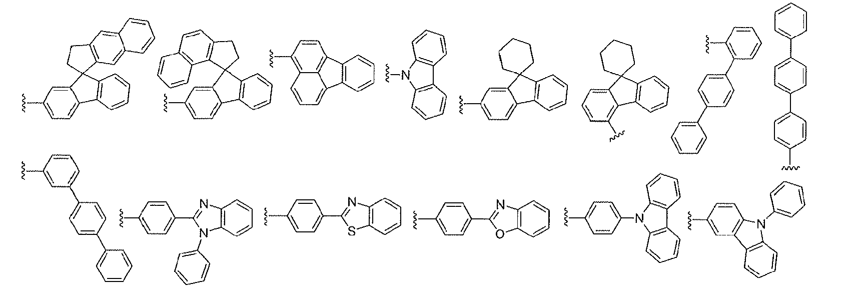

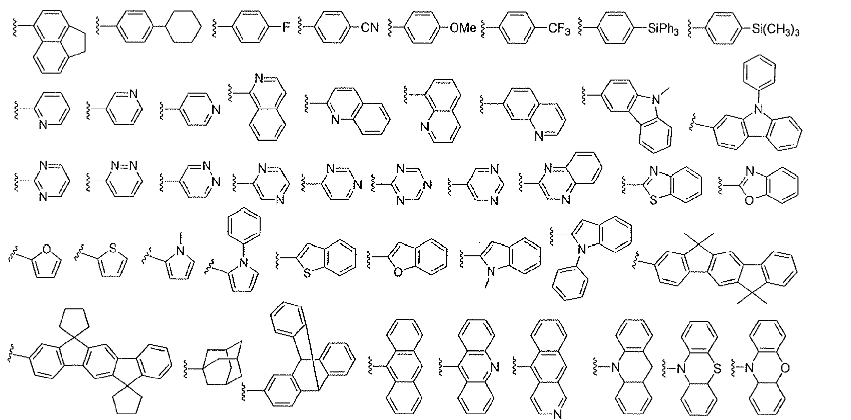

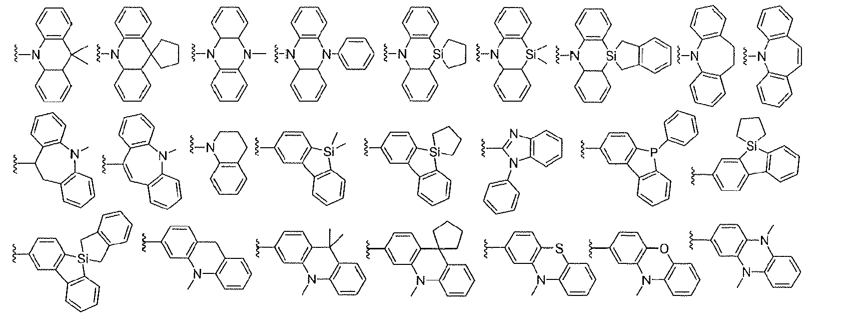

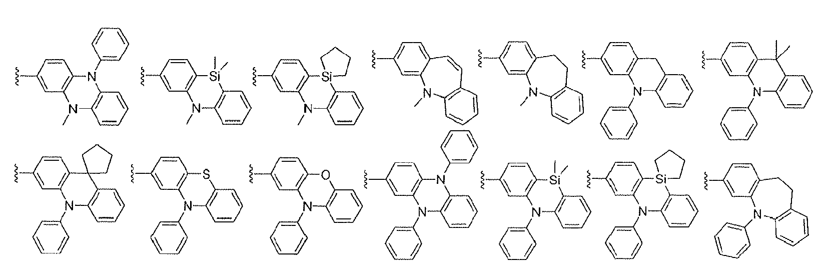

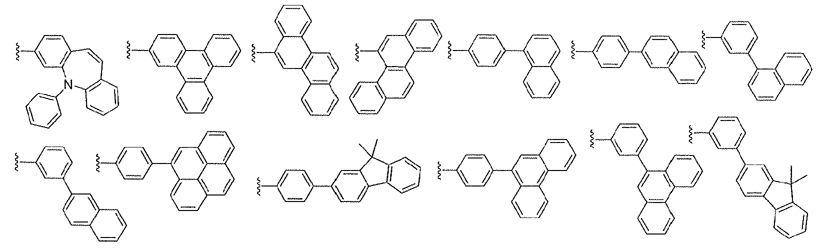

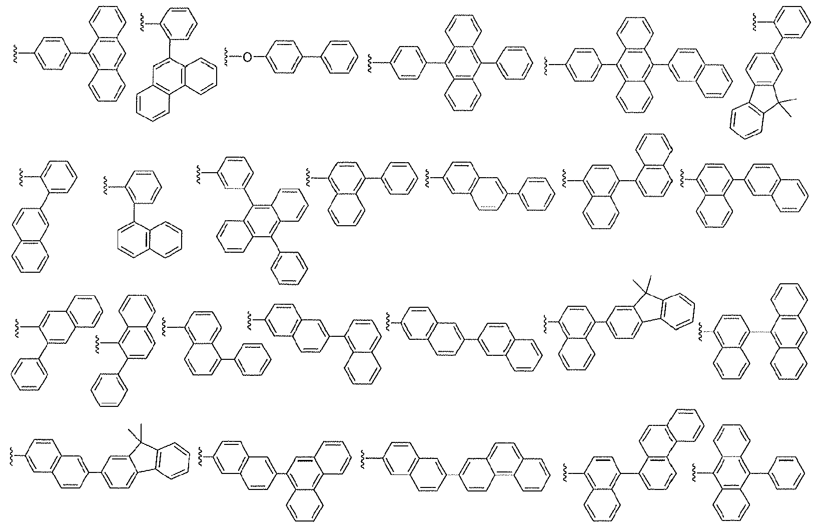

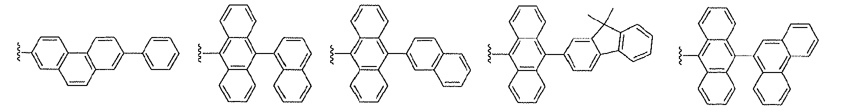

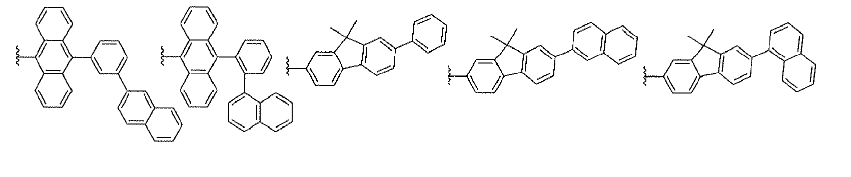

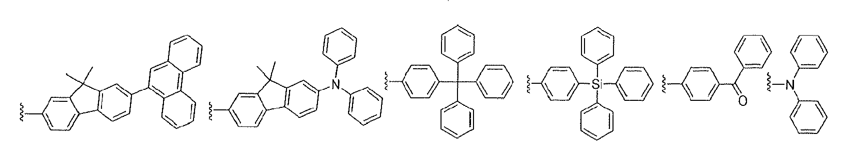

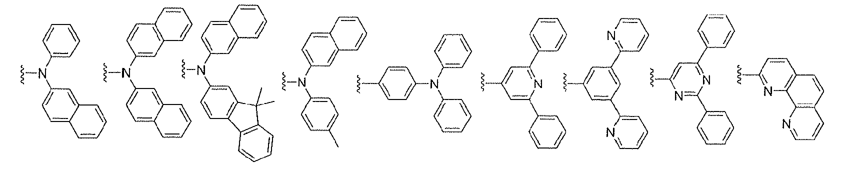

More specifically, the organic electroluminescent compound according to the present invention may be exemplified by the following compounds, but not limited thereto:

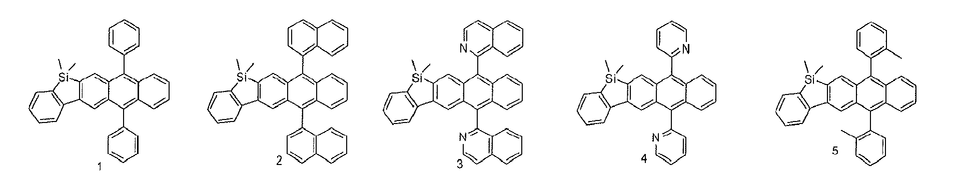

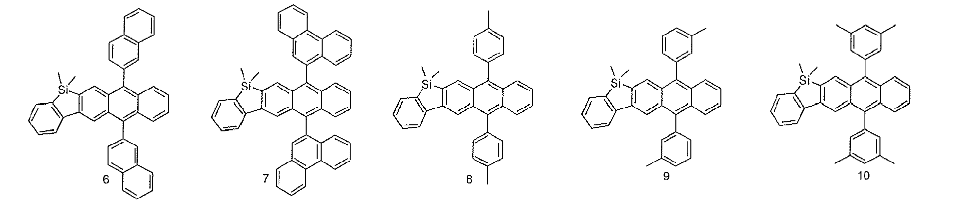

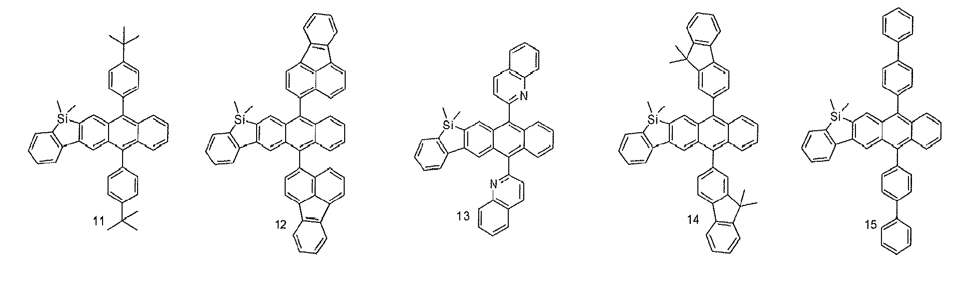

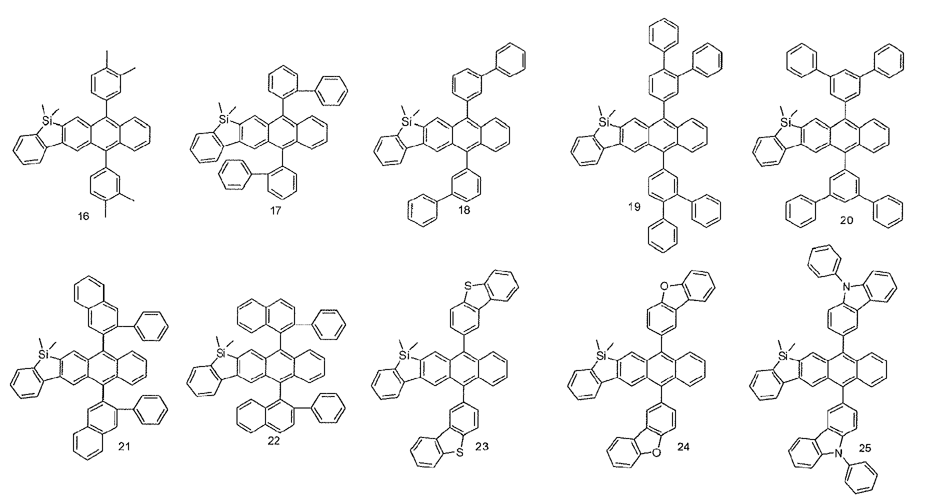

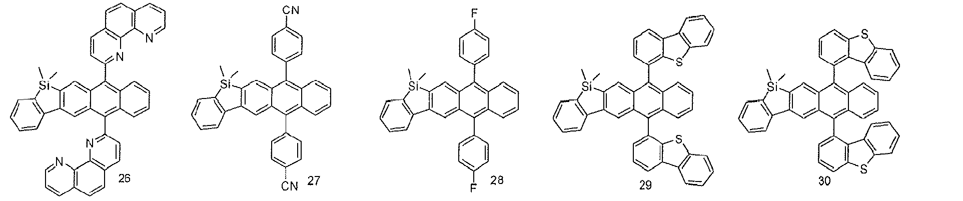

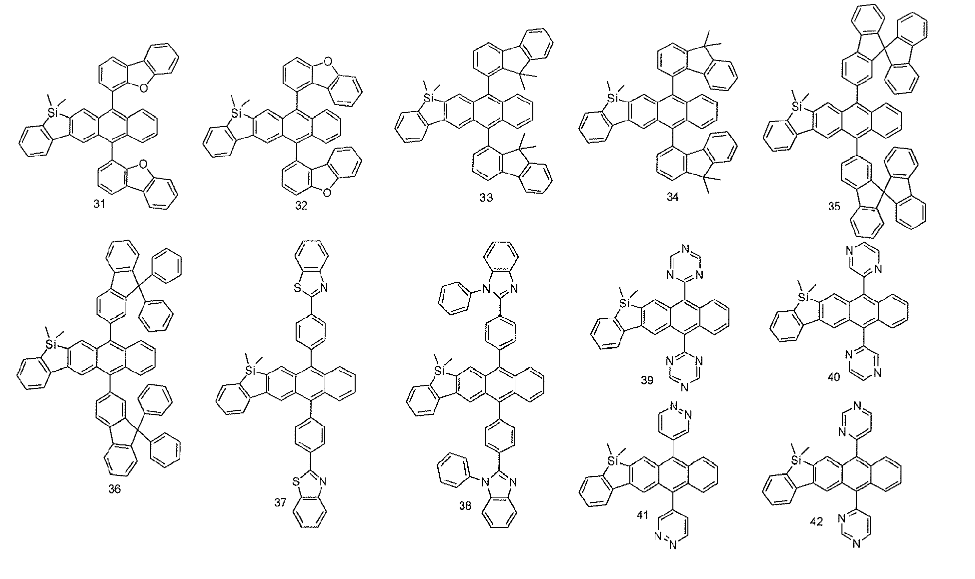

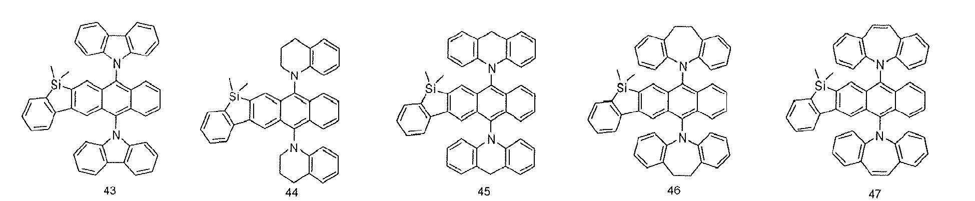

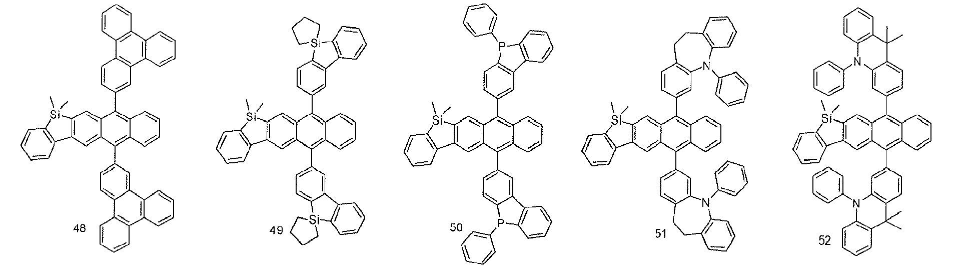

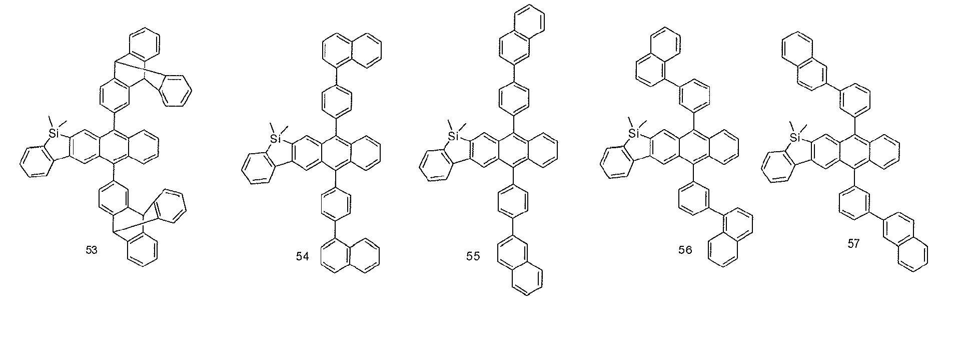

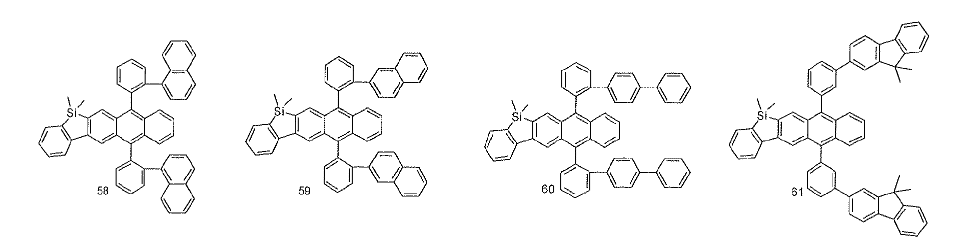

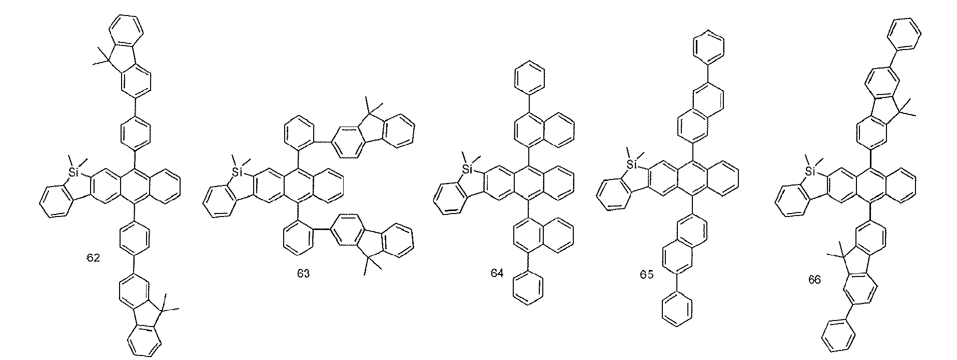

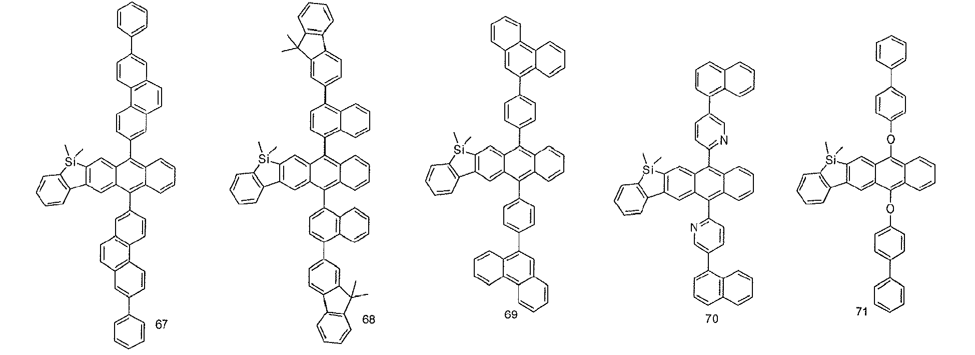

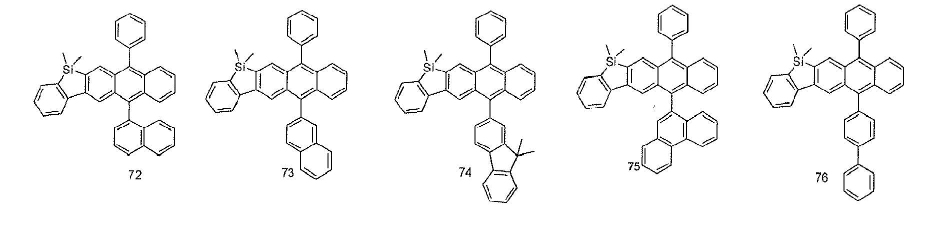

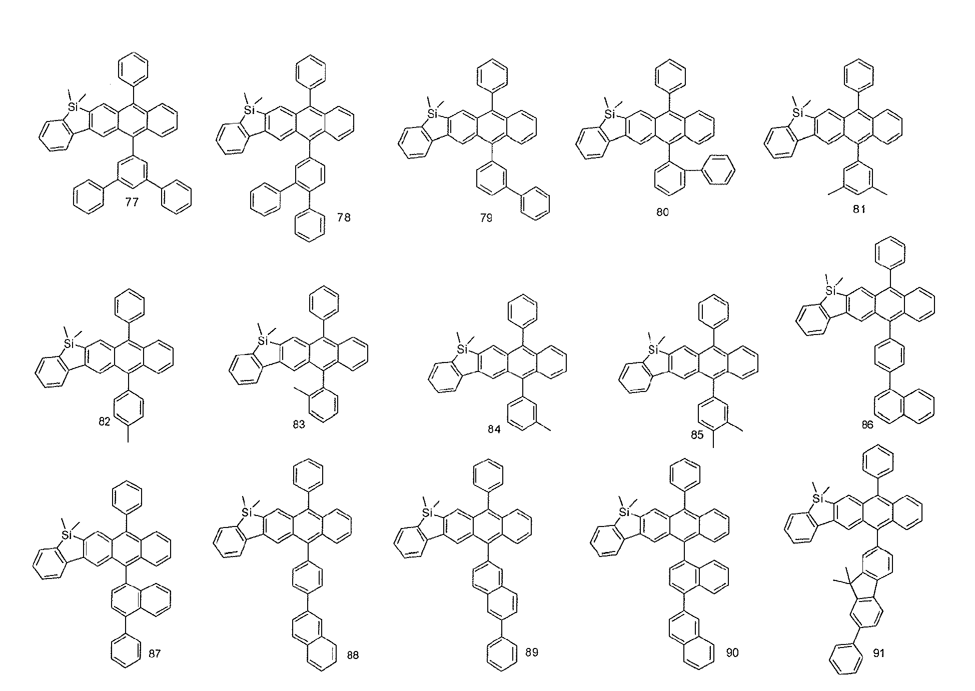

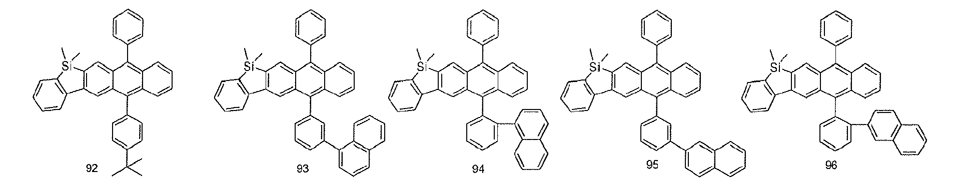

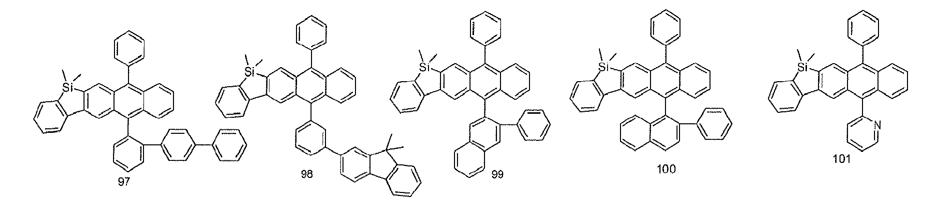

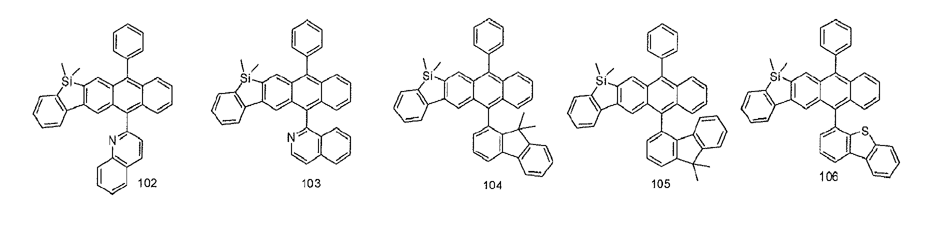

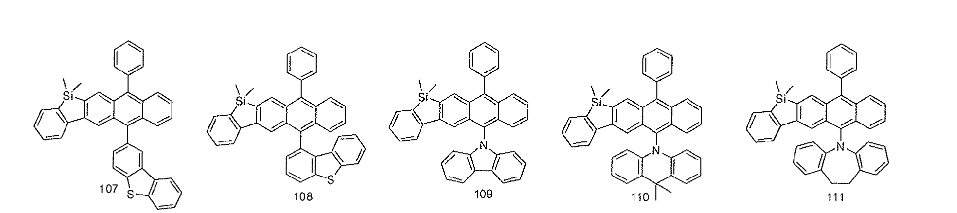

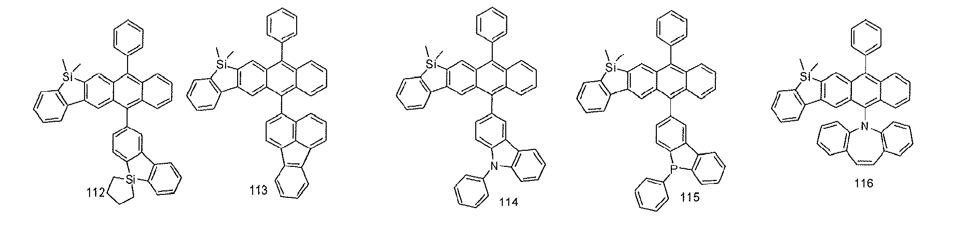

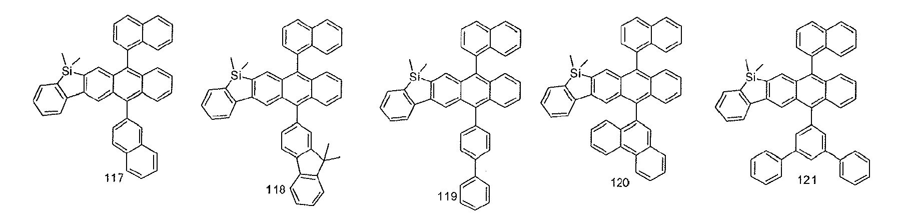

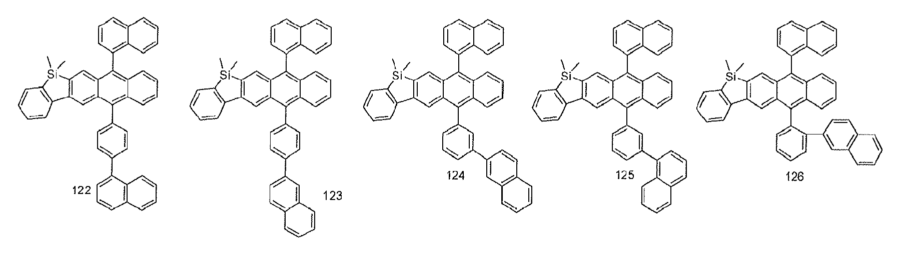

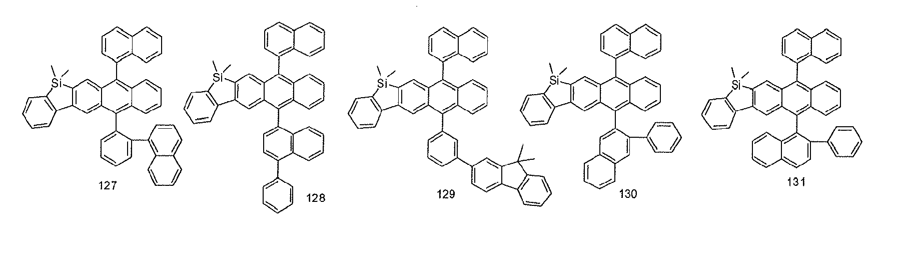

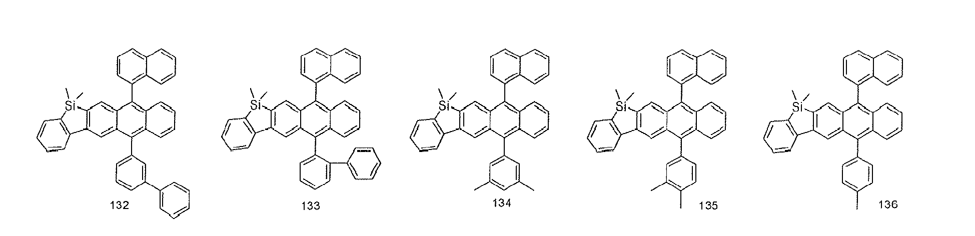

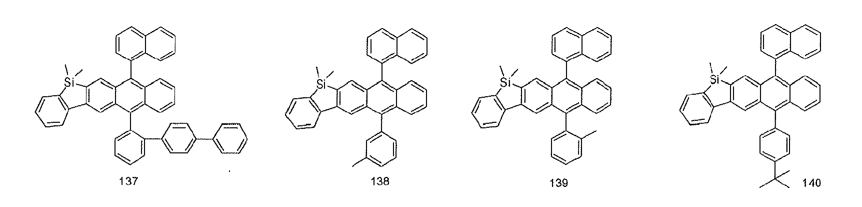

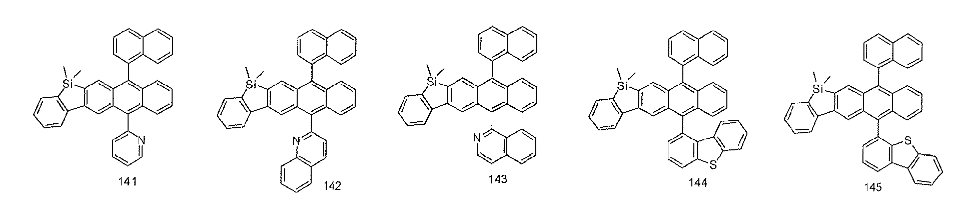

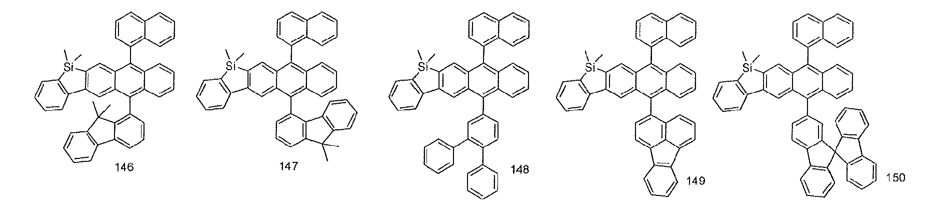

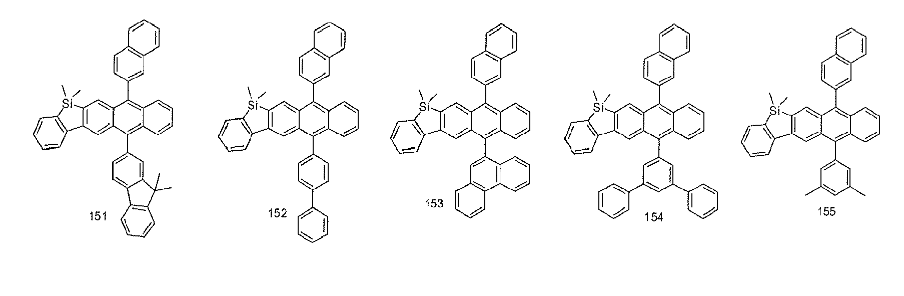

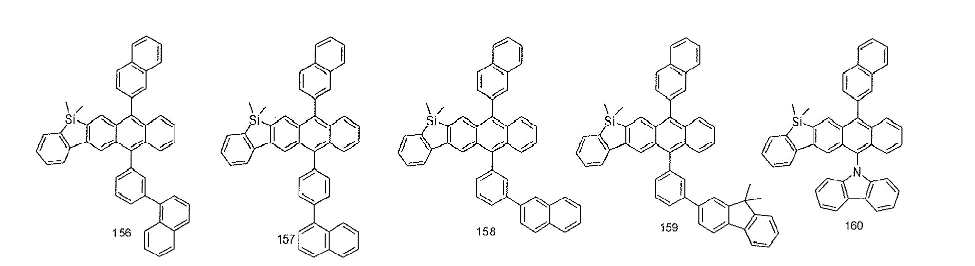

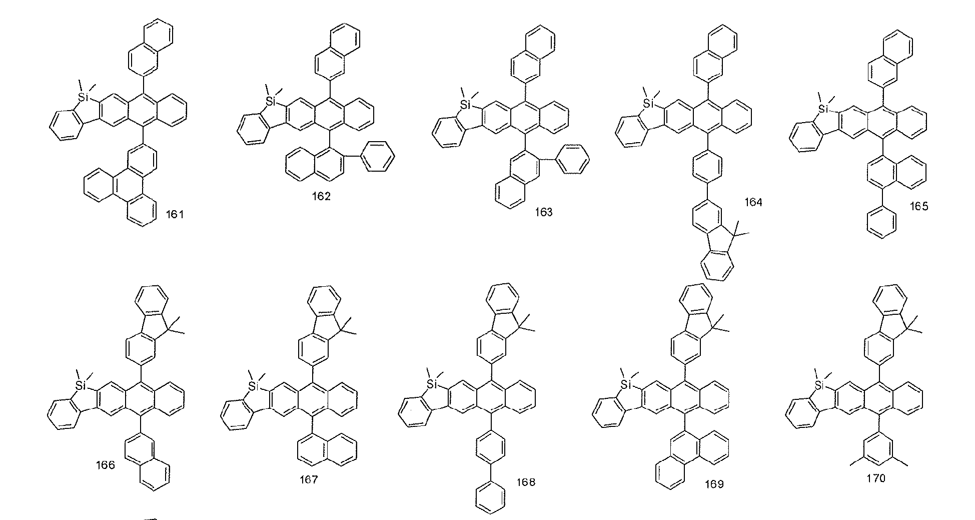

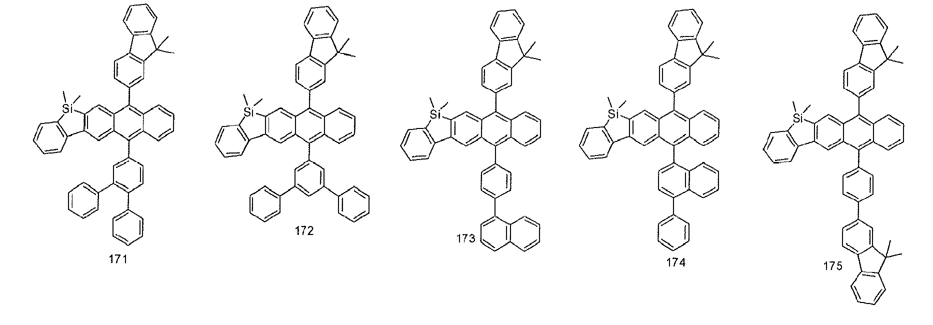

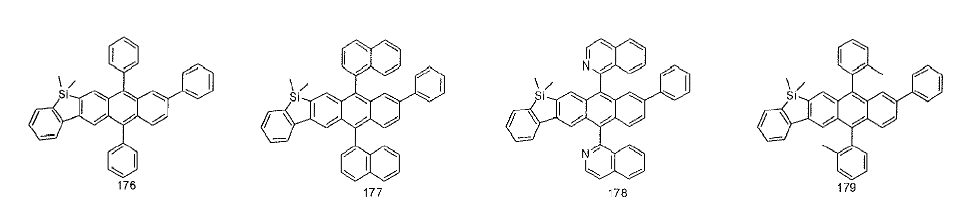

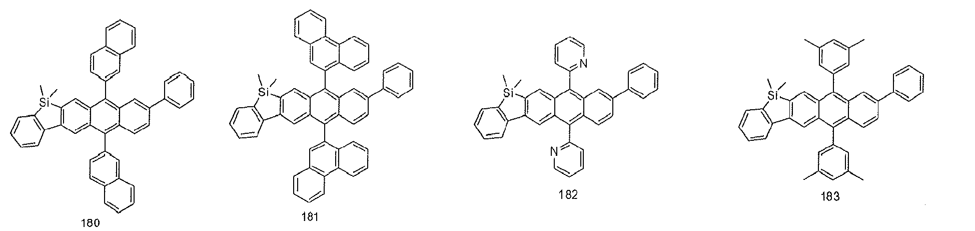

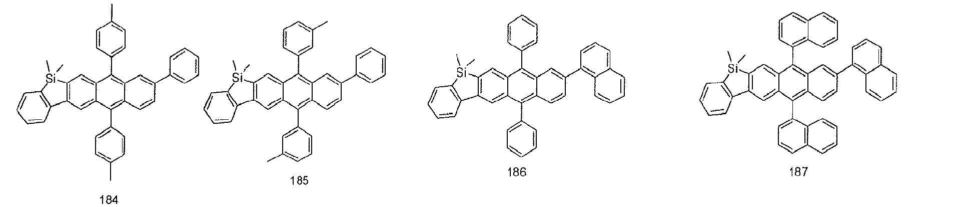

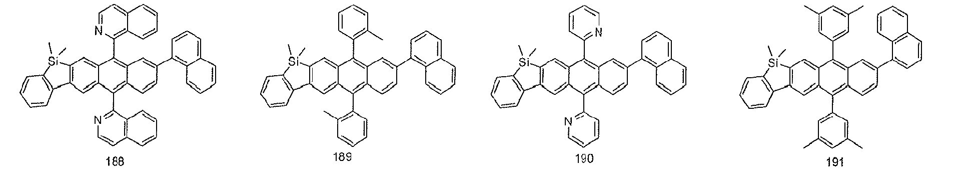

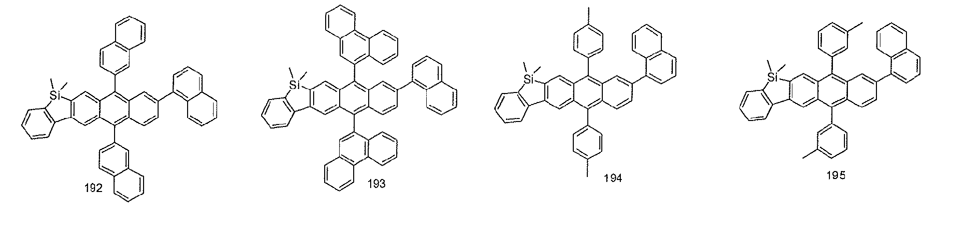

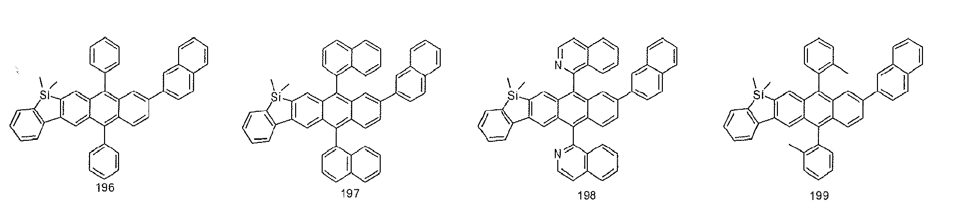

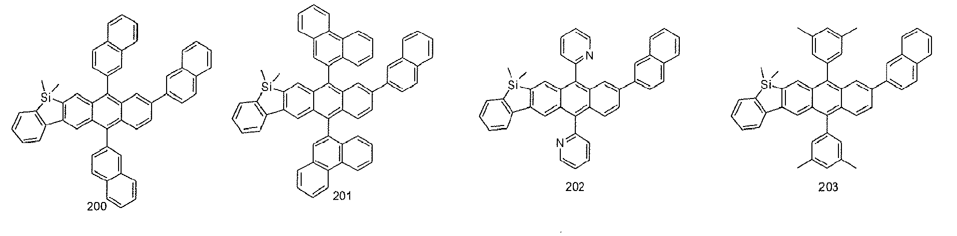

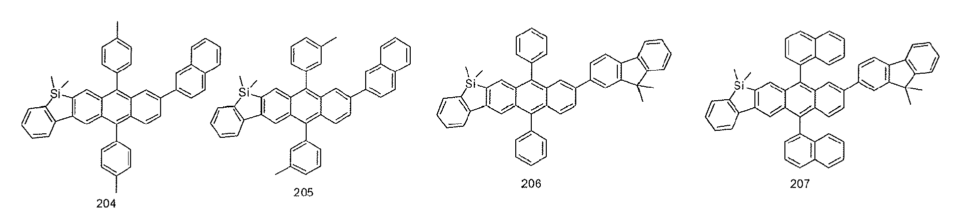

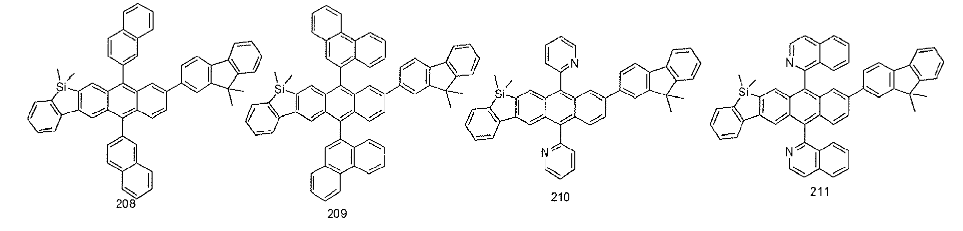

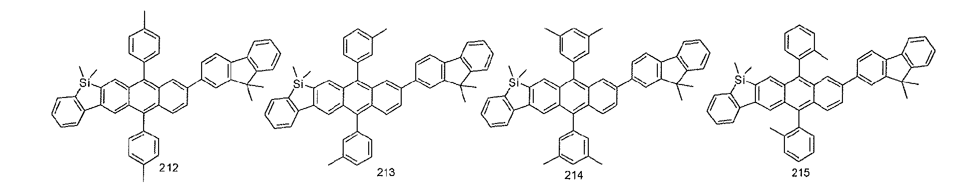

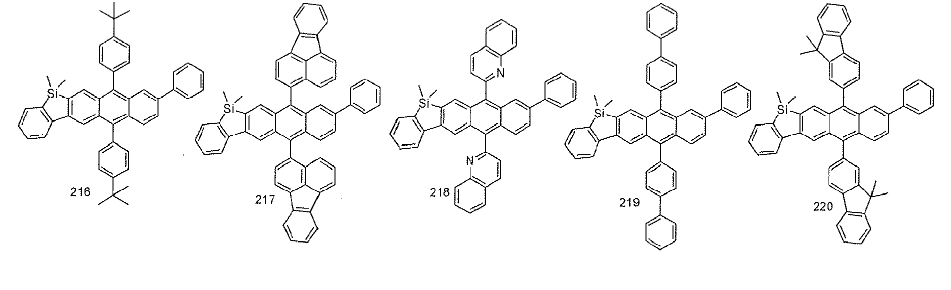

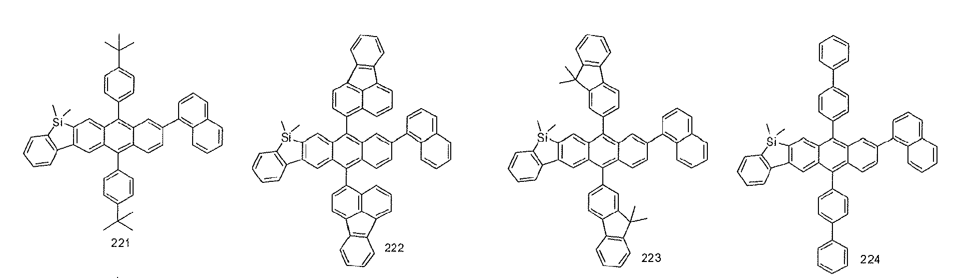

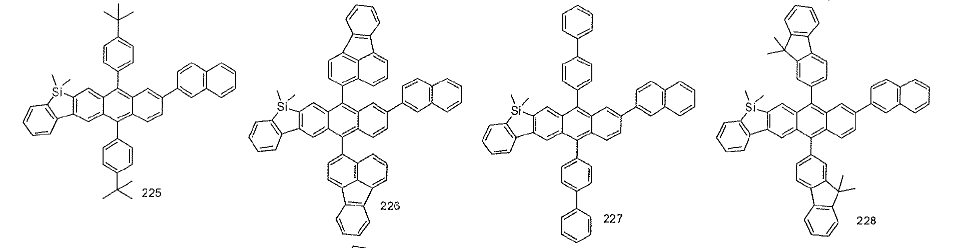

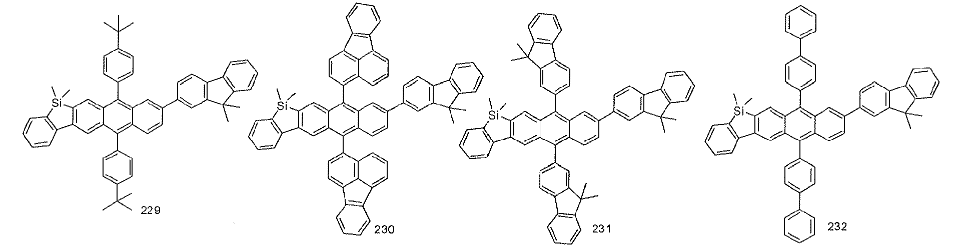

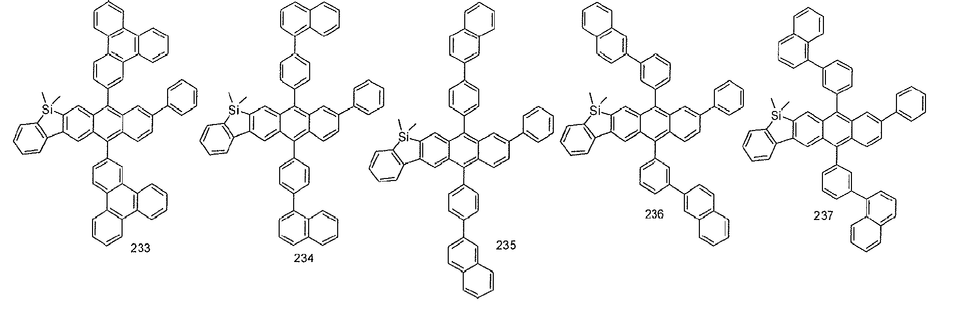

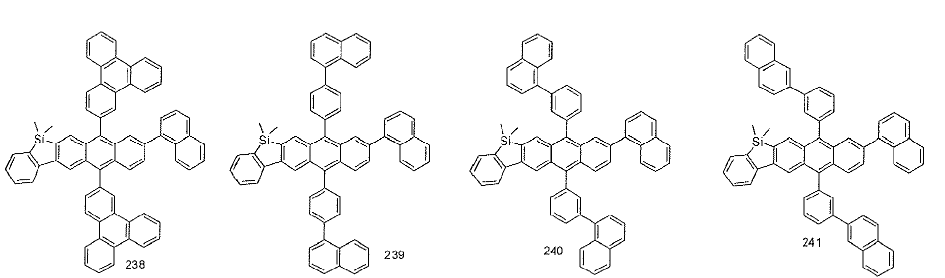

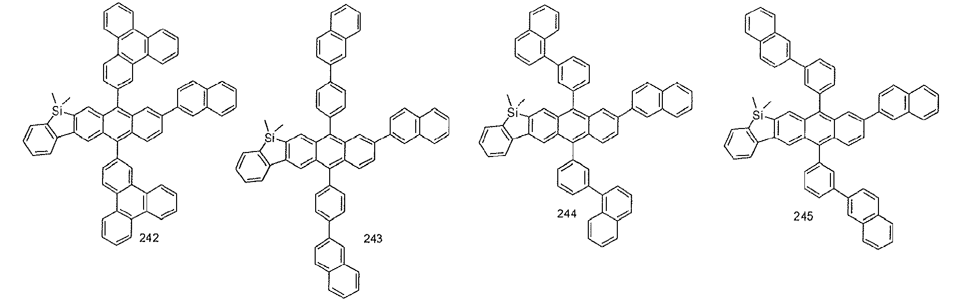

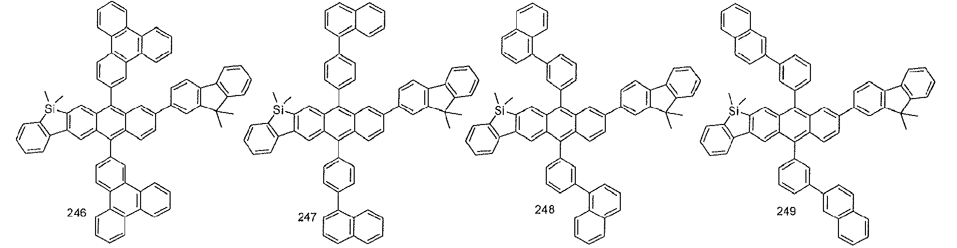

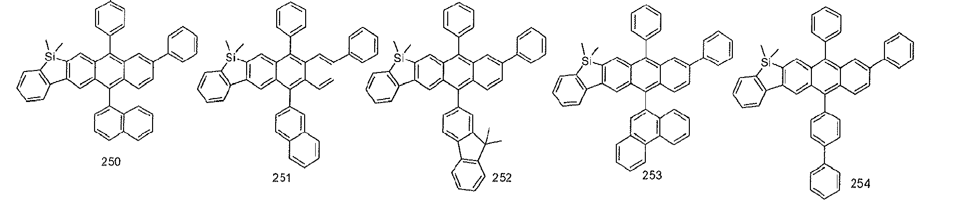

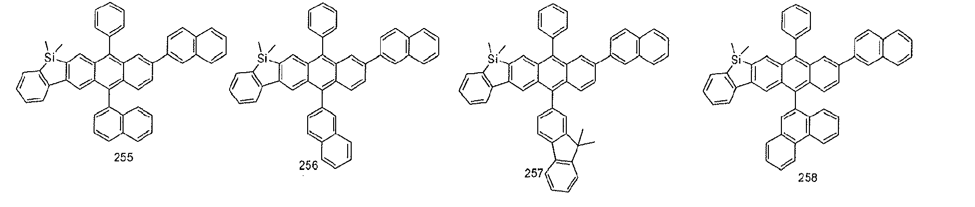

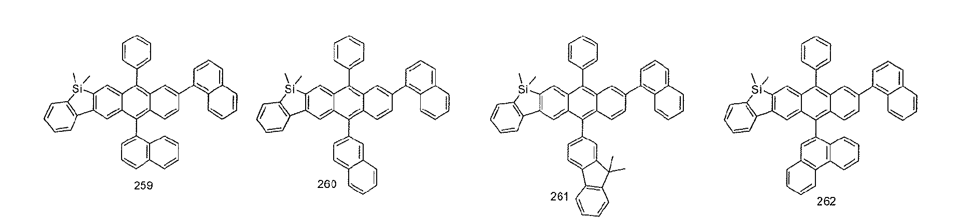

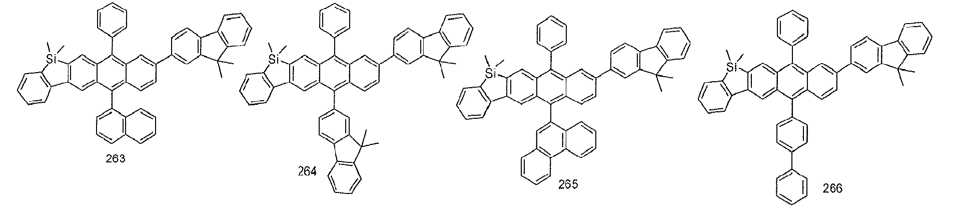

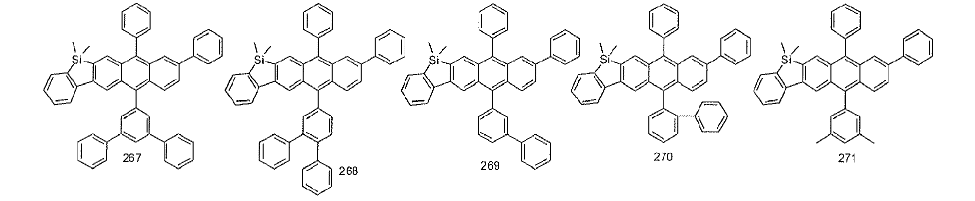

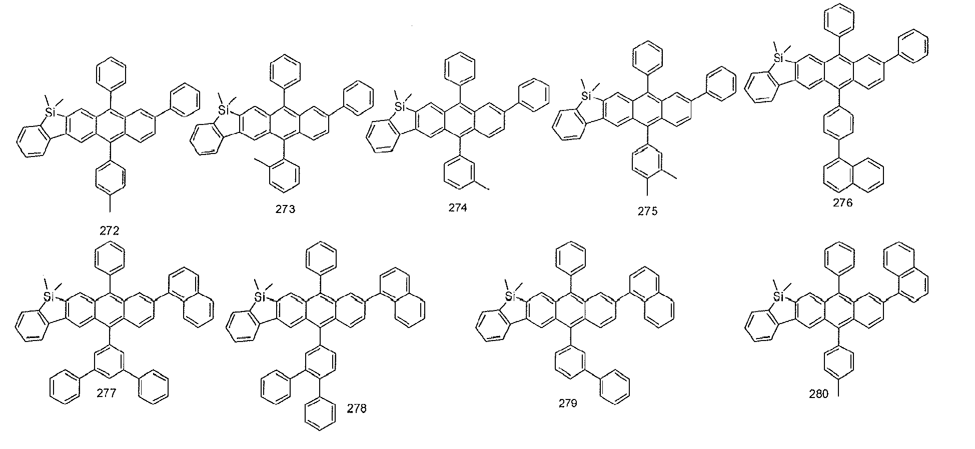

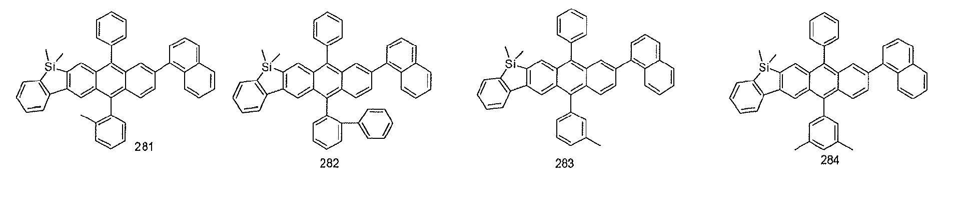

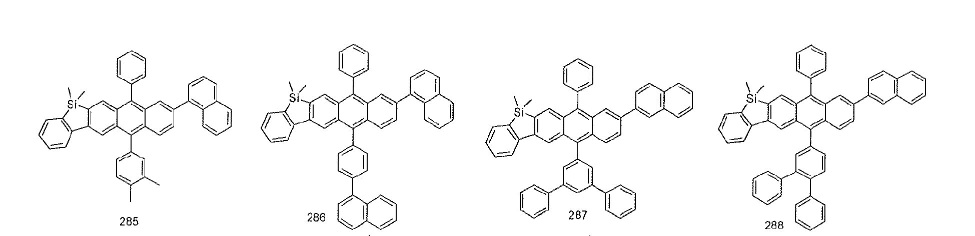

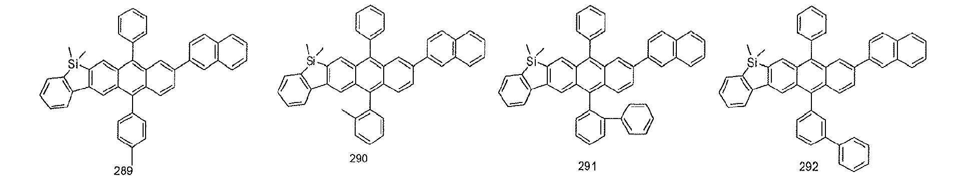

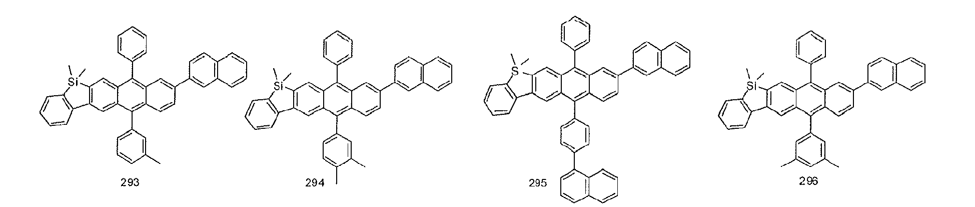

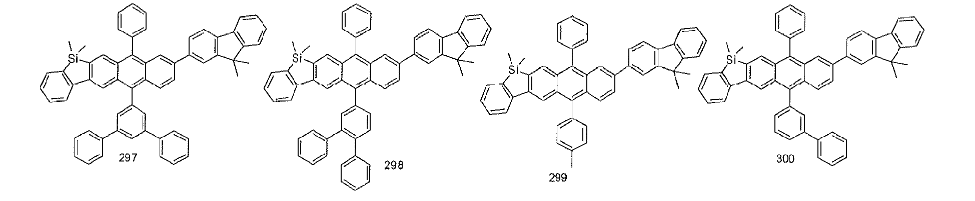

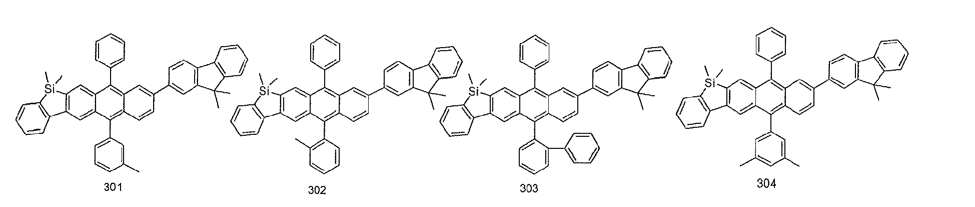

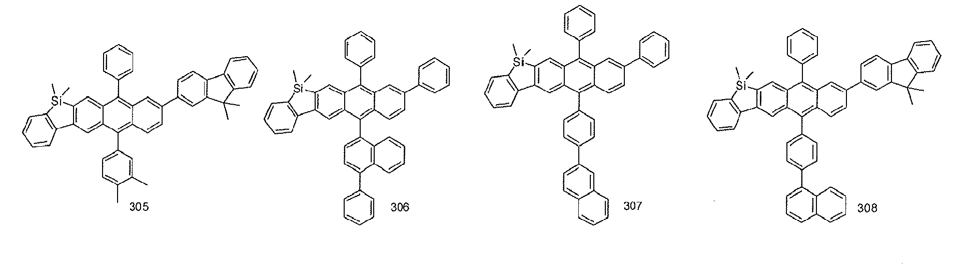

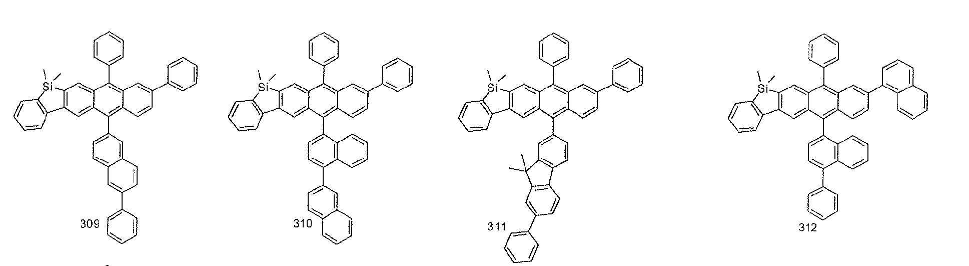

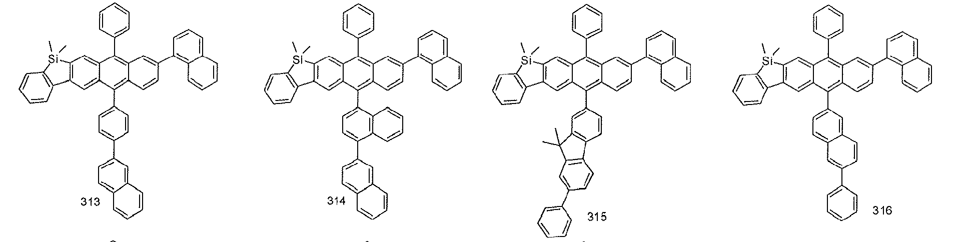

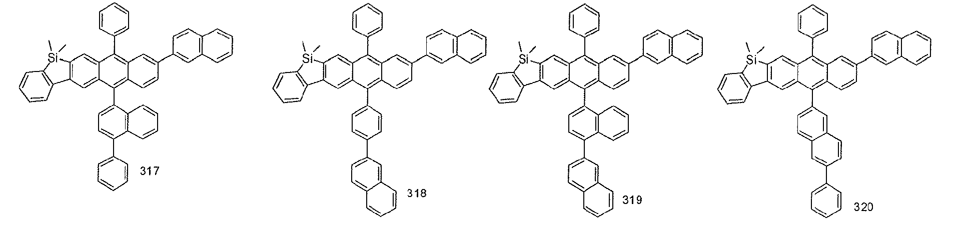

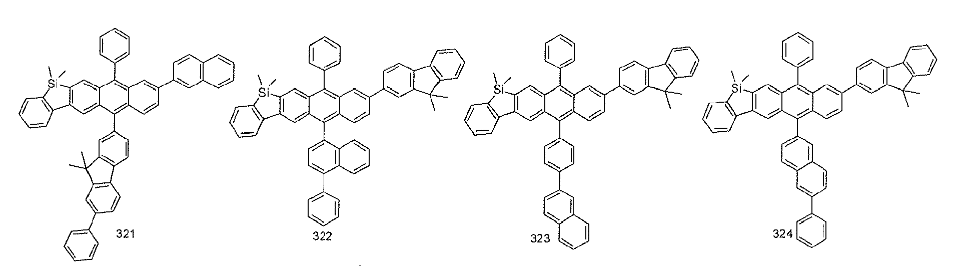

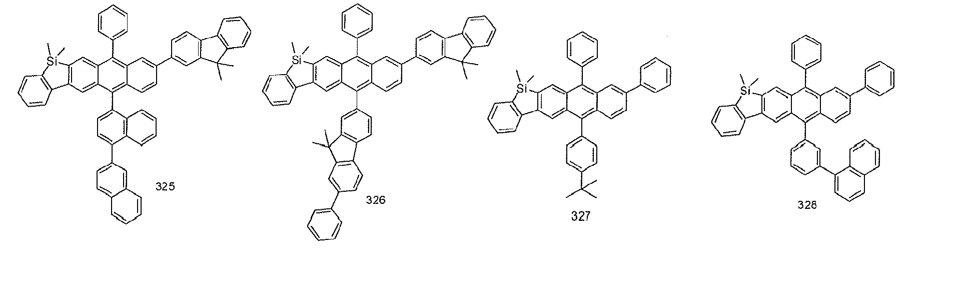

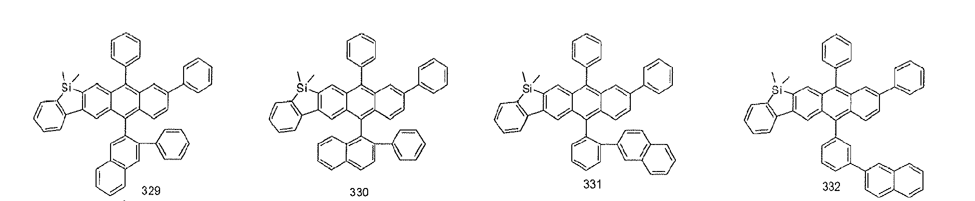

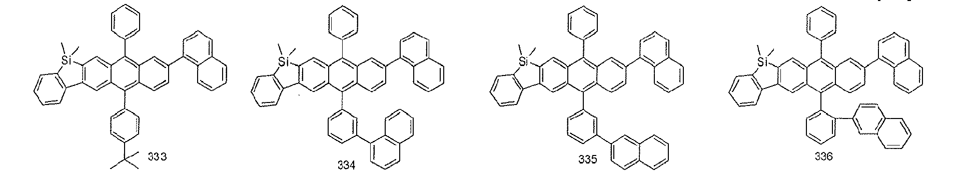

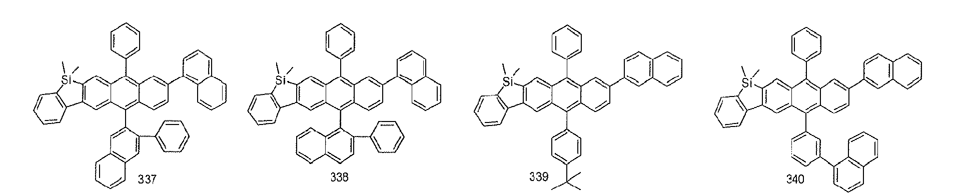

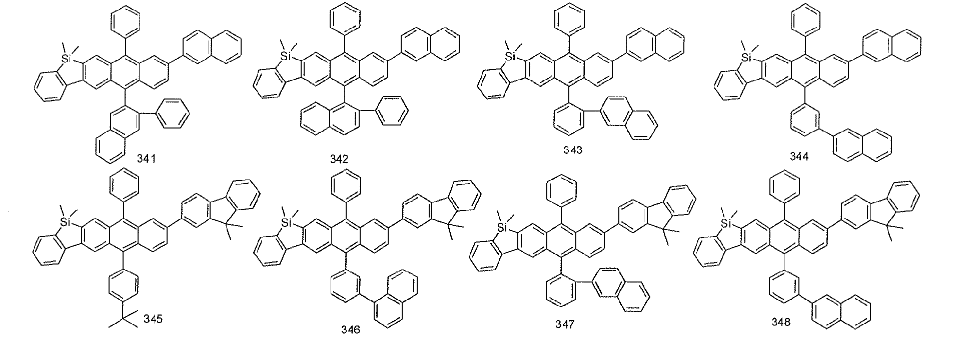

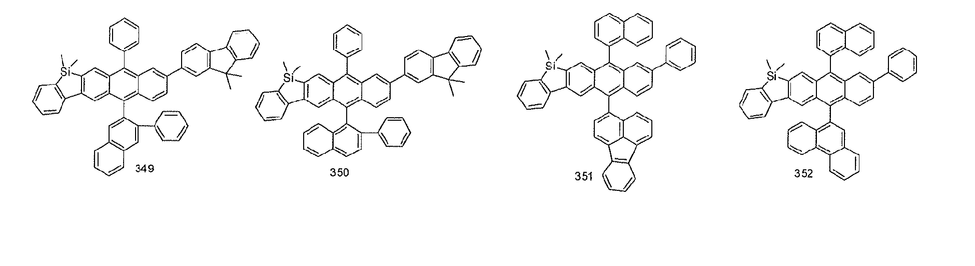

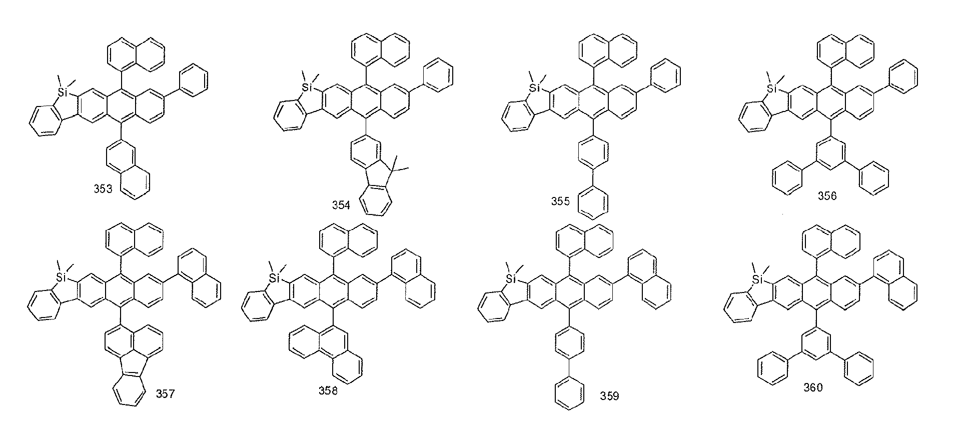

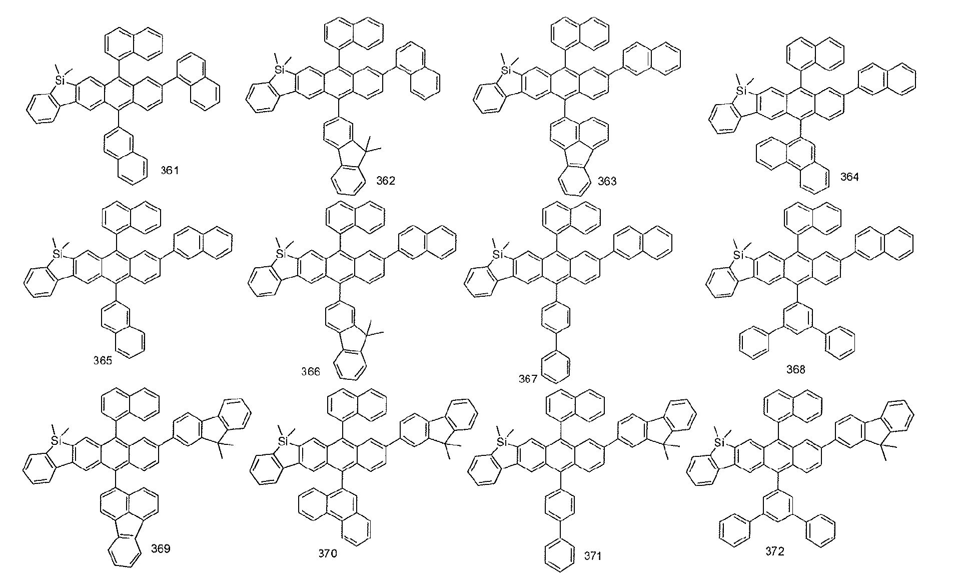

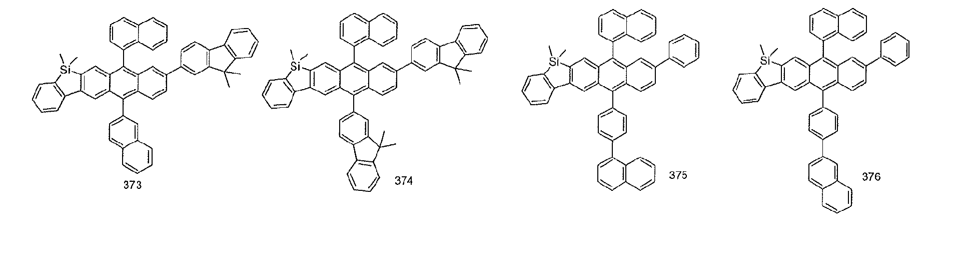

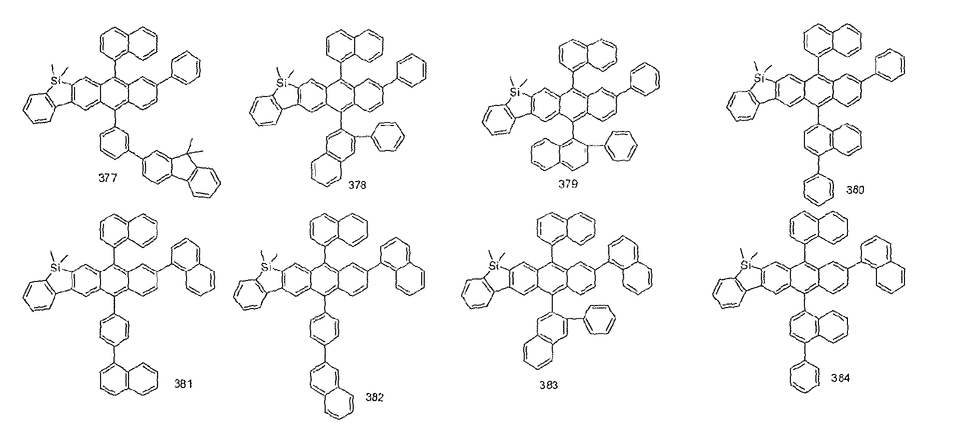

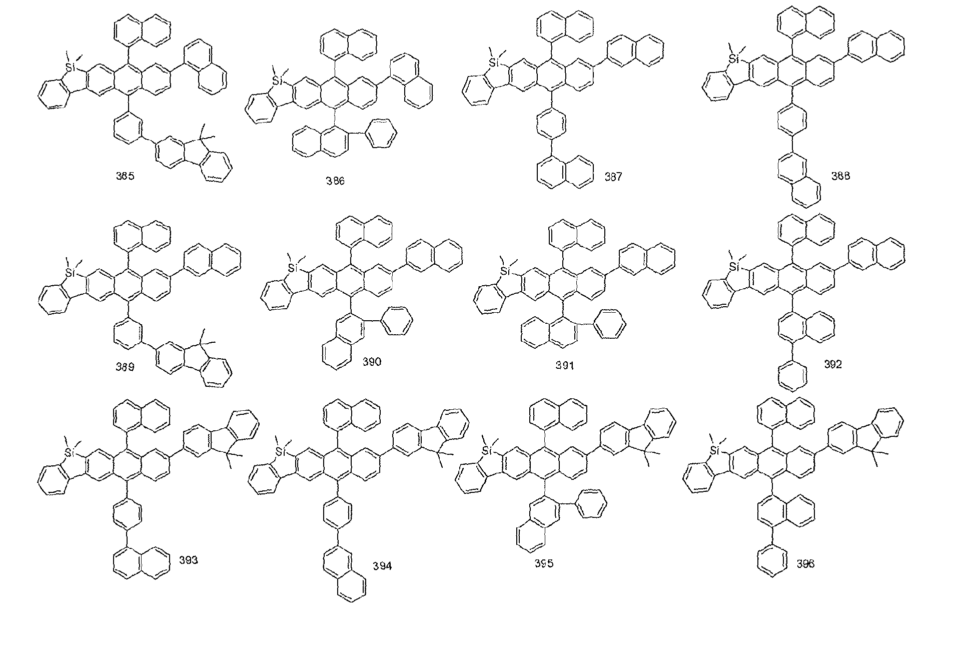

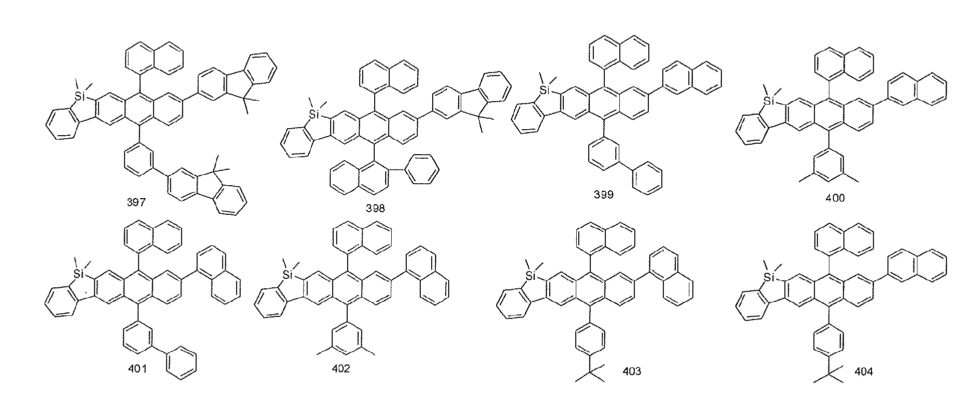

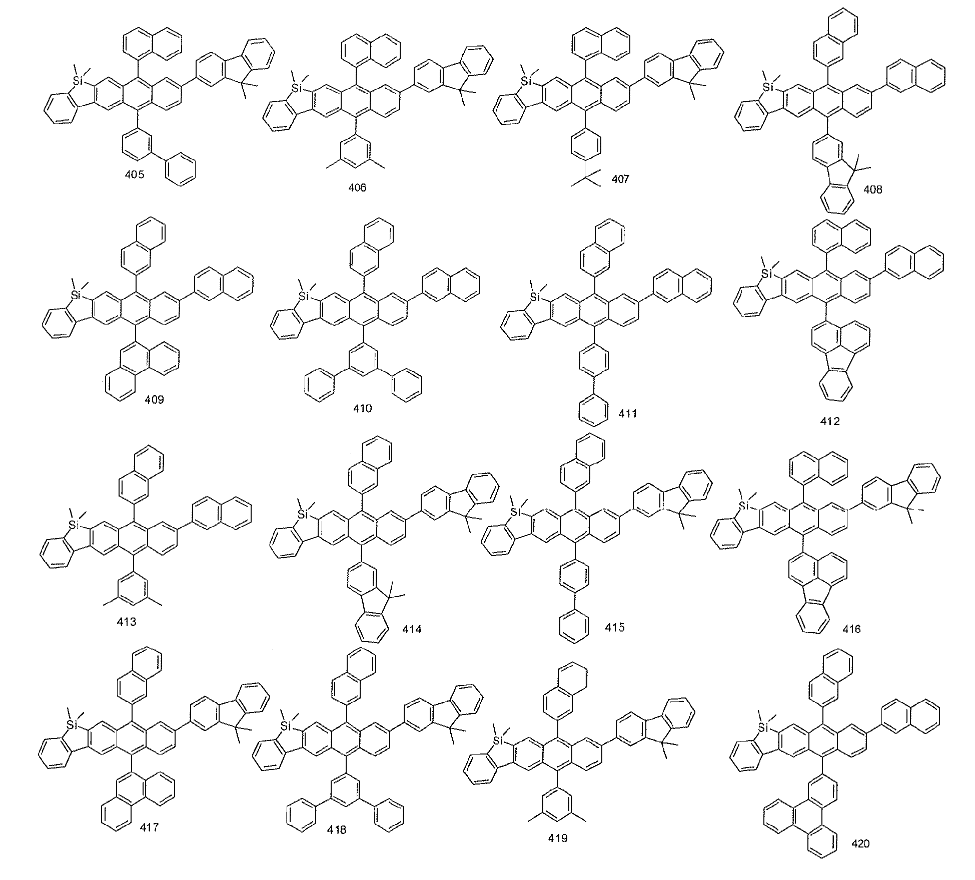

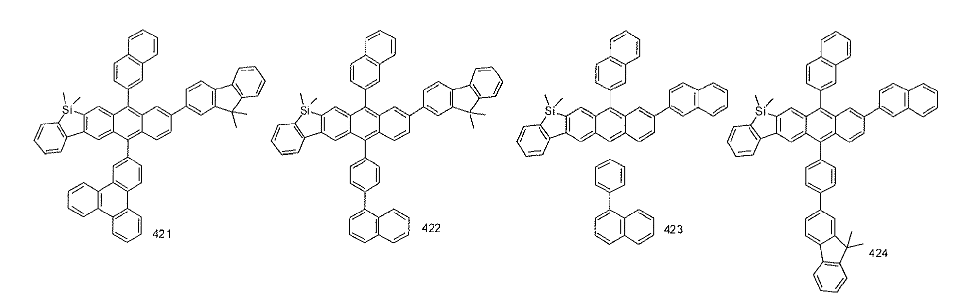

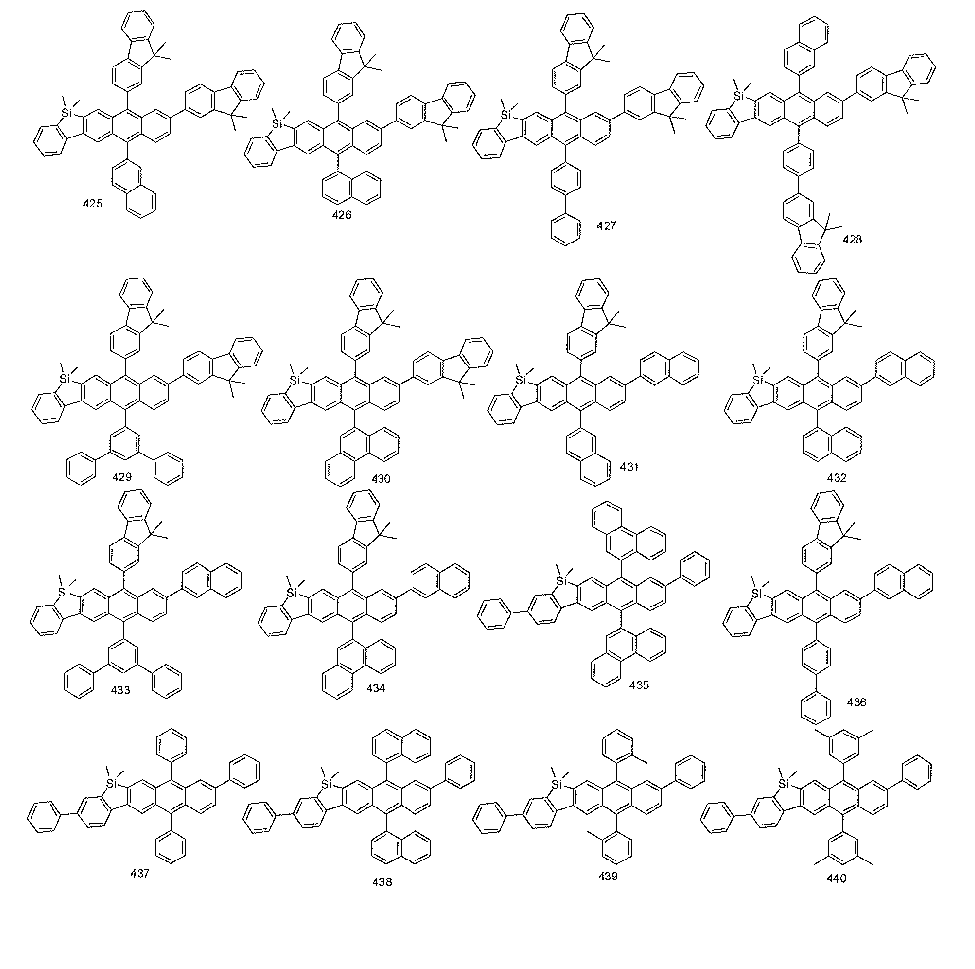

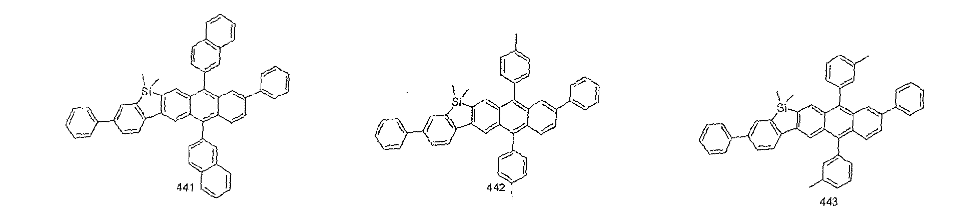

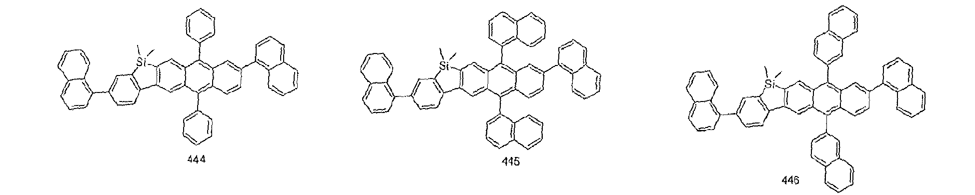

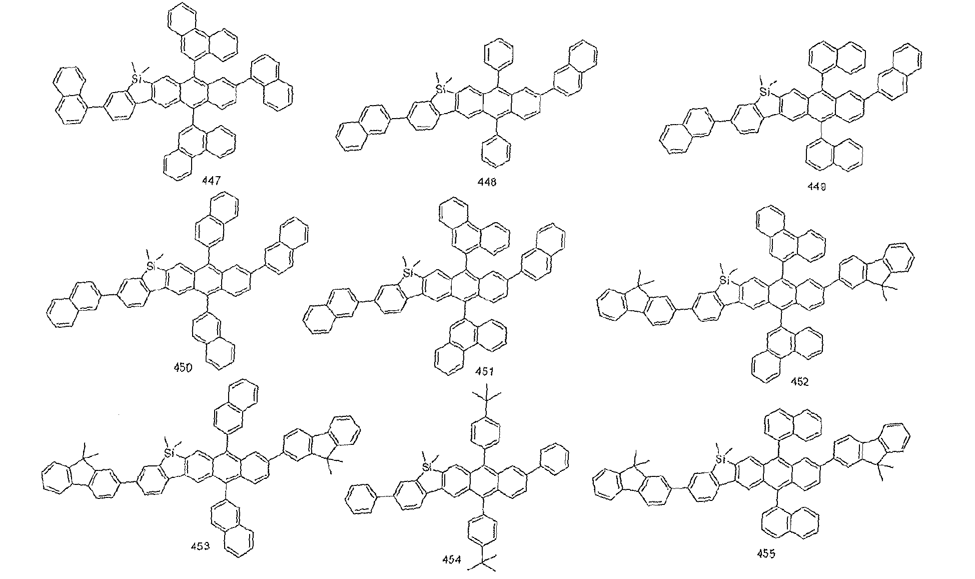

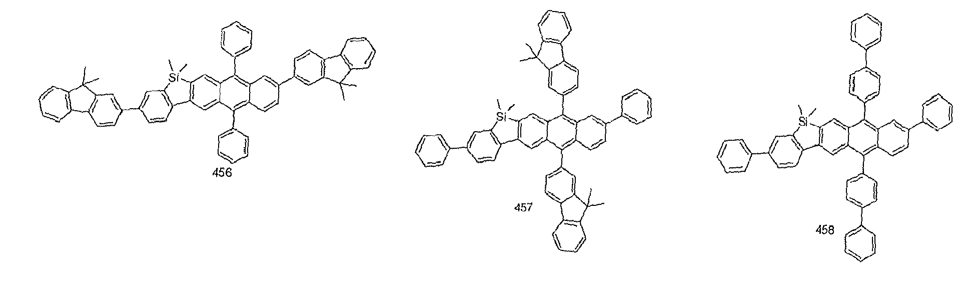

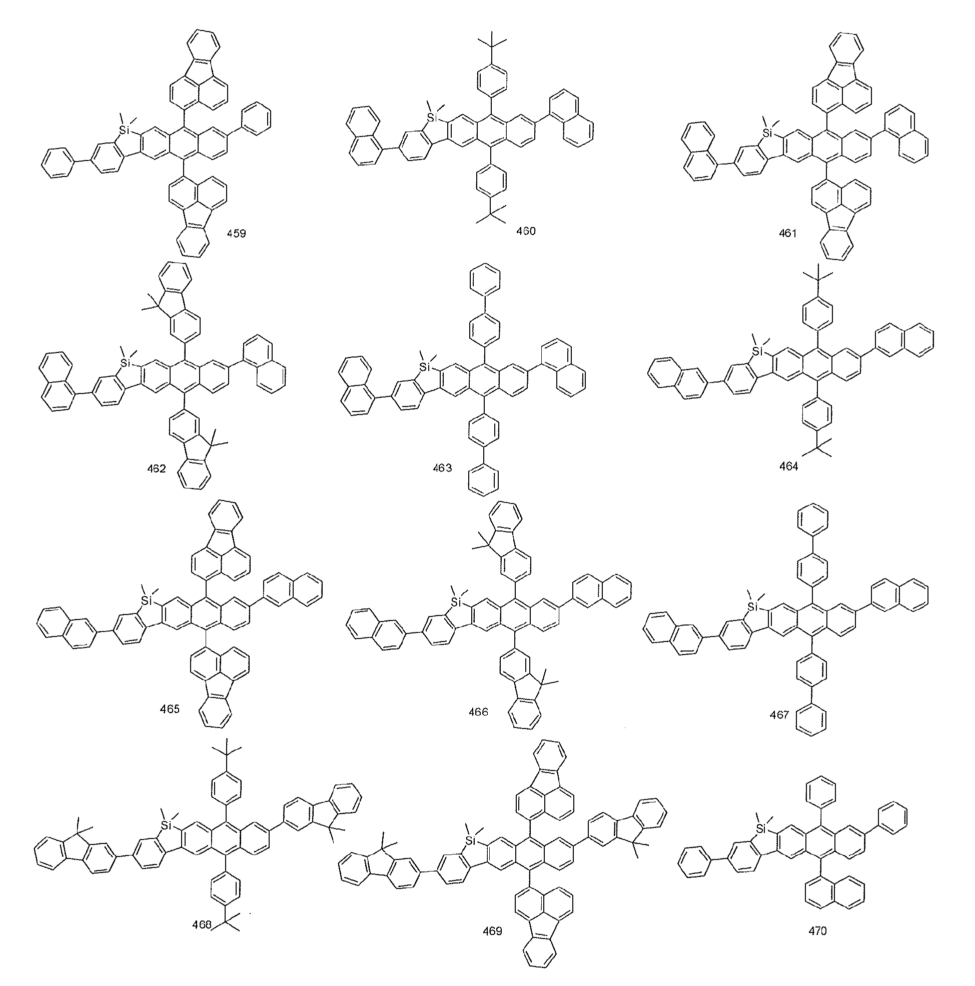

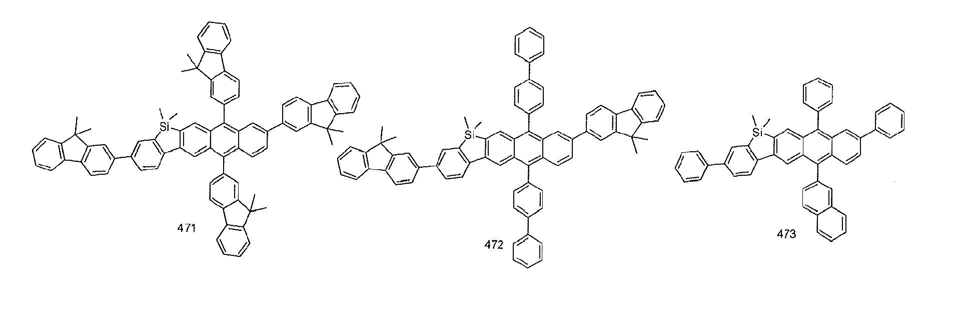

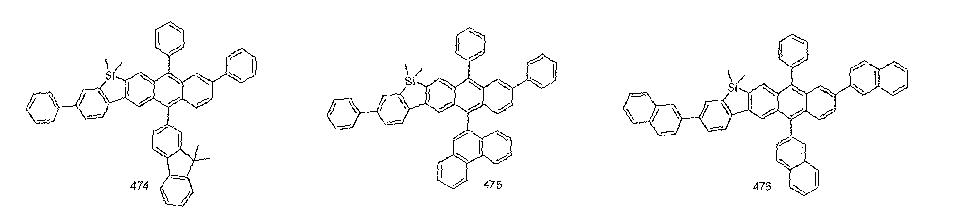

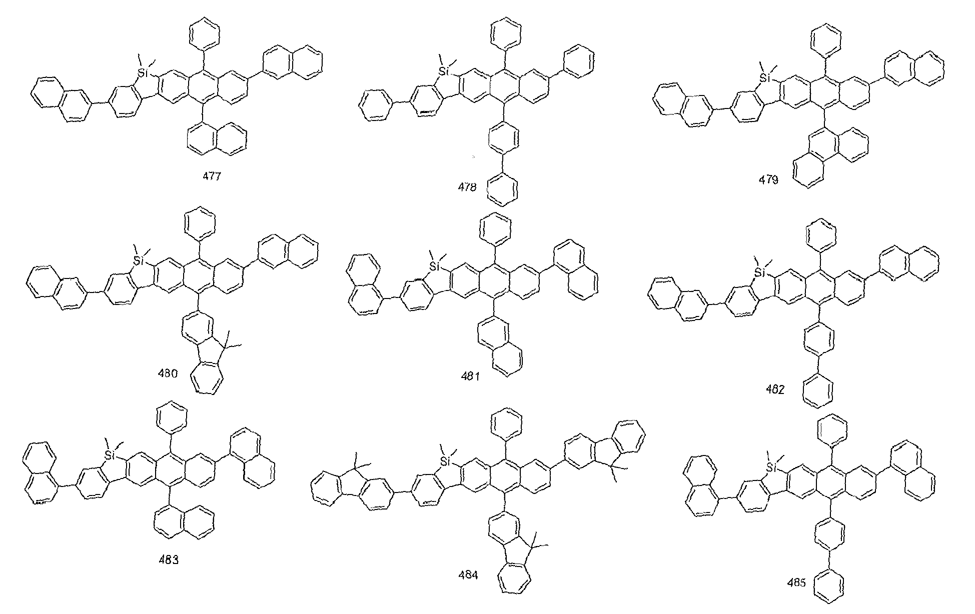

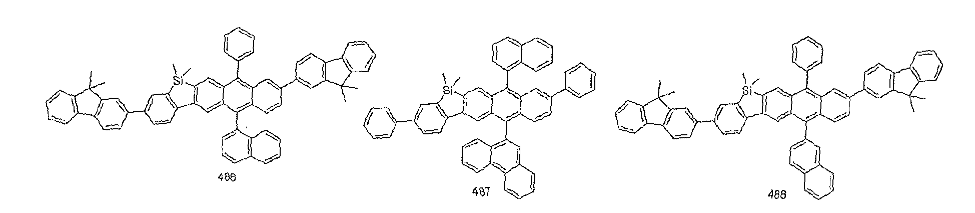

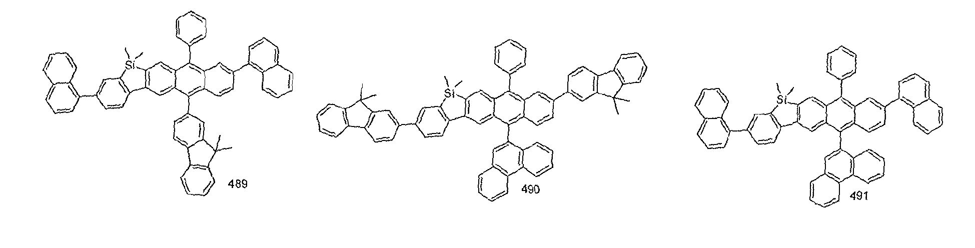

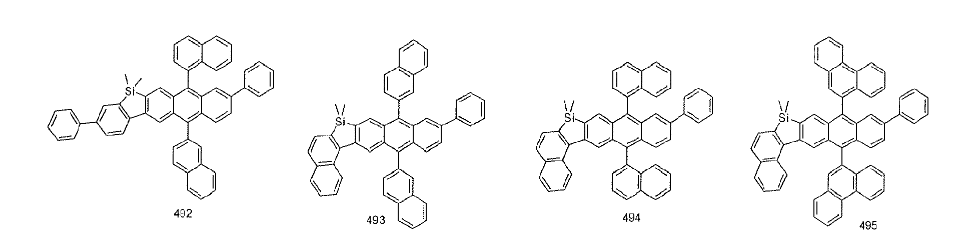

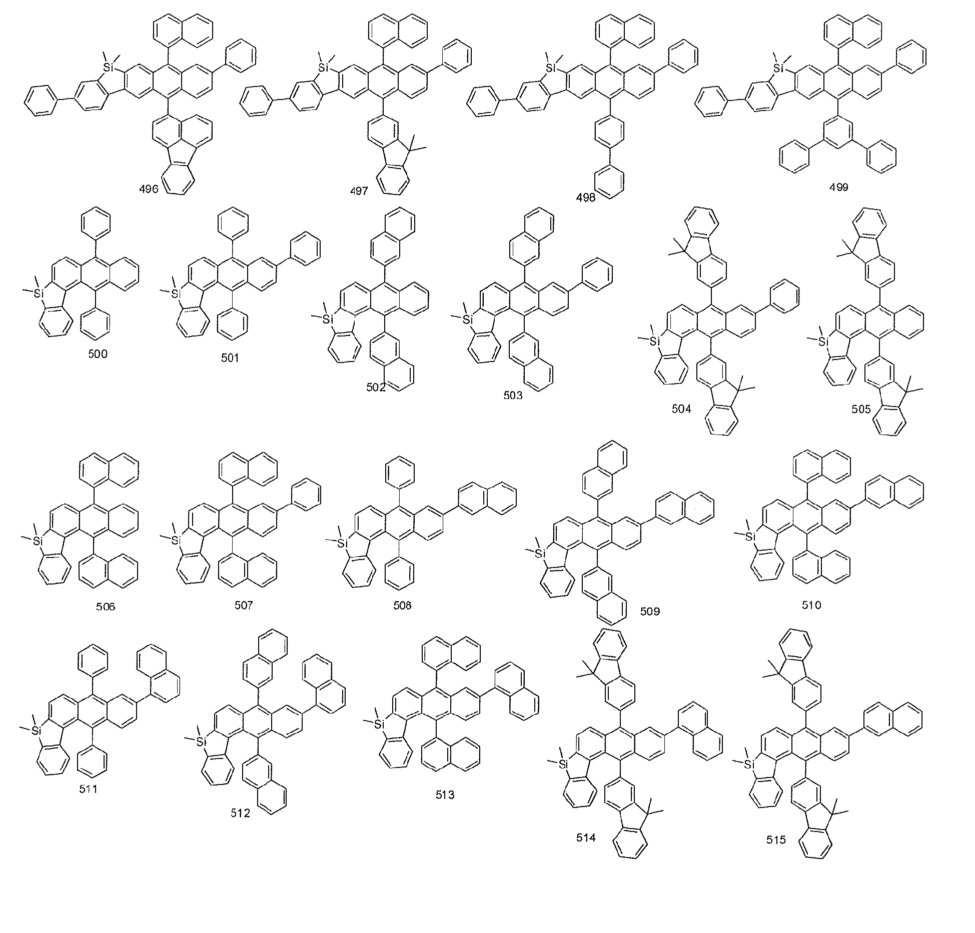

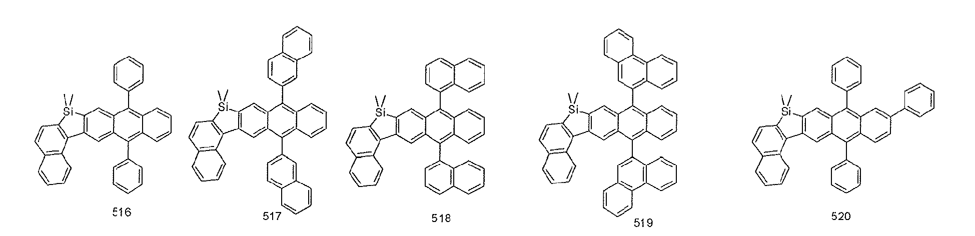

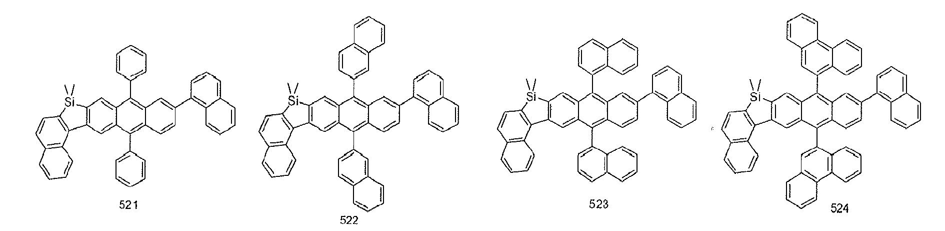

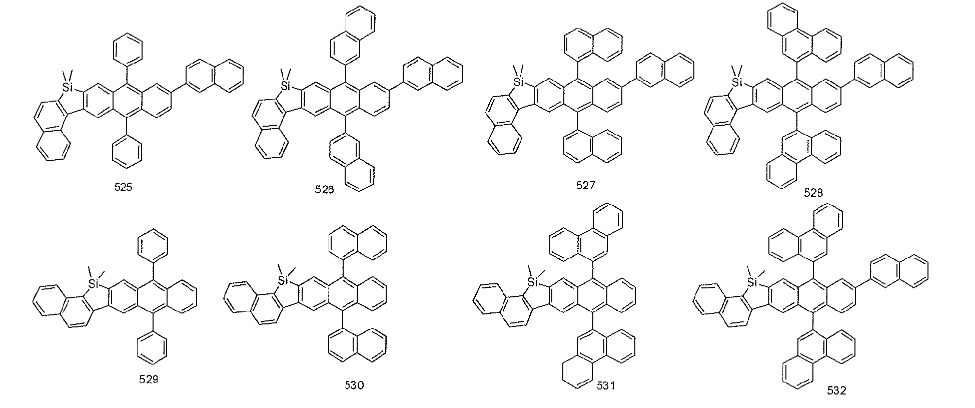

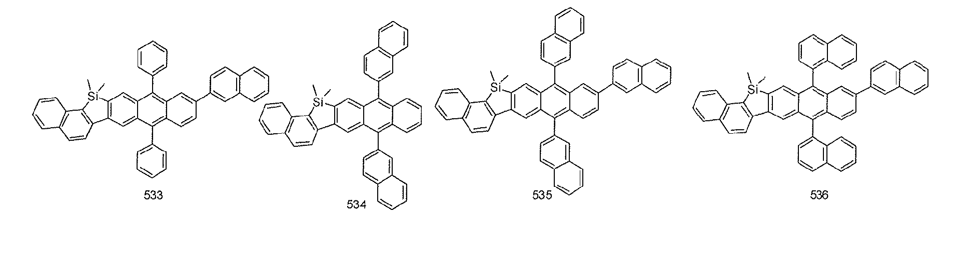

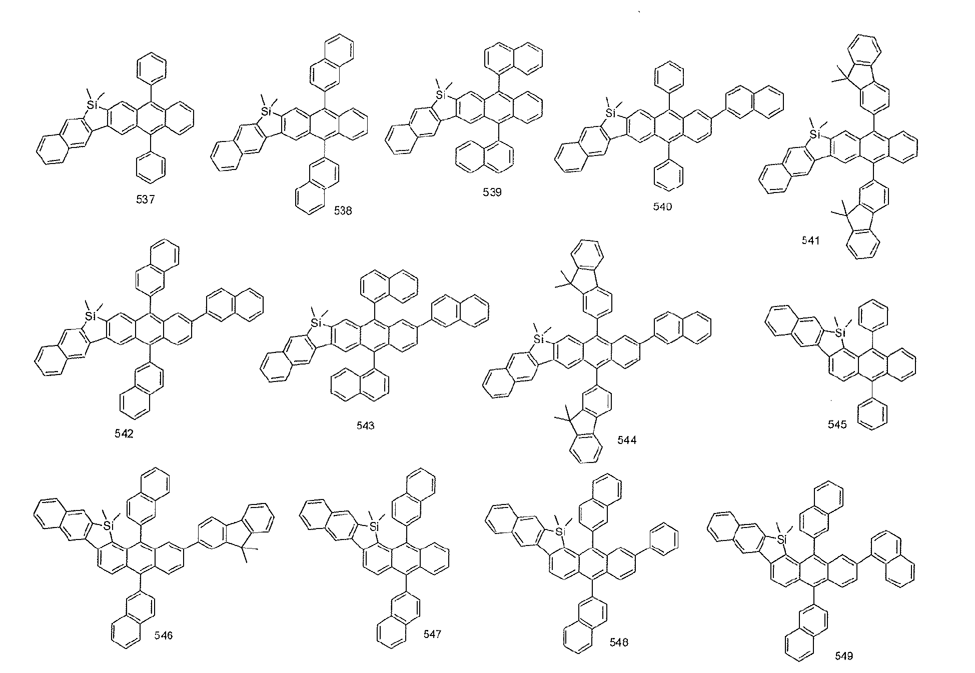

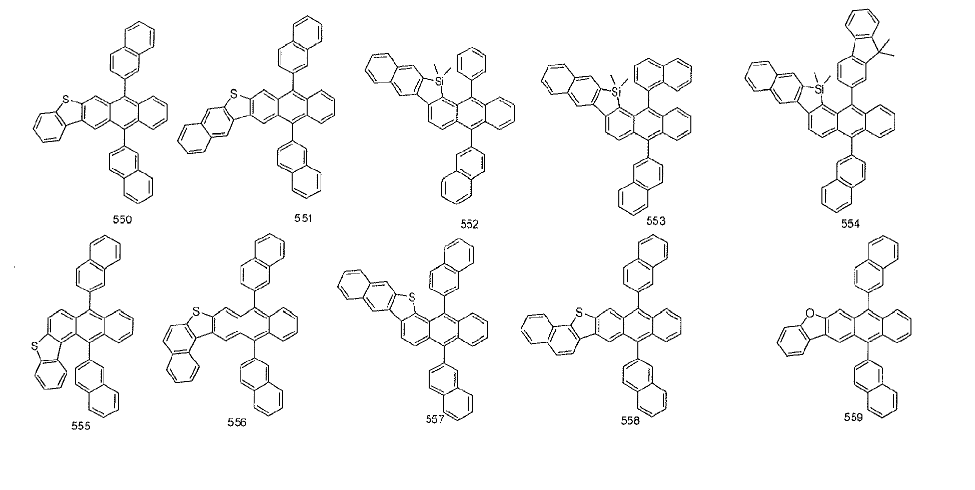

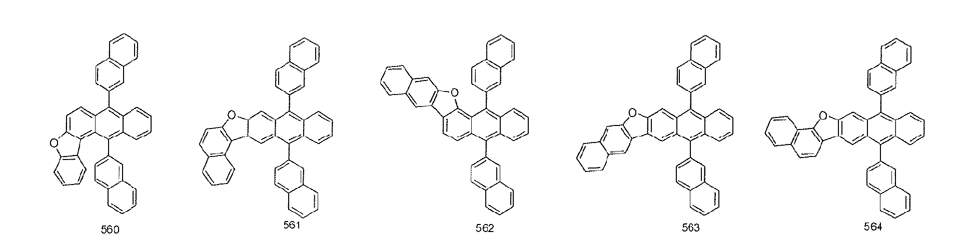

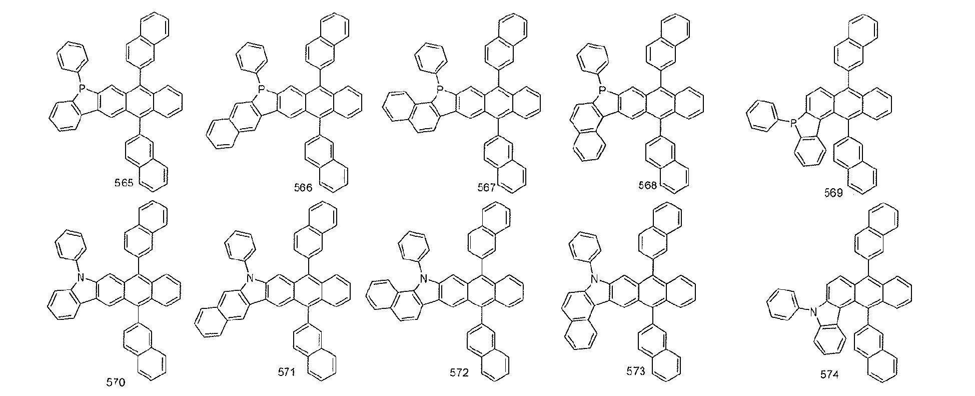

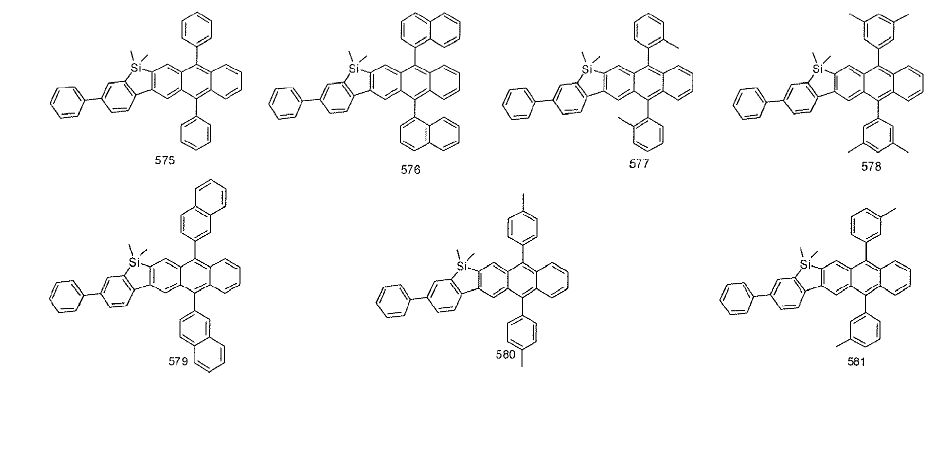

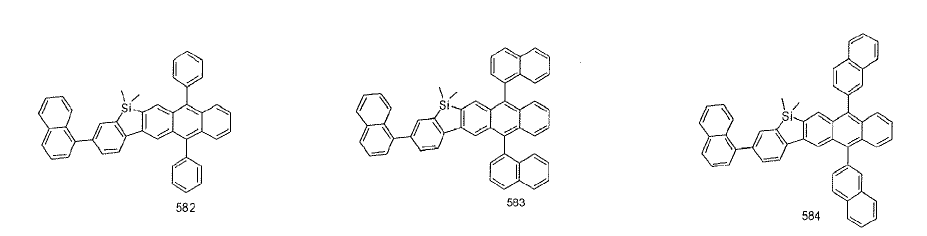

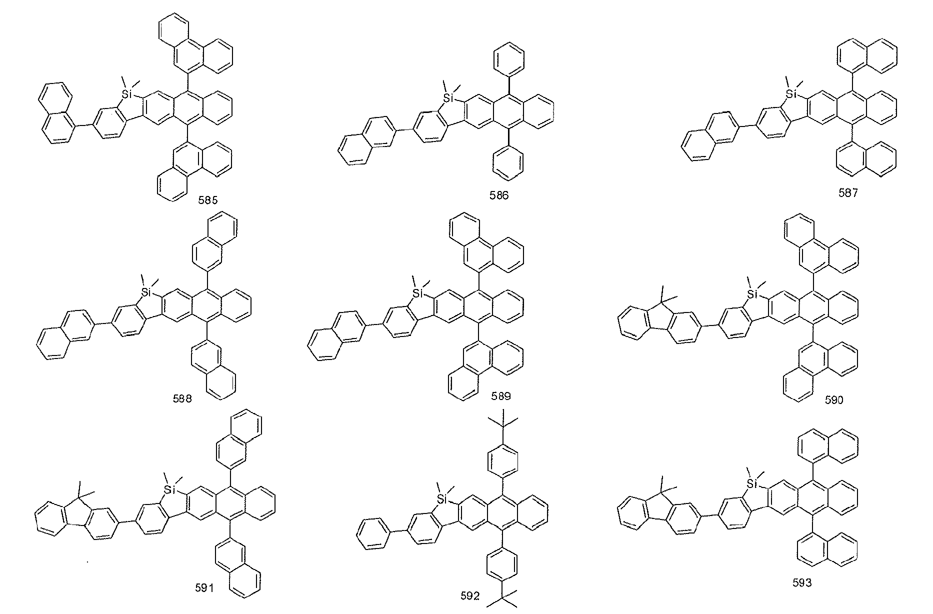

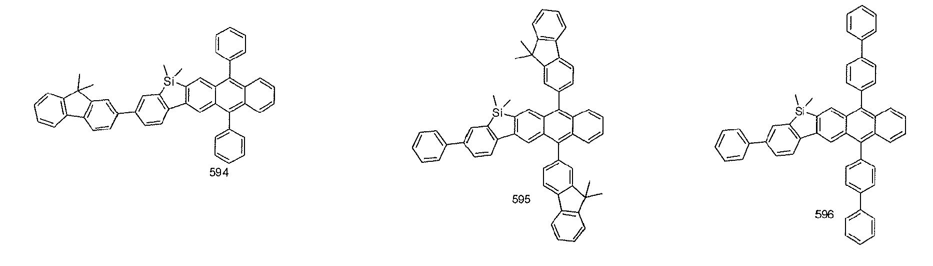

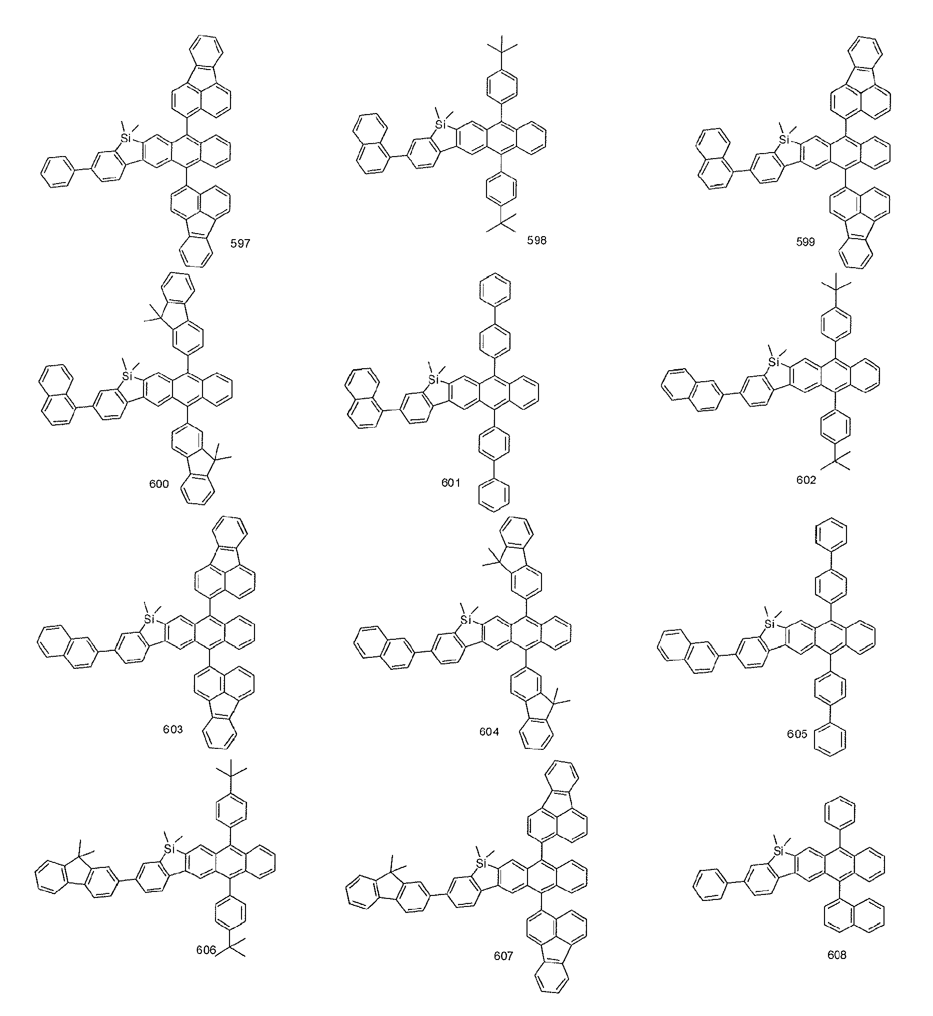

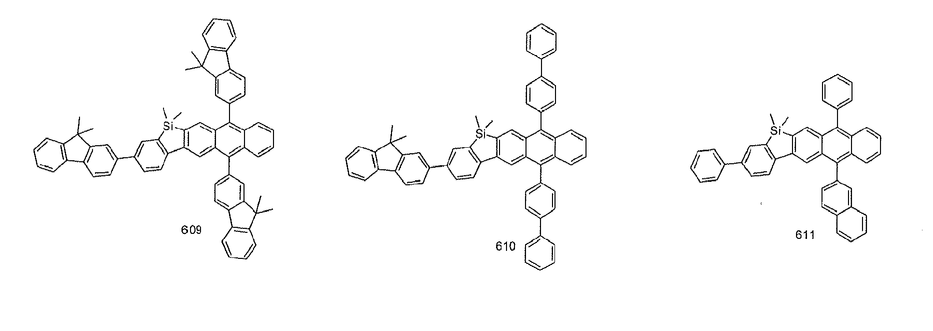

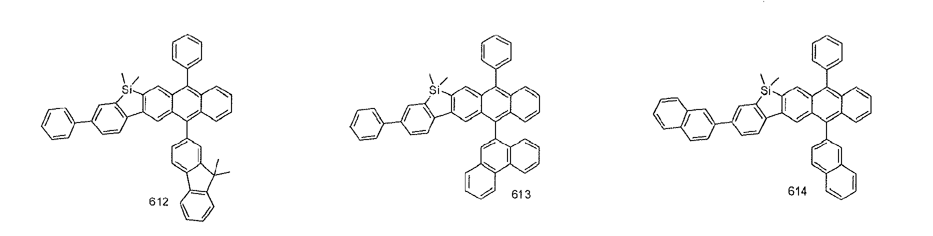

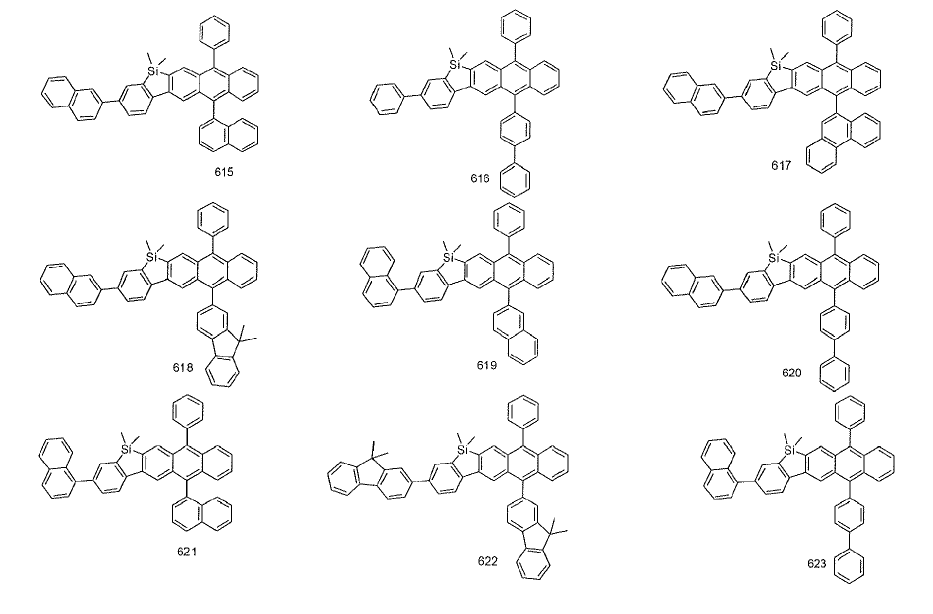

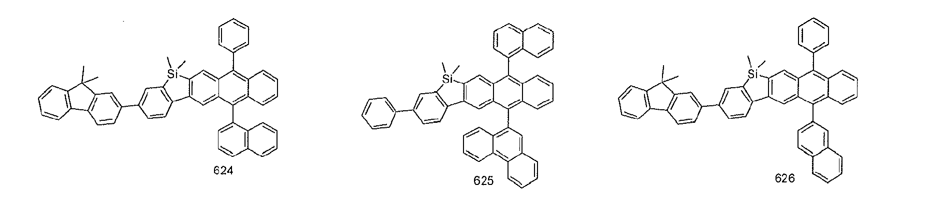

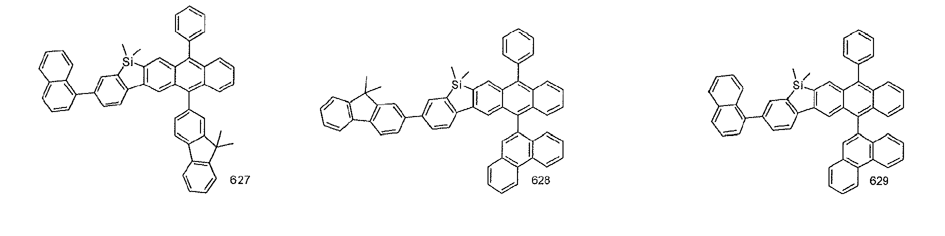

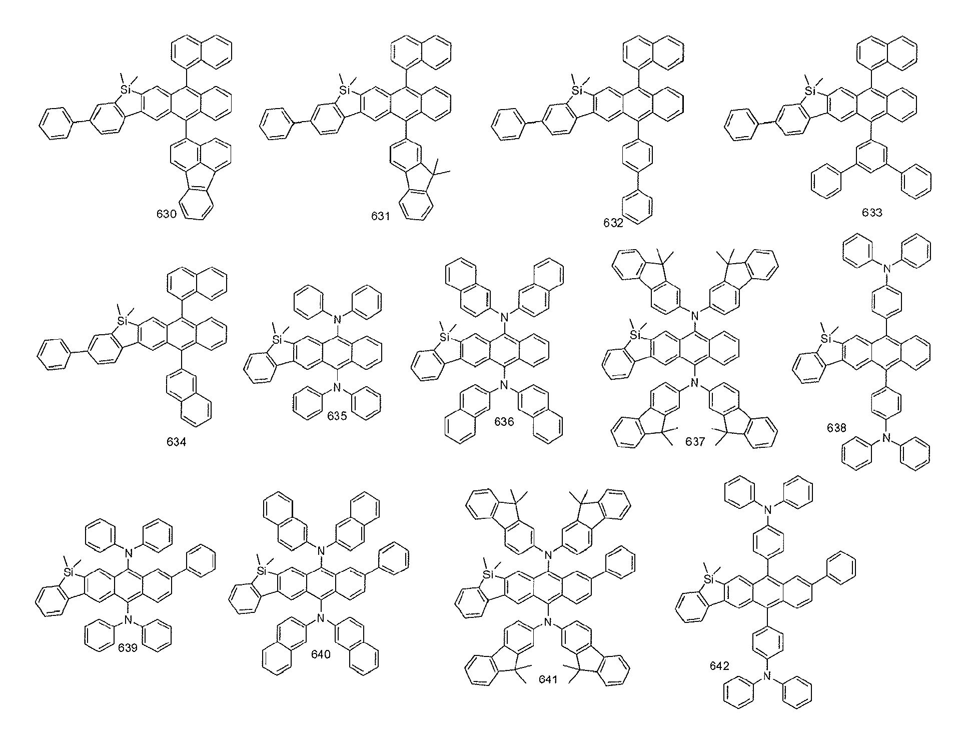

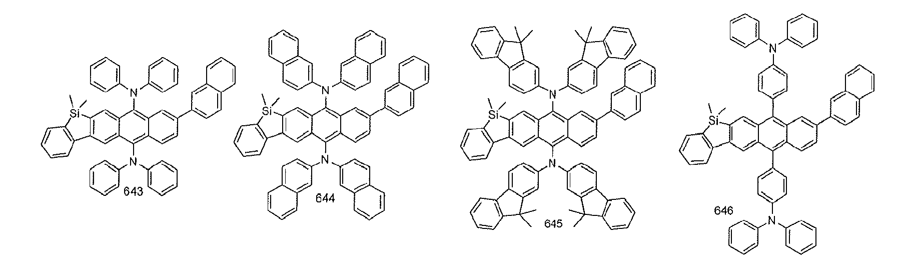

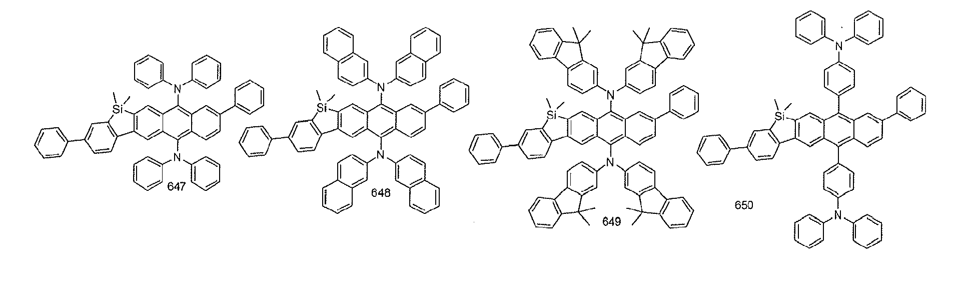

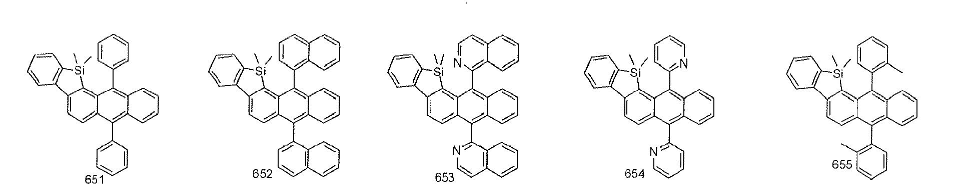

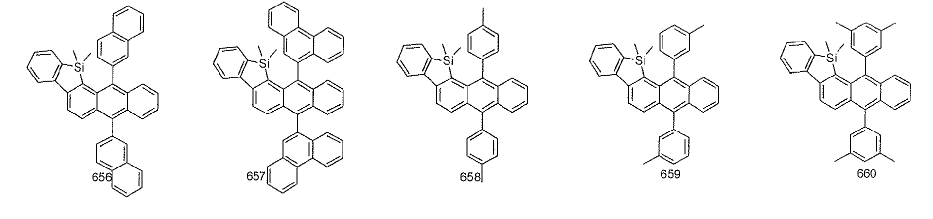

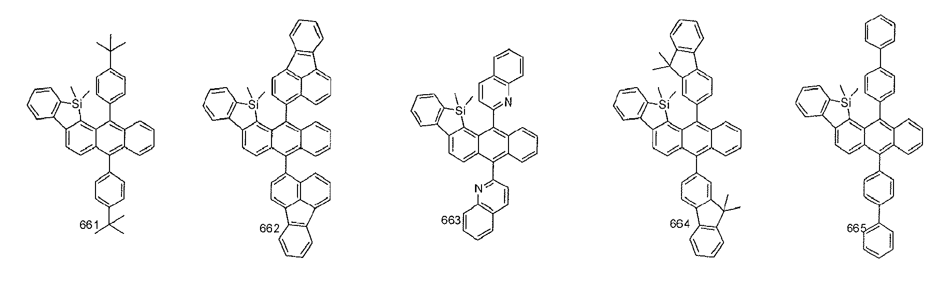

The organic electroluminescent compound according to the present invention may be prepared in accordance with Schemes 1 to 7: 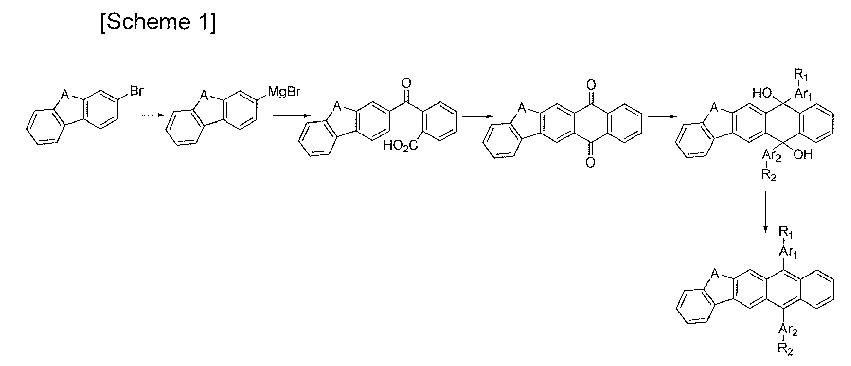 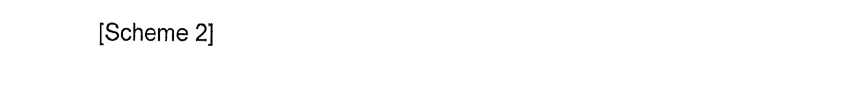 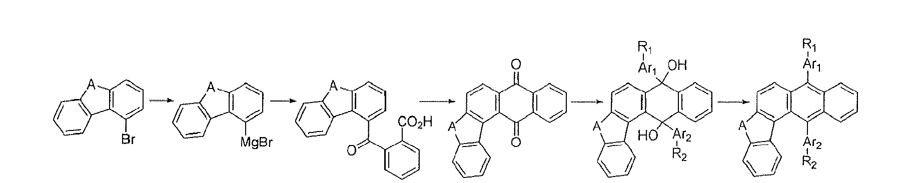 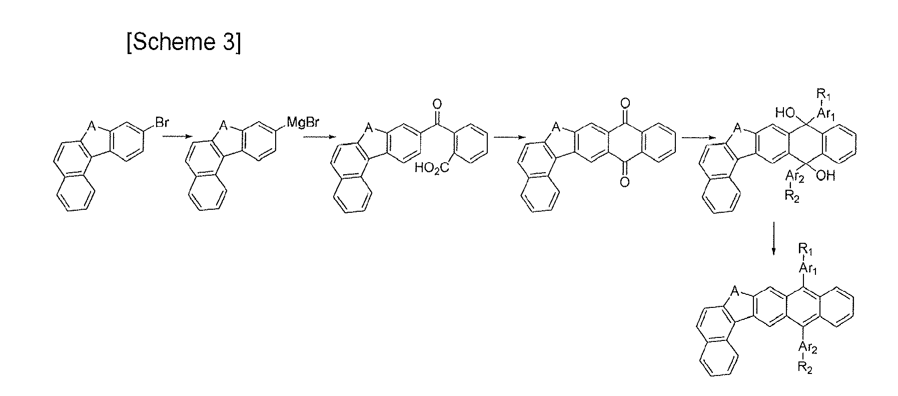 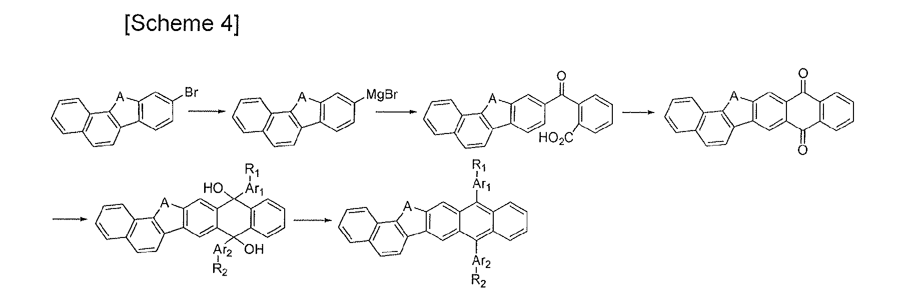 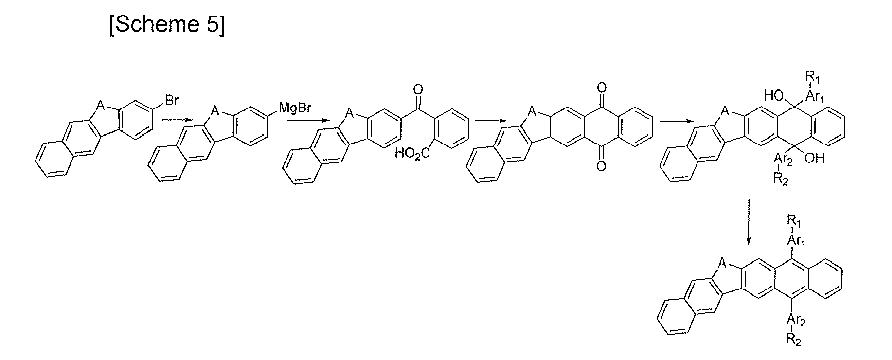 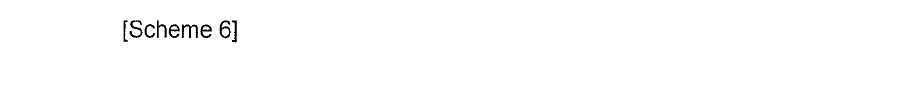 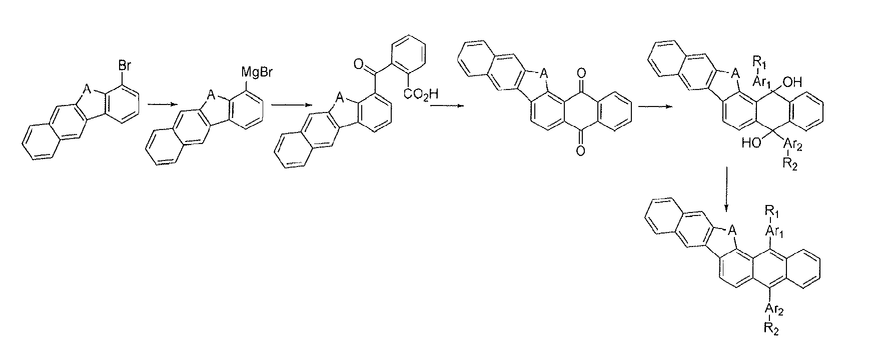 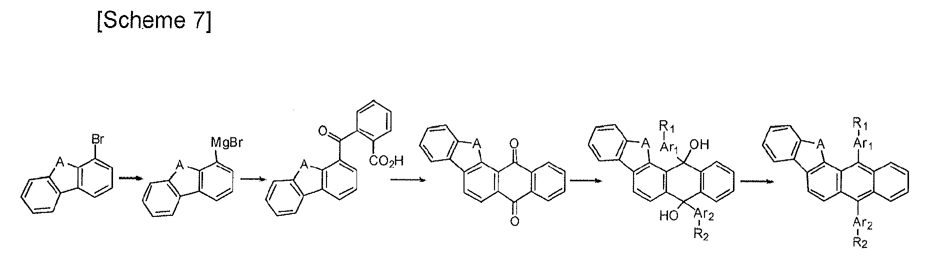 wherein A, Ar₁, Ar₂, R₁ and R₂ are the same as defined in Chemical Formula 1.

Further, as shown in Schemes 8 to 10, R₁₁ and/or R₁₂ substituent(s) may bind to the substituent L of the organic electroluminescent compound according to the present invention: 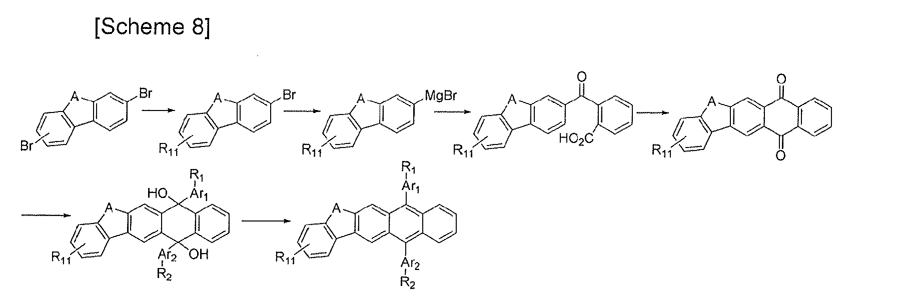 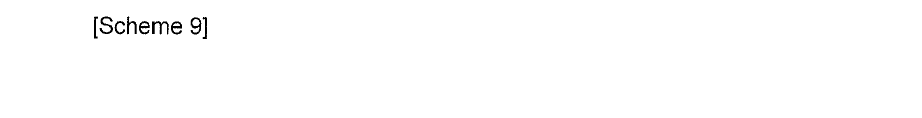 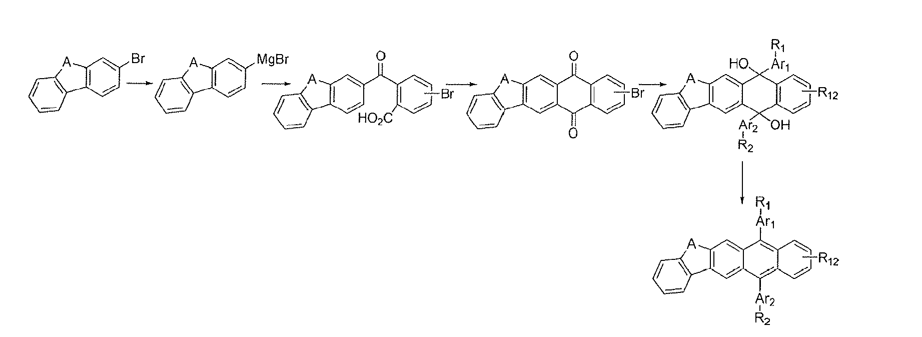 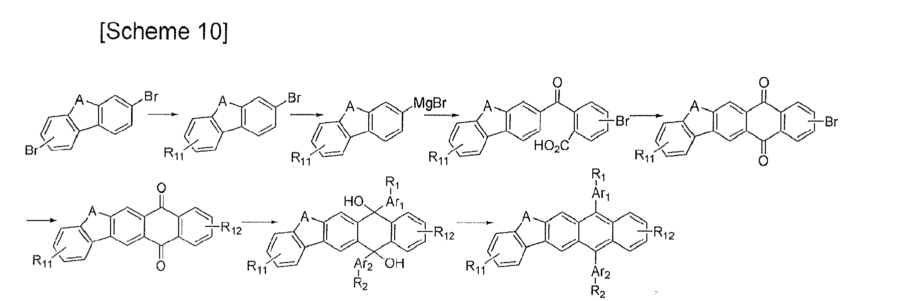 wherein
A, Ar₁, Ar₂, R₁, R₂, R₁₁ and R₁₂ are the same as defined in Chemical Formula 1.

The present invention further provides an organic solar cell. The organic solar cell according to the present invention comprises one or more organic electroluminescent compound(s) represented by Chemical Formula 1.

The present invention further provides an organic electroluminescent device. The organic electroluminescent device according to the present invention comprises a first electrode; a second electrode; and at least one organic layer(s) interposed between the first electrode and the second electrode, wherein the organic layer comprises one or more organic electroluminescent compound(s) represented by Chemical Formula 1.

The organic layer comprises an electroluminescent layer. In addition to one or more organic electroluminescent compound(s) represented by Chemical Formula 1, the electroluminescent layer comprises further comprises one or more dopant(s) or host(s). The dopant or host used in the organic electroluminescent device according to the present invention is not particularly limited.

The dopant used in the organic electroluminescent device according to the present invention may be selected from the compounds represented by Chemical Formulas 2 to 4: 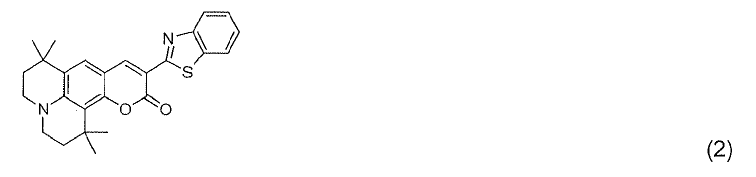 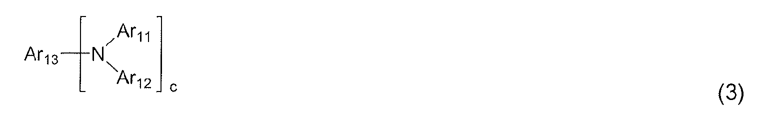 wherein
Ar₁₁ and Ar₁₂ independently represent hydrogen, deuterium, halogen, (C1-C60)alkyl, (C6-C60)aryl, (C4-C60)heteroaryl, mono- or di-(C6-C60)arylamino, mono- or di-(C1-C60)alkylamino, 5- or 6-membered heterocycloalkyl containing one or more heteroatom(s) selected from N, O and S or (C3-C60)cycloalkyl, or Ar₁₁ and Ar₁₂ may be linked via (C3-C60)alkylene or (C3-C60)alkenylene with or without a fused ring to form an alicyclic ring or a monocyclic or polycyclic aromatic ring;
Ar₁₃ represents (C6-C60)aryl, (C4-C60)heteroaryl or aryl having one of the following structures, when c is 1: 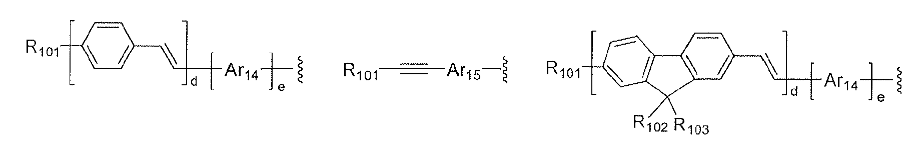 Ar₁₃ represents (C6-C60)arylene, (C4-C60)heteroarylene or arylene having one of the following structures, when c is 2: 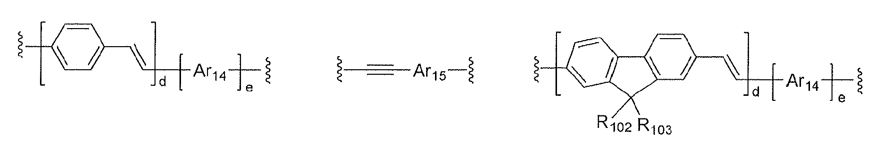 wherein
Ar₁₄ and Ar₁₅ independently represent (C6-C60)arylene or (C4-C60)heteroarylene;
R₁₀₁ through R₁₀₃ independently represent hydrogen, deuterium, (C1-C60)alkyl or (C6-C60)aryl;
d represents an integer from 1 to 4;
e represents an integer 0 or 1;
the alkyl, aryl, heteroaryl, arylamino, alkylamino, cycloalkyl or heterocycloalkyl of Ar₁₁ and Ar₁₂, the aryl, heteroaryl, arylene or heteroarylene of Ar₁₃, the arylene or heteroarylene of Ar₁₄ and Ar₁₅, or the alkyl or aryl of R₁₀₁ through R₁₀₃ may be further substituted by one or more substituent(s) selected from halogen, deuterium, (C1-C60)alkyl, (C6-C60)aryl, (C4-C60)heteroaryl, 5-or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di-(C1-C60)alkylamino, mono- or di-(C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl; 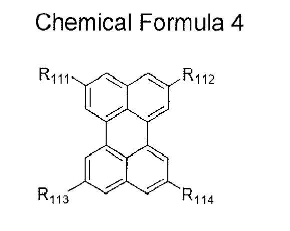 wherein
R₁₁₁ through R₁₁₄ independently represent hydrogen, deuterium, halogen, (C1-C60)alkyl, (C6-C60)aryl, (C4-C60)heteroaryl containing one or more heteroatom(s) selected from N, O and S, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, mono- or di-(C1-C60)alkylamino, mono- or di-(C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₁₁₁ through R₁₁₄ may be linked to an adjacent substituent via (C3-C60)alkylene or (C3-C60)alkenylene with or without a fused ring to form an alicyclic ring or a monocyclic or polycyclic aromatic ring; and
the alkyl, alkenyl, alkynyl, cycloalkyl, heterocycloalkyl, aryl, heteroaryl, arylsilyl, alkylsilyl, alkylamino or arylamino of R₁₁₁ through R₁₁₄, or the alicyclic ring or monocyclic or polycyclic aromatic ring formed as they are linked to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl containing one or more heteroatom(s) selected from N, O and S, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, mono- or di-(C1-C60)alkylamino, mono- or di-(C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl.

The dopant compound represented by Chemical Formulas 2 to 4 may be exemplified by the compounds having the following structures, but not limited thereto:

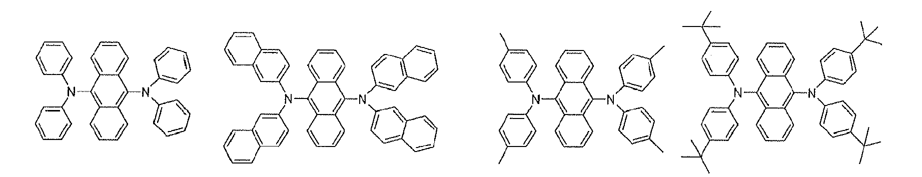

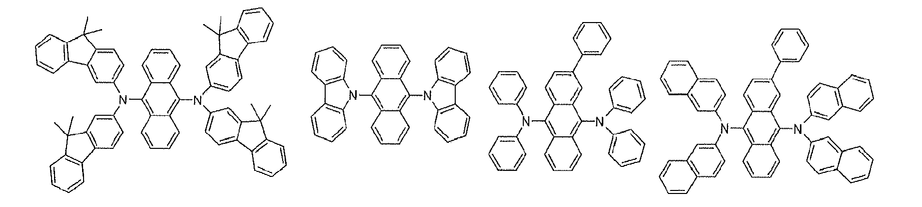

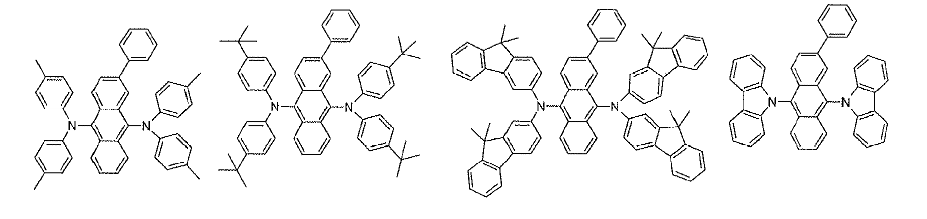

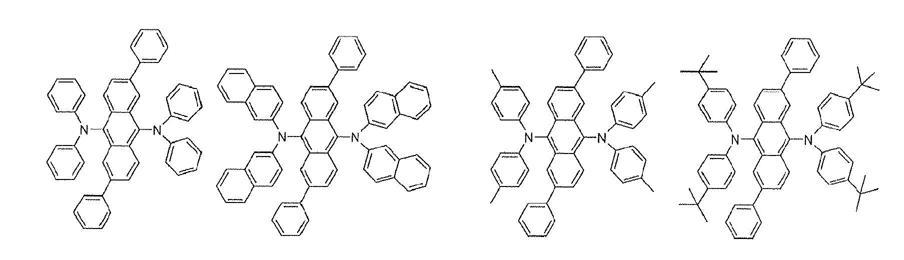

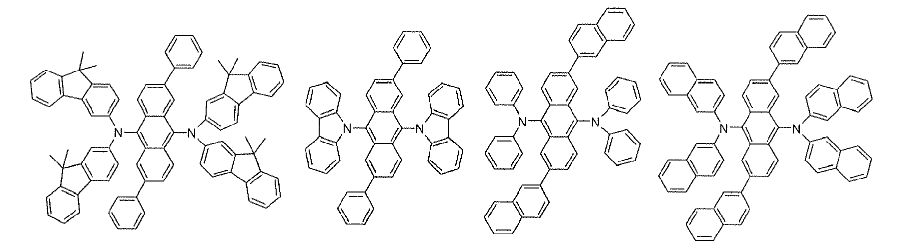

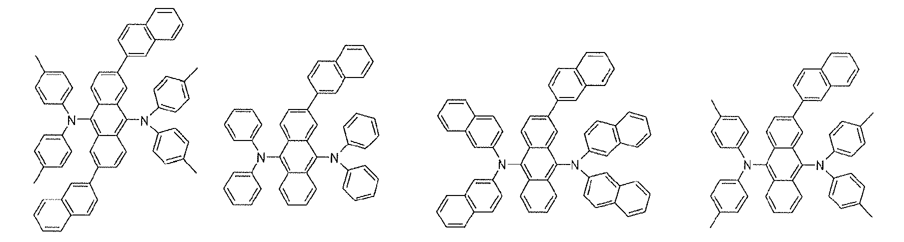

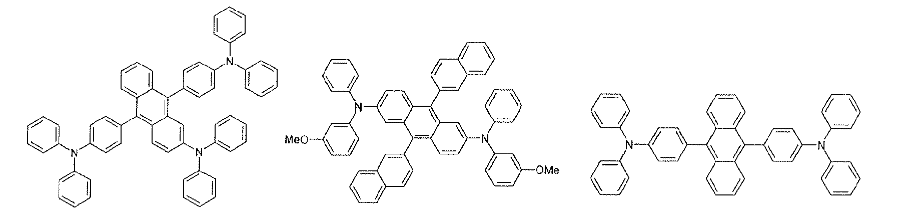

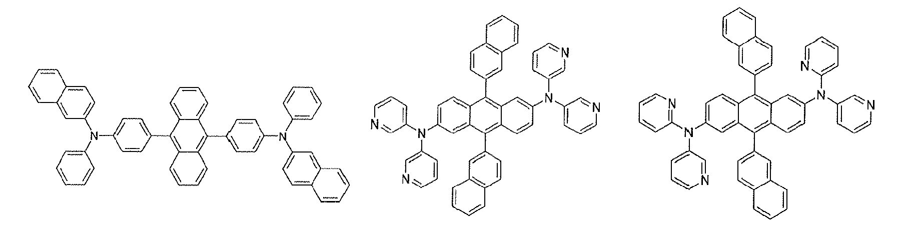

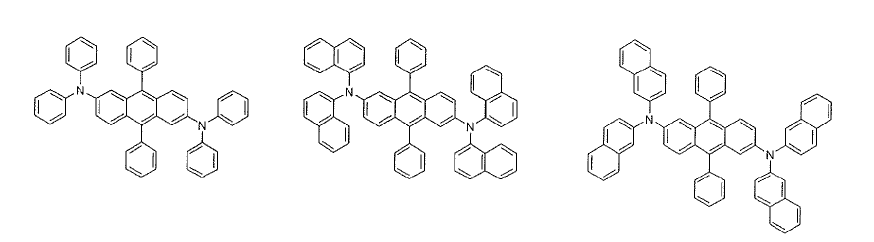

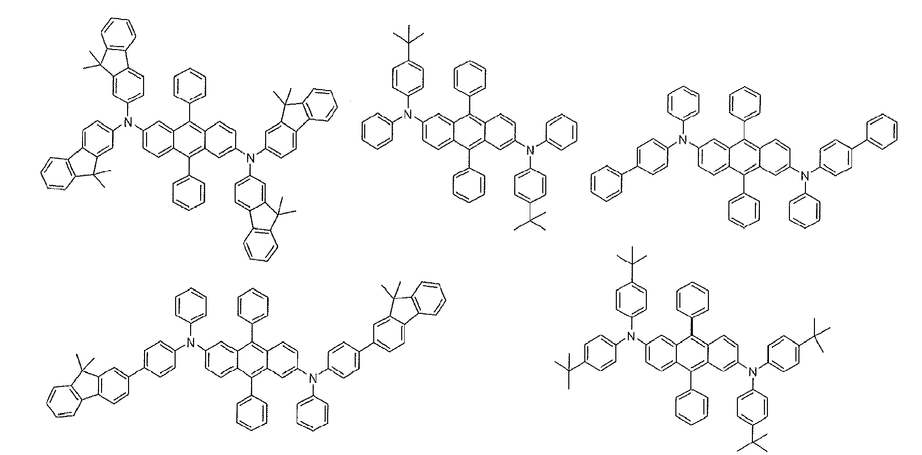

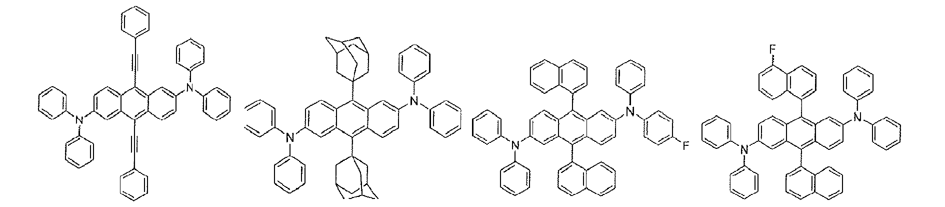

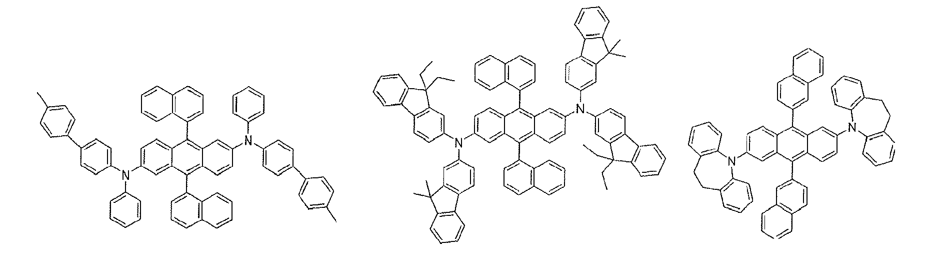

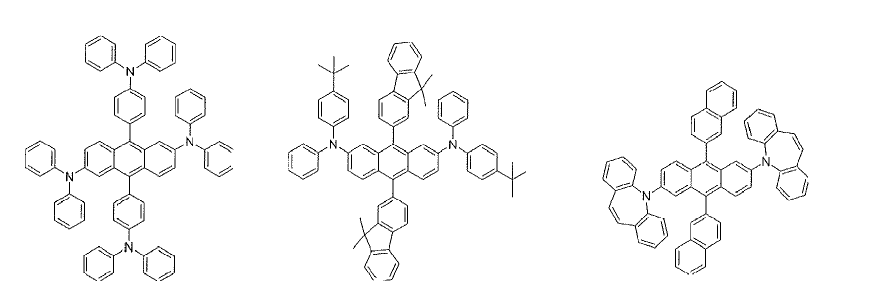

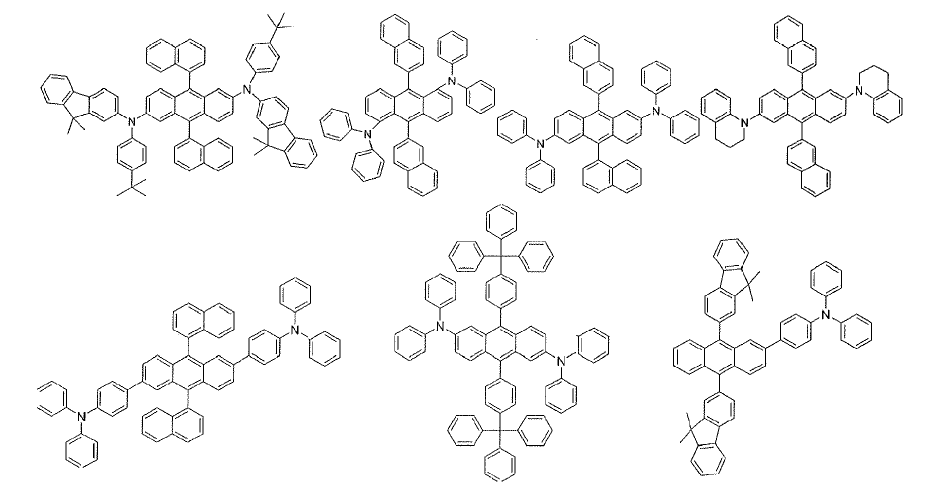

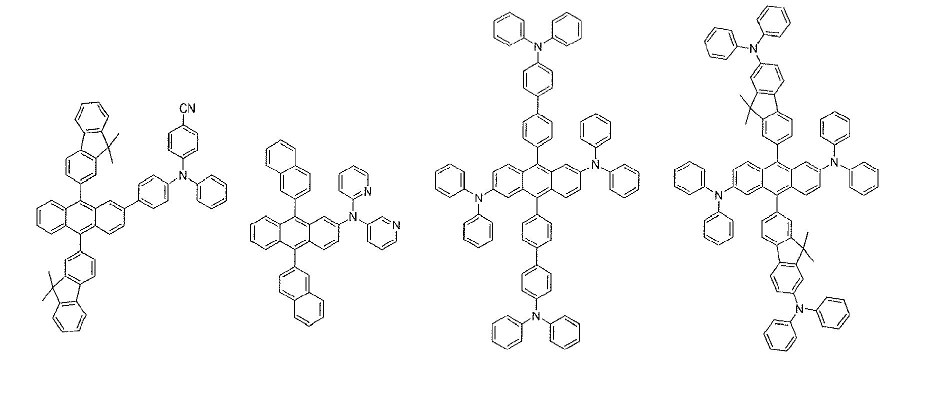

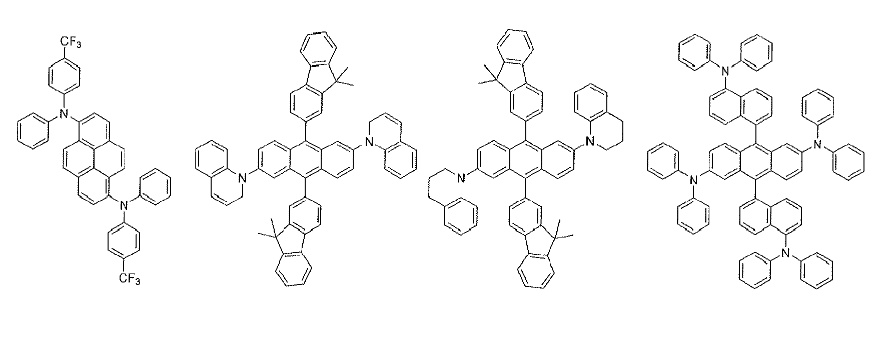

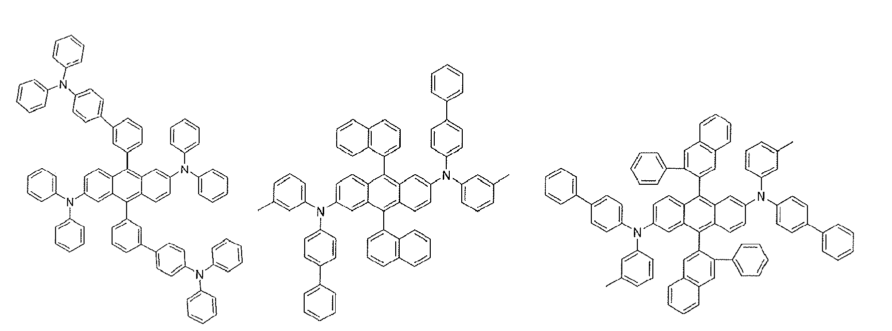

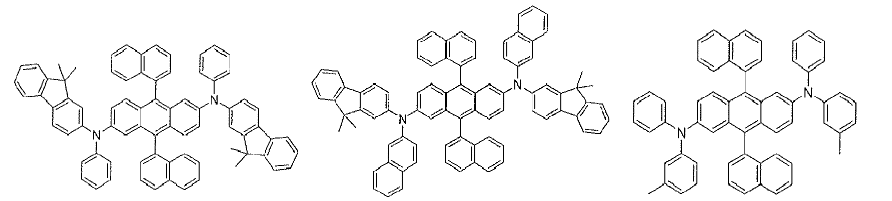

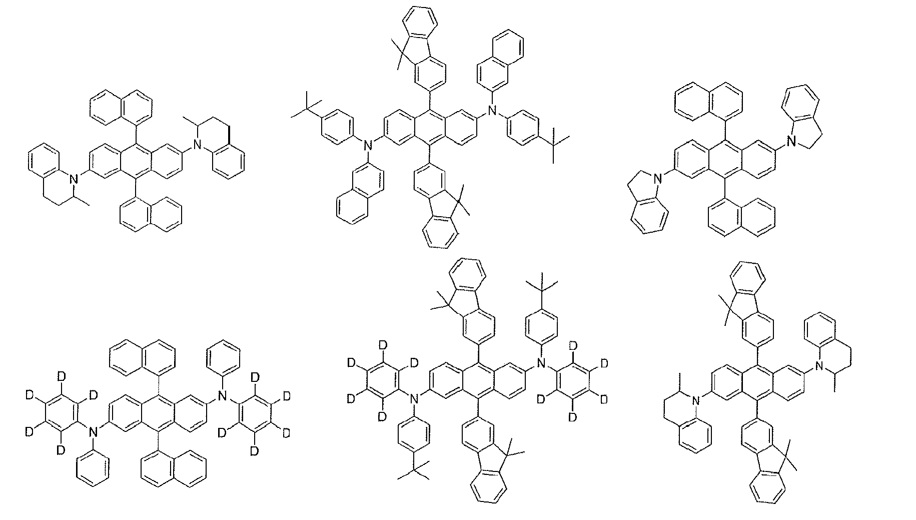

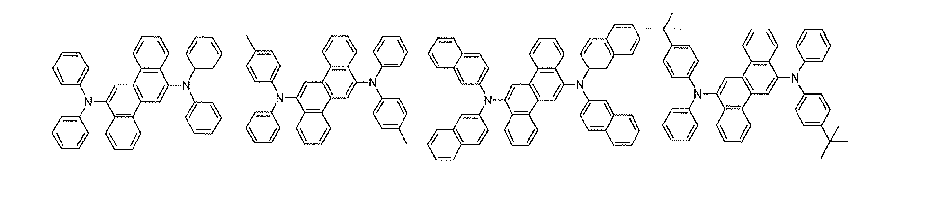

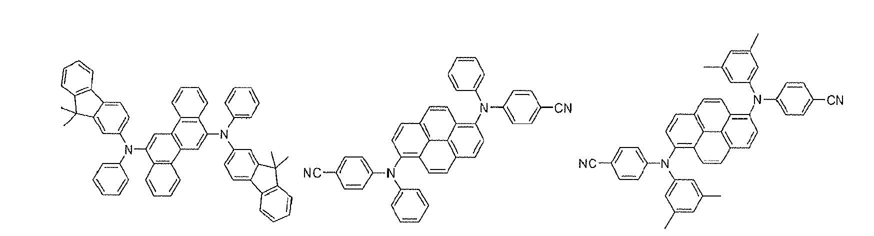

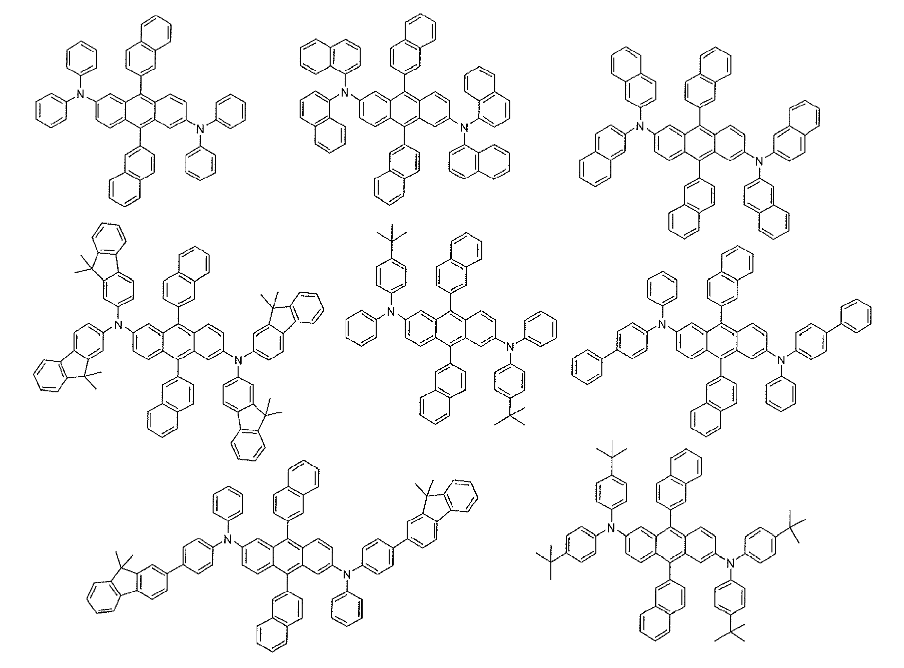

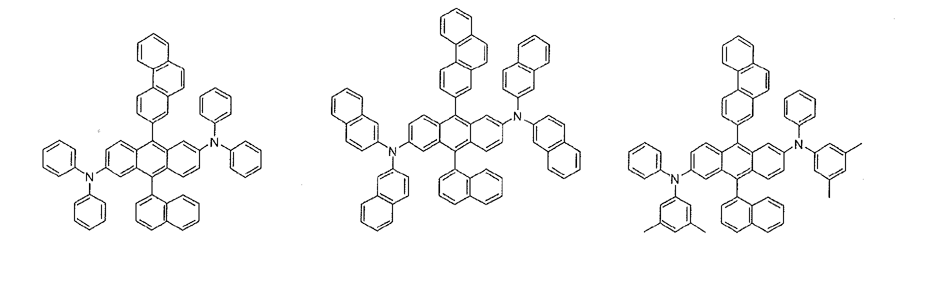

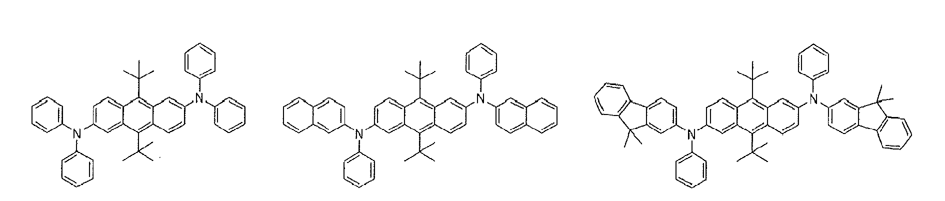

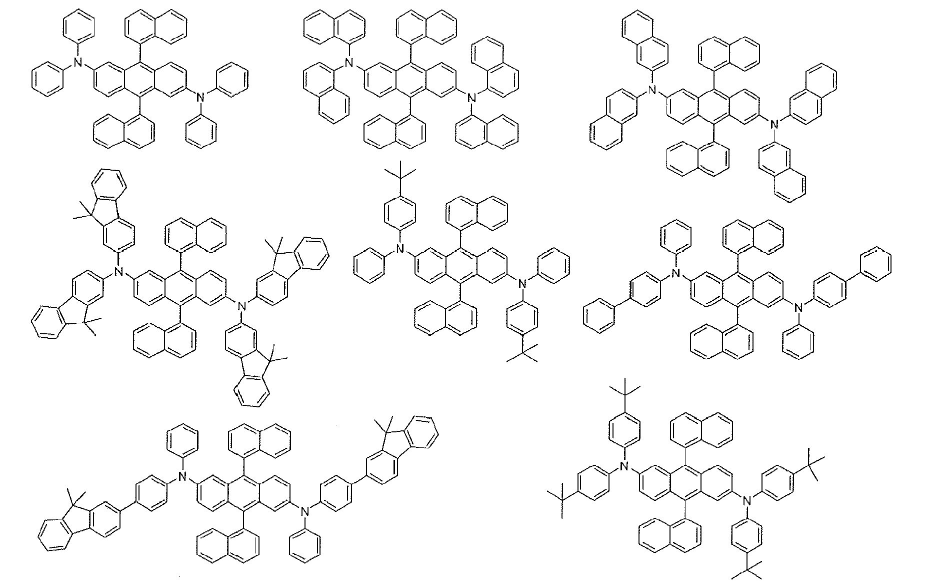

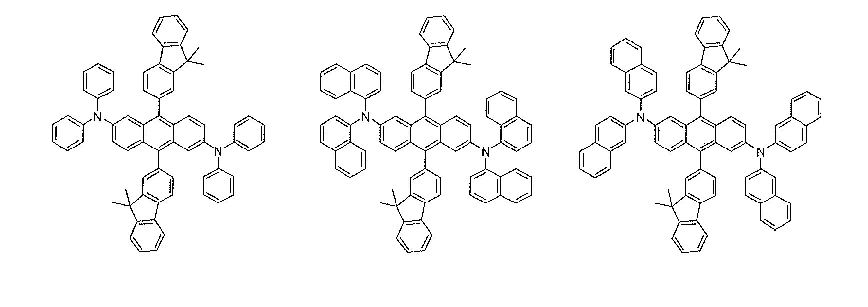

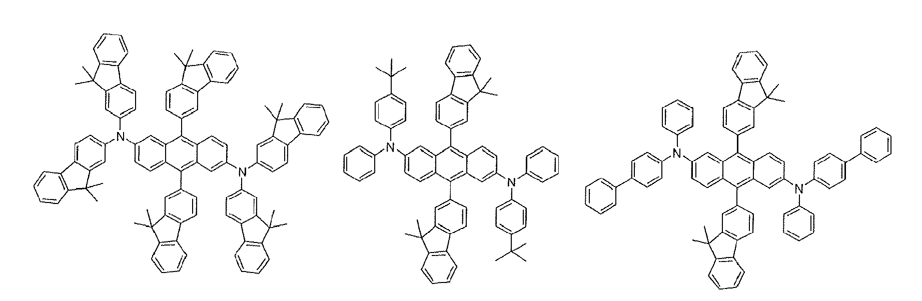

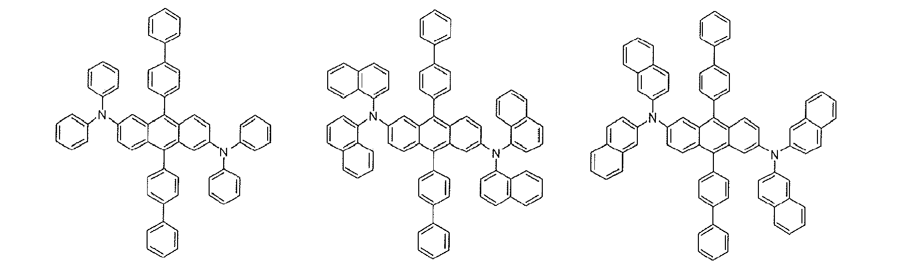

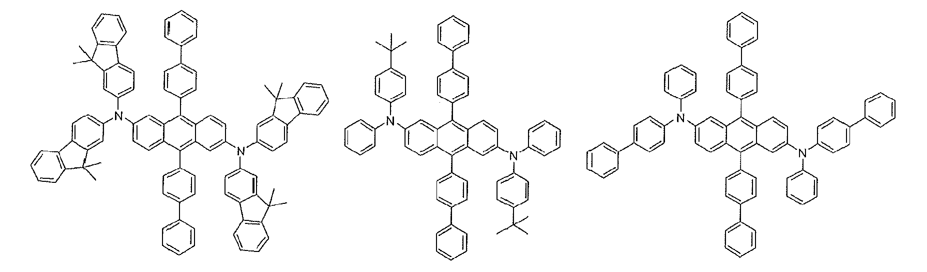

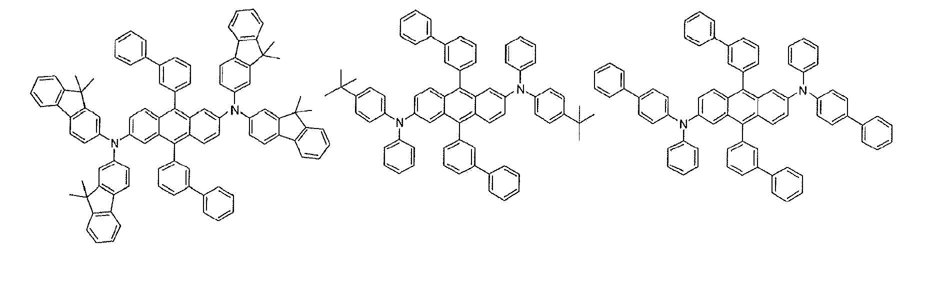

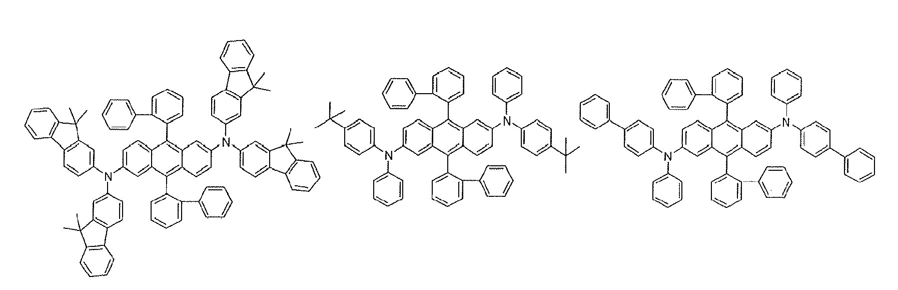

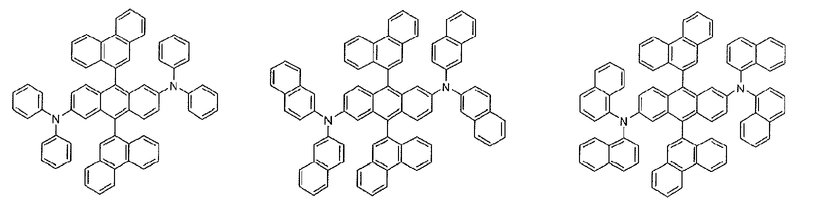

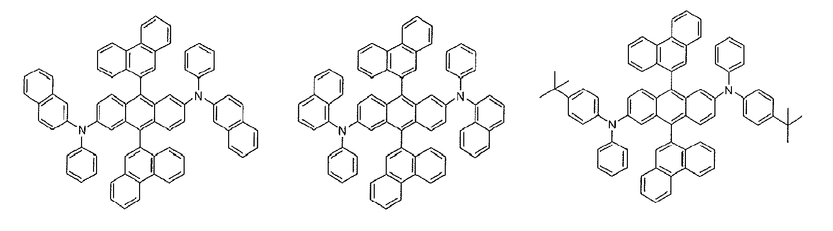

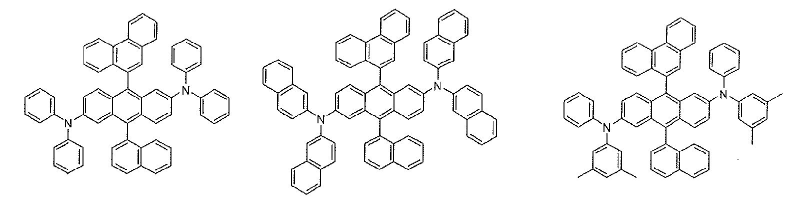

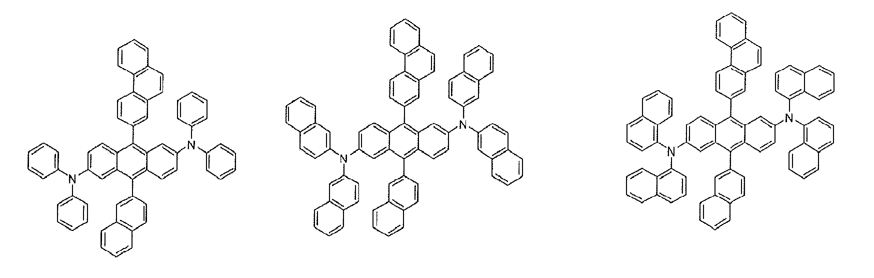

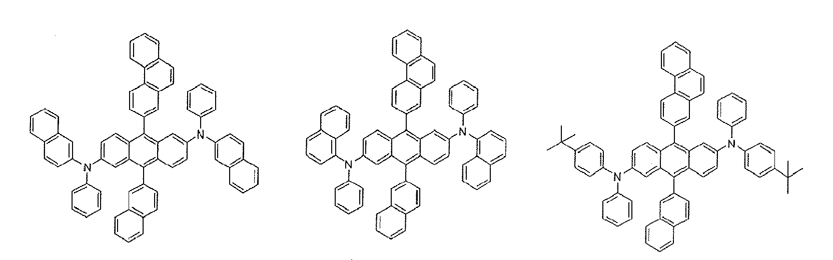

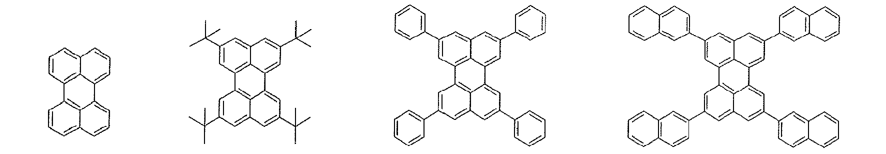

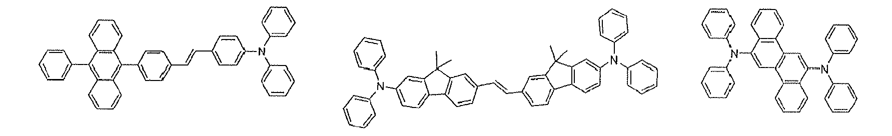

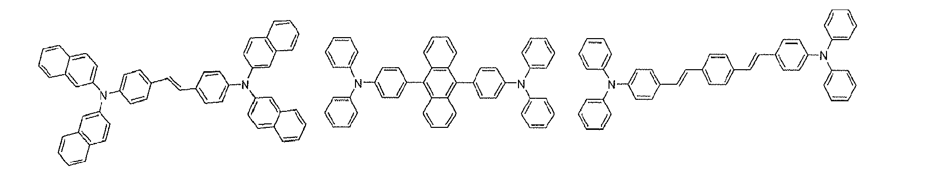

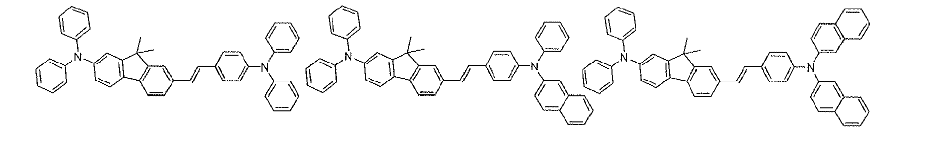

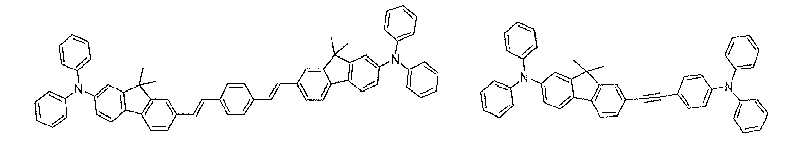

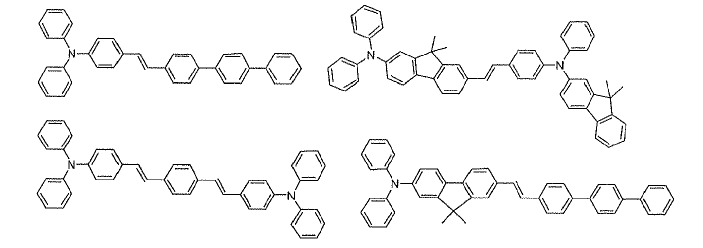

The host used in the organic electroluminescent device according to the present invention may be selected from the compounds represented by Chemical Formulas 5 and 6:

(Ar₂₁)_{f}-L₂₁-(Ar₂₂)_{g} (5)

(Ar₂₃)ₕ-L₂₂-(Ar₂₄)ₗ (6)

wherein
L₂₁ represents (C6-C60)arylene or (C4-C60)heteroarylene;
L₂₂ represents anthracenylene;
Ar₂₁ through Ar₂₄ independently represent hydrogen, (C1-C60)alkyl, (C1-C60)alkoxy, halogen, (C4-C60)heteroaryl, (C5-C60)cycloalkyl or (C6-C60)aryl, and the cycloalkyl, aryl or heteroaryl of Ar₂₁ through Ar₂₄ may be further substituted by one or more substituent(s) selected from a group consisting of (C6-C60)aryl or (C4-C60)heteroaryl with or without one or more substituent(s) selected from a group consisting of deuterium, (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl, (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
f, g, h and i independently represent an integer from 0 to 4.

The compound represented by Chemical Formula 5 or 6 may be exemplified by the anthracene derivatives or benz[a]anthracene derivatives represented by Chemical Formulas 7 to 10: 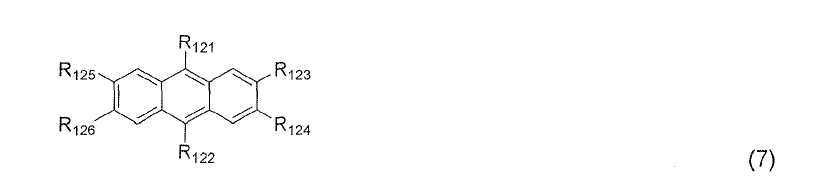 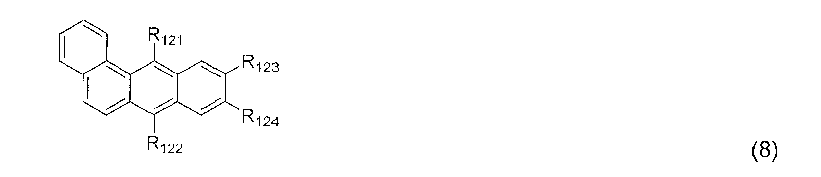 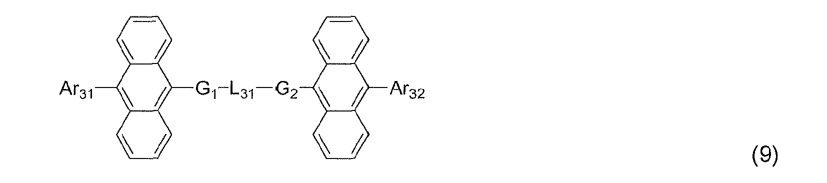 wherein
R₁₂₁ and R₁₂₂ independently represent (C6-C60)aryl, (C4-C60)heteroaryl, 5- or 6-membered heterocycloalkyl containing one or more heteroatom(s) selected from N, O and S or (C3-C60)cycloalkyl, and the aryl or heteroaryl of R₁₂₁ and R₁₂₂ may be further substituted by one or more substituent(s) selected from deuterium, (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₁₂₃ through R₁₂₆ independently represent hydrogen, deuterium, (C1-C60)alkyl, (C1-C60)alkoxy, halogen, (C4-C60)heteroaryl, (C5-C60)cycloalkyl or (C6-C60)aryl, and the heteroaryl, cycloalkyl or aryl of R₁₂₃ through R₁₂₆ may be further substituted by one or more substituent(s) selected from deuterium, (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
G₁ and G₂ independently represent a chemical bond or (C6-C60)arylene with or without one or more substituent(s) selected from (C1-C60)alkyl, (C1-C60)alkoxy, (C6-C60)aryl, (C4-C60)heteroaryl and halogen;
Ar₃₁ and Ar₃₂ independently represent (C4-C60)heteroaryl or aryl selected from the following structures: 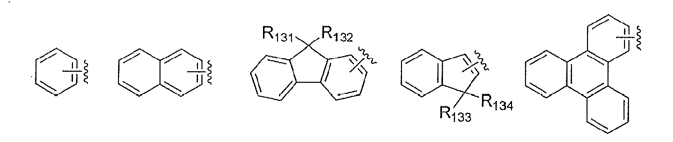 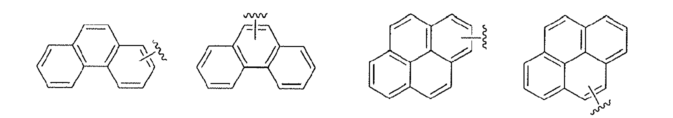 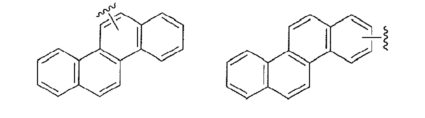 wherein
the aryl or heteroaryl of Ar₃₁ and Ar₃₂ may be substituted by one or more substituent(s) selected from deuterium, (C1-C60)alkyl, (C1-C60)alkoxy, (C6-C60)aryl and (C4-C60)heteroaryl;
L₃₁ represents (C6-C60)arylene, (C4-C60)heteroarylene or a compound having the following structure: 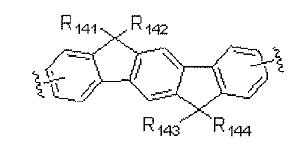 wherein
the arylene or heteroarylene of L₃₁ may be substituted by one or more substituent(s) selected from deuterium, (C1-C60)alkyl, (C1-C60)alkoxy, (C6-C60)aryl, (C4-C60)heteroaryl and halogen;
R₁₃₁ through R₁₃₄ independently represent hydrogen, deuterium, halogen, (C1-C60)alkyl or (C6-C60)aryl, or they may be linked to an adjacent substituent via (C3-C60)alkylene or (C3-C60)alkenylene with or without a fused ring to form an alicyclic ring or a monocyclic or polycyclic aromatic ring; and
R₁₄₁ through R₁₄₄ independently represent hydrogen, deuterium, (C1-C60)alkyl, (C1-C60)alkoxy, (C6-C60)aryl, (C4-C60)heteroaryl or halogen, or they may be linked to an adjacent substituent via (C3-C60)alkylene or (C3-C60)alkenylene with or without a fused ring to form an alicyclic ring or a monocyclic or polycyclic aromatic ring; 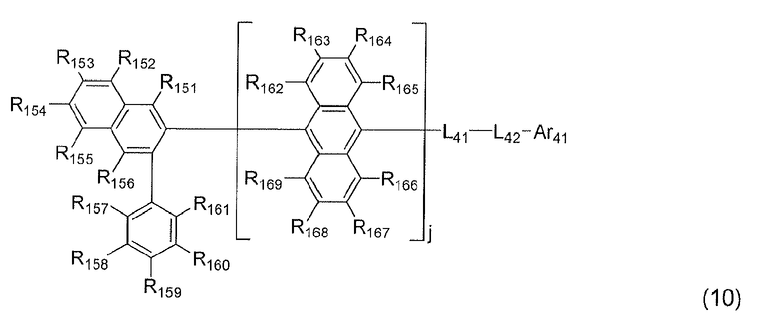 wherein
L₄₁ and L₄₂ independently represent a chemical bond, (C6-C60)arylene or (C3-C60)heteroarylene, and the arylene or heteroarylene of L₄₁ and L₄₂ may be further substituted by one or more substituent(s) selected from deuterium, (C1-C60)alkyl, halogen, cyano, (C1-C60)alkoxy, (C3-C60)cycloalkyl, (C6-C60)aryl, (C3-C60)heteroaryl, tri(C1-C30)alkylsilyl, di(C1-C30)alkyl(C6-C30)arylsilyl and tri(C6-C30)arylsilyl;
R₁₅₁ through R₁₆₉ independently represent hydrogen, halogen, deuterium, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, mono- or di-(C1-C60)alkylamino, mono- or di-(C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₁₅₁ through R₁₆₉ may be linked to an adjacent substituent via (C3-C60)alkylene or (C3-C60)alkenylene with or without a fused ring to form an alicyclic ring or a monocyclic or polycyclic aromatic ring;
Ar₄₁ represents (C6-C60)aryl, (C4-C60)heteroaryl, 5- or 6-membered heterocycloalkyl containing one or more heteroatom(s) selected from N, O and S, (C3-C60)cycloalkyl, adamantyl, (C7-C60)bicycloalkyl or a substituent selected from the following structures: 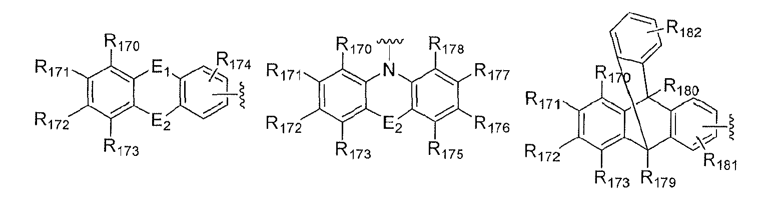 wherein
R₁₇₀ through R₁₈₂ independently represent hydrogen, halogen, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, mono- or di-(C1-C60)alkylamino, mono- or di-(C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
E₁ and E₂ independently represent a chemical bond, -(CR₁₈₃R₁₈₄)ₙ-, - N(R₁₈₅)-, -S-, -O-, -Si(R₁₈₆)(R₁₈₇)-, -P(R₁₈₈)-, -C(=O)-, -B(R₁₈₉)-, -In(R₁₉₀)-, -Se-, - Ge(R₁₉₁)(R₁₉₂)-, -Sn(R₁₉₃)(R₁₉₄)-, -Ga(R₁₉₅)- or -(R₁₉₆)C=C(R₁₉₇)-;
R₁₈₃ through R₁₉₇ independently represent hydrogen, halogen, deuterium, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, mono- or di-(C1-C60)alkylamino, mono- or di-(C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₁₈₃ through R₁₉₇ may be linked to an adjacent substituent via (C3-C60)alkylene or (C3-C60)alkenylene with or without a fused ring to form an alicyclic ring or a monocyclic or polycyclic aromatic ring;
the aryl, heteroaryl, heterocycloalkyl, adamantyl or bicycloalkyl of Ar₄₁, or the alkyl, alkenyl, alkynyl, cycloalkyl, heterocycloalkyl, aryl, heteroaryl, arylsilyl, alkylsilyl, alkylamino or arylamino of R₁₅₁ through R₁₈₂ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, mono- or di-(C1-C60)alkylamino, mono- or di-(C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
j represents an integer from 1 to 4; and
m represents an integer 0 to 4.

The host compound represented by Chemical Formulas 7 to 10 may be exemplified by the compounds having the following structures, but not limited thereto:

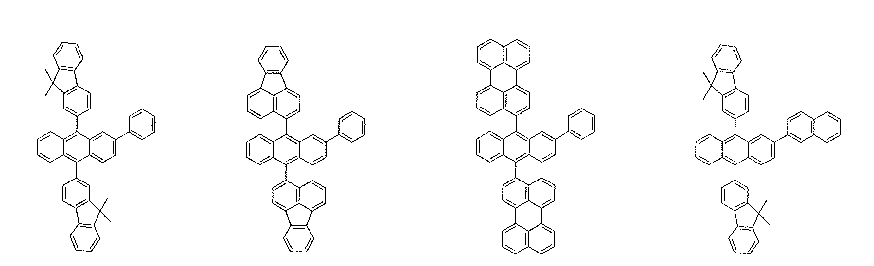

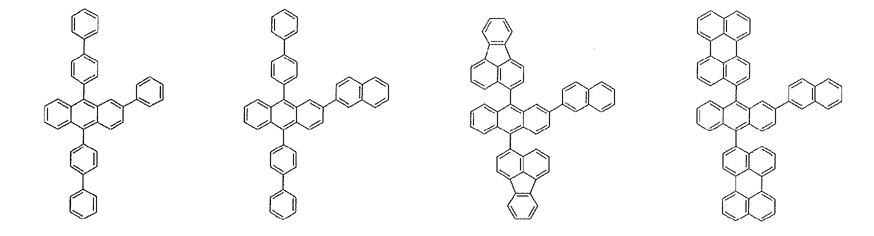

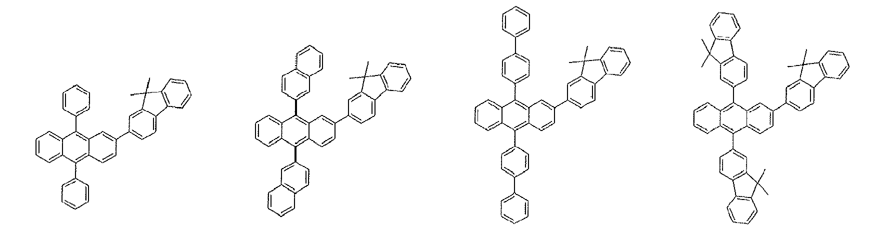

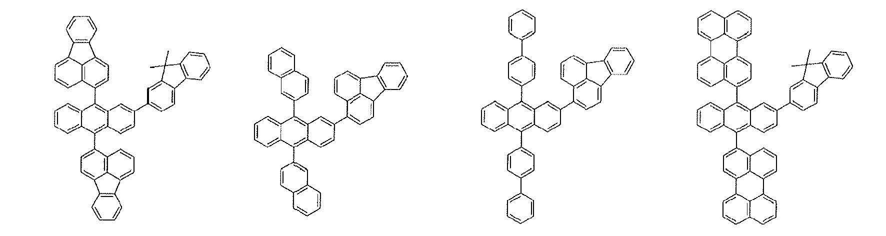

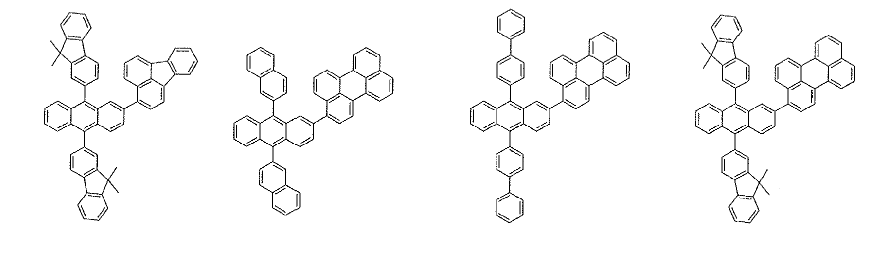

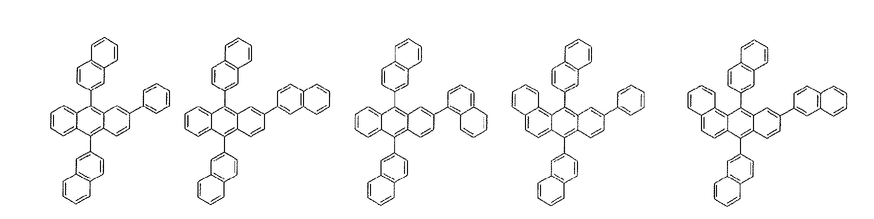

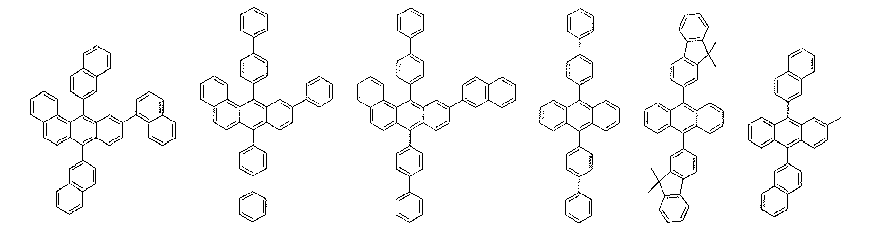

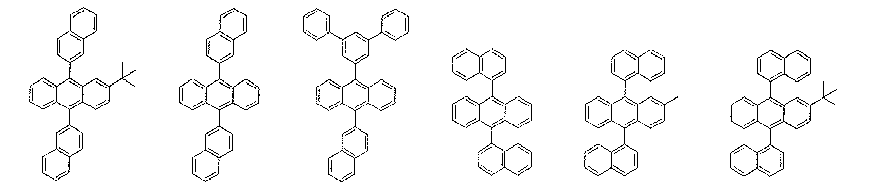

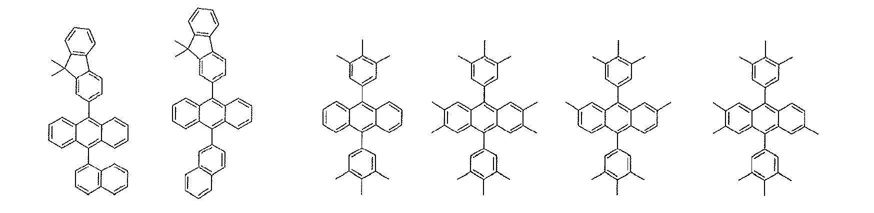

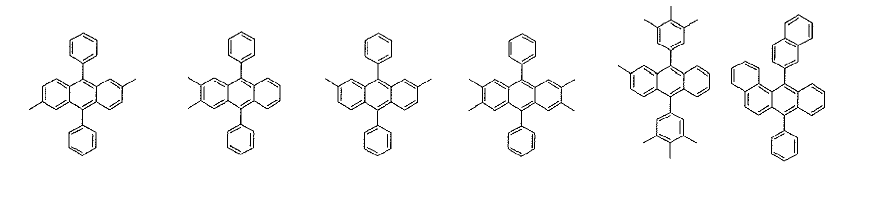

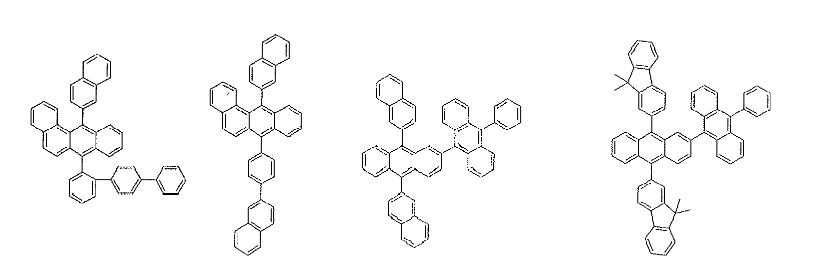

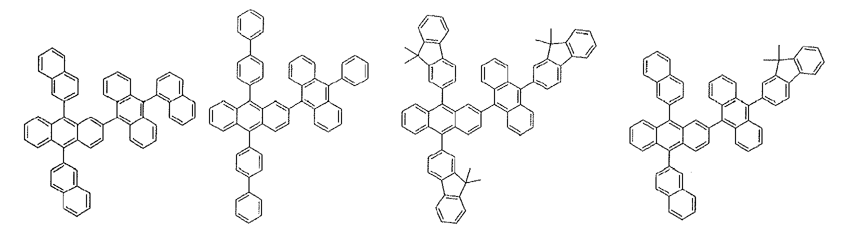

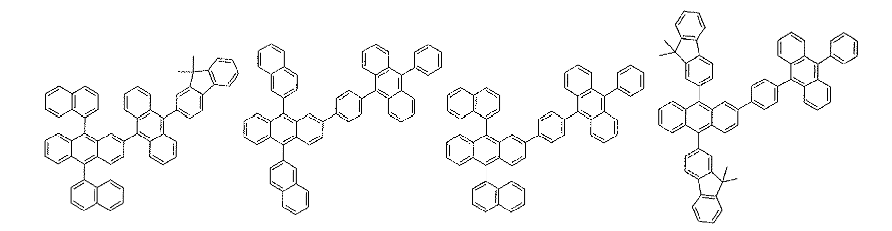

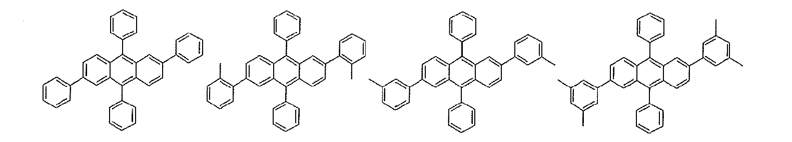

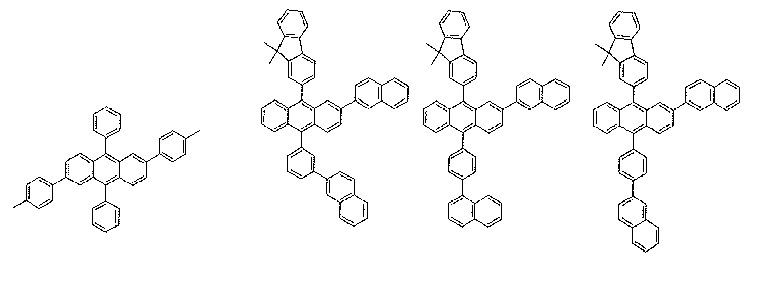

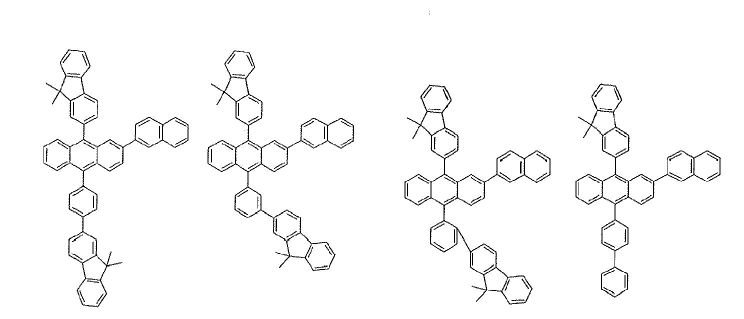

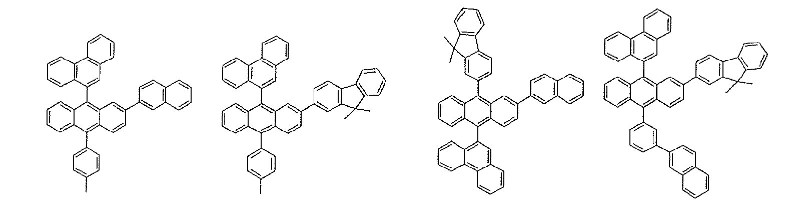

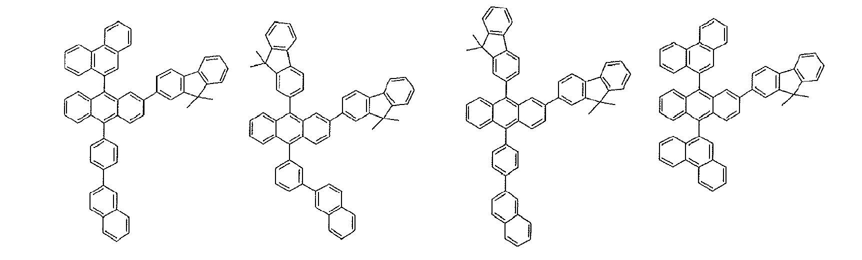

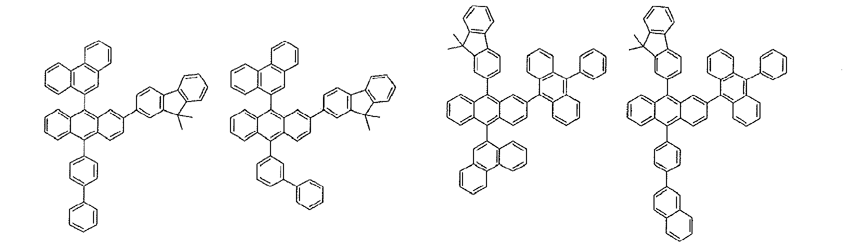

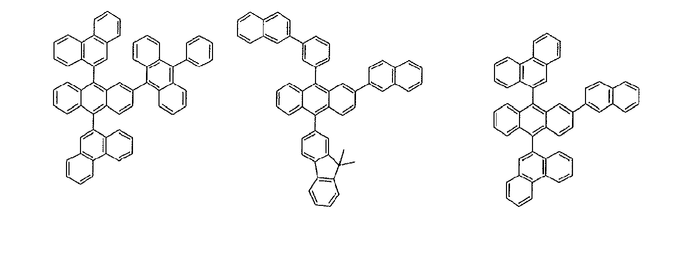

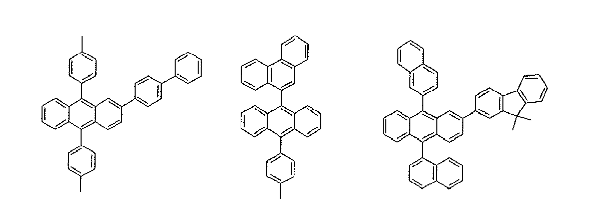

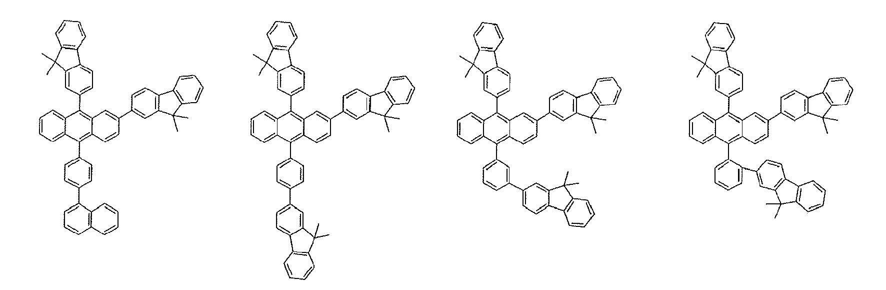

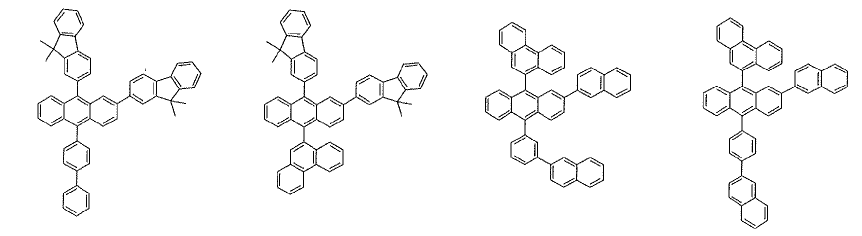

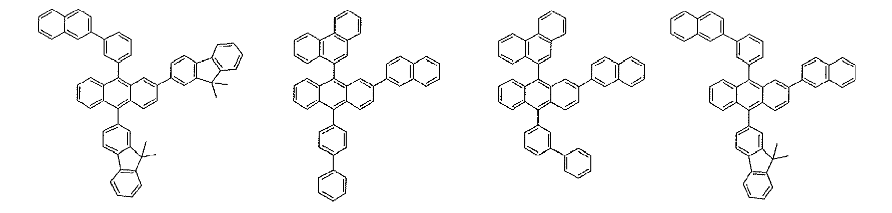

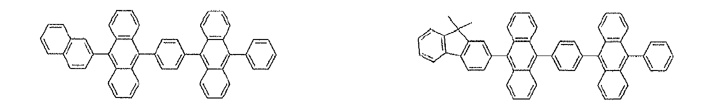

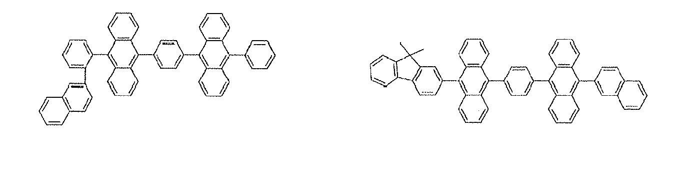

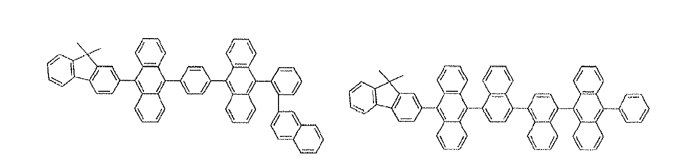

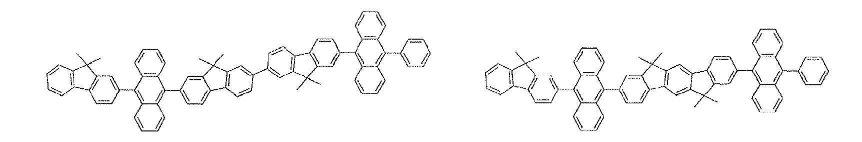

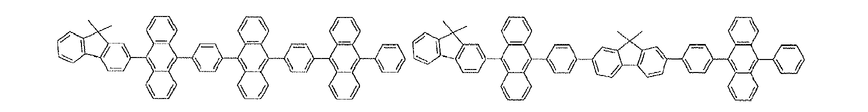

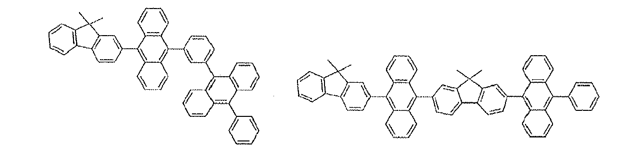

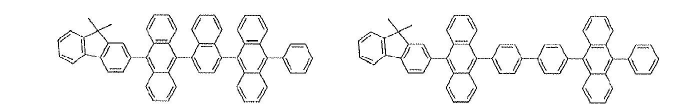

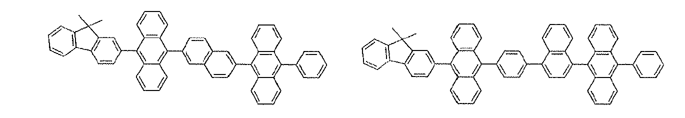

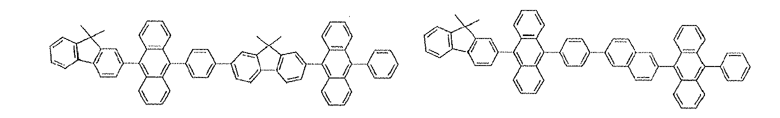

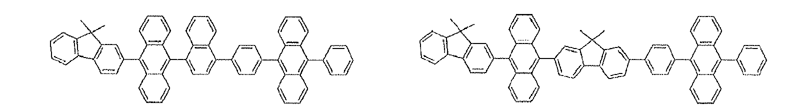

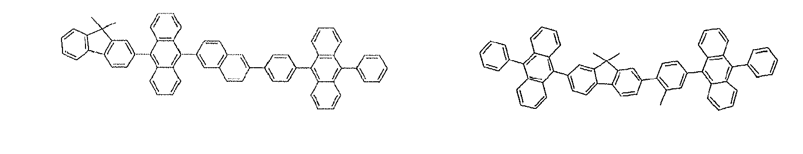

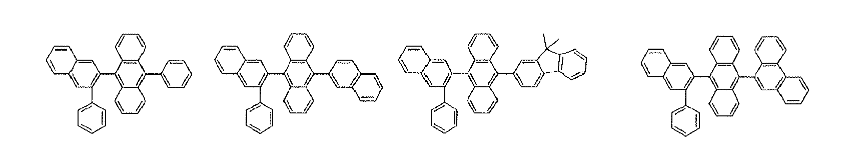

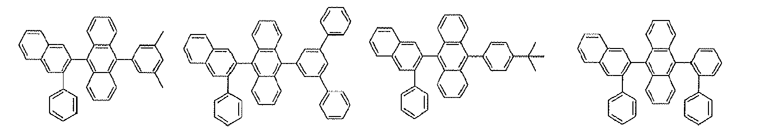

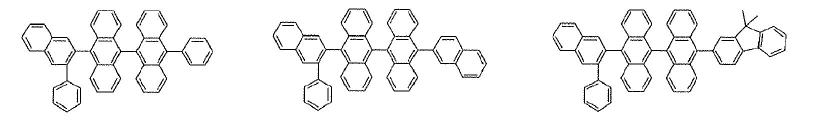

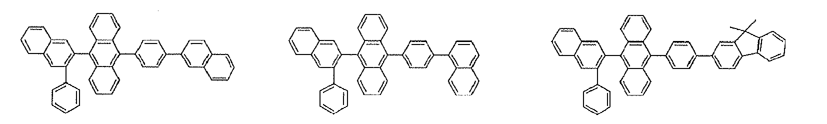

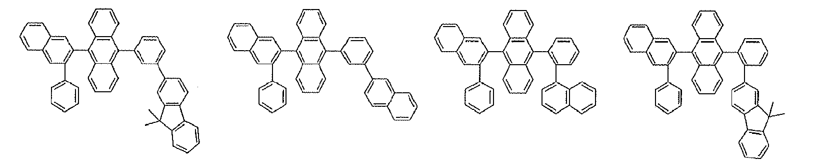

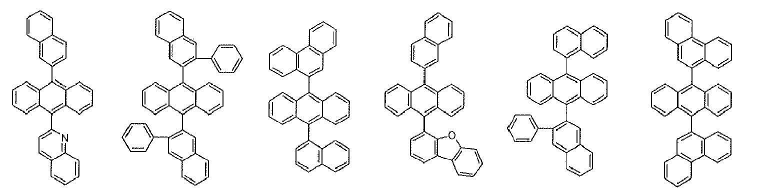

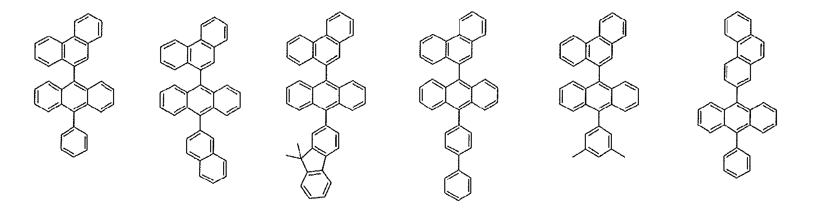

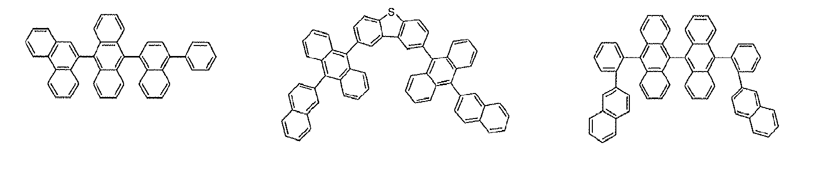

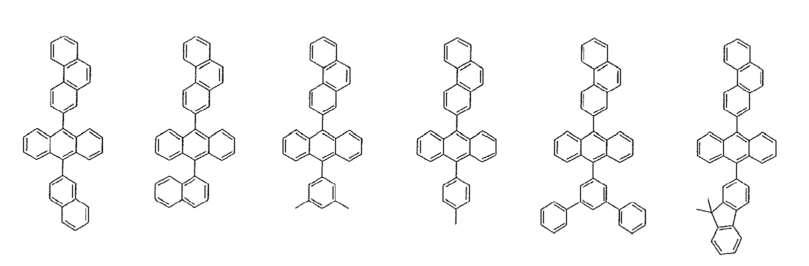

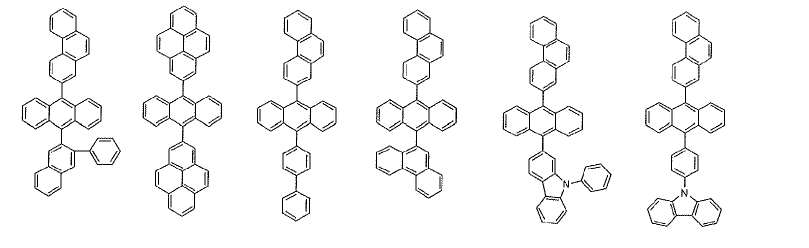

The organic electroluminescent device according to the present invention comprises the organic electroluminescent compound represented by Chemical Formula 1, and, at the same time, may comprise one or more compound(s) selected from a group consisting of arylamine compounds and styrylarylamine compounds. The arylamine compounds or the styrylarylamine compounds may be exemplified by the compound represented by Chemical Formula 11, but not limited thereto: 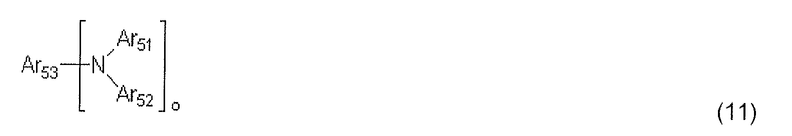 wherein
Ar₅₁ and Ar₅₂ independently represent hydrogen, deuterium, halogen, (C1-C60)alkyl, (C6-C60)aryl, (C4-C60)heteroaryl, mono- or di-(C6-C60)arylamino, mono- or di-(C1-C60)alkylamino, 5- or 6-membered heterocycloalkyl containing one or more heteroatom(s) selected from N, O and S or (C3-C60)cycloalkyl, and Ar₅₁ and Ar₅₂ may be linked via (C3-C60)alkylene or (C3-C60)alkenylene with or without a fused ring to form an alicyclic ring or a monocyclic or polycyclic aromatic ring;
Ar₅₃ represents (C6-C60)aryl, (C4-C60)heteroaryl or a substituent selected from the following structures, when o is 1: 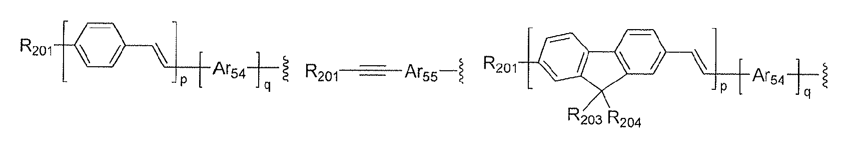 Ar₅₃ represents (C6-C60)arylene, (C4-C60)heteroarylene or a substituent selected from the following structures, when o is 2: 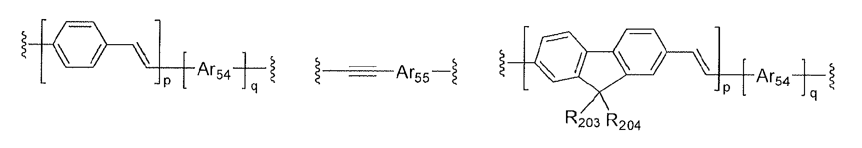 Ar₅₄ and Ar₅₅ independently represent (C6-C60)arylene or (C4-C60)heteroarylene;
R₂₀₁ through R₂₀₃ independently represent hydrogen, halogen, deuterium, (C1-C60)alkyl or (C6-C60)aryl;
p represents an integer from 1 to 4;
q represents an integer 0 or 1; and
the alkyl, aryl, heteroaryl, arylamino, alkylamino, cycloalkyl or heterocycloalkyl of Ar₅₁ and Ar₅₂, the aryl, heteroaryl, arylene or heteroarylene of Ar₅₃, the arylene or heteroarylene of Ar₅₄ and Ar₅₅, or the alkyl or aryl of R₂₀₁ through R₂₀₃ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di-(C1-C60)alkylamino, mono- or di-(C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

Specifically, the arylamine compound or styrylarylamine compound may be exemplified by the following compounds, but not limited thereto:

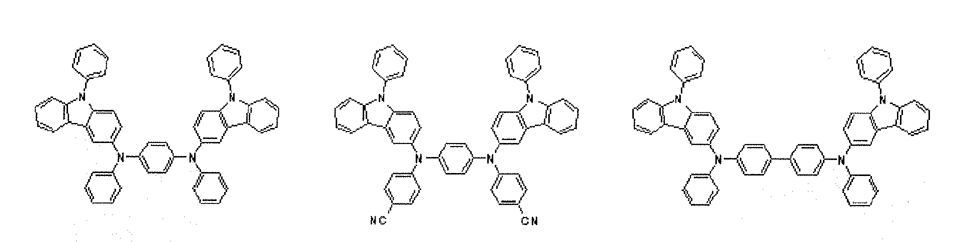

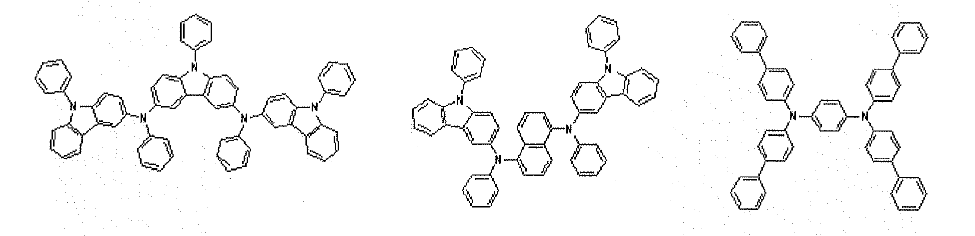

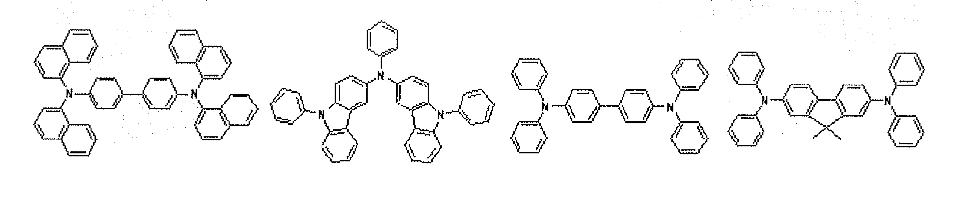

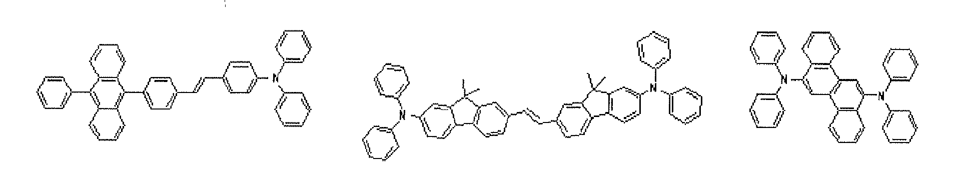

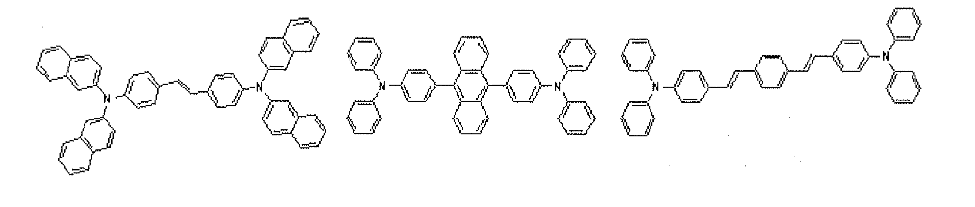

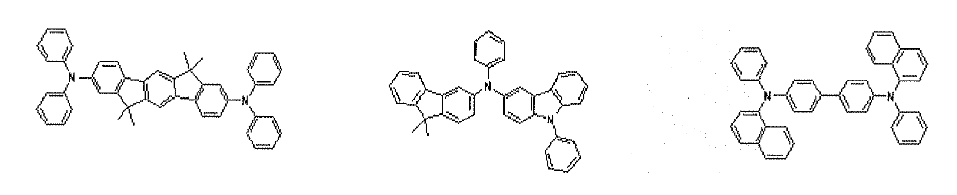

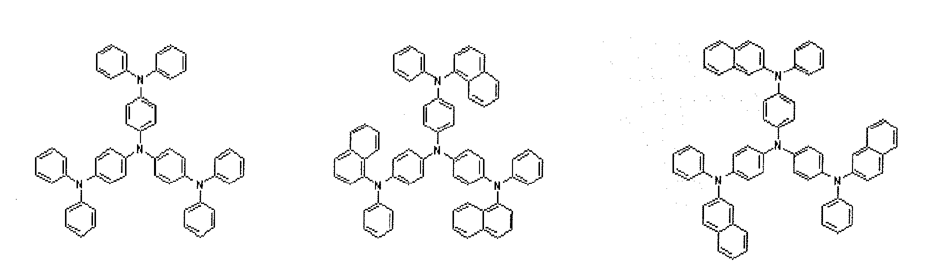

In the organic electroluminescent device according to the present invention, the organic layer may further comprise, in addition to the organic electroluminescent compound represented by Chemical Formula 1, one or more metal(s) selected from a group consisting of organic metals of Group 1, Group 2, 4th period and 5th period transition metals, lanthanide metals and d-transition elements. Also, the organic layer may comprise an electroluminescent layer and a charge generating layer.

An independent electroluminescence type organic electroluminescent device having a pixel structure in which the organic electroluminescent device according to the present invention comprising the organic electroluminescent compound represented by Chemical Formula 1 is used as a subpixel and one or more subpixel(s) comprising one or more metal compound(s) selected from a group consisting of Ir, Pt, Pd, Rh, Re, Os, TI, Pb, Bi, In, Sn, Sb, Te, Au and Ag is patterned in parallel may be manufactured.

The organic layer may further comprise, in addition to the organic electroluminescent compound, one or more compound(s) having an electroluminescence peak with wavelength of not less than 560 nm. The compound having an electroluminescence peak with wavelength of not less than 560 nm may be exemplified by the compounds represented by Chemical Formulas 12 to 16, but not limited thereto:

M¹L¹⁰¹L¹⁰²L¹⁰³ (12)

wherein
M¹ is a metal selected from a group consisting of Group 7, Group 8, Group 9, Group 10, Group 11, Group 13, Group 14, Group 15 and Group 16 metals;
ligands L¹⁰¹, L¹⁰² and L¹⁰³ are independently selected from the following structures: 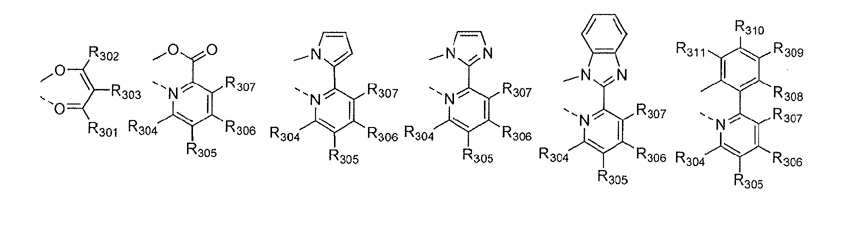 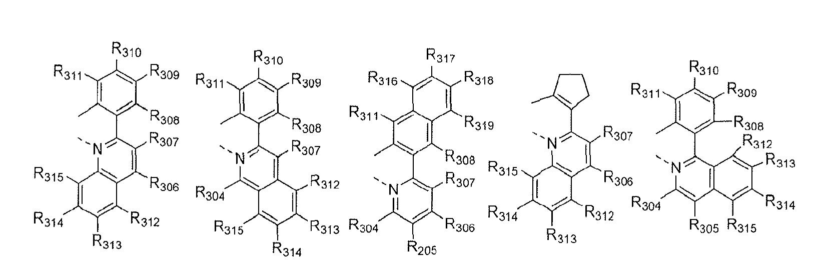 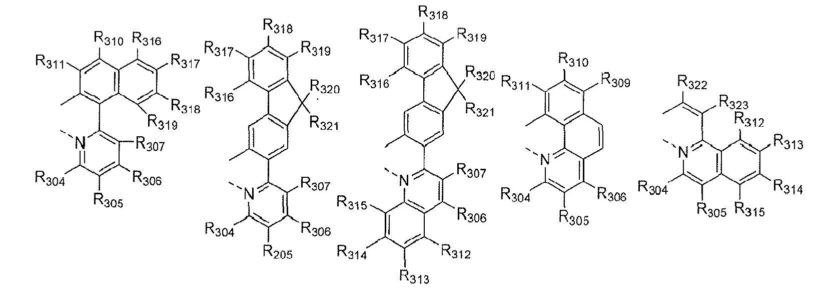 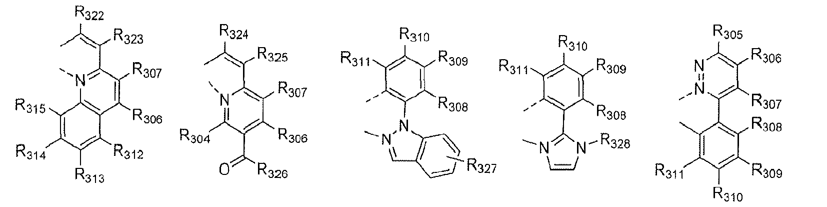 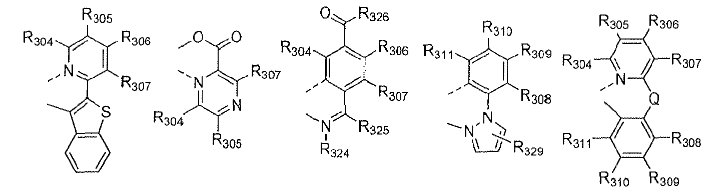 wherein
R₃₀₁ through R₃₀₃ independently represent hydrogen, (C1-C60)alkyl with or without halogen substituent(s), (C6-C60)aryl with or without (C1-C60)alkyl substituent(s) or halogen;
R₃₀₄ through R₃₁₉ independently represent hydrogen, (C1-C60)alkyl, (C1-C30)alkoxy, (C3-C60)cycloalkyl, (C2-C30)alkenyl, (C6-C60)aryl, mono- or di-(C1-C30)alkylamino, mono- or di-(C6-C30)arylamino, SF₅, tri(C1-C30)alkylsilyl, di(C1-C30)alkyl(C6-C30)arylsilyl, tri(C6-C30)arylsilyl, cyano or halogen, and the alkyl, cycloalkyl, alkenyl or aryl of R₃₀₄ through R₃₁₉ may be further substituted by one or more substituent(s) selected from (C1-C60)alkyl, (C6-C60)aryl and halogen;
R₃₂₀ through R₃₂₃ independently represent hydrogen, (C1-C60)alkyl with or without halogen substituent(s) or (C6-C60)aryl with or without (C1-C60)alkyl substituent(s);
R₃₂₄ and R₃₂₅ independently represent hydrogen, (C1-C60)alkyl, (C6-C60)aryl or halogen, or R₃₂₄ and R₃₂₅ may be linked via (C3-C12)alkylene or (C3-C12)alkenylene with or without a fused ring to form an alicyclic ring or a monocyclic or polycyclic aromatic ring, and the alkyl or aryl of R₃₂₄ and R₃₂ or the alicyclic ring or monocyclic or polycyclic aromatic ring formed as they are linked via (C3-C12)alkylene or (C3-C12)alkenylene with or without a fused ring may be further substituted by one or more substituent(s) selected from (C1-C60)alkyl with or without halogen substituent(s), (C1-C30)alkoxy, halogen, tri(C1-C30)alkylsilyl, tri(C6-C30)arylsilyl and (C6-C60)aryl;
R₃₂₆ represents (C1-C60)alkyl, (C6-C60)aryl, (C5-C60)heteroaryl containing one or more heteroatom(s) selected from N, O and S or halogen;
R₃₂₇ through R₃₂₉ independently represent hydrogen, (C1-C60)alkyl, (C6-C60)aryl or halogen, and the alkyl or aryl of R₃₂₆ through R₃₂₉ may be further substituted by halogen or (C1-C60)alkyl;
Q represents 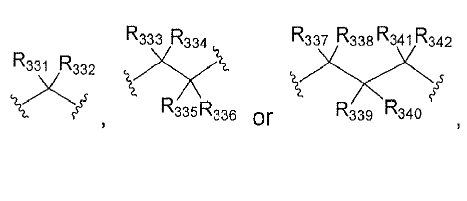 wherein R₃₃₁ through R₃₄₂ independently represent hydrogen, (C1-C60)alkyl with or without halogen substituent(s), (C1-C30)alkoxy, halogen, (C6-C60)aryl, cyano or (C5-C60)cycloalkyl, or each of R₃₃₁ through R₃₄₂ may be linked to an adjacent substituent via alkylene or alkenylene to form a (C5-C7)spiro ring or (C5-C9)fused ring, or may be linked to R₃₀₇ or R₃₀₈ via alkylene or alkenylene to form a (C5-C7)fused ring; 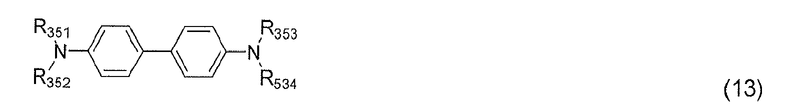 wherein
R₃₅₁ through R₃₅₄ independently represent (C1-C60)alkyl or (C6-C60)aryl, or they are linked to an adjacent substituent via (C3-C60)alkylene or (C3-C60)alkenylene with or without a fused ring to form an alicyclic ring or a monocyclic or polycyclic aromatic ring;
the alkyl or aryl of R₃₅₁ through R₃₅₄, or the alicyclic ring or monocyclic or polycyclic aromatic ring formed as they are linked via (C3-C60)alkylene or (C3-C60)alkenylene with or without a fused ring may be further substituted by one or more substituent(s) selected from (C1-C60)alkyl with or without halogen substituent(s), (C1-C60)alkoxy, halogen, tri(C1-C60)alkylsilyl, tri(C6-C60)arylsilyl and (C6-C60)aryl;

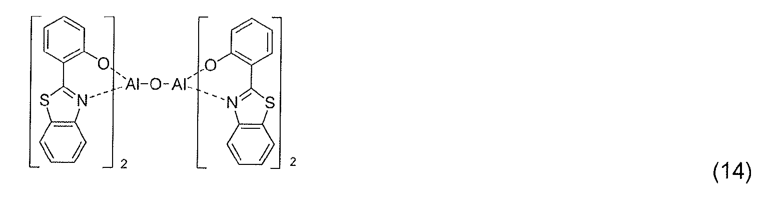

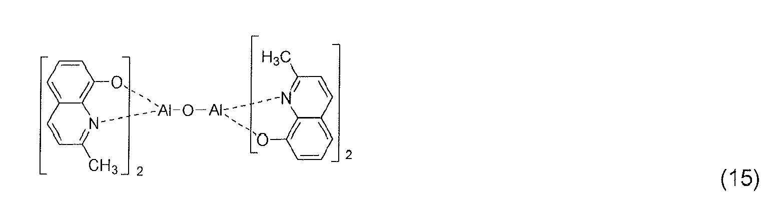

L²⁰¹L²⁰²M²(T)ᵣ (16)

wherein
ligands L²⁰¹ and L²⁰² are independently selected from the following structures: 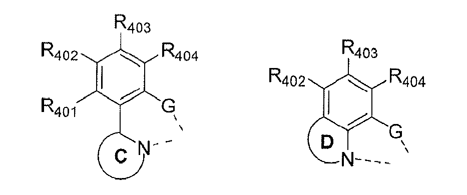 wherein
M² represents a divalent or trivalent metal;
r is 0 when M² is a divalent metal, and r is 1 when M² is a trivalent metal;
T represents (C6-C60)aryloxy or tri(C6-C60)arylsilyl, and the aryloxy or triarylsilyl of T may be further substituted by (C1-C60)alkyl or (C6-C60)aryl;
G represents O, S or Se;
ring C represents oxazole, thiazole, imidazole, oxadiazole, thiadiazole, benzoxazole, benzothiazole, benzoimidazole, pyridine or quinoline;
ring D represents pyridine or quinoline, and the ring D may be further substituted by (C1-C60)alkyl, phenyl with or without (C1-C60)alkyl substituent(s) or naphthyl;
R₄₀₁ through R₄₀₄ independently represent hydrogen, (C1-C60)alkyl, halogen, tri(C1-C60)alkylsilyl, tri(C6-C60)arylsilyl or (C6-C60)aryl, or they may be linked to an adjacent substituent via (C3-C60)alkylene or (C3-C60)alkenylene to form a fused ring, and the pyridine or quinoline may be linked to R₄₀₁ via a chemical bond to form a fused ring; and
the aryl of ring C and R₄₀₁ through R₄₀₄ may be further substituted by (C1-C60)alkyl, halogen, (C1-C60)alkyl with halogen substituent(s), phenyl, naphthyl, tri(C1-C60)alkylsilyl, tri(C6-C60)arylsilyl or amino.

The compound having an electroluminescence peak with wavelength of not less than 560 nm included in the electroluminescent layer may be exemplified by the following compounds, but not limited thereto:

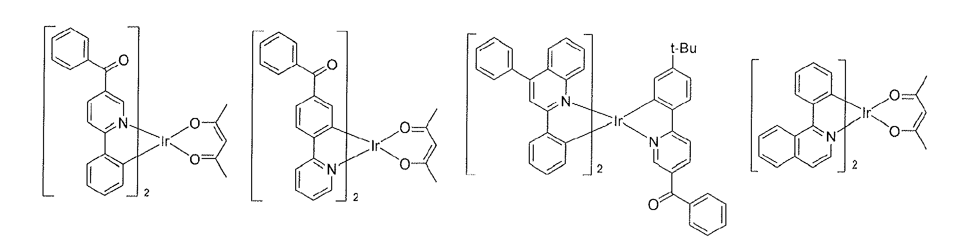

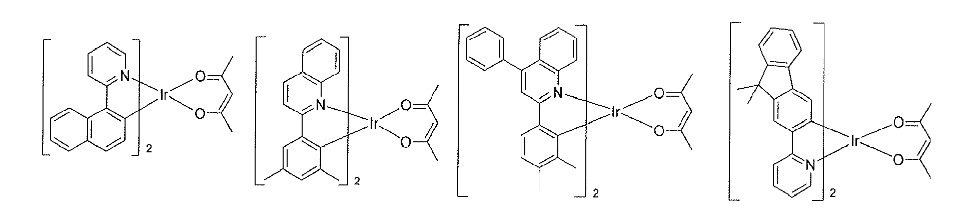

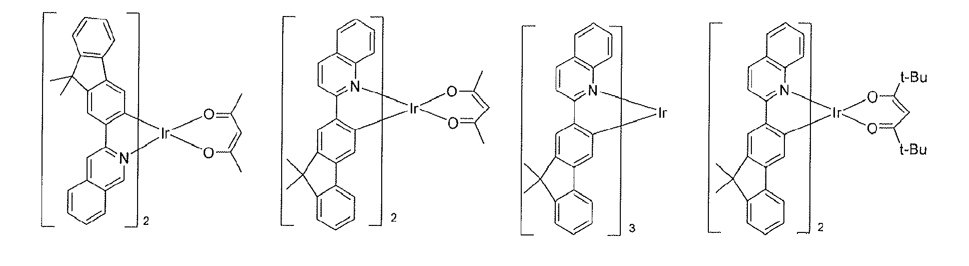

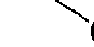

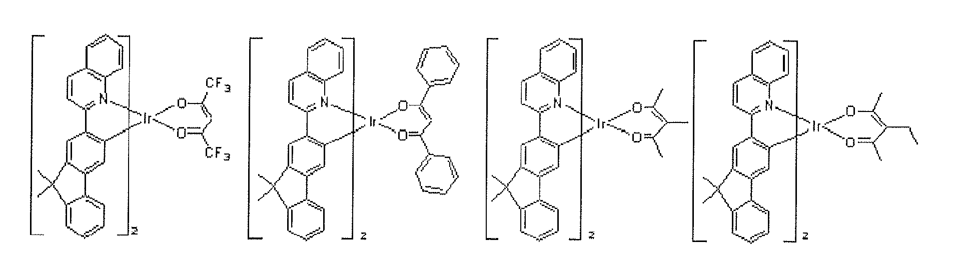

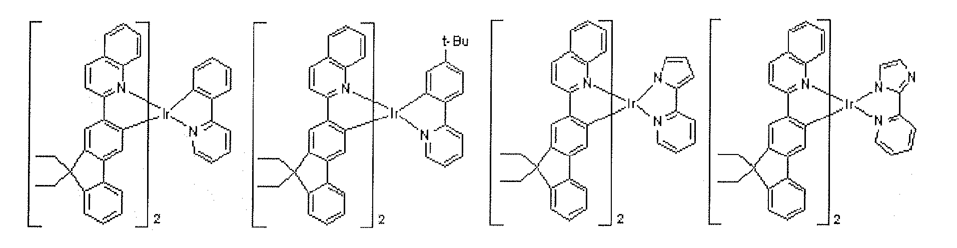

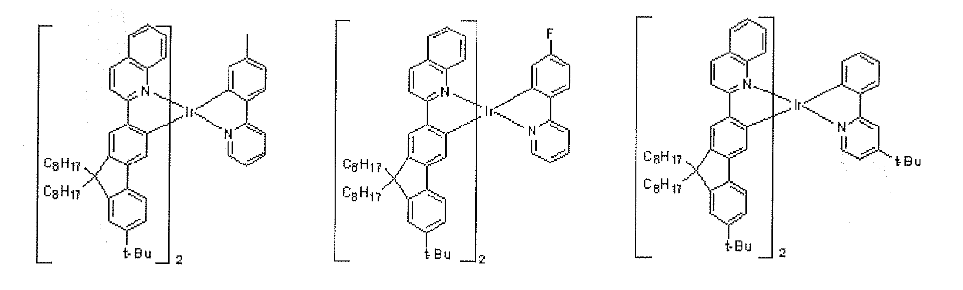

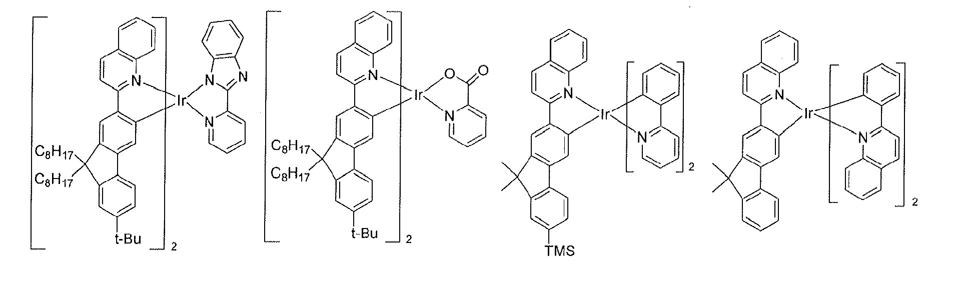

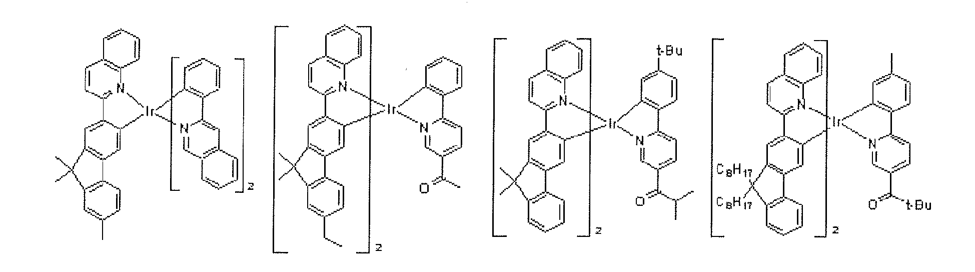

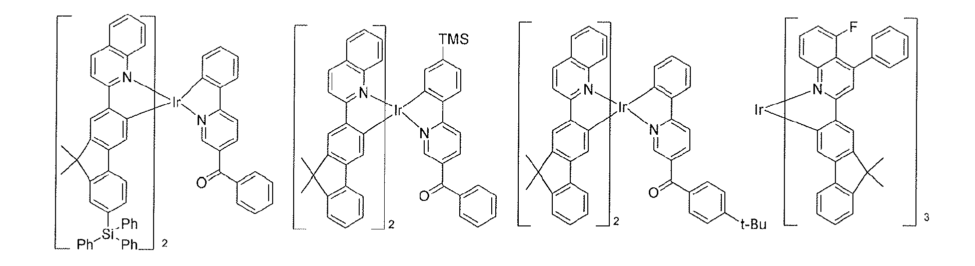

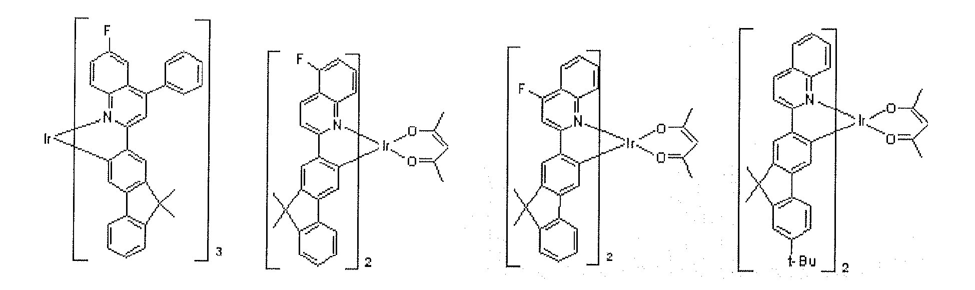

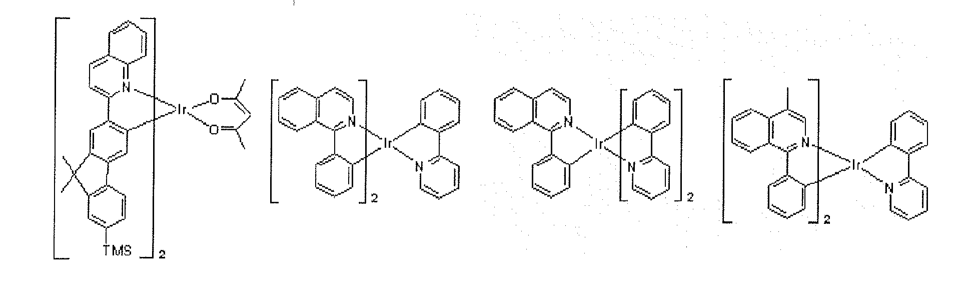

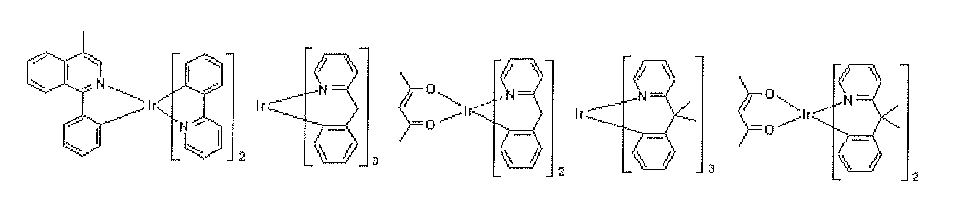

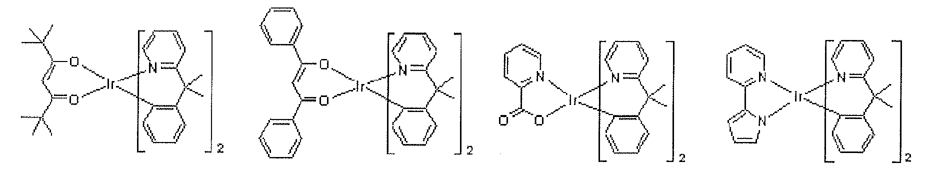

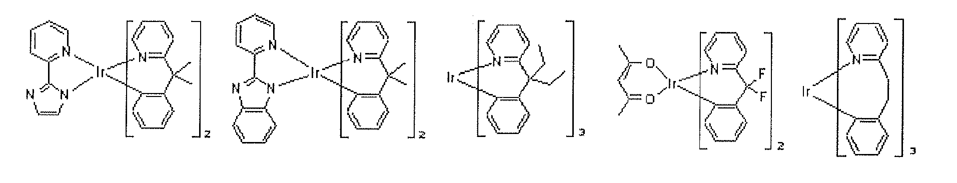

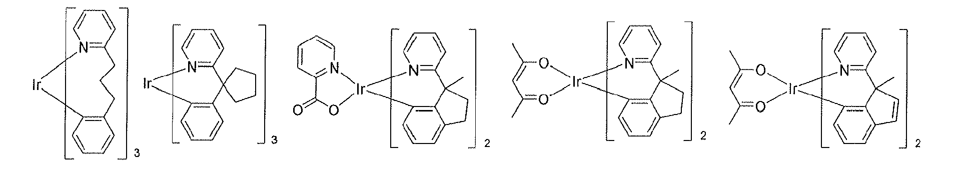

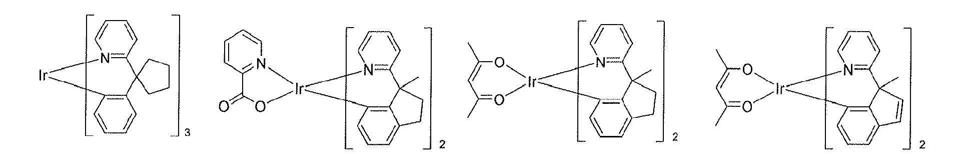

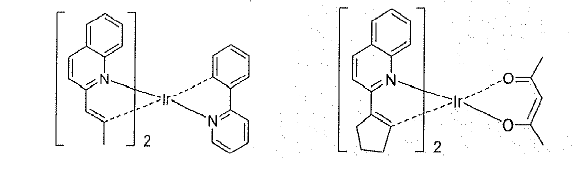

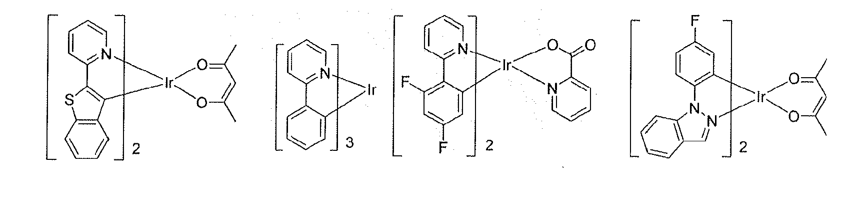

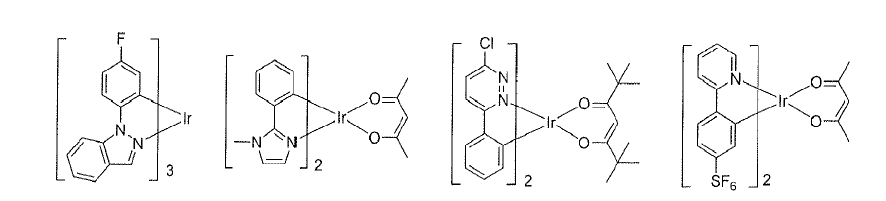

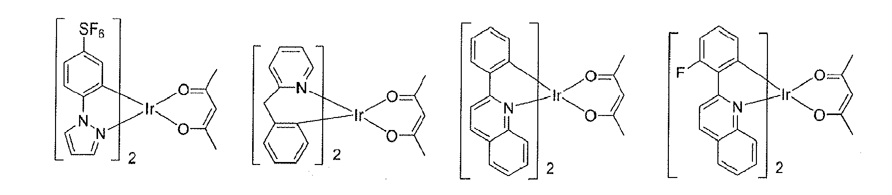

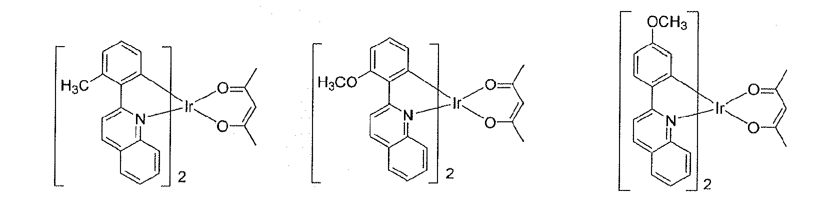

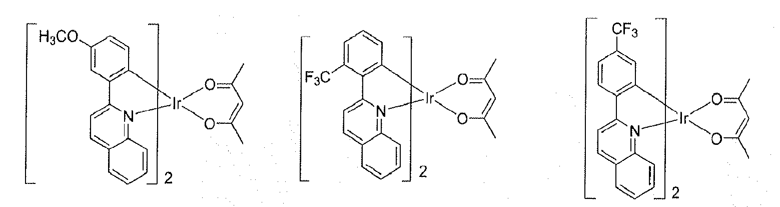

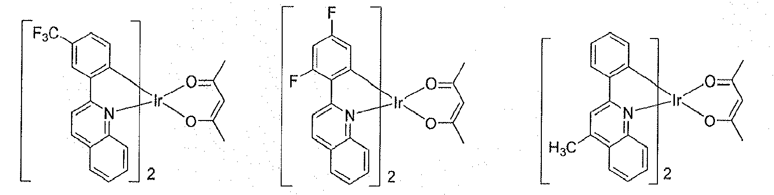

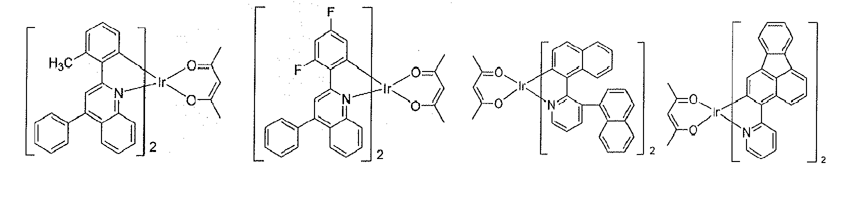

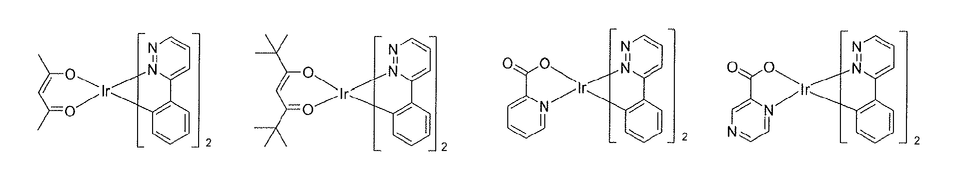

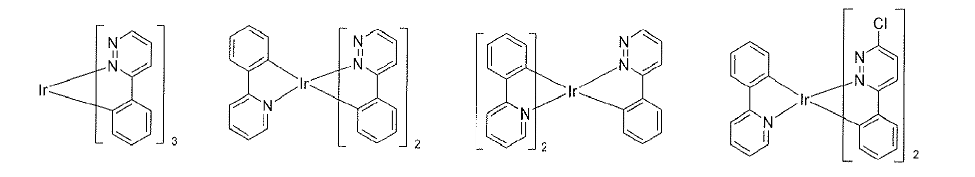

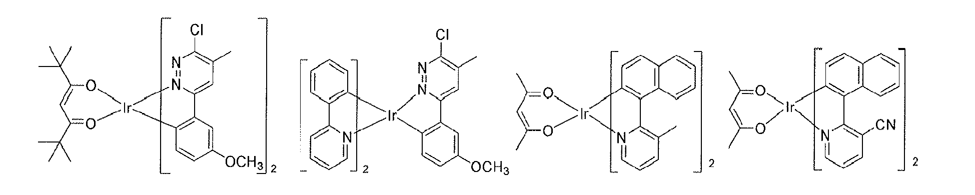

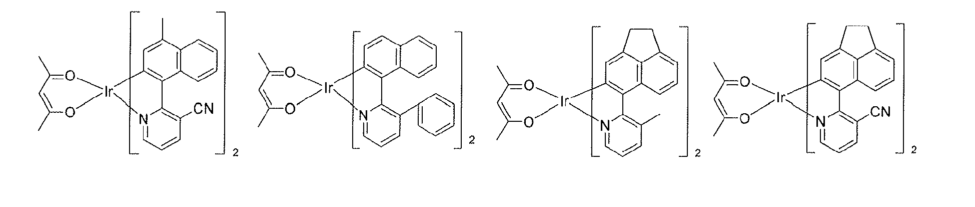

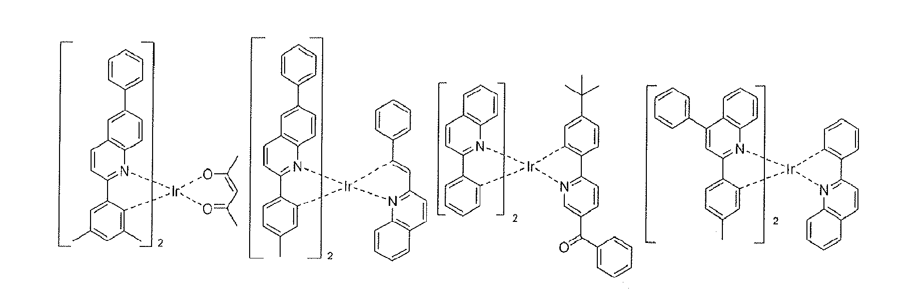

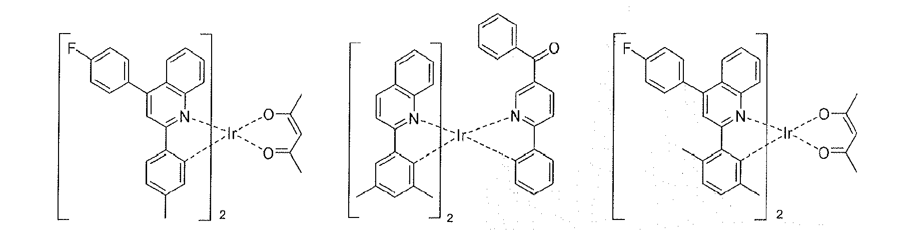

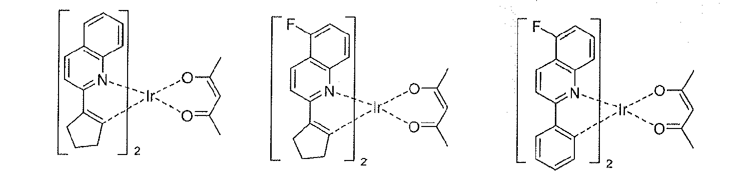

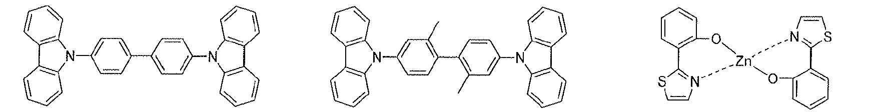

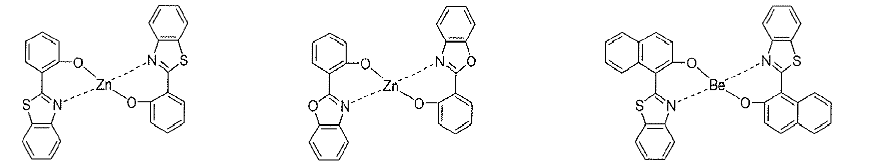

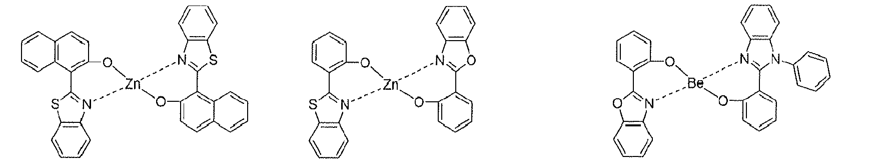

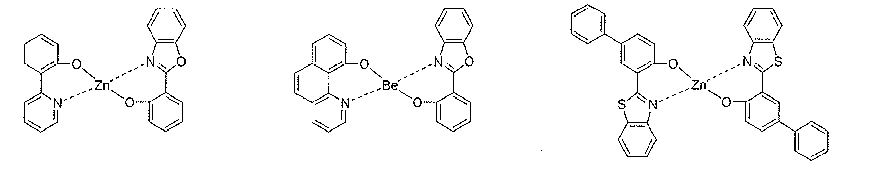

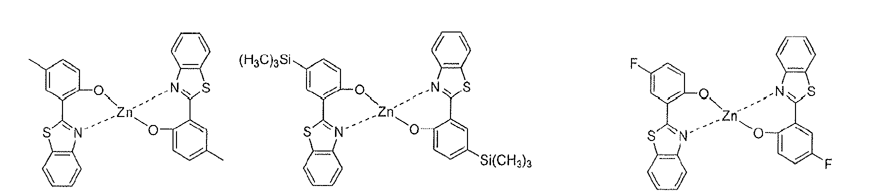

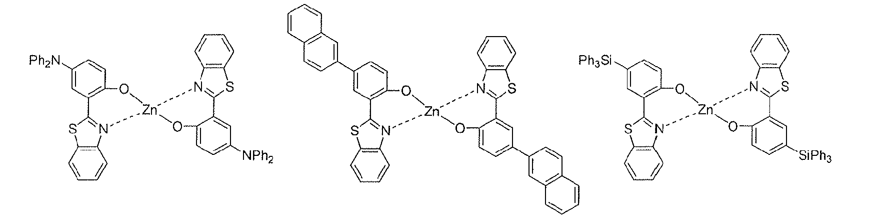

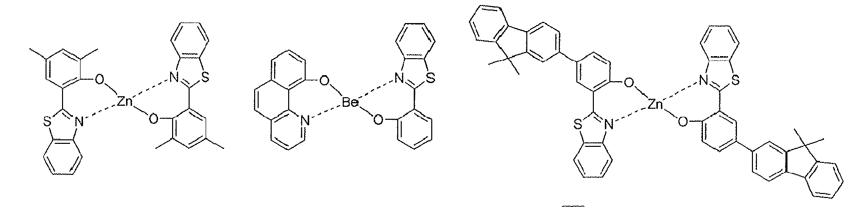

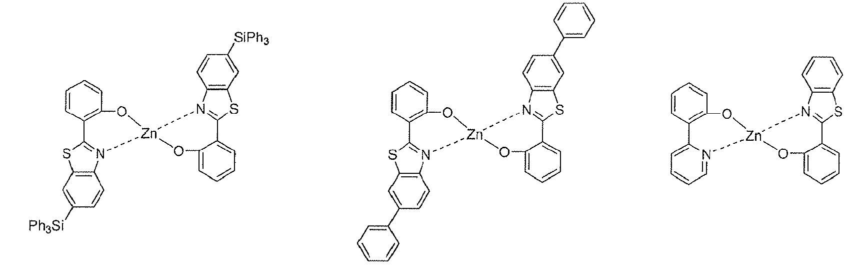

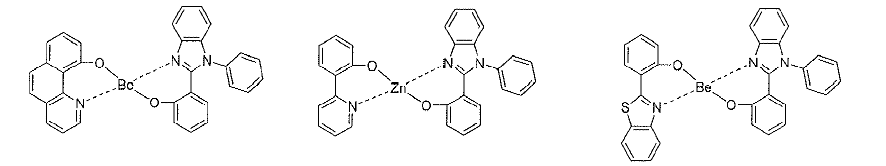

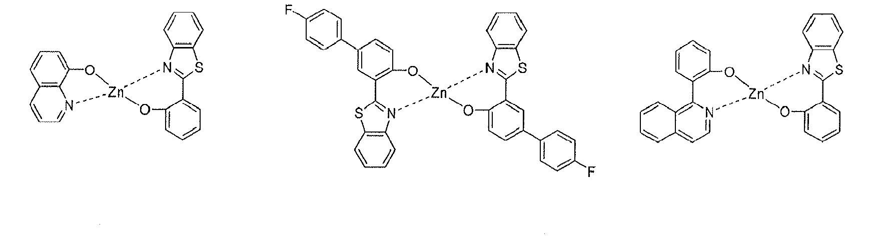

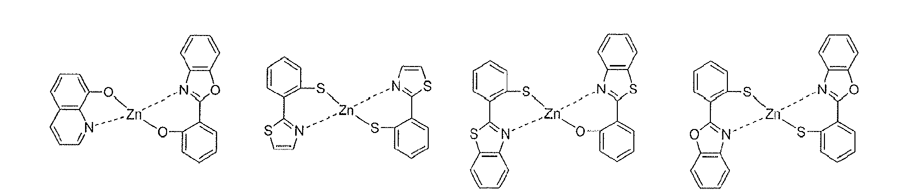

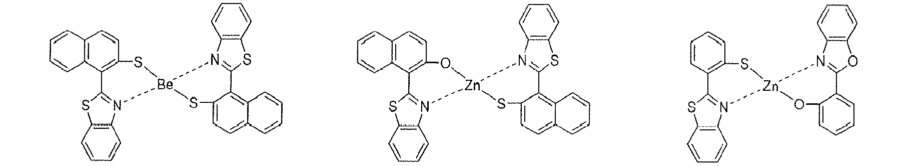

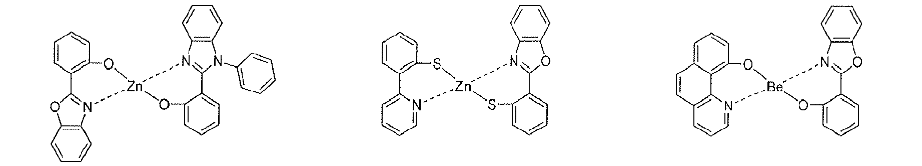

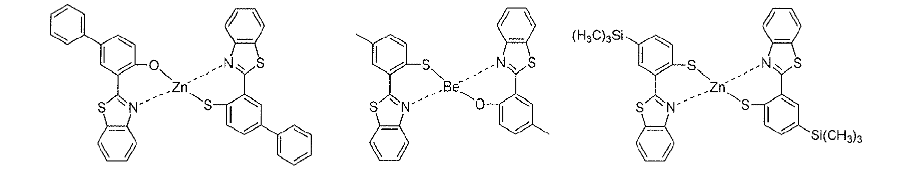

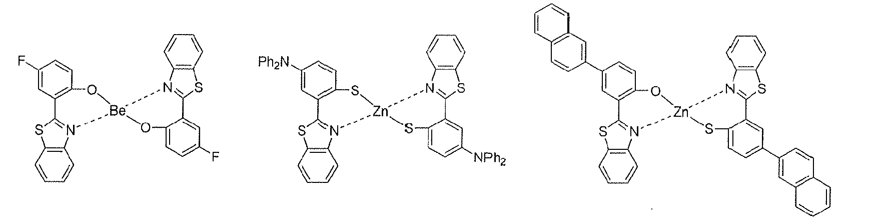

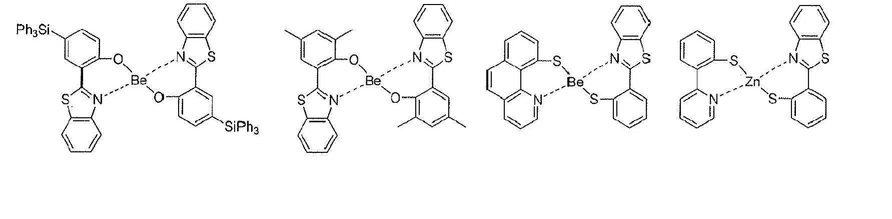

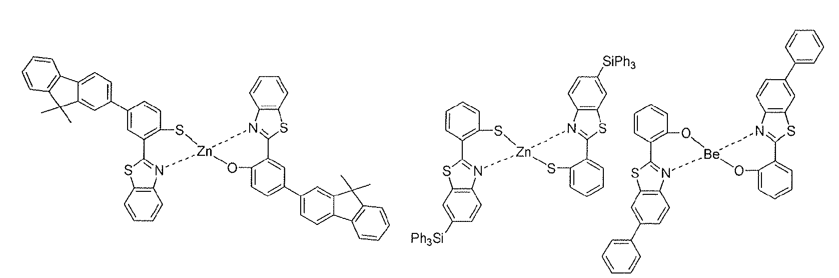

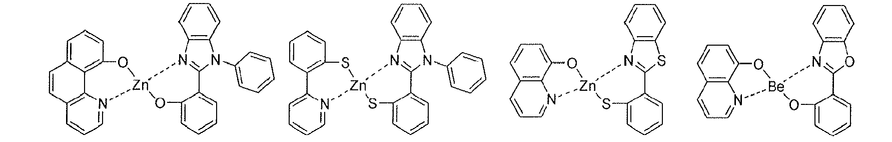

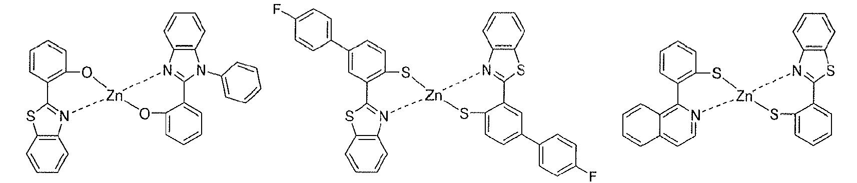

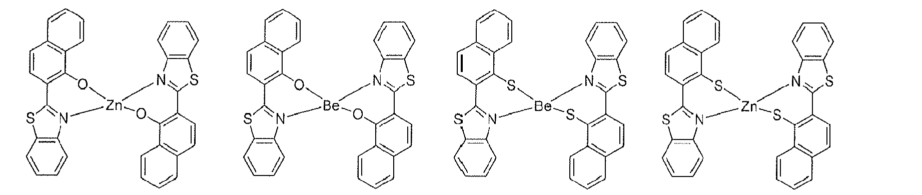

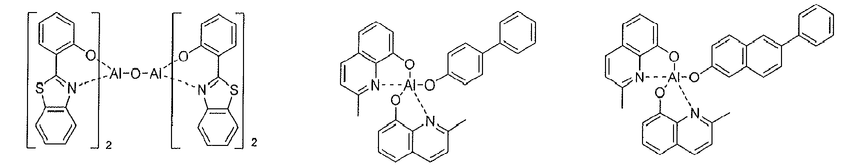

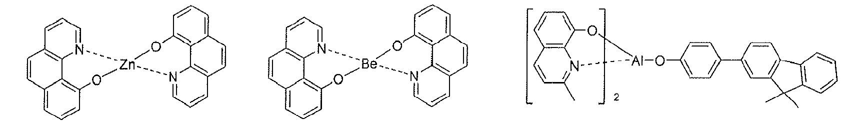

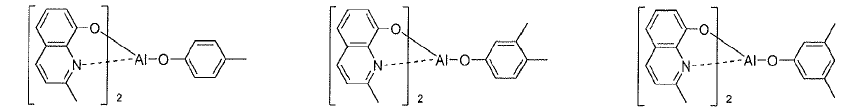

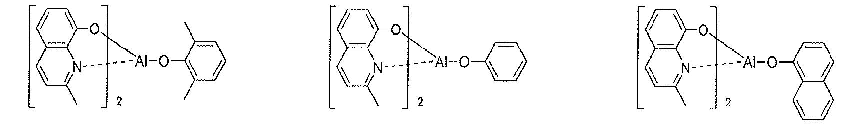

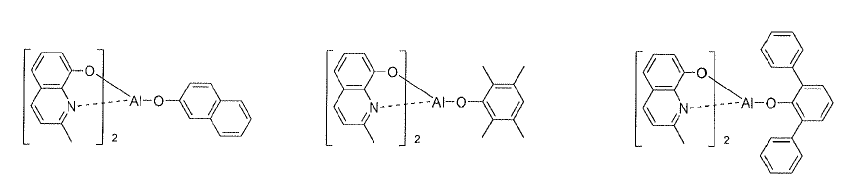

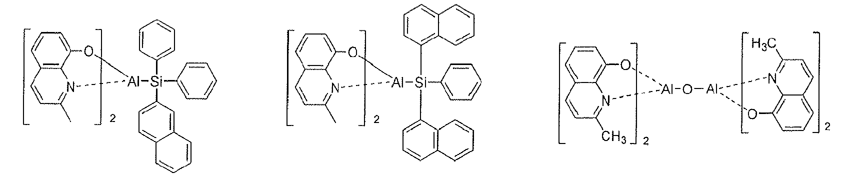

In the organic electroluminescent device according to the present invention, a layer (hereinafter referred to as "surface layer") selected from a metal chalcogenide layer, a metal halide layer and a metal oxide layer may be placed on the inner surface of one or both electrode(s) among the pair of electrodes. More specifically, a metal chalcogenide (including oxide) layer of silicon or aluminum may be placed on the anode surface of the electroluminescent layer, and a metal halide layer or metal oxide layer may be placed on the cathode surface of the electroluminescent layer. A driving stability may be attained therefrom.

The chalcogenide may be, for example, SiOₓ (1 ≤ x ≤ 2), AlOₓ (1 ≤ x ≤ 1.5), SiON, SiAION, etc. The metal halide may be, for example, LiF, MgF₂, CaF₂, a rare earth metal fluoride, etc. The metal oxide may be, for example,Cs₂O, Li₂O, MgO, SrO, BaO, CaO, etc.

Further, in the organic electroluminescent device according to the present invention, a mixed region of an electron transport compound and a reductive dopant or a mixed region of a hole transport compound and an oxidative dopant may be placed on the inner surface of one or both electrode(s) among the pair of electrodes. In that case, transport of electrons from the mixed region to the electroluminescent layer becomes easier, because the electron transport compound is reduced to an anion. Further, transport of holes from the mixed region to the electroluminescent layer becomes easier, because the hole transport compound is oxidized to a cation. Preferred examples of the oxidative dopant include various Lewis acids and acceptor compounds. Preferred examples of the reductive dopant include alkali metals, alkali metal compounds, alkaline earth metals, rare earth metals and mixtures thereof.

The organic electroluminescent compound according to the present invention has superior luminous efficiency, excellent color purity of the material and very good life property. Therefore, it may be used to manufacture OLED devices having very good operation life.

### EXAMPLES

Hereinafter, organic electroluminescent compounds according to the present invention, preparation method thereof and electroluminescence characteristics thereof will be described referring to representative exemplary compounds. However, the following examples are for illustrative purposes only and not intended to limit the scope of the present invention.

### Preparation Examples

### Preparation Example 1: Preparation of Compound 6

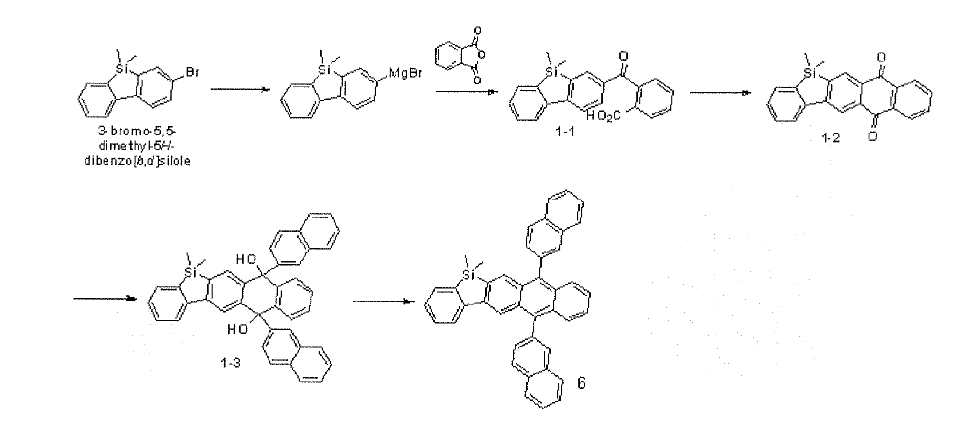

### Preparation of Compound 1-1

Magnesium (Mg) (1.1 g, 44.9 mmol) and iodine (I₂) (1.7 g, 6.9 mmol) were mixed with THF (70 mL) and stirred under reflux. One hour later, after cooling to room temperature, 3-bromo-5,5-dimethyl-5*H*-dibenzo[b,d]silole (10.0 g, 34.6 mmol) dissolved in THF (500 mL) were added to the mixture solution of Mg and I₂. After stirring for an hour under reflux, the solution was cooled to room temperature. After adding phthalic anhydride (5.1 g, 34.6 mmol), followed by stirring for 5 hours at 50 °C, distilled water was added at room temperature. After extracting with MC, followed by drying with MgSO₄, Compound **1-1** (10.0 g, 27.9 mmol, 82.05 %) was obtained by distillation under reduced pressure and column separation.

### Preparation of Compound 1-2

Compound **1-1** (10.0 g, 27.9 mmol) was mixed with methanesulfonic acid (70 mL) and stirred for 2 hours at 100 °C. After cooling to room temperature, distilled water was added. The produced solid was filtered under reduced pressure and washed with aqueous NaOH solution. Compound **1-2** (4.0 g, 11.7 mmol, 43.51 %) was obtained by column separation.

### Preparation of Compound 1-3

2-Bromonaphthalene (7.2 g, 35.2 mmol) was dissolved in THF (100 mL) and n-butyllithium (14.6 mmol, 2.5M in hexane) was slowly added at -78 °C. After stirring for an hour, Compound **1-2** (4.0 g, 11.7 mmol) was added at -78 °C. After stirring for 6 hours at room temperature, distilled water was added. After extracting with MC, followed by drying with MgSO₄, Compound **1-3** (6.7 g, 11.7 mmol, 100 %) was obtained by distillation under reduced pressure.

### Preparation of Compound 6

Compound **1-3** (6.7 g, 11.7 mmol), KI (5.5 g, 33.5 mmol) and NaH₂PO₂H₂O (7.1 g, 69.0 mmol) were mixed with acetic acid (100 mL) and stirred under reflux. 6 hours later, the mixture was cooled to room temperature and distilled water was added to filter the produced solid under reduced pressure. The solid was neutralized by washing with aqueous NaOH solution. Compound **6** (3.0 g, 63.7 %, 5.3 mmol) was obtained by column separation.

### Preparation Example 2: Preparation of Compound 180

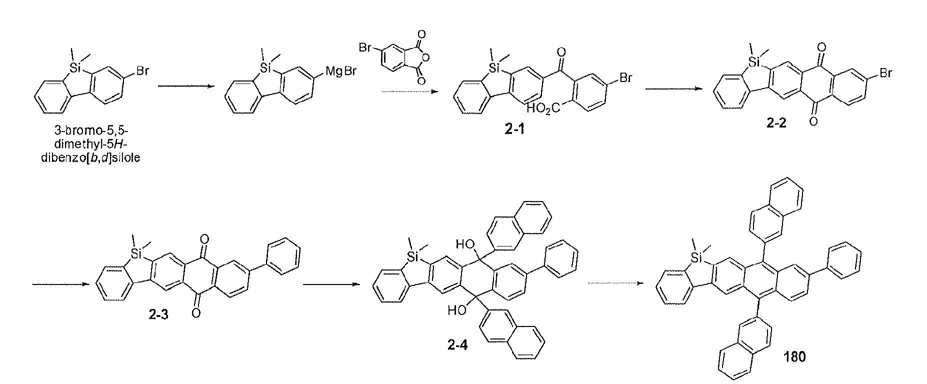

### Preparation of Compound 2-1

Mg (1.1 g, 44.9 mmol) and I₂ (1.7 g, 6.9 mmol) were mixed with THF (70 mL) and stirred under reflux. One hour later, after cooling to room temperature, 3-bromo-5,5-dimethyl-5*H*-dibenzo[b,d]silole (10.0 g, 34.6 mmol) dissolved in THF (500 mL) was added to the mixture solution of Mg and I₂. The mixture was stirred under reflux for an hour and cooled to room temperature. 5-Bromoisobenzofuran-1,3-dione (5.12 g, 34.57 mmol) was added. After stirring at 50 °C for 5 hours, distilled water was added at room temperature. After extracting with MC, followed by drying with MgSO₄, Compound **2-1** (10 g, 27.89 mmol, 82.05 %) was obtained by distillation under reduced pressure and column separation.

### Preparation of Compound 2-2

Compound **2-1** (10.0 g, 27.9 mmol) was mixed with methanesulfonic acid (70 mL) and stirred for two hours at 100 °C. After cooling to room temperature, distilled water was added. The produced solid was filtered under reduced pressure and washed with aqueous NaOH solution. Compound **2-2** (4.0 g, 11.7 mmol, 43.5 %) was obtained by column separation.

### Preparation of Compound 2-3

Compound **2-2** (2.0 g, 4.1 mmol), phenylboronic acid (1.3 g, 10.3 mmol) and tetrakis palladium(0) triphenylphosphine (Pd(PPh₃)₄) (0.6 g, 0.4 mmol) were dissolved in toluene (100 mL) and ethanol (50 mL). After adding 2 M aqueous sodium carbonate solution (50 mL), the mixture was stirred at 120 °C for 4 hours under reflux. After cooling to 25 °C, distilled water (200 mL) was added to terminate the reaction, followed by extraction with ethyl acetate (150 mL) and drying under reduced pressure. Compound **2-3** (1.6 g, 3.3 mmol) was obtained by column chromatography.

### Preparation of Compound 2-4

2-Bromonaphthalene (7.2 g, 35.2 mmol) was dissolved in THF (100 mL) and n-butyllithium (14.6 mmol, 2.5M in hexane) was slowly added at -78 °C. After stirring for an hour, Compound **2-3** (4.0 g, 11.7 mmol) was added at -78 °C. After stirring for 6 hours at room temperature, distilled water was added. After extracting with MC, followed by drying with MgSO₄, Compound **2-4** (7.9 g, 11.7 mmol) was obtained by distillation under reduced pressure.

### Preparation of Compound 180

Compound **2-4** (7.9 g, 11.7 mmol), KI (5.5 g, 33.5 mmol) and NaH₂PO₂H₂O (7.1 g, 69.0 mmol) were mixed with acetic acid (100 mL) and stirred under reflux. 6 hours later, after cooling to room temperature, distilled water was added and the produced solid was filtered under reduced pressure. The solid was neutralized by washing with aqueous NaOH solution. Compound **180** (3 g, 5.3mmol, 63.9%) was obtained by column separation.

### Preparation Example 3: Preparation of Compound 444

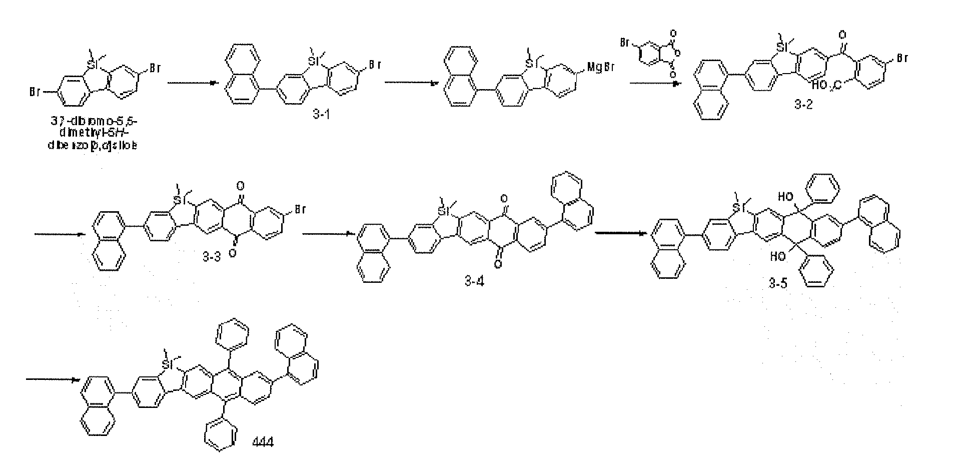

### Preparation of Compound 3-1

3,7-Dibromo-5,5-dimethyl-5H-dibenzo[b,d]silole (2.0 g, 4.1 mmol), 1-naphthylboronic acid (1.3 g, 10.3 mmol) and tetrakis palladium(0) triphenylphosphine (Pd(PPh₃)₄) (0.6 g, 0.4 mmol) were dissolved in toluene (100 mL) and ethanol (50 mL). After adding 2 M aqueous sodium carbonate solution (50 mL), the mixture was stirred at 120 °C for 4 hours under reflux.
After cooling to 25 °C, distilled water (200 mL) was added to terminate the reaction, followed by extraction with ethyl acetate (150 mL) and drying under reduced pressure. Compound **3-1** (1.6 g, 3.3 mmol) was obtained by column chromatography.

### Preparation of Compound 3-2

Mg (1.1 g, 44.9 mmol) and I₂ (1.7 g, 6.9 mmol) were mixed with THF (70 mL) and stirred under reflux. One hour later, after cooling to room temperature, Compound **3-1** (10.0 g, 24.1 mmol) dissolved in THF (500 mL) was added to the mixture solution of Mg and I₂. After stirring for an hour under reflux, the mixture was cooled to room temperature. 5-Bromoisobenzofuran-1,3-dione (5.1 g, 34.8 mmol) was added. After stirring at 50 °C for 5 hours, distilled water was added at room temperature. After extracting with MC, followed by drying with MgSO₄, Compound **3-2** (10.0 g, 27.9 mmol, 82.1 %) was obtained by distillation under reduced pressure and column separation.

### Preparation of Compound 3-3

Compound **3-2** (10.0 g, 27.9 mmol) was mixed with methanesulfonic acid (70 mL) and stirred for two hours at 100 °C. After cooling to room temperature, distilled water was added. The produced solid was filtered under reduced pressure and washed with aqueous NaOH solution. Compound **3-3** (4.0 g, 11.7 mmol, 43.5 %) was obtained by column separation.

### Preparation of Compound 3-4

Compound **3-3** (2.0 g, 4.1 mmol), 1-naphthylboronic acid (1.3 g, 10.3 mmol) and tetrakis palladium(0) triphenylphosphine (Pd(PPh₃)₄) (0.6 g, 0.4 mmol) were dissolved in toluene (100 mL) and ethanol (50 mL). 2 M aqueous sodium carbonate solution (50 mL) was added and the mixture was stirred at 120 °C for 4 hours under reflux. After cooling to 25 °C, distilled water (200 mL) was added to terminate the reaction, followed by extraction with ethyl acetate (150 mL) and drying under reduced pressure. Compound **3-4** (1.6 g, 3.3 mmol) was obtained by column chromatography.

### Preparation of Compound 3-5

Bromobenzene (7.2 g, 35.2 mmol) was dissolved in THF (100 mL) and n-butyllithium (14.6 mmol, 2.5M in hexane) was slowly added at -78 °C. After stirring for an hour, Compound **3-4** (4.0 g, 11.7 mmol) was added at -78 °C. After stirring for 6 hours at room temperature, distilled water was added. After extracting with MC, followed by drying with MgSO₄, Compound **3-5** (8.8 g, 11.7 mmol) was obtained by distillation under reduced pressure.

### Preparation of Compound 444

Compound **3-5** (8.8 g, 11.7 mmol), KI (5.5 g, 33.5 mmol) and NaH₂PO₂H₂O (7.1 g, 69.0 mmol) were mixed with acetic acid (100 mL) and stirred under reflux. 6 hours later, after cooling to room temperature, distilled water was added and the produced solid was filtered under reduced pressure. The solid was neutralized by washing with aqueous NaOH solution. Compound **444** (3.0 g, 5.3 mmol, 63.9 %) was obtained by column separation.

### Preparation Example 4: Preparation of Compound 502

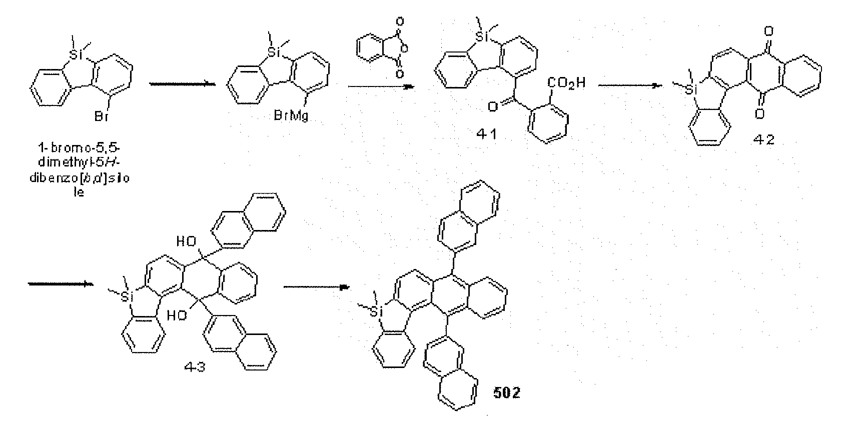

### Preparation of Compound 4-1

Mg (1.1 g, 44.9 mmol) and I₂ (1.7 g, 6.9 mmol) were mixed with THF (70 mL) and stirred under reflux. One hour later, after cooling to room temperature, 1-bromo-5,5-dimethyl-5H-dibenzo[b,d]silole (10.0 g, 34.6 mmol) dissolved in THF (500 mL) was added to the mixture solution of Mg and I₂. After stirring for an hour under reflux, the mixture was cooled to room temperature. Phthalic anhydride (5.1 g, 34.6 mmol) was added. After stirring at 50 °C for 5 hours, distilled water was added at room temperature. After extracting with MC, followed by drying with MgSO₄, Compound **4-1** (10.0 g, 27.9 mmol, 82.0 %) was obtained by distillation under reduced pressure and column separation.

### Preparation of Compound 4-2

Compound **4-1** (10.0 g, 27.9 mmol) was mixed with methanesulfonic acid (70 mL) and stirred for two hours at 100 °C. After cooling to room temperature, distilled water was added. The produced solid was filtered under reduced pressure and washed with aqueous NaOH solution. Compound **4-2** (4.0 g, 11.7 mmol, 43.5 %) was obtained by column separation.

### Preparation of Compound 4-3

2-Bromonaphthalene (7.2 g, 35.2 mmol) was dissolved in THF (100 mL) and n-butyllithium (14.6 mmol, 2.5M in hexane) was slowly added at -78 °C. After stirring for an hour, Compound **4-2** (4 g, 11.7 mmol) was added at -78 °C. After stirring for 6 hours at room temperature, distilled water was added. After extracting with MC, followed by drying with MgSO₄, Compound **4-3** (7.0 g, 11.7 mmol, 100 %) was obtained by distillation under reduced pressure.

### Preparation of Compound 502

Compound **4-3** (7.0 g, 11.7 mmol), KI (5.5 g, 33.5 mmol) and NaH₂PO₂H₂O (7.1 g, 69.0 mmol) were mixed with acetic acid (100 mL) and stirred under reflux. 6 hours later, after cooling to room temperature, distilled water was added and the produced solid was filtered under reduced pressure.
The solid was neutralized by washing with aqueous NaOH solution. Compound **502** (3.0 g, 5.3 mmol, 63.9 %) was obtained by column separation.

### Preparation Example 5: Preparation of Compound 517

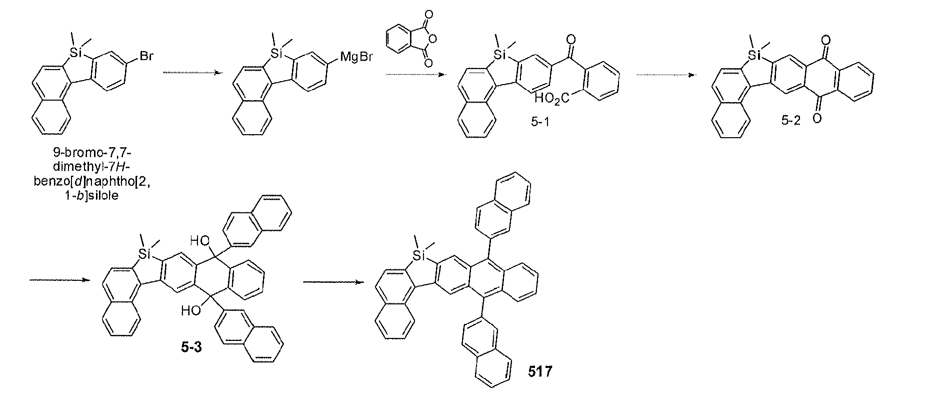

### Preparation of Compound 5-1

Mg (1.1 g, 44.9 mmol) and I₂ (1.7 g, 6.9 mmol) were mixed with THF (70 mL) and stirred under reflux. One hour later, after cooling to room temperature, 9-bromo-7,7-dimethyl-7H-benzo[d]naphtho[2,1-b]silole (10.0 g, 29.5 mmol) dissolved in THF (500 mL) was added to the mixture solution of Mg and I₂.
After stirring for an hour under reflux, the mixture was cooled to room temperature. Phthalic anhydride (5.1 g, 34.8 mmol) was added. After stirring at 50 °C for 5 hours, distilled water was added at room temperature. After extracting with MC, followed by drying with MgSO₄, Compound **5-1** (10.0 g, 27.9 mmol, 82.1 %) was obtained by distillation under reduced pressure and column separation.

### Preparation of Compound 5-2

Compound **5-1** (10.0 g, 27.9 mmol) was mixed with methanesulfonic acid (70 mL) and stirred for two hours at 100 °C. After cooling to room temperature, distilled water was added. The produced solid was filtered under reduced pressure and washed with aqueous NaOH solution. Compound **5-2** (4.0 g, 11.7 mmol, 43.5 %) was obtained by column separation.

### Preparation of Compound 5-3

2-Bromonaphthalene (7.2 g, 35.2 mmol) was dissolved in THF (100 mL) and n-butyllithium (14.6 mmol, 2.5M in hexane) was slowly added at 78 °C. After stirring for an hour, Compound **5-2** (4.0 g, 11.7 mmol) was added at -78 °C. After stirring for 6 hours at room temperature, distilled water was added. After extracting with MC, followed by drying with MgSO₄, Compound **5-3** (7.6 g, 11.7 mmol, 100 %) was obtained by distillation under reduced pressure.

### Preparation of Compound 517

Compound **5-3** (7.6 g, 11.7 mmol), KI (5.5 g, 33.5 mmol) and NaH₂PO₂H₂O (7.1 g, 69.0 mmol) were mixed with acetic acid (100 mL) and stirred under reflux. 6 hours later, after cooling to room temperature, distilled water was added and the produced solid was filtered under reduced pressure. The solid was neutralized by washing with aqueous NaOH solution. Compound **517** (3.0 g, 5.3 mmol, 63.9 %) was obtained by column separation.

### Preparation Example 6: Preparation of Compound 534

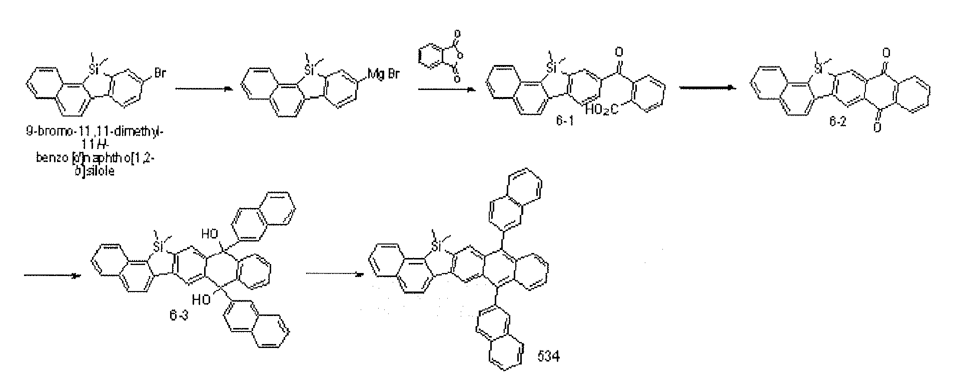

### Preparation of Compound 6-1

Mg (1.1 g, 44.9 mmol) and I₂ (1.7 g, 6.9 mmol) were mixed with THF (70 mL) and stirred under reflux. One hour later, after cooling to room temperature, 9-bromo-11,11-dimethyl-11H-benzo[d]naphtho[1,2-b]silole (10.0 g, 29.5 mmol) dissolved in THF (500 mL) was added to the mixture solution of Mg and I₂. After stirring for an hour under reflux, the mixture was cooled to room temperature. Phthalic anhydride (5.1 g, 34.6 mmol) was added. After stirring at 50 °C for 5 hours, distilled water was added at room temperature. After extracting with MC, followed by drying with MgSO₄, Compound **6-1** (10.0 g, 27.9 mmol, 82.1 %) was obtained by distillation under reduced pressure and column separation.

### Preparation of Compound 6-2

Compound **6-1** (10.0 g, 27.9 mmol) was mixed with methanesulfonic acid (70 mL) and stirred for two hours at 100 °C. After cooling to room temperature, distilled water was added. The produced solid was filtered under reduced pressure and washed with aqueous NaOH solution. Compound **6-3** (4.0 g, 11.7 mmol, 43.5 %) was obtained by column separation.

### Preparation of Compound 6-3

2-Bromonaphthalene (7.2 g, 35.2 mmol) was dissolved in THF (100 mL) and n-butyllithium (14.6 mmol, 2.5M in hexane) was slowly added at -78 °C. After stirring for an hour, Compound **6-2** (4.0 g, 11.7 mmol) was added at -78 °C. After stirring for 6 hours at room temperature, distilled water was added. After extracting with MC, followed by drying with MgSO₄, Compound **6-3** (7.6 g, 11.7 mmol, 100 %) was obtained by distillation under reduced pressure.

### Preparation of Compound 534

Compound **6-4** (7.6 g, 11.7 mmol), KI (5.5 g, 33.5 mmol) and NaH₂PO₂H₂O (7.1 g, 69.0 mmol) were mixed with acetic acid (100 mL) and stirred under reflux. 6 hours later, after cooling to room temperature, distilled water was added and the produced solid was filtered under reduced pressure. The solid was neutralized by washing with aqueous NaOH solution. Compound **534** (3.0 g, 5.3 mmol, 63.9 %) was obtained by column separation.

### Preparation Example 7: Preparation of Compound 538

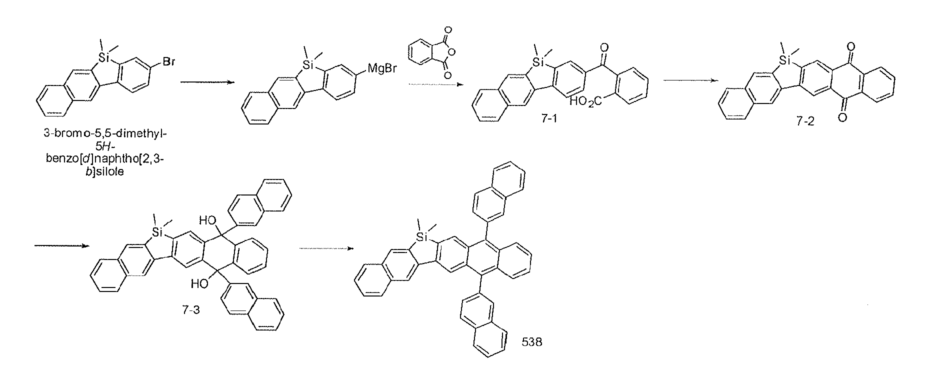

### Preparation of Compound 7-1

Mg (1.1 g, 44.9 mmol) and I₂ (1.7 g, 6.9 mmol) were mixed with THF (70 mL) and stirred under reflux. One hour later, after cooling to room temperature, 3-bromo-5,5-dimethyl-5H-benzo[d]naphtho[2,3-b]silole (10.0 g, 29.5 mmol) dissolved in THF (500 mL) was the mixture solution of Mg and I₂. After stirring for an hour under reflux, the mixture was cooled to room temperature. Phthalic anhydride (5.1 g, 34.6 mmol) was added. After stirring at 50 °C for 5 hours, distilled water was added at room temperature. After extracting with MC, followed by drying with MgSO₄, Compound **7-1** (10.0 g, 27.9 mmol, 82.1 %) was obtained by distillation under reduced pressure and column separation.

### Preparation of Compound 7-2

Compound **7-1** (10.0 g, 27.9 mmol) was mixed with methanesulfonic acid (70 mL) and stirred for two hours at 100 °C. After cooling to room temperature, distilled water was added. The produced solid was filtered under reduced pressure and washed with aqueous NaOH solution. Compound **7-2** (4.0 g, 11.7 mmol, 43.5 %) was obtained by column separation.

### Preparation of Compound 7-3

2-Bromonaphthalene (7.2 g, 35.2 mmol) was dissolved in THF (100 mL) and n-butyllithium (14.6 mmol, 2.5M in hexane) was slowly added at -78 °C.
After stirring for an hour, Compound **7-2** (4.0 g, 11.7 mmol) was added at -78 °C.
After stirring for 6 hours at room temperature, distilled water was added. After extracting with MC, followed by drying with MgSO₄, Compound **7-3** (7.6 g, 11.7 mmol, 100 %) was obtained by distillation under reduced pressure.

### Preparation of Compound 538

Compound **7-3** (7.6 g, 11.7 mmol), KI (5.5 g, 33.5 mmol) and NaH₂PO₂H₂O (7.1 g, 69.0 mmol) were mixed with acetic acid (100 mL) and stirred under reflux. 6 hours later, after cooling to room temperature, distilled water was added and the produced solid was filtered under reduced pressure.
The solid was neutralized by washing with aqueous NaOH solution. Compound **538** (3.0 g, 5.3 mmol, 63.9 %) was obtained by column separation.

### Preparation Example 8: Preparation of Compound 545

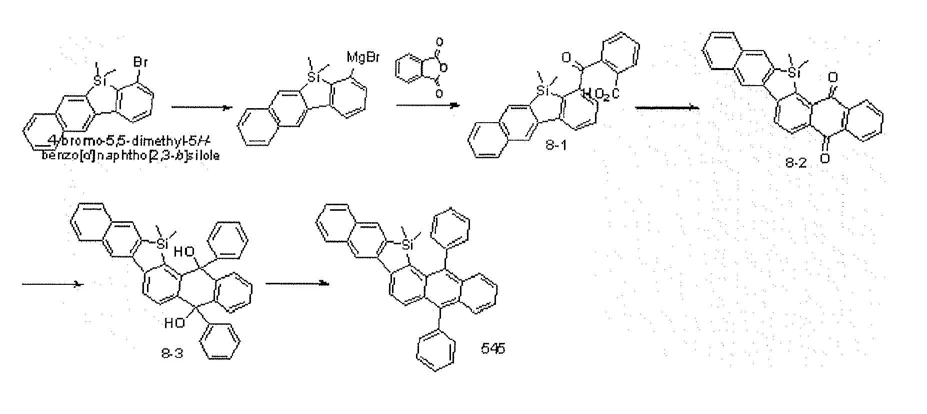

### Preparation of Compound 8-1

Mg (1.1 g, 44.9 mmol) and I₂ (1.7 g, 6.9 mmol) were mixed with THF (70 mL) and stirred under reflux. One hour later, after cooling to room temperature, 4-bromo-5,5-dimethyl-5H-benzo[d]naphtho[2,3-b]silole (10.0 g, 29.5 mmol) dissolved in THF (500 mL) was the mixture solution of Mg and I₂. After stirring for an hour under reflux, the mixture was cooled to room temperature. Phthalic anhydride (5.1 g, 34.8 mmol) was added. After stirring at 50 °C for 5 hours, distilled water was added at room temperature. After extracting with MC, followed by drying with MgSO₄, Compound **8-1** (10.0 g, 27.9 mmol, 82.1 %) was obtained by distillation under reduced pressure and column separation.

### Preparation of Compound 8-2

Compound **8-1** (10.0 g, 27.9 mmol) was mixed with methanesulfonic acid (70 mL) and stirred for two hours at 100 °C. After cooling to room temperature, distilled water was added. The produced solid was filtered under reduced pressure and washed with aqueous NaOH solution. Compound **8-2** (4.0 g, 11.7 mmol, 43.5 %) was obtained by column separation.

### Preparation of Compound 8-3

2-Bromonaphthalene (7.2 g, 35.2 mmol) was dissolved in THF (100 mL) and n-butyllithium (14.6 mmol, 2.5M in hexane) was slowly added at -78 °C. After stirring for an hour, Compound **8-2** (4.0 g, 11.7 mmol) was added at -78 °C. After stirring for 6 hours at room temperature, distilled water was added. After extracting with MC, followed by drying with MgSO₄, Compound **8-3** (7.6 g, 11.7 mmol, 100 %) was obtained by distillation under reduced pressure.

### Preparation of Compound 545

Compound **8-3** (7.6 g, 11.7 mmol), KI (5.5 g, 33.5 mmol) and NaH₂PO₂H₂O (7.1 g, 69.0 mmol) were mixed with acetic acid (100 mL) and stirred under reflux. 6 hours later, after cooling to room temperature, distilled water was added and the produced solid was filtered under reduced pressure. The solid was neutralized by washing with aqueous NaOH solution. Compound **545** (3.0 g, 5.3 mmol, 63.9 %) was obtained by column separation.

### Preparation Example 9: Preparation of Compound 582

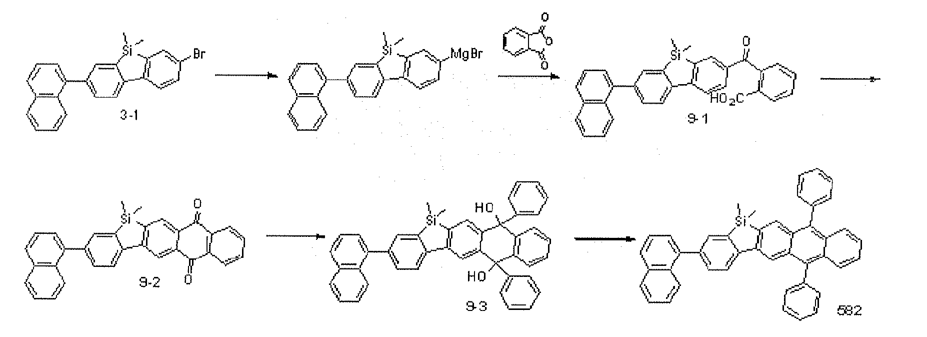

### Preparation of Compound 9-1

Mg (1.1 g, 44.9 mmol) and I₂ (1.7 g, 6.9 mmol) were mixed with THF (70 mL) and stirred under reflux. One hour later, after cooling to room temperature, Compound **3-1** (10.0 g, 24.1 mmol) dissolved in THF (500 mL) was added to the mixture solution of Mg and I₂. After stirring for an hour under reflux, the mixture was cooled to room temperature. Phthalic anhydride (5.1 g, 34.8 mmol) was added. After stirring at 50 °C for 5 hours, distilled water was added at room temperature. After extracting with MC, followed by drying with MgSO₄, Compound **9-1** (10.0 g, 27.9 mmol, 82.1%) was obtained by distillation under reduced pressure and column separation.

### Preparation of Compound 9-2

Compound **9-1** (10.0 g, 27.9 mmol) was mixed with methanesulfonic acid (70 mL) and stirred for two hours at 100 °C. After cooling to room temperature, distilled water was added. The produced solid was filtered under reduced pressure and washed with aqueous NaOH solution. Compound **9-2** (4.0 g, 11.7 mmol, 43.5 %) was obtained by column separation.

### Preparation of Compound 9-3

Bromobenzene (7.2 g, 35.2 mmol) was dissolved in THF (100 mL) and n-butyllithium (14.6 mmol, 2.5M in hexane) was slowly added at -78 °C. After stirring for an hour, Compound **9-2** (4.0 g, 11.7 mmol) was added at -78 °C. After stirring for 6 hours at room temperature, distilled water was added. After extracting with MC, followed by drying with MgSO₄, Compound **9-3** (7.3 g, 11.7 mmol, 100 %) was obtained by distillation under reduced pressure.

### Preparation of Compound 582

Compound **9-3** (7.3 g, 11.7 mmol), KI (5.5 g, 33.5 mmol) and NaH₂PO₂H₂O (7.1 g, 69.0 mmol) were mixed with acetic acid (100 mL) and stirred under reflux. 6 hours later, after cooling to room temperature, distilled water was added and the produced solid was filtered under reduced pressure. The solid was neutralized by washing with aqueous NaOH solution. Compound **582** (3.0 g, 5.3 mmol, 63.9 %) was obtained by column separation.

Organic electroluminescent compounds (Compounds **1** to **665)** were prepared according to the method of Preparation Examples 1 to 9. Table 1 shows ¹H NMR and MS/FAB data of the prepared organic electroluminescent compounds.

**[Table 1]**

| compound | ¹H NMR(CDCl₃, 200 MHz) | MS/FAB | |
|---|---|---|---|
| | | found | calculated |
| 1 | δ = 0.66(6H, s), 7.33∼7.41 (5H, m), 7.51∼7.52(9H, m), 7.61(1H, m), 7.89∼7.91(3H, m), 8.23(1H, s), 8.25(1H, s) | 462.66 | 462.18 |
| 2 | δ = 0.66(6H, s), 7.33∼7.39(3H, m), 7.52∼7.55(5H, m), 7.61(3H, m), 7.89∼7.91(3H, m), 8.04∼8.08(4H, m), 8.23(1H, s), 8.25(1H, s), 8.42(2H, m), 8.55(2H, m) | 562.77 | 562.21 |
| 6 | δ = 0.66(6H, s), 7.33∼7.39(3H, m), 7.52(1H, m), 7.58∼7.61(7H, m), 7.73(2H, m), 7.89∼7.92(5H, m), 8(4H, m), 8.23(1H, s), 8.25(1H, s) | 562.77 | 562.21 |
| 7 | δ = 0.66(6H, s), 7,33∼7.39(3H, m), 7.52(1H, m), 7.61(1H, m), 7.82∼7.93(13H, m), 8.12(4H, m), 8.23(1H, s), 8.25(1H, s), 8.93(4H, m) | 662.89 | 662.24 |
| 11 | δ = 0.66(6H, s), 1.35(18H, s), 7.33∼7.39(11H, m), 7.52(1H, m), 7.61 (1H, m), 7.89∼7.91(3H, m), 8.23(1H, s), 8.25(1H, s) | 574.87 | 574.31 |
| 14 | δ = 0.66(6H, s), 1.72(12H, s), 7.28∼7.39(7H, m), 7.52∼7.55(3H, m), 7.61∼7.63(3H, m), 7.77(2H, m), 7.87∼7.93(7H, m), 8.23(1H, s), 8.25(1H, s) | 694.98 | 694.31 |
| 20 | δ = 0.66(6H, s), 7.33∼7.41(7H, m), 7.51∼7.52(17H, m), 7.61∼7.66(7H, m), 7.89∼7.91(3H, m), 8.23(1H, s), 8.25(1H, s) | 767.04 | 766.31 |
| 23 | δ = 0.66(6H, s), 7.33∼7.39(3H, m), 7.5∼7.52(5H, m), 7.61(1H, m), 7.86∼7.91(5H, m), 7.98∼8(6H, m), 8.23(1H, s), 8.25(1H, s), 8.45(2H, m) | 674.95 | 674.16 |
| 25 | δ = 0.66(6H, s), 7.25(2H, m), 7.33∼7.39(5H, m), 7.45∼7.52(7H, m), 7.58∼7.61(5H, m), 7.69(2H, m), 7.77(2H, m), 7.87∼7.94(7H, m), 8.23(1H, s), 8.25(1H, s), 8.55(2H, m) | 793.04 | 792.30 |
| 28 | δ = 0.66(6H, s), 7.3∼7.39(11H, m), 7.52(1H, m), 7.61(1H, m), 7.89∼7.91(3H, m), 8.23(1H, s), 8.25(1H, s) | 498.64 | 498.16 |
| 34 | δ = 0.66(6H, s), 1.72(12H, s), 7.28∼7.39(9H, m), 7.51∼7.55(5H, m), 7.61∼7.63(3H, m), 7.87∼7.91(5H, m), 8.23(1H, s), 8.25(1H, s) | 694.98 | 694.31 |
| 43 | δ = 0.66(6H, s), 7.25∼7.33(7H, m), 7.4(2H, m), 7.5∼7.52(3H, m), 7.61∼7.63(3H, m), 7.89∼7.94(5H, m), 8.12(2H, m), 8.2(1H, s), 8.3(1H, s), 8.55(2H, m) | 640.85 | 640.23 |
| 47 | δ = 0.66(6H, s), 6.63(4H, m), 6.81(4H, m), 6.99∼7.05(8H, m), 7.25(4H, m), 7.33∼7.39(3H, m), 7.52(1H, m), 7.61(1H, m), 7.89∼7.91(3H, m), 8.16(1H, s), 8.18(1H, s) | 692.92 | 692.26 |
| 50 | δ = 0.66(6H, s), 7.33∼7,42(9H, m), 7.48∼7.52(3H, m), 7.61(1H, m), 7.74∼7.91(13H, m), 8.03∼8.12(6H, m), 8.23(1H, s), 8.25(1H, s) | 826.97 | 826.24 |
| 55 | δ = 0.66(6H, s), 7.25(8H, m), 7.33∼7.39(3H, m), 7.52(1H, m), 7.58∼7.61(7H, m), 7.73(2H, m), 7.89∼7.92(5H, m), 8(4H, m), 8.23(1H, s), 8.25(1H, s) | 714.97 | 714.27 |
| 57 | δ = 0.66(6H, s), 7.33∼7.39(3H, m), 7.48∼7.61(14H, m), 7.7∼7.73(4H, m), 7.89∼7.92(5H, m), 8(4H, m), 8.23(1H, s), 8.25(1H, s) | 714.97 | 714.27 |
| 61 | δ = 0.66(6H, s), 1.72(12H, s), 7,28∼7.39(7H, m), 7.48∼7.63(12H, m), 7.7(2H, m), 7.77(2H, m), 7.87∼7.93(7H, m), 8.23(1H. s), 8.25(1H, s) | 847.17 | 846.37 |
| 69 | δ = 0.66(6H, s), 7.25(8H, m), 7.33∼7.39(3H, m), 7.52(1H, m), 7.61(1H, m), 7.82∼7.93(13H, m), 8.12(4H, m), 8.23(1H, s), 8.25(1H, s), 8.93(4H, m) | 815.08 | 814.31 |
| 72 | δ = 0.66(6H, s), 7.33∼7.41(4H, m), 7.51∼7.55(7H, m), 7.61(2H, m), 7.89∼7.91(3H, m), 8.04∼8.08(2H, m), 8.23(1H, s), 8.25(1H, s), 8.42(1H, m), 8.55(1H, m) | 512.71 | 512.20 |
| 73 | δ = 0.66(6H, s), 7.33∼7.41(4H, m), 7.51∼7.52(5H, m), 7.58∼7.61(4H, m), 7.73(1H, m), 7.89∼7.92(4H, m), 8(2H, m), 8.23(1H, s), 8.25(1H, s) | 512.71 | 512.20 |
| 74 | δ = 0.66(6H, s), 1.72(6H, s), 7.28∼7.41(6H, m), 7.51∼7.55(6H, m), 7.61∼7.63(2H, m), 7.77(1H, m), 7.87∼7.93(5H, m), 8.23(1H, s), 8.25(1H, s) | 578.82 | 578.24 |
| 75 | δ = 0.66(6H, s), 7.33∼7.41(4H, m), 7.51∼7.52(5H, m), 7.61(1H, m), 7.82∼7.93(8H, m), 8.12(2H, m), 8.23(1H, s), 8.25(1H, s), 8.93(2H, m) | 562.77 | 562.21 |
| 77 | δ = 0.66(6H, s), 7.33∼7.41(6H, m), 7.51∼7.52(13H, m), 7.61∼7.66(4H, m), 7.89∼7.91(3H, m), 8.23(1H, s), 8.25(1H, s) | 614.85 | 614.24 |
| 79 | δ = 0.66(6H, s), 7.33∼7.41(5H, m), 7.48∼7.61(13H, m), 7.7(1H, m), 7.89∼7.91(3H, m), 8.23(1H, s), 8.25(1H, s) | 538.75 | 538.21 |
| 87 | δ = 0.66(6H, s), 7.33∼7.41(5H, m), 7.51∼7.55(9H, m), 7.61 (1H, m), 7.79(2H, m), 7.89∼7.91(3H, m), 8.01(2H, m), 8.23(1H, s), 8.25(1H, s), 8.55(2H, m) | 588.81 | 588.23 |
| 93 | δ = 0.66(6H, s), 7.33∼7.41(4H, m), 7.48∼7.61(12H, m), 7.7(1H, m), 7.89∼7.91(3H, m), 8.04∼8.08(2H, m), 8.23(1H, s), 8.25(1H, s), 8.42(1H, m), 8.55(1H, m) | 588.81 | 588.23 |
| 98 | δ = 0.66(6H, s), 1.72(6H, s), 7.28∼7.41(6H, m), 7.48∼7.63(11H, m), 7.7(1H, m), 7.77(1H, m), 7.87∼7.93(5H, m), 8.23(1H, s), 8.25(1H, s) | 654.91 | 654.27 |
| 104 | δ = 0.66(6H, s), 1.72(6H, s), 7.28∼7.44(7H, m), 7.51∼7.55(7H, m), 7.61(1H, m), 7.83∼7.91(5H, m), 8.23(1H, s), 8.25(1H, s) | 578.82 | 578.24 |
| 107 | δ = 0.66(6H, s), 7.33∼7.41(4H, m), 7.5∼7.52(7H, m), 7.61(1H, m), 7.86∼7.91(4H, m), 7.98∼8(3H, m), 18.23(1H, s), 8.25(1H, s), 8.45(1H, m) | 568.80 | 568.17 |
| 117 | δ = 0.66(6H, s), 7.33∼7.39(3H, m), 7.52∼7.61(8H, m), 7.73(1H, m), 7.89∼7.92(4H, m), 8∼8.08(4H, m), 8.23(1H, s), 8.25(1H, s), 8.42(1H, m), 8.55(1H, m) | 562.77 | 562.21 |
| 118 | δ = 0.66(6H, s), 1.72(6H, s), 7.28∼7.39(5H, m), 7.52∼7.55(4H, m), 7.61∼7.63(3H, m), 7.77(1H, 7.87∼7.93(5H, m), 8.04∼8.08(2H, m), 8.23(1H, s), 8.25(1H, s), 8.42(1H, m), 8.55(1H, m) | m), 628.87 | 628.26 |
| 120 | δ = 0.66(6H, s), 7.33∼7.39(3H, m), 7.52∼7.55(3H, m), 7.61(2H, m), 7.82∼7.93(8H, m), 8.04∼8.12(4H, m), 8.23(1H, s), 8.25(1H, s), 8.42(1H, m), 8.55(1H, m), 8.93(2H, m) | 612.83 | 612.23 |
| 121 | δ = 0.66(6H, s), 7.33∼7.41(5H, m), 7.51∼7.55(1H, m), 7.61∼7.66(5H, m), 7.89∼7.91(3H, m), 8.04∼8.08(2H, m), 8.23(1H, s), 8.25(1H, s), 8.42(1H, m), 8.55(1H, m) | 664.91 | 664.26 |
| 126 | δ = 0.66(6H, s), 7.33∼7.39(3H, m). 7.47∼7.61(10H, m), 7.73(1H, m), 7.85∼7.92(6H, m), 8∼8.08(4H, m), 8.23(1H, s), 8.25(1H, s), 8.42(1H, m), 8.55(1H, m) | 638.87 | 638.24 |
| 130 | δ = 0.66(6H, s), 7.33∼7.41(4H, m), 7.51∼7.61 (9H, m), 7.79(2H, m), 7.89∼7.91(3H, m), 8∼8.08(4H, m), 8.23(1H, s), 8.25(1H, s), 8.4∼8.42(3H, m), 8.55(1H, m) | 638.87 | 638.24 |
| 134 | δ = 0.66(6H, s), 2.34(6H, s), 7.31∼7.39(4H, m), 7.52∼7.61(7H, m), 7.89∼7.91(3H, m), 8.04∼8.08(2H, m), 8.23(1H, s), 8.25(1H, s), 8.42(1H, m), 8.55(1H, m) | 540.77 | 540.23 |
| 148 | δ = 0.66(6H, s), 7.21(1H, m), 7.33∼7.41(5H, m), 7.51∼7.55(7H, m), 7.61(2H, m), 7.76∼7.79(5H, m), 7.89∼7.91(4H, m), 8.04∼8.08(2H, m), 8.23(1H, s), 8.25(1H, s), 8.42(1H, m), 8.55(1H, m) | 664.91 | 664.26 |
| 151 | δ = 0.66(6H, s), 1.72(6H, s), 7.28∼7.39(5H, m), 7.52∼7.63(7H, m), 7.73∼7.77(2H, m), 7.87∼7.93(6H, m), 8(2H, m), 8.23(1H, s), 8.25(1H, s) | 628.87 | 628.26 |
| 153 | δ = 0.66(6H, s), 7.33∼7.39(3H, m), 7.52(1H, m), 7.58∼7.61(4H, m), 7.73(1H, m), 7.82∼7.93(9H, m), 8(2H, m), 8.12(2H, m), 8.23(1H, s), 8.25(1H, s), 8.93(2H, m) | 612.83 | 612.23 |
| 160 | δ = 0.66(6H, s), 7.25∼7.33(4H, m), 7.4(2H, m), 7.5∼7.52(2H, m), 7.58∼7.63(5H, m), 7.73(1H, m), 7.89∼8(7H, m), 8.12(1H, m), 8.2(1H, s), 8.3(1H, s), 8.55(1H, m) | 601.81 | 601.22 |
| 161 | δ = 0.66(6H, s), 7.33∼7.39(3H, m), 7.52(1H, m), 7.58∼7.61(4H, m), 7.73(1H, m), 7.82∼7.92(8H, m), 8∼8.04(3H, m), 8.12(2H, m), 8,18(1H, m), 8.23(1H, s), 8.25(1H, s), 8.93(2H, m), 9.15(1H, m) | 662.89 | 662.24 |
| 166 | δ = 0.66(6H, s), 1.72(6H, s), 7.28∼7.39(5H, m). 7.52∼7.63(7H, m), 7.73∼7.77(2H, m), 7.87∼7.93(6H, m), 8(2H, m), 8.23(1H, s), 8.25(1H, s) | 628.87 | 628.26 |
| 167 | δ = 0.66(6H, s), 1.72(6H, s), 7.28∼7.39(5H, m), 7.52-7.55(4H, m), 7.61∼7.63(3H, m), 7.77(1H, m), 7.87∼7.93(5H, m), 8.04∼8.08(2H, m), 8.23(1H, s), 8.25(1H, s), 8.42(1H, m), 8.55(1H, m) | 628.87 | 628.26 |
| 169 | δ = 0.66(6H, s), 1.72(6H, s), 7.28∼7.39(5H, m), 7.52∼7.55(2H, m), 7.61∼7.63(2H, m), 7.77∼7.93(11H, m), 8.12(2H, m), 8.23(1H, s), 8.25(1H, s), 8.93(2H, m) | 678.93 | 678.27 |
| 170 | δ = 0.66(6H, s), 1.72(6H, s), 2.34(6H, s), 7.28∼7.39(6H, m), 7.52∼7.63(6H, m), 7.77(1H, m), 7.87∼7.93(5H, m), 8.23(1H, s), 8.25(1H, s) | 606.87 | 606.27 |
| 175 | δ = 0.66(6H, s), 1.72(12H, s), 7.25∼7.39(11H, m), 7.52∼7.55(3H, m), 7.61∼7.63(3H, m), 7.77(2H, m), 7.87∼7.93(7H, m), 8.23(1H, s), 8.25(1H, s) | 771.07 | 770.34 |
| 176 | δ = 0.66(6H, s), 7.33(1H, m), 7.41(3H, m), 7.51∼7.52(13H, m), 7.61(2H, m), 7.89(1H, m), 7.97(1H, m), 8.13(1H, m), 8.23(1H, s), 8.25(1H, s) | 538.75 | 538.21 |
| 177 | δ = 0.66(6H, s), 7.33(1H, m), 7.41(1H, m), 7.51∼7.55(9H, m), 7.61(4H, m), 7.89(1H, m), 7.97(1H, m), 8.04∼8.13(5H, m), 8.23(1H, s), 8.25(1H, s), 8.42(2H, m), 8.55(2H, m) | 638.87 | 638.24 |
| 180 | δ = 0.66(6H, s), 7.33(1H, m), 7.41(1H, m), 7.51∼7.52(5H, m), 7.58∼7.61(8H, m), 7.73(2H, m), 7.89∼8(8H, m), 8.13(1H, m), 8.23(1H, s), 8.25(1H, s) | 638.87 | 638.24 |
| 181 | δ = 0.66(6H, s), 7.33(1H, m), 7.41(1H, m), 7.51∼7.52(5H, m), 7.61(2H, m), 7.82∼7.97(12H, m), 8.12∼8.13(5H, m), 8.23(1H, s), 8.25(1H, s), 8.93(4H, m) | 738.99 | 738.27 |
| 183 | δ = 0.66(6H, s), 2.34(12H, s), 7.31∼7.33(3H, m), 7.41(1H, m), 7.51∼7.52(5H, m), 7.6∼7.61(6H, m), 7.89(1H, m), 7.97(1H, m), 8.13(1H, m), 8.23(1H, s), 8.25(1H, s) | 594.86 | 594.27 |
| 187 | 6 = 0.66(6H, s), 7.33(1H, m), 7.52∼7.55(7H, m), 7.61 (5H, m), 7.89(1H, m), 7.97(1H, m), 8.04∼8.13(7H, m), 8.23(1H, s), 8.25(1H, s), 8.42(3H, m), 8.55(3H, m) | 688.93 | 688.26 |
| 191 | δ = 0.66(6H, s), 2.34(12H, s), 7.31∼7.33(3H, m), 7.52∼7.61(10H, m), 7.89(1H, m), 7.97(1H, m), 8.04∼8.13(3H, m), 8.23(1H, s), 8.25(1H, s), 8.42(1H, m), 8.55(1H, m) | 644.92 | 644.29 |
| 196 | δ = 0.66(6H, s), 7.33(1H, m), 7.41(2H, m), 7.51∼7.52(9H, m), 7.58∼7.61(5H, m), 7.73(1H, m), 7.89∼8(5H, m), 8.13(1H, m), 8.23(1H, s), 8.25(1H, s) | 588.81 | 588.23 |
| 197 | δ = 0.66(6H, s), 7.33(1H, m), 7.52∼7.61(12H, m), 7.73(1H, m), 7.89∼8.13(10H, m), 8.23(1H, s), 8.25(1H, s), 8.42(2H, m), 8.55(2H, m) | 688.93 | 688.26 |
| 201 | δ = 0.66(6H, s), 7.33(1H, m), 7.52(1H, m), 7.58∼7.61(5H, m), 7.73(1H, m), 7.82∼8(15H, m), 8.12∼8.13(5H, m), 8.23(1H, s), 8.25(1H, s), 8.93(4H, m) | 789.05 | 788.29 |
| 206 | δ = 0.66(6H, s), 1.72(6H, s), 7.28∼7.41(5H, m), 7.51∼7.55(10H, m), 7.61∼7.63(3H, m), 7.77(1H, m), 7.87∼7.97(4H, m), 8.13(1H, m), 8.23(1H, s), 8.25(1H, s) | 654.91 | 654.27 |
| 207 | δ = 0.66(6H, s), 1.72(6H, s), 7.28∼7.38(3H, m). 7.52∼7.55(6H, m), 7.61∼7.63(5H, m), 7.77(1H, m), 7.87∼7.97(4H, m), 8.04∼8.13(5H, m), 8.23(1H, s), 8.25(1H, s), 8.42(2H, m), 8.55(2H, m) | 755.03 | 754.31 |
| 208 | δ = 0.66(6H, s), 1.72(6H, s), 7.28∼7.38(3H, m), 7.52∼7.63(11H, m), 7.73∼7.77(3H, m), 7.87∼8(10H, m), 8.13(1H, m), 8.23(1H, s), 8.25(1H, s) | 755.03 | 754.31 |
| 214 | δ = 0.66(6H, s), 1.72(6H, s), 2.34(12H, s), 7.28∼7.38(5H, m), 7.52∼7.63(9H, m), 7.77(1H, m), 7.87∼7.97(4H, m), 8.13(1H, 8.23(1H, s), 8.25(1H, s) | 711.02 | 710.34 |
| 216 | δ = 0.66(6H, s), 1.35(18H, s), 7.33∼7.41(10H, m), 7.51∼7.52(5H, m), 7.61(2H, m), 7.89(1H, m), 7.97(1H, m), 8.13(1H, m), 8.23(1H, s), 8.25(1H, s) | 650.96 | 650.34 |
| 219 | δ = 0.66(6H, s), 7.25(8H, m), 7.33(1H, m), 7.41(3H, m), 7.51∼7.52(13H, m), 7.61(2H, m), 7.89(1H, m), 7.97(1H, m), 8.13(1H, m), 8.23(1H, s), 8.25(1H, s) | 690.94 | 690.27 |
| 223 | δ = 0.66(6H, s), 1.72(12H, s), 7.28∼7.38(5H, m), 7.52∼7.55(5H, m), 7.61∼7.63(5H, m), 7.77(2H, m), 7.87∼7.97(6H, m), 8.04∼8.13(3H, m), 8.23(1H, s), 8.25(1H, s), 8.42(1H, m), 8.55(1H, m) | 821.13 | 820.35 |
| 225 | δ = 0.66(6H, s), 1.35(18H, s), 7.33∼7.38(9H, m), 7.52(1H, m), 7.58∼7.61(5H, m), 7.73(1H, m), 7.89∼8(5H, m), 8.13(1H, m), 8.23(1H, s), 8.25(1H, s) | 701.02 | 700.35 |
| 230 | 6 = 0.66(6H, s), 1.72(6H, s), 7.28∼7.38(3H, m), 7.52∼7.63(7H, m), 7.77∼7.8(5H, m), 7.87∼7.97(8H, m), 8.1∼8.13(5H, m), 8.23(1H, s), 8.25(1H, s), 8.42(4H, m) | 903.19 | 902.34 |
| 235 | δ = 0.66(6H, s), 7.25(8H, m), 7.33(1H, m), 7.41(1H, m), 7.51∼7.52(5H, m), 7.58∼7.61(8H, m), 7.73(2H, m), 7.89∼8(8H, m), 8.13(1H, m), 8.23(1H, s), 8.25(1H, s) | 791.06 | 790.31 |
| 240 | δ = 0.66(6H, s), 7.33(1H, m), 7.48∼7.61(18H, m), 7.7(2H, m), 7.89(1H, m), 7.97(1H, m), 8.04∼8.13(7H, m), 8.23(1H, s), 8.25(1H, s), 8.42(3H, m), 8.55(3H, m) | 841.12 | 840.32 |
| 245 | δ = 0.66(6H, s), 7.33(1H, m), 7.48∼7.61(18H, m), 7.7∼7.73(5H, m), 7.89∼8(11H, m), 8.13(1H, m), 8.23(1H, s), 8.25(1H, s) | 841.12 | 840.32 |
| 246 | δ = 0.66(6H, s), 1.72(6H, s), 7.28∼7.38(3H, m). 7.52∼7.55(2H, m). 7.61∼7.63(3H, m), 7.77∼7.97(13H, m), 8.04(2H, m), 8.12∼8.1817H, m), 8.23(1H, s), 8.25(1H, s), 8.93(4H, m), 9.15(2H, m) | 955.26 | 954.37 |
| 252 | δ = 0.66(6H, s), 1.72(6H, s), 7.28∼7.41(5H, m), 7.51∼7.55(10H, m), 7.61∼7.63(3H, m), 7.77(1H, m), 7.87∼7.97(4H, m), 8.13(1H, m), 8.23(1H, s), 8.25(1H, s) | 654.91 | 654.27 |
| 256 | δ = 0.66(6H, s), 7.33(1H, m), 7.41(1H, m), 7.51∼7.52(5H, m), 7.58∼7.61(8H, m), 7.73(2H, m), 7.89∼8(8H, m), 8.13(1H, m), 8.23(1H, s), 8.25(1H, s) | 638.87 | 638.24 |
| 259 | δ = 0.66(6H, s), 7.33(1H, m), 7.41(1H, m), 7.51∼7.55(9H, m), 7.61(4H, m), 7.89(1H, m), 7.97(1H, m), 8.04∼8.13(5H, m), 8.23(1H, s), 8.25(1H, s), 8.42(2H, m), 8.55(2H, m) | 638.87 | 638.24 |
| 266 | δ = 0.66(6H, s), 1.72(6H, s), 7.25∼7.41(9H, m), 7.51∼7.55(10H, m), 7.61∼7.63(3H, m), 7.77(1H, m), 7.87∼7.97(4H, m), 8.13(1H, m), 8.23(1H, s), 8.25(1H, s) | 731.01 | 730.31 |
| 267 | δ = 0.66(6H, s), 7.33(1H, m), 7.41(4H, m), 7.51∼7.52(17H, m), 7.61∼7.66(5H, m), 7.89(1H, m), 7.97(1H, m), 8.13(1H, m), 8.23(1H, s), 8.25(1H, s) | 690.94 | 690.27 |
| 278 | δ = 0.66(6H, s), 7.21(1H, m), 7.33(1H, m), 7.41(3H, m), 7.51-7.55(11H, m), 7.61(3H, m), 7.76∼7.79(5H, m), 7.89∼7.97(3H, m), 8.04∼8.13(3H, m), 8.23(1H, s), 8.25(1H, s), 8.42(1H, m), 8.55(1H, m) | 741.00 | 740.29 |
| 286 | δ = 0.66(6H, s), 7.25(4H, m), 7.33(1H, m), 7.41(1H, m), 7.51∼7.55(9H, m), 7.61(4H, m), 7.89(1H, m), 7.97(1H, m), 8.04∼8.13(5H, m), 8.23(1H, s), 8.25(1H, s), 8.42(2H, m), 8.55(2H, m) | 714.97 | 714.27 |
| 287 | δ = 0.66(6H, s), 7.33(1H, m), 7.41(3H, m), 7.51∼7.52(13H, m), 7.58∼7.66(8H, m), 7.73(1H, m), 7.89∼8(5H, m), 8.13(1H, m), 8.23(1H, s), 8.25(1H, s) | 741.00 | 740.29 |
| 300 | δ = 0.66(6H, s), 1.72(6H, s), 7.28∼7.41(5H, m), 7.48∼7.63(16H, m), 7.7(1H, m), 7.77(1H, m), 7.87∼7.97(4H, m), 8.13(1H, m), 8.23(1H, s), 8.25(1H, s) | 731.01 | 730.31 |
| 307 | δ = 0.66(6H, s), 7.25(4H, m), 7.33(1H, m), 7.41(2H, m), 7.51∼7.52(9H, m), 7.58∼7.61(5H, m), 7.73(1H, m), 7.89∼8(5H, m), 8.13(1H, m), 8.23(1H, s), 8.25(1H, s) | 664.91 | 664.26 |
| 312 | δ = 0.66(6H, s), 7.33(1H, m), 7.41(2H, m), 7.51∼7.55(11H, m), 7.61(3H, m), 7.79(2H, m), 7.89(1H, m), 7.97∼8.13(6H, m), 8.23(1H, s), 8.25(1H, s), 8.42(1H, m), 8.55(3H, m) | 714.97 | 714.27 |
| 320 | δ = 0.66(6H, s), 7.33(1H, m), 7.41(2H, m), 7.51∼7.52(9H, m), 7.58∼7.61(7H, m), 7.73(3H, m), 7.89∼8(7H, m), 8.13(1H, m), 8.23(1H, s), 8.25(1H, s) | 714.97 | 714.27 |
| 326 | δ = 0.66(6H, s), 1.72(12H, s), 7.28∼7.41(5H, m), 17.51∼7.55(10H, m), 7.61∼7.63(5H, m), 7.77(3H, m), 7.87∼7.97(6H, m), 8.13(1H, m), 8.23(1H, s), 8.25(1H, s) | 847.17 | 846.37 |
| 332 | δ = 0.66(6H, s), 7.33(1H, m), 7.41(2H, m), 7.48∼7.61(17H, m), 7.7∼7.73(2H, m), 7.89∼8(5H, m), 8.13(1H, m), 8.23(1H, s), 8.25(1H, s) | 664.91 | 664.26 |
| 333 | δ = 0.66(6H, s), 1.35(9H, s), 7.33∼7.41(6H, m), 7.51∼7.55(7H, m), 7.61(3H, m), 7.89(1H, m), 7.97(1H, m), 8.04∼8.13(3H, m), 8.23(1H, s), 8.25(1H, s), 8.42(1H, m), 8.55(1H, m) | 644.92 | 644.29 |
| 343 | δ = 0.66(6H, s), 7.33(1H, m), 7.41∼7.52(8H, m), 7.58∼7,61(8H, m), 7.73(2H, m), 7.85∼8(10H, m), 8.13(1H, m), 8.23(1H, s), 8.25(1H, s) | 714.97 | 714.27 |
| 345 | δ = 0.66(6H, s), 1.35(9H, s), 1.72(6H, s), 7.28∼7.41(8H, m), 7.51∼7.55(6H, m), 7.61∼7.63(3H, m), 7.77(1H, m), 7.87∼7.97(4H, m), 8.13(1H, m), 8.23(1H, s), 8.25(1H, s) | 711.02 | 710.34 |
| 351 | δ = 0.66(6H, s), 7.33(1H, m), 7.41(1H, m), 7.51∼7.61(11H, m), 7.79∼7.8(2H, m), 7.89∼7.97(4H, m), 8.04∼8.13(5H, m), 8.23(1H, s), 8.25(1H, s), 8.42(3H, m), 8.55(1H, m) | 712.95 | 712.26 |
| 352 | δ = 0.66(6H, s), 7.33(1H, m), 7.41(1H, m), 7.51∼7.55(7H, m), 7.61 (3H, m), 7.82∼7.97(7H, m), 8.04∼8.13(5H, m), 8.23(1H, s), 8.25(1H, s), 8.42(1H, m), 8.55(1H, m), 8.93(2H, m) | 688.93 | 688.26 |
| 357 | δ = 0.66(6H, s), 7.33(1H, m), 7.52∼7.61(10H, m), 7.79∼7.8(2H, m), 7.89∼7.97(4H, m), 8.04∼8.13(7H, m), 8.23(1H, s), 8.25(1H, s), 8.42(4H, m), 8.55(2H, m) | 763.01 | 762.27 |
| 358 | δ = 0.66(6H, s), 7.33(1H, m), 7.52∼7.55(5H, m), 7.61(4H, m), 7.82∼7.97(7H, m), 8.04∼8.13(7H, m), 8.23(1H, s), 8.25(1H, s), 8.42(2H, m), 8.55(2H, m), 8.93(2H, m) | 738.99 | 738.27 |
| 359 | δ = 0.66(6H, s), 7.25(4H, m), 7.33(1H, m), 7.41(1H, m), 7.51∼7.55(9H, m), 7.61(4H, m), 7.89(1H, m), 7.97(1H, m), 8.04∼8.13(5H, m), 8.23(1H, s), 8.25(1H, s), 8.42(2H, m), 8.55(2H, m) | 714.97 | 714.27 |
| 364 | δ = 0.66(6H, s), 7.33(1H, m), 7.52∼7.61(9H, m), 7.73(1H, m), 7.82(2H, m), 7.89(1H, m), 7.92∼8(10H, m), 8.23(1H, s), 8.25(1H, s), 8.42(1H, m), 8.55(1H, m), 8.93(2H, m) | 738.99 | 738.27 |
| 366 | δ = 0.66(6H, s), 1.72(6H, s), 7.28∼7.38(3H, m), 7.52∼7.63(11H, m), 7.73∼7.77(2H, m), 7.87(1H, m), 7.89∼7.97(9H, m), 8.23(1H, s), 8.25(1H, s), 8.42(1H, m), 8.55(1H, m) | 755.03 | 754.31 |
| 368 | δ = 0.66(6H, s), 7.33(1H, m), 7.41(2H, m), 7.51∼7.66(20H, m), 7.73(1H, m), 7.89∼8.13(8H, m). 8.23(1H, s), 8.25(1H, s), 8.42(1H, m), 8.55(1H, m) | 791.06 | 790.31 |
| 371 | δ = 0.66(6H, s), 1.72(6H, s), 7.25∼7.41(8H, m). 7.51∼7.55(8H, m), 7.61∼7.63(4H, m), 7.77(1H, m), 7.87∼7.97(4H, m), 8.04∼8.13(3H, m), 8.23(1H, s). 8.25(1H, s), 8.42(1H, m), 8.55(1H, m) | 781.07 | 780.32 |
| 373 | δ = 0.66(6H, s), 1.72(6H, s), 7.28∼7.8(3H, m), 7.52∼7.63(11H, m), 7.73∼7.77(2H, m), 7.87(1H, m), 7.89∼7.97(9H, m), 8.23(1H, s), 8.25(1H, s), 8.42(1H, m), 8.55(1H, m) | 755.03 | 754.31 |
| 374 | δ = 0.66(6H, s), 1.72(12H, s), 7.28∼7.38(5H, m), 7.52∼7.55(5H, m), 7.61∼7.63(5H, m), 7.77(2H, m), 7.87∼7.97(6H, m), 8.04∼8.13(3H, m), 8.23(1H, s), 8.25(1H, s), 8.42(1H, m), 8.55(1H, m) | 821.13 | 820.35 |
| 376 | δ = 0.66(6H, s), 7.25(4H, m), 7.33(1H, m), 7.41(1H, m), 7.51∼7.61(13H, m), 7.73(1H, m), 7.89∼8.13(8H, m), 8.23(1H, s), 8.25(1H, s), 8.42(1H, m), 8.55(1H, m) | 714.97 | 714.27 |
| 381 | δ = 0.66(6H, s), 7.25(4H, m), 7.33(1H, m), 7.52∼7.55(7H, m), 7.61 (5H, m), 7.89(1H, m), 7.97(1H, m), 8.04∼8.13(7H, m), 8.23(1H, s), 8.25(1H, s), 8.42(3H, m), 8.55(3H, m) | 765.02 | 764.29 |
| 388 | δ = 0.66(6H, s), 7.25(4H, m), 7.33(1H, m), 7.52∼7.61(12H, m), 7.73(2H, m), 7.89∼8.13(11H, m), 8.23(1H, s), 8.25(1H, s), 8.42(1H, m), 8.55(1H, m) | 765.02 | 764.29 |
| 397 | δ = 0.66(6H, s), 1.72(12H, s), 7.28∼7.38(5H, m), 7.48∼7.63(13H, m), 7.7(1H, m), 7.77(2H, m), 7.87∼7.97(6H, m), 8.04∼8.13(3H, m), 8.23(1H, s), 8.25(1H, s), 8.42(1H, m), 8.55(1H, m) | 897.23 | 896.38 |
| 403 | δ = 0.66(6H, s), 1.35(9H, s), 7.33∼7.38(5H, m), 7.52∼7.55(5H, m), 7.61 (4H, m), 7.89(1H, m), 7.97(1H, m), 8,04∼8.13(5H, m), 8.23(1H, s), 8.25(1H, s), 8.42(2H, m), 8.55(2H, m) | 694.98 | 694.31 |
| 406 | δ = 0.66(6H, s), 1.72(6H, s), 2.34(6H, s), 7.28∼7.38(4H, m), 7.52∼7.63(10H, m), 7.77(1H, m), 7.87∼7.97(4H, m), 8.04∼8.13(3H, m), 8.23(1H, s), 8.25(1H, s), 8.42(1H, m), 8.55(1H, m) | 733.02 | 732.32 |
| 408 | δ = 0.66(6H, s), 1.72(6H, s), 7.28∼7.38(3H, m), 7.52∼7.63(11H, m), 7.73∼7.77(3H, m), 7.87∼8(10H, m), 8.13(1H, m), 8.23(1H, s), 8.25(1H, s) | 755.03 | 754.31 |
| 409 | δ = 0.66(6H, s), 7.33(1H, m), 7.52(1H, m), 7.58∼7.61(8H, m), 7.73(2H, m), 7.82∼8(13H, m), 8.12∼8.13(3H, m), 8.23(1H, s), 8.25(1H, s), 8.93(2H, m) | 738.99 | 738.27 |
| 412 | δ = 0.66(6H, s), 7.33(1H, m), 7.52∼7.61(10H, m), 7.73∼7.8(3H, m), 7.89(1H, m), 7.9(1H, m), 763.01 7.92∼8(10H, m), 8.23(1H, s), 8.25(1H, s), 8.42(3H, m), 8.55(1H, m) | | 762.27 |
| 416 | δ = 0.66(6H, s), 1.72(6H, s), 7.28∼7.38(3H, m), 7.52∼7.63(9H, m), 7.77∼7.8(3H, m), 7.87∼7.97(6H, m), 8.04∼8.13(5H, m), 8.23(1H, s), 8.25(1H, s), 8.42(3H, m), 8.55(1H, m) | 829.11 | 828.32 |
| 417 | δ = 0.66(6H, s), 1.72(6H, s), 7.28∼7.38(3H, m), 7.52∼7.63(8H, m), 7.73(1H, m), 7.77(1H, m), 7.82∼7.89(12H, m), 8.12∼8.13(3H, m), 8.23(1H, s), 8.25(1H, s), 8.93(2H, m) | 805.09 | 804.32 |
| 422 | δ = 0.66(6H, s), 1.72(6H, s), 7.25∼7.38(7H, m), 7.52∼7.63(11H, m), 7.73∼7.77(2H, m), 7.87(1H, m), 7.89∼7.97(9H, m), 8.23(1H, s), 8.25(1H, s), 8.42(1H, m), 8.55(1H, m) | 831.12 | 830.34 |
| 424 | δ = 0.66(6H, s), 1.72(6H, s), 7.25∼7.38(7H, m), 7.52∼7.63(11H, m), 7.73∼7.77(3H, m), 7.87∼8(10H, m), 8.13(1H, m), 8.23(1H, s), 8.25(1H, s) | 831.12 | 830.34 |
| 427 | δ = 0.66(6H, s), 1.72(12H, s), 7.25∼7.41(10H, m), 7.51∼7.55(7H, m), 7.61∼7.63(4H, m), 7.77(2H, m), 7.87∼7.97(6H, m), 8.13(1H, m), 8.23(1H, s), 8.25(1H, s) | 847.17 | 846.37 |
| 430 | δ = 0.66(6H, s), 1.72(12H, s), 7.28∼7.38(5H, m), 7.52∼7.55(3H, m), 7.61∼7.63(4H, m), 7.77∼7.97(13H, m), 8.12∼8.13(3H, m), 8.23(1H, s), 8.25(1H, s), 8.93(2H, m) | 871.19 | 870.37 |
| 431 | δ = 0.66(6H, s), 1.72(6H, s), 7.28∼7.38(3H, m), 7.52∼7.63(11H, m), 7.73∼7.77(3H, m), 7.87∼8(10H, m), 8.13(1H, m), 8.23(1H, s), 8.25(1H, s) | 755.03 | 754.31 |
| 432 | δ = 0.66(6H, s), 1.72(6H, s), 7.28∼7.38(3H, m), 7.52∼7.63(11H, m), 7.73∼7.77(2H, m), 7.87(1H, m), 7.89∼7.97(9H, m), 8.23(1H, s), 8.25(1H, s), 8.42(1H, m), 8.55(1H, m) | 755.03 | 754.31 |
| 434 | δ = 0.66(6H, s), 1.72(6H, s), 7.28∼7.38(3H, m), 7.52∼7.63(8H, m), 7.73(1H, m), 7.77(1H, m), 7.82∼7.89(12H, m), 8.12∼8.13(3H. m), 8.23(1H, s), 8.25(1H, s), 8.93(2H, m) | 805.09 | 804.32 |
| 438 | δ = 0.66(6H, s), 7.35(1H, m), 7.41(2H, m), 7.51∼7.55(12H, m), 7.61(3H, m), 7.82(1H, m), 7.95∼7.97(2H, m), 8.04∼8.13(5H, m), 8.23(1H, s), 8.25(1H, s), 8.42(2H, m), 8.55(2H, m) | 714.97 | 714.27 |
| 441 | δ = 0.66(6H, s), 7.35(1H, m), 7.41(2H, m), 7.51∼7.52(8H, m), 7.58∼7.61(7H, m), 7.73(2H, m), 7.82(1H, m), 7.92∼8(8H, m), 8.13(1H, m), 8.23(1H, s), 8.25(1H, s) | 714.97 | 714.27 |
| 445 | δ = 0.66(6H, s), 7.35(1H, m), 7.55(8H, m), 7.61(5H, m), 7.82(1H, m), 7.95∼7.97(2H, m), 8.04∼8.13(9H, m), 8.23(1H, s), 8.25(1H, s), 8.42(4H, m), 8.55(4H, m) | 815.08 | 814.31 |
| 454 | δ = 0.66(6H, s), 1.35(18H, s), 7.35∼7.41(11H, m), 7.51∼7.52(8H, m), 7.61(1H, m), 7.82(1H, m), 7.95∼7.97(2H, m), 8.13(1H, m), 8.23(1H, s), 8.25(1H, s) | 727.06 | 726.37 |
| 457 | δ = 0.66(6H, s), 1.72(12H, s), 7.28(2H, m), 7.35∼7.41(5H, m), 7.51∼7.55(10H, m), 7.61∼7.63(3H, m), 7.77∼7.97(9H, m), 8.13(1H, m), 8.23(1H, s), 8.25(1H, s) | 847.17 | 846.37 |
| 460 | δ = 0.66(6H, s), 1.35(18H, s), 7.35∼7.38(9H, m), 7.55(4H, m), 7.61(3H, m), 7.82(1H, m), 7.95∼7.97(2H, m), 8.04∼8.13(5H, m), 8.23(1H, s), 8.25(1H, s), 8.42(2H, m), 8.55(2H, m) | 817.18 | 816.40 |
| 462 | δ = 0.66(6H, s), 1.72(12H, s), 7.28(2H, m), 7.35∼7.38(3H, m), 7.55(6H, m), 7.61∼7.63(5H, m), 7.77∼7.97(9H, m), 8.04∼8.13(5H, m), 8.23(1H, s), 8.25(1H, s), 8.42(2H, m), 8.55(2H, m) | 947.28 | 946.40 |
| 474 | δ = 0.66(6H, s), 1.72(6H, s), 7.28(1H, m), 7.35∼7.41(5H, m), 7.51∼7.55(13H, 7.61∼7.63(2H, m), 7.77∼7.97(6H, m), 8.13(1H, m), 8.23(1H, s), 8.25(1H, s) | 731.01 | 730.31 |
| 479 | δ = 0.66(6H, s), 7.35(1H, m), 7.41(1H, m), 7.51∼7.52(4H, m), 7.58∼7.61(7H, m), 7.73(2H, m), 7.82∼8(14H, m), 8.12∼8.13(3H, m), 8.23(1H, s), 8.25(1H, s), 8.93(2H, m) | 815.08 | 814.31 |
| 480 | δ = 0.66(6H, s), 1.72(6H, s), 7.28(1H, m), 7.35∼7.41(3H, m), 7.51∼7.63(13H, m), 7.73(2H, m), 7.77∼7.92(12H, m), 8.13(1H, m), 8.23(1H, s), 8.25(1H, s) | 831.12 | 830.34 |
| 483 | δ = 0.66(6H, s), 7.35(1H, m), 7.41(1H, m), 7.51∼7.55(10H, m), 7.61(4H, m), 7.82(1H, m), 7.95∼7.97(2H, m), 8.04∼8.13(7H, m), 8.23(1H, s), 8.25(1H, s), 8.42(3H, m), 8.55(3H, m) | 765.02 | 764.29 |
| 487 | δ = 0.66(6H, s), 7.35(1H, m), 7.41(2H, m), 7.51∼7.55(10H, m), 7.61(2H, m), 7.82∼7.97(8H, m), 8.04∼8.13(5H, m), 8.23(1H, s), 8.25(1H, s), 8.42(1H, m), 8.55(1H, m), 8.93(2H, m) | 765.02 | 764.29 |
| 488 | δ = 0.66(6H, s), 1.72(12H, s), 7.28(2H, m), 7.35∼7.41(4H, m), 7.51∼7.63(12H, m), 7.73(1H, m), 7.77∼7.92(12H, m), 8.13(1H, m), 8.23(1H, s), 8.25(1H, s) | 897.23 | 896.38 |
| 493 | δ = 0.66(6H, s), 7.41(1H, m), 7.51∼7.66(14H, m), 7.73(2H, m), 7.92∼8(7H, m), 8.08∼8.14(3H, m), 8.23(1H, s), 8.25(1H, s), 8.55(1H, m) | 688.93 | 688.26 |
| 495 | δ = 0.66(6H, s), 7.41(1H, m), 7.51∼7.55(6H, m), 7.61∼7.66(2H, m), 7.82∼7.97(11H, m), 8.08∼8.14(7H, m), 8.23(1H, s), 8.25(1H, s), 8.55(1H, m), 8.93(4H, m) | 789.05 | 788.29 |
| 500 | δ = 0.66(6H, s), 7.33∼7.41(5H, m), 7.51∼7.52(9H, m), 7.61(1H, m), 7.73(1H, m), 7.89∼7.97(4H, m) | 462.66 | 462.18 |
| 501 | δ = 0.66(6H, s), 7.33(1H, m), 7.41(3H, m), 7.51∼7.52(13H, m), 7.61(2H, m), 7.73(1H, m), 7.89(1H, m), 7.97(2H, m), 8.13(1H, m) | 538.75 | 538.21 |
| 502 | δ = 0.66(6H, s), 7.33∼7.39(3H, m), 7.52(1H, m), 7.58∼7.61(7H, m), 7.73(3H, m), 7.89∼8(10H, m) | 562.77 | 562.21 |
| 503 | δ = 0.66(6H, s), 7.33(1H, m), 7.41(1H, m), 7.51∼7.52(5H, m), 7.58∼7.61(8H, m), 7.73(3H, m), 7.89∼8(9H, m), 8.13(1H, m) | 638.87 | 638.24 |
| 505 | δ = 0.66(6H, s), 1.72(12H, s), 7.28∼7.39(7H, m), 7.52∼7.55(3H, m), 7.61∼7.63(3H, m), 7.73∼7.77(3H, m), 7.87∼7.97(8H, m) | 694.98 | 694.31 |
| 507 | δ = 0.66(6H, s), 7.33(1H, m), 7.41(1H, m), 7.51∼7.55(9H, m), 7.61(4H, m), 7.73(1H, m), 7.89(1H, m), 7.97(2H, m), 8.04∼8.13(5H, m), 8.42(2H, m), 8.55(2H, m) | 638.87 | 638.24 |
| 509 | δ = 0.66(6H, s), 7.33(1H, m), 7.52(1H, m), 7.58∼7.61(11H, m), 7.73(4H, m), 7.89∼8(12H, m), 8.13(1H, m) | 688.93 | 688.26 |
| 514 | δ = 0.66(6H, s), 1.72(12H, s), 7.28∼7.38(5H, m), 7.52∼7.55(5H, m), 7.61∼7.63(5H, m), 7.73∼7.77(3H, m), 7.87∼7.97(7H, m), 8.04∼8.13(3H, m), 8.42(1H, m), 8.55(1H, m) | 821.13 | 820.35 |
| 519 | δ = 0.66(6H, s), 7.39(2H, m), 7.55(2H, m), 7.66(1H, m), 7.82∼7.93(12H, m), 8.08∼8.14(6H, m), 8.23(1H, s), 8.25(1H, s), 8.55(1H, m), 8.93(4H, m) | 712.95 | 712.26 |
| 522 | δ = 0.66(6H, s), 7.55∼7.66(13H, m), 7.73(2H, m), 7.92∼8.14(12H, m), 8.23(1H, s), 8.25(1H, s), 8.42(1H, m), 8.55(2H, m) | 738.99 | 738.27 |
| 527 | δ = 0.66(6H, s), 7.55∼7.66(13H, m), 7.73(1H, m), 7.92∼8.14(11H, m), 8.23(1H, s), 8.25(1H, s), 8.42(2H, m), 8.55(3H, m) | 738.99 | 738.27 |
| 534 | δ = 0.66(6H, s), 7.39(2H, m), 7.55∼7.59(8H, m), 7.73(2H, m), 7.91∼7.92(4H, m), 8∼8.08(7H, m), 8.23(1H, s), 8.24(1H, m), 8.25(1H, s) | 612.83 | 612.23 |
| 535 | δ = 0.66(6H, s), 7.55∼7.61(12H, m), 7.73(3H, m), 7.92∼8.13(14H, m), 8.23(1H, s), 8.24(1H, m), 8.25(1H, s) | 738.99 | 738.27 |
| 538 | δ = 0.66(6H, s), 7.39(2H, m), 7.58∼7.59(8H, m), 7.73(2H, m), 7.91∼7.92(4H, m), 8∼8.01(7H, m), 8.23(1H, s), 8.25(1H, s), 8.44(1H, m) | 612.83 | 612.23 |
| 542 | δ = 0.66(6H, s), 7.58∼7.61(12H, m), 7.73(3H, m), 7.92∼8.01(13H, m), 8.13(1H, m), 8.23(1H, s), 8.25(1H, s), 8.44(1H, m) | 738.99 | 738.27 |
| 544 | δ = 0.66(6H, s), 1.72(12H, s), 7.28(2H, m), 7.38(2H, m), 7.55∼7.63(10H, m), 7.73∼7.77(3H, m), 7.87∼8.01(11H, m), 8.13(1H, m), 8.23(1H, s), 8.25(1H, s), 8.44(1H, m) | 871.19 | 870.37 |
| 545 | δ = 0.66(6H, s), 7.39∼7.41 (4H, m), 7.51∼7.52(8H, m), 7.59(2H, m), 7.71(1H, m), 7.91(2H, m), 8∼8.01(3H, m), 8.07(1H, m), 8.44(1H, m) | 512.71 | 512.20 |
| 551 | δ = 7.39(2H, m), 7.58∼7.59(6H, m), 7.67(2H, m), 7.73∼7.78(3H, m), 7.86(1H, m), 7.91(4H, s), 7.91∼7.92(2H, m), 8(4H, m), 8.16(2H, m) | 586.74 | 586.18 |
| 554 | δ = 0.66(6H, s), 1.72(6H, s), 7.28(1H, m), 7.38∼7.39(3H, m), 7.55∼7.63(7H, m), 7.71∼7.77(3H, m), 7.87∼7.93(5H, m), 8∼8.01(5H, m), 8.07(1H, m), 8.44(1H, m) | 678.93 | 678.27 |
| 556 | δ = 7.39(2H, m), 7.58∼7.59(6H, m), 7.67(2H, m), 7.73∼7.8(4H, m), 7.91(4H, s), 7.91∼7.92(2H, m), 8(4H, m), 8.16(1H, m), 8.54(1H, m) | 586.74 | 586.18 |
| 558 | δ = 7.39(2H, m), 7.58∼7.59(6H, m), 7.67(2H, m), 7.73(2H, m), 7.83(1H, m), 7.91(4H, s), 7.91∼7.92(2H, m), 8∼8.05(5H, m), 8.16(2H, m) | 586.74 | 586.18 |
| 559 | δ = 7.32∼7.39(4H, m), 7.58∼7.59(6H, m), 7.66(1H, m), 7.73(2H, m), 7.89(1H, m), 7.91(4H, s), 7.91∼7.92(2H, m), 8(4H, m) | 520.62 | 520.18 |
| 560 | δ = 7.32∼7.39(5H, m), 7.58∼7.59(6H, m), 7.66(1H, m), 7.73(2H, m), 7.89∼7.92(6H, m), 8(4H, m) | 520.62 | 520.18 |
| 562 | δ = 7.39∼7.42(4H, m), 7.49(1H, m), 7.58∼7.59(6H, m), 7.67(2H, m), 7.73(2H, m), 7.91∼7.92(5H, m), 8(4H, m), 8.16(2H, m) | 570.68 | 570.20 |
| 565 | δ = 7.36∼7.42(5H, m), 7.58∼7.59(6H, m), 7.73∼7.84(7H, m), 7.91∼8(9H, m), 8.12(1H, m), 8.46(1H, s) | 612.70 | 612.20 |
| 569 | δ = 7.36∼7.43(6H, m), 7.58∼7.59(6H, m), 7.73∼7.84(7H, m), 7.91∼7.92(4H, m), 8(4H, m), 8.12(1H, m), 8.2(1H, m) | 612.70 | 612.20 |
| 570 | δ = 7.25(1H, m), 7.33∼7.39(3H, m), 7.45∼7.5(3H, m), 7.58∼7.59(8H, m), 7.73(2H, m), 7.91(4H, s), 7.91∼8(7H, m), 8.55(1H, m) | 595.73 | 595.23 |
| 571 | δ = 7.39∼7.59(15H, m), 7.67(2H, m), 7.73(2H, m), 7.91(4H, s), 7.91∼7.92(2H, m), 8(4H, m), 8.16(2H, m) | 645.79 | 645.25 |
| 576 | 6 = 0.66(6H, s), 7.35∼7.41(4H, m), 7.51∼7.55(8H, m), 7.61(2H, m), 7.82(1H, m), 7.91∼7.95(3H, m), 8.04∼8.08(4H, m), 8.23(1H, s), 8.25(1H, s), 8.42(2H, m), 8.55(2H, m) | 638.87 | 638.24 |
| 579 | δ = 0.66(6H, s), 7.35∼7.41(4H, m), 7.51∼7.52(4H, m), 7.58∼7.59(6H, m), 7.73(2H, m), 7.82(1H, m), 7.91∼8(9H, m), 8.23(1H, s), 8.25(1H, s) | 638.87 | 638.24 |
| 583 | δ = 0.66(6H, s), 7.35∼7.39(3H, m), 7.55(6H, m), 7.61(3H, m), 7.82(1H, m), 7.91∼7.95(3H, m), 8.04∼8.08(6H, m), 8.23(1H, s), 8.25(1H, s), 8.42(3H, m), 8.55(3H, m) | 688.93 | 688.26 |
| 584 | δ = 0.66(6H, s), 7.35∼7.39(3H, m), 7.55∼7.61 (9H, m), 7.73(2H, m), 7.82(1H, m), 7.91∼8.08(11H, m), 8.23(1H, s), 8.25(1H, s), 8.42(1H, m), 8.55(1H, m) | 688.93 | 688.26 |
| 588 | δ = 0.66(6H, s), 7.35∼7.39(3H, m), 7.58∼7.59(9H, m), 7.73(3H, m), 7.82(1H, m), 7.91∼8(12H, m), 8.23(1H, s), 8.25(1H, s) | 688.93 | 688.26 |
| 589 | 6 = 0.66(6H, s), 7.35∼7.39(3H, m), 7.58∼7.59(3H, m), 7.73(1H, m), 7.82∼8(17H, m), 8.12(4H, m), 8.23(1H, s), 8.25(1H, s), 8.93(4H, m) | 789.05 | 788.29 |
| 590 | δ = 0.66(6H, s), 1.72(2H, s), 7.28(1H, m), 7.35∼7.39(4H, m), 7.55(1H, H, m), 7.63(1H, m), 7.77∼7.95(17H, m), 8.12(4H, m), 8.23(1H, s), 8.25(1H, s), 8.93(4H, m) | 855.15 | 854.34 |
| 591 | δ = 0.66(6H, s), 1.72(6H, s), 7.28(1H, m), 7.35∼7.39(4H, m), 7.55∼7.63(8H, m), 7.73(2H, m), 7.77∼7.91(13H, m), 8.23(1H, s), 8.25(1H, s) | 755.03 | 754.31 |
| 592 | δ = 0.66(6H, s), 1.35(18H, s), 7.35∼7.41(12H, m), 7.51∼7.52(4H, m), 7.82(1H, m), 7.91∼7.95(3H, m), 8.23(1H, s), 8.25(1H, s) | 650.96 | 650.34 |
| 593 | δ = 0.66(6H, s), 1.72(6H, s), 7.28(1H, m), 7.35∼7.39(4H, m), 7.55(5H, m), 7.61∼7.63(3H, m), 7.77∼7.95(7H, m). 8.04∼8.08(4H, m), 8.23(1H, s), 8.25(1H, s), 8.42(2H, m), 8.55(2H, m) | 755.03 | 754.31 |
| 598 | δ = 0.66(6H. s), 1.35(18H, s), 7.35∼7.39(11H, m), 7.55(2H, m), 7.61(1H, m), 7.82(1H, m), 7.91∼7.95(3H, m), 8.04∼8.08(2H, m), 8.23(1H, s), 8.25(1H, s), 8.42(1H, m), 8.55(1H, m) | 701.02 | 700.35 |
| 604 | δ = 0.66(6H, s), 1.72(12H, s), 7.28(2H, m), 7.35∼7.39(5H, m), 7.55∼7.63(7H, m), 7.73(1H, m), 7.77∼7.91 (13H, m), 8.23(1H, s), 8.25(1H, s) | 821.13 | 820.35 |
| 606 | δ = 0.66(6H, s), 1.35(18H, s), 1.72(6H, s), 7.28(1H, m), 7.35∼7.39(12H, m), 7.55(1H, m), 7.63(1H, m), 7.77∼7.95(7H, m), 8.23(1H, s), 8.25(1H, s) | 767.12 | 766.40 |
| 609 | δ = 0.66(6H, s), 1.72(18H, s), 7.28(3H, m), 7.35∼7.39(6H, m), 7.55(3H, m), 7.63(3H, m), 7.77∼7.95(13H, m), 8.23(1H, s), 8.25(1H, s) | 887.23 | 886.40 |
| 614 | δ = 0.66(6H, s), 7.35∼7.41(4H, m), 7.51∼7.52(4H, m), 7.58∼7.59(6H, m), 7.73(2H, m), 7.82(1H, m). 7.91∼8(9H, m), 8.23(1H, s), 8.25(1H, s) | 638.87 | 638.24 |
| 618 | δ = 0.66(6H, s), 1.72(6H, s), 7.28(1H, m), 7.35∼7.41(5H, m), 7.51∼7.63(9H, m), 7.73(1H, m), 7.77∼7.91 (10H, m), 8.23(1H, s), 8.25(1H, s) | 704.97 | 704.29 |
| 621 | δ = 0.66(6H, s), 7.35∼7.41(4H, m), 7.51∼7.55(8H, m), 7.61 (2H, m), 7.82(1H, m), 7.91∼7.95(3H, m), 8.04∼8.08(4H, m), 8.23(1H, s), 8.25(1H, s), 8.42(2H, m), 8.55(2H, m) | 638.87 | 638.24 |
| 625 | δ = 0.66(6H, s), 7.35∼7.41(4H, m), 7.51∼7.55(6H, m), 7.61(1H, m), 7.82∼7.95(9H, m), 8.04∼8.12(4H, m). 8.23(1H, s), 8.25(1H, s), 8.42(1H, m), 8.55(1H, m). 8.93(2H, m) | 688.93 | 688.26 |
| 630 | δ = 0.66(6H, s), 7.35∼7.41(4H, m), 7.51∼7.61(8H, m), 7.79∼7.82(3H, m), 7.9∼7.96(5H, m), 8.04∼8.1(4H, m), 8.23(1H, s), 8.25(1H, s), 8.42(3H, m), 8.55(1H, m) | 712.95 | 712.26 |
| 631 | δ = 0.66(6H, s), 1.72(6H, s), 7.28(1H, m), 7.35∼7.41(5H, m), 7.51∼7.55(7H, m), 7.61-7.63(2H, m), 7.77∼7.95(7H, m), 8.04∼8.08(2H, m), 8.23(1H, 8.25(1H, s), 8.42(1H, m), 8.55(1H, m) | 704.97 s), | 704.29 |
| 632 | δ = 0.66(6H, s), 7.25(4H, m), 7.35∼7.41(5H, m), 7.51-7.55(10H, m), 7.61(1H, m), 7.82(1H, m), 7.91~7.95(3H, m), 8.04∼8.08(2H, m), 8.23(1H, s), 8.25(1H, s), 8.42(1H, m), 8.55(1H, m) | 664.91 | 664.29 |
| 633 | δ = 0.66(6H, s), 7.35∼7.41(6H, m), 7.51∼7.55(14H, m), 7.61-7.66(4H, m), 7.82(1H, m), 7.91-7.95(3H, m), 8.04∼8.08(2H, m), 8.23(1H, s), 8.25(1H, s), 8.42(1H, m), 8.55(1H, m) | 741.00 | 740.29 |
| 634 | δ = 0.66(6H, s), 7.35∼7.41(4H, m), 7.51∼7.61(10H, m), 7.73(1H, m), 7.82(1H, m), 7.91∼8.08(8H, m), 8.23(1H, s), 8.25(1H, s), 8.42(1H, m), 8,55(1H, m) | 638.87 | 638.24 |
| 635 | δ = 0.66(6H, s), 6.63(8H, m), 6.81(4H, m), 7.2(8H, m), 7.33∼7.39(3H, m), 7.52(1H, m), 7.61(1H, m), 7.89∼7.91(3H, m), 8.16(1H, s), 8.18(1H, s) | 644.88 | 644.26 |
| 639 | δ = 0.66(6H, s), 6.63(8H, m), 6.81(4H, m), 7.2(8H, m), 7.33(1H, m), 7.41(1H, m), 7.51∼7.52(5H, m), 7.61(2H, m), 7.89(1H, m), 7.97(1H, m), 8.13(1H, m), 8.16(1H, s), 8.18(1H, s) | 720.97 | 720.30 |
| 643 | 6 = 0.66(6H, s), 6.63(8H, m), 6.81(4H, m), 7.2(8H, m), 7.33(1H, m), 7.52(1H, m), 7.58∼7.61(5H, m), 7.73(1H, m), 7.89∼8(5H, m), 8.13(1H, m), 8.16(1H, s), 8.18(1H, s) | 771.03 | 770.31 |
| 647 | δ = 0.66(6H, s), 6.63(8H, m), 6.81(4H, m), 7.2(8H, m), 7.35(1H, m), 7.41(2H, m), 7.51∼7.52(8H, m), 7.61(1H, m), 7.82(1H, m), 7.95∼7.97(2H, m), 8.13(1H, m), 8.16(1H, s), 8.18(1H, s) | 797.07 | 796.33 |
| 656 | δ = 0.66(6H, s), 7.33∼7.39(3H, m), 7.52(1H, m), 7.58∼7.61(7H, m), 7.71∼7.73(3H, m), 7.89∼7.92(5H, m), 8(4H, m), 8.07(1H, m) | 562.77 | 562.21 |
| 657 | δ = 0.66(6H, s), 7.33∼7.39(3H, m), 7.52(1H, m), 7.61(1H, m), 7.71(1H, m), 7.82∼7.93(13H, m), 8.07∼8.12(5H, m), 8.93(4H, m) | 662.89 | 662.24 |
| 665 | δ = 0.66(6H, s), 7.25(8H, m), 7.33∼7.41(5H, m), 7.51~7.52(9H, m), 7.61(1H, m), 7.71(1H, m), 7.89∼7.91(3H, m), 8.07(1H, m) | 614.85 | 614.24 |

### Example 1: Manufacture of OLED device using the organic electroluminescent compound according to the present invention

An OLED device was manufactured using the organic electroluminescent compound according to the present invention.

First, a transparent electrode ITO film (15 Ω/□) 2 prepared from a glass substrate for an OLED (Samsung Corning) 1 was subjected to ultrasonic washing sequentially using trichloroethylene, acetone, ethanol and distilled water, and stored in isopropanol for later use.

Next, the ITO substrate was mounted on a substrate holder of a vacuum deposition apparatus. After filling 4,4',4"-tris(N,N-(2-naphthyl)-phenylamino)triphenylamine (2-TNATA) of the following structure in a cell of the vacuum deposition apparatus, the pressure inside the chamber was reduced to 10⁻⁶ torr. Then, 2-TNATA was evaporated by applying electrical current to the cell. A hole injection layer 3 having a thickness of 60 nm was formed on the ITO substrate.

Subsequently, after filling *N*,*N'*-bis(α-naphthyl)-*N*,*N'*-diphenyl-4,4'-diamine (NPB) of the following structure in another cell of the vacuum deposition apparatus, NPB was evaporated by applying electrical current. A hole transport layer 4 having a thickness of 20 nm was formed on the hole injection layer.

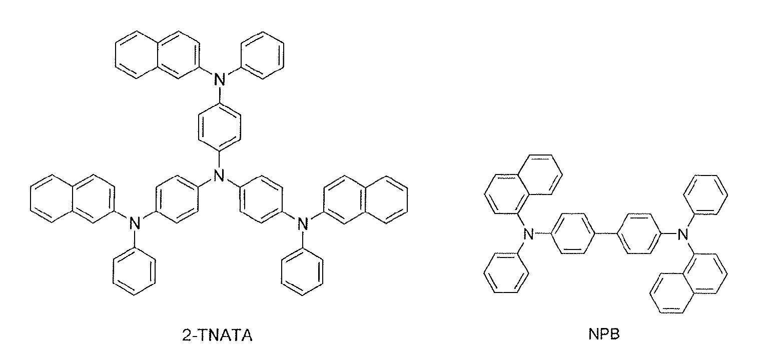

After forming the hole injection layer and the hole transport layer, an electroluminescent layer was formed thereon as follows. Compound 6 was filled in a cell of a vacuum deposition apparatus as a host, and Compound E was filled in another cell as a dopant. The two materials were evaporated at different speeds, so that an electroluminescent layer 5 having a thickness of 30 nm was formed on the hole transport layer at 2 to 5 wt% based on the host.

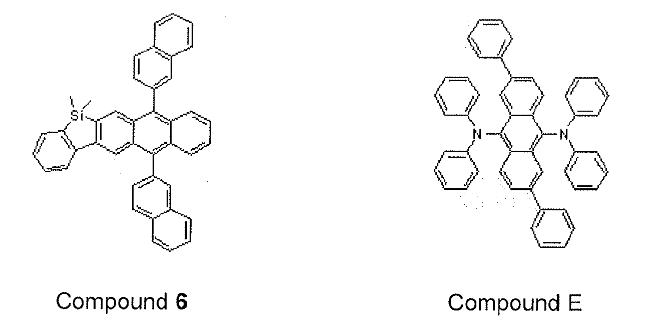

Thereafter, tris(8-hydroxyquinoline)-aluminum(III) (Alq) of the following structure was deposited with a thickness of 20 nm as an electron transport layer 6. Then, lithium quinolate (Liq) of the following structure was deposited with a thickness of 1 to 2 nm as an electron injection layer_7. Then, an Al cathode 8 having a thickness of 150 nm was formed using another vacuum deposition apparatus to manufacture an OLED.

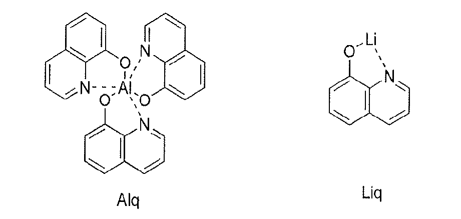

Each OLED electroluminescent material was purified by vacuum sublimation at 10⁻⁶ torr.

### Comparative Example 1: Manufacture of OLED device using existing electroluminescent material

A hole injection layer 3 and a hole transport layer 4 were formed as in Example 1. Tris(8-hydroxyquinoline)-aluminum(III) (Alq) was filled in a cell of a vacuum deposition apparatus as an electroluminescent host material, and Coumarin 545T (C545T) of the following structure was filled in another cell. The two materials were doped by evaporating at different speeds. An electroluminescent layer having a thickness of 30 nm was formed on the hole transport layer. Preferred doping concentration is 1 to 3 wt% based on Alq.

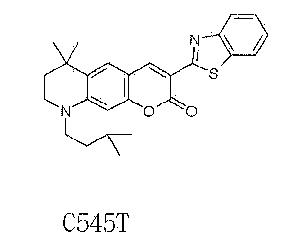

Then, an electron transport layer 6 and an electron injection layer 7 were formed as in Example 1, and an Al cathode 8 having a thickness of 150 nm was formed using another vacuum deposition apparatus to manufacture an

### OLED.

Luminous efficiency of the OLED devices manufactured in Example 1 and Comparative Example 1, which comprise the organic electroluminescent compounds according to the present invention and the existing electroluminescent compound respectively, was measured at 5,000 cd/m².
The result is given in Table 2.

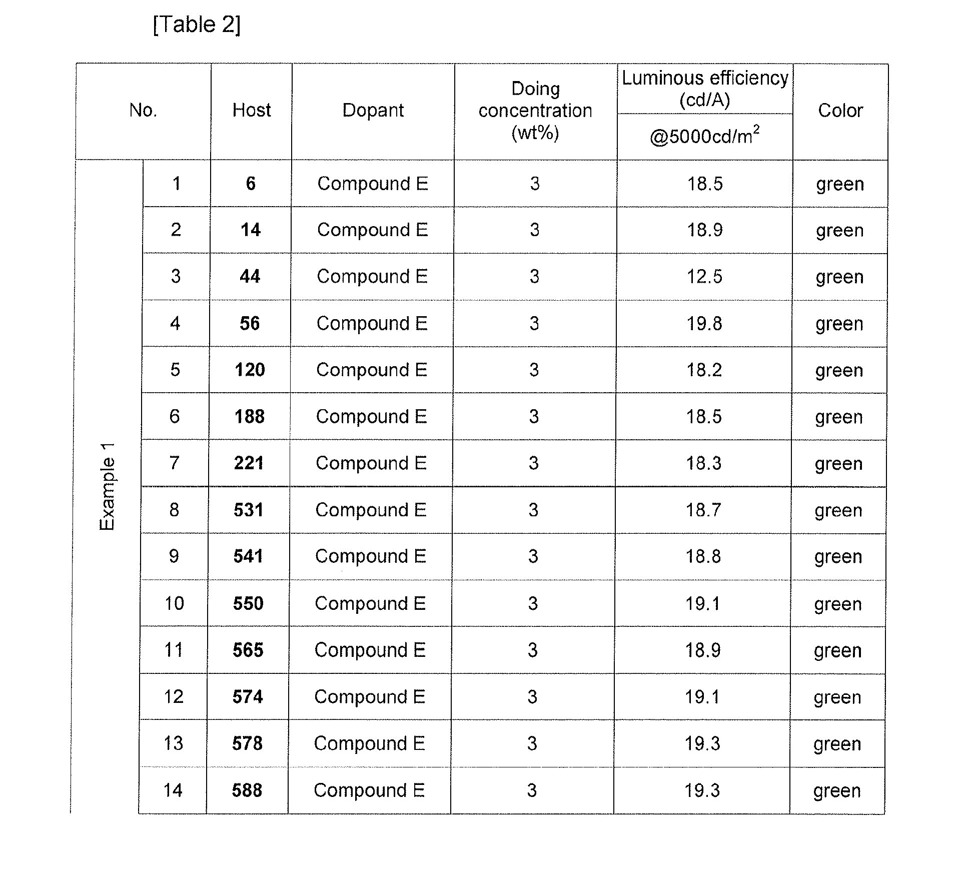

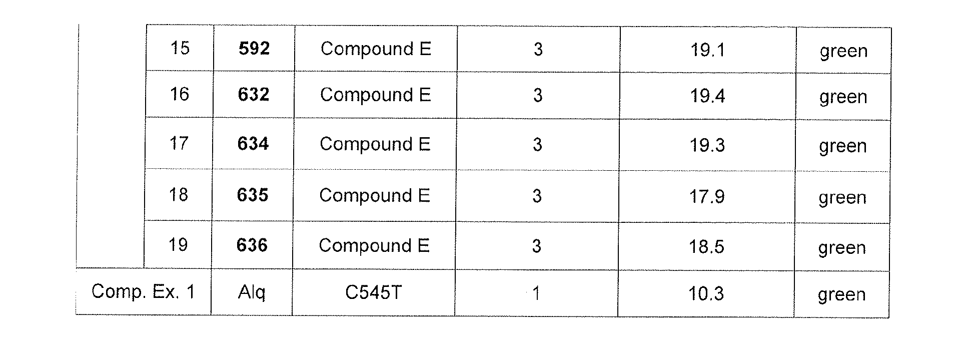

As seen in Table 2, when the compounds according to the present invention were used to manufacture green electroluminescent devices, luminous efficiency was significantly improved as compared to Comparative Example 1, while the color purity was maintained comparable or better.

### Example 2: Manufacture of OLED device using the organic electroluminescent compound according to the present invention

A hole injection layer 3 and a hole transport layer 4 were formed as in Example 1, and an electroluminescent layer was formed thereupon as follows. Dinaphthylanthracene (DNA) of the following formula was filled in a cell of a vacuum deposition apparatus as a host, and Compound 43 was filled in another cell as a dopant. The two materials were doped by evaporating at different speed, at 2 to 5 wt% based on the host. An electroluminescent layer 5 having a thickness of 30 nm was formed on the hole transport layer.

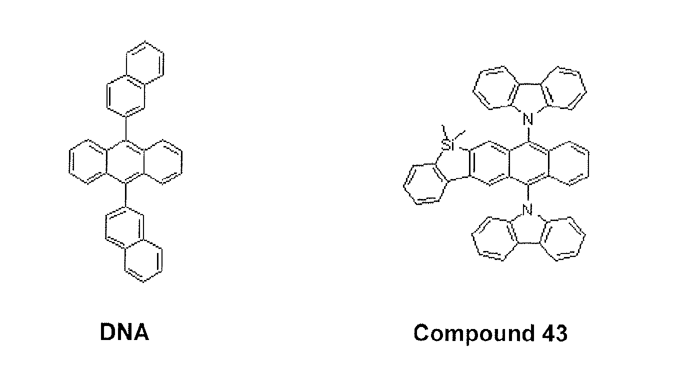

Subsequently, an electron transport layer and an electron injection layer were formed as in Example 1, and an Al cathode having a thickness of 150 nm was formed using another vacuum deposition apparatus to manufacture an OLED.

### Comparative Example 2: Electroluminescence characteristics of OLED device manufactured using existing electroluminescent material

A hole injection layer and a hole transport layer were formed as in Example 1. Dinaphthylanthracene (DNA) was filled in a cell of a vacuum deposition apparatus as an electroluminescent host material, and Compound A, a blue electroluminescent material having the following structure, was filled in another ell. An electroluminescent layer having a thickness of 30 nm was formed on the hole transport layer at a deposition rate of 100:1.

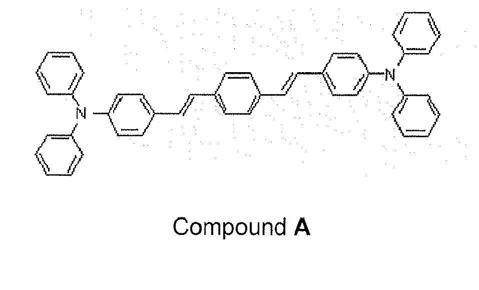

Subsequently, an electron transport layer and an electron injection layer were formed as in Example 1, and an Al cathode having a thickness of 150 nm was formed using another vacuum deposition apparatus to manufacture an

### OLED.

Luminous efficiency of the OLED devices manufactured in Example 2 and Comparative Example 2, which comprise the organic electroluminescent compounds according to the present invention and the existing electroluminescent compound respectively, was measured at 1,000 cd/m².
The result is given in Table 3.

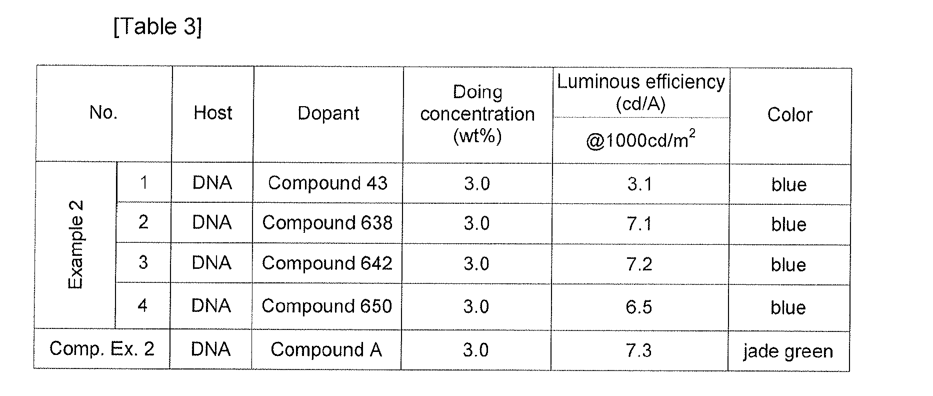

As seen in Table 3, when the compounds according to the present invention were used to manufacture blue electroluminescent devices, color purity was significantly improved as light blue to blue, as compared to jade green, and luminous efficiency was maintained comparable to or better than Comparative Example 2.

### Example 3: Manufacture of OLED device using the organic electroluminescent compound according to the present invention

A hole injection layer 3 and a hole transport layer 4 were formed as in Example 1. 9,10-Di(biphenyl-4-yl)-2-(naphthalen-2-yl)anthracene (DBNA) was filled in a cell of a vacuum deposition apparatus as a host, and Compound 636 was filled in another cell as a dopant. The two materials were doped 2 to 5 wt% based on the host, by evaporating at different speed. An electroluminescent layer 5 having a thickness of 30 nm was formed on the hole transport layer.

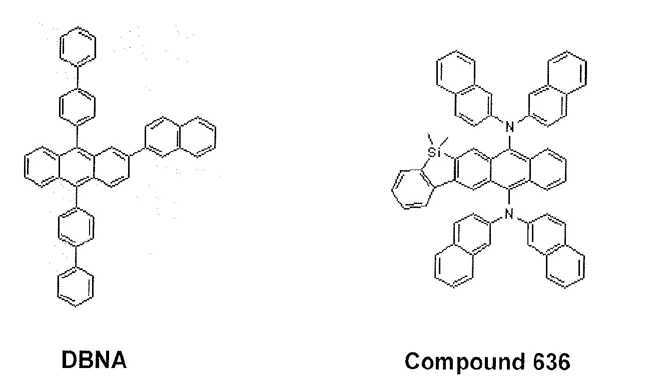

Subsequently, an electron transport layer 6 and an electron injection layer 7 were formed as in Example 1, and an Al cathode having a thickness of 150 nm was formed using another vacuum deposition apparatus to manufacture an OLED.

Luminous efficiency of the OLED devices manufactured in Example 3 and Comparative Example 1, which comprise the organic electroluminescent compounds according to the present invention and the existing electroluminescent compound respectively, was measured at 5,000 cd/m². The result is given in Table 4.

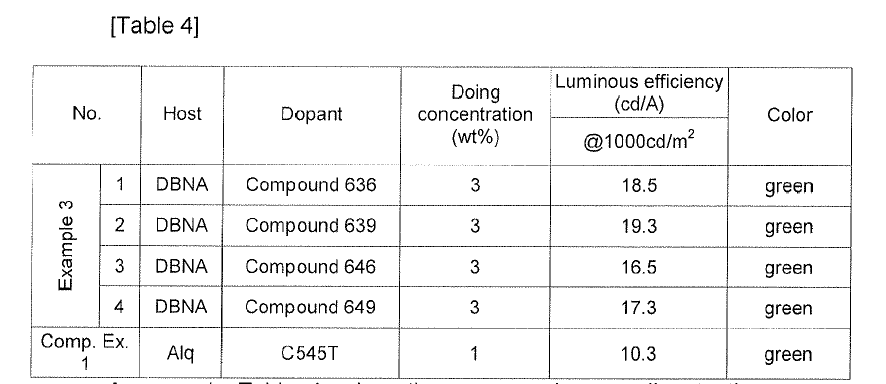

As seen in Table 4, when the compounds according to the present invention were used to manufacture green electroluminescent devices, luminous efficiency was significantly improved, and color purity was maintained comparable to or better than Comparative Example 1.

While the exemplary embodiments have been shown and described, it will be understood by those skilled in the art that various changes in form and details may be made thereto without departing from the spirit and scope of this disclosure as defined by the appended claims.

In addition, many modifications can be made to adapt a particular situation or material to the teachings of this disclosure without departing from the essential scope thereof. Therefore, it is intended that this disclosure not be limited to the particular exemplary embodiments disclosed as the best mode contemplated for carrying out this disclosure, but that this disclosure will include all embodiments falling within the scope of the appended claims.

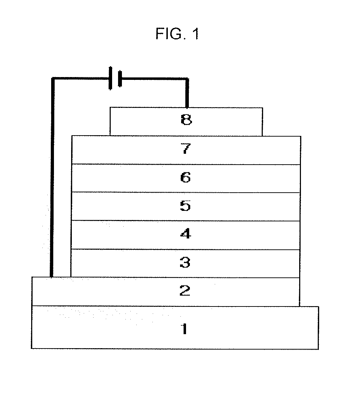

## Claims

1. An organic electroluminescent compound represented by Chemical Formula 1: 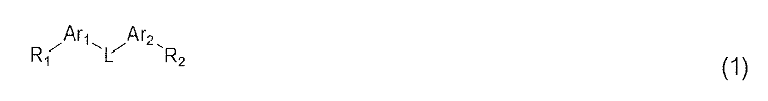 In Chemical Formula 1,
L is a substituent represented by the following structural formula: 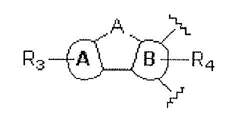 wherein
A represents -N(R₇₁)-, -S-, -O-, -Si(R₇₂)(R₇₃)-, -P(R₇₄)-, -C(=O)-, -B(R₇₅)-, -In(R₇₆)-, -Se-, -Ge(R₇₇)(R₇₈)-, -Sn(R₇₉)(R₈₀)- or -Ga(R₈₁)-;
ring A represents a monocyclic or polycyclic (C6-C60)aromatic ring;
ring B represents anthracene;
Ar₁ and Ar₂ independently represent a chemical bond, (C6-C60)arylene, (C3-C60)heteroarylene containing one or more heteroatom(s) selected from N, O and S, 5- or 6-membered heterocycloalkylene containing one or more heteroatom(s) selected from N, O and S, (C3-C60)cycloalkylene, (C2-C60)alkenylene, (C2-C60)alkynylene, (C1-C60)alkylenoxy, (C6-C60)arylenoxy or (C6-C60)arylenethio;
R₁ and R₂ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or a substituent selected from the following structures: 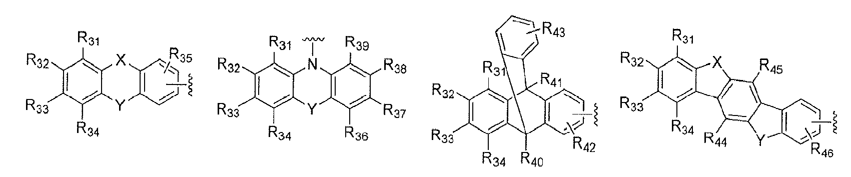 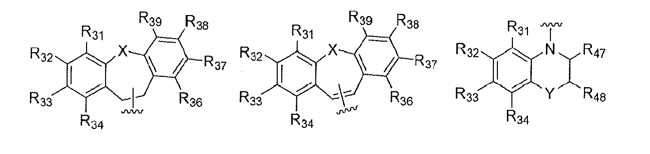 wherein
X and Y independently represent a chemical bond, -(CR₅₁R₅₂)ₘ-, N(R₅₃)-, -S-, -O-, -Si(R₅₄)(R₅₅)-, -P(R₅₆)-, -C(=O)-, -B(R₅₇)-, -In(R₅₈)-, -Se-, -Ge(R₅₉)(R₆₀)-, -Sn(R₆₁)(R₆₂)-, -Ga(R₆₃)- or -(R₆₄)C=C(R₆₅)-, excluding the case where both X and Y are chemical bonds at the same time;
R₃, R₄ and R₃₁ through R₄₈ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₃₁ through R₄₃ may be linked to an adjacent substituent via (C3-C60)alkylene or (C3-C60)alkenylene with or without a fused ring to form an alicyclic ring or a monocyclic or polycyclic aromatic ring;
R₅₁ through R₆₅ and R₇₁ through R₈₁ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₅₁ and R₅₂, R₅₄ and R₅₅, R₅₉ and R₆₀, R₆₁ and R₆₂, R₆₄ and R₆₅, R₇₂ and R₇₃, R₇₇ and R₇₈ and R₇₉ and R₈₀ may be linked via (C3-C60)alkylene or (C3-C60)alkenylene with or without a fused ring to form an alicyclic ring or a monocyclic or polycyclic aromatic ring;
the arylene, heteroarylene, heterocycloalkylene, cycloalkylene or alkenylene of Ar₁ and Ar₂ or the alkyl, aryl, heteroaryl, heterocycloalkyl, cycloalkyl, trialkylsilyl, dialkylarylsilyl, triarylsilyl, adamantyl, alkenyl, alkynyl, amino, alkylamino or arylamino of R₁, R₂, R₃, R₄, R₃₁ through R₄₈, R₅₁ through R₆₅ and R₇₁ through R₈₁ may be further substituted by one or more substituent(s) selected from deuterium, halogen, halo(C1-C60)alkyl, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
m represents an integer from 1 to 4.

2. The organic electroluminescent compound according to claim 1, wherein L is selected from the following structures: 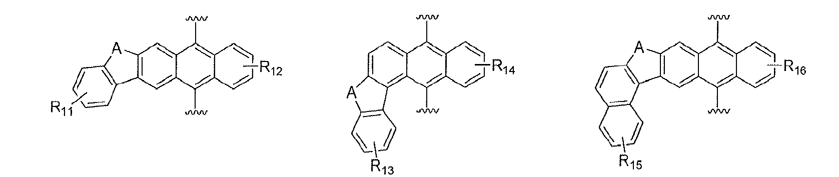 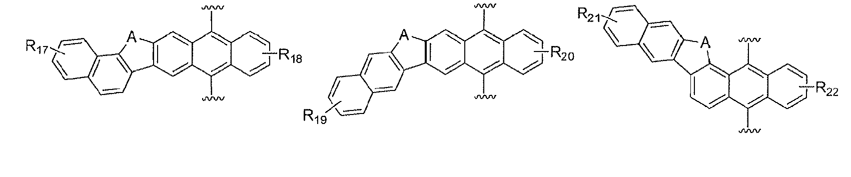 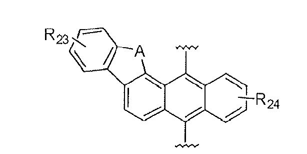 wherein
A is the same as defined in claim 1;
R₁₁ through R₂₄ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl; and
the alkyl, aryl, heteroaryl, heterocycloalkyl, cycloalkyl, trialkylsilyl, dialkylarylsilyl, triarylsilyl, adamantyl, alkenyl, alkynyl, amino, alkylamino or arylamino of R₁₁ through R₂₄ may be further substituted by one or more substituent(s) selected from deuterium, halogen, halo(C1-C60)alkyl, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyi, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

3. An organic electroluminescent device which comprises a first electrode; a second electrode; and at least one organic layer(s) interposed between the first electrode and the second electrode, wherein the organic layer comprises an organic electroluminescent compound(s) represented by 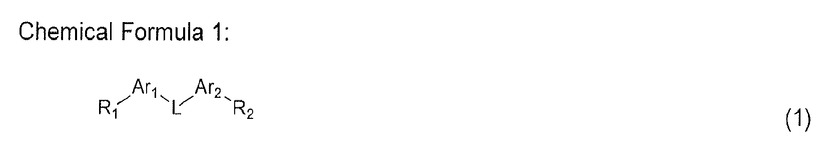 In Chemical Formula 1,
L is a substituent represented by the following structural formula: 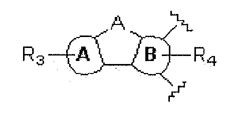 wherein
A represents -N(R₇₁)-, -S-, -O-, -Si(R₇₂)(R₇₃)-, -P(R₇₄)-, -C(=O)-, -B(R₇₅)-, -In(R₇₆)-, -Se-, -Ge(R₇₇)(R₇₈)-, -Sn(R₇₉)(R₈₀)- or -Ga(R₈₁)-;
ring A represents a monocyclic or polycyclic (C6-C60)aromatic ring;
ring B represents anthracene;
Ar₁ and Ar₂ independently represent a chemical bond, (C6-C60)arylene, (C3-C60)heteroarylene containing one or more heteroatom(s) selected from N, O and S, 5- or 6-membered heterocycloalkylene containing one or more heteroatom(s) selected from N, O and S, (C3-C60)cycloalkylene, (C2-C60)alkenylene, (C2-C60)alkynylene, (C1-C60)alkylenoxy, (C6-C60)arylenoxy or (C6-C60)arylenethio;
R₁ and R₂ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or a substituent selected from the following structures: 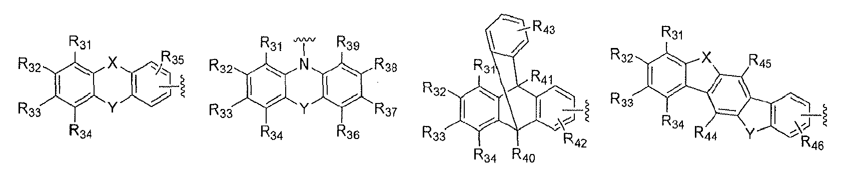 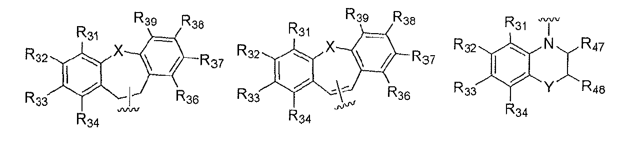 wherein
X and Y independently represent a chemical bond, -(CR₅₁R₅₂)ₘ-, -N(R₅₃)-, -S-, -O-, -Si(R₅₄)(R₅₅)-, -P(R₅₆)-, -C(=O)-, -B(R₅₇)-, -In(R₅₈)-, -Se-, -Ge(R₅₉)(R₆₀)-, -Sn(R₆₁)(R₆₂)-, -Ga(R₆₃)- or -(R₆₄)C=C(R₆₅)-, excluding the case where both X and Y are chemical bonds at the same time;
R₃, R₄ and R₃₁ through R₄₈ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₃₁ through R₄₃ may be linked to an adjacent substituent via (C3-C60)alkylene or (C3-C60)alkenylene with or without a fused ring to form an alicyclic ring or a monocyclic or polycyclic aromatic ring;
R₅₁ through R₆₅ and R₇₁ through R₈₁ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₅₁ and R₅₂, R₅₄ and R₅₅, R₅₉ and R₆₀, R₆₁ and R₆₂, R₆₄ and R₆₅, R₇₂ and R₇₃, R₇₇ and R₇₈ and R₇₉ and R₈₀ may be linked via (C3-C60)alkylene or (C3-C60)alkenylene with or without a fused ring to form an alicyclic ring or a monocyclic or polycyclic aromatic ring;
the arylene, heteroarylene, heterocycloalkylene, cycloalkylene or alkenylene of Ar₁ and Ar₂ or the alkyl, aryl, heteroaryl, heterocycloalkyl, cycloalkyl, trialkylsilyl, dialkylarylsilyl, triarylsilyl, adamantyl, alkenyl, alkynyl, amino, alkylamino or arylamino of R₁, R₂, R₃, R₄, R₃₁ through R₄₈, R₅₁ through R₆₅ and R₇₁ through R₈₁ may be further substituted by one or more substituent(s) selected from deuterium, halogen, halo(C1-C60)alkyl, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
m represents an integer from 1 to 4 and one or more dopant(s) selected from the compounds represented by Chemical Formulas 2 to 4: 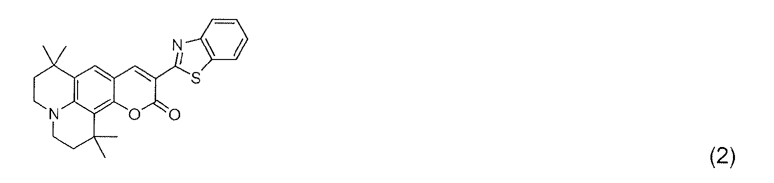 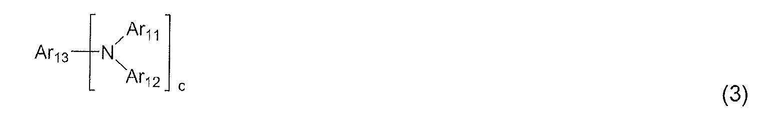 wherein
Ar₁₁ and Ar₁₂ independently represent hydrogen, deuterium, halogen, (C1-C60)alkyl, (C6-C60)aryl, (C4-C60)heteroaryl, mono- or di-(C6-C60)arylamino, mono- or di-(C1-C60)alkylamino, 5- or 6-membered heterocycloalkyl containing one or more heteroatom(s) selected from N, O and S or (C3-C60)cycloalkyl, or Ar₁₁ and Ar₁₂ may be linked via (C3-C60)alkylene or (C3-C60)alkenylene with or without a fused ring to form an alicyclic ring or a monocyclic or polycyclic aromatic ring;
Ar₁₃ represents (C6-C60)aryl, (C4-C60)heteroaryl or aryl having one of the following structures, when c is 1: 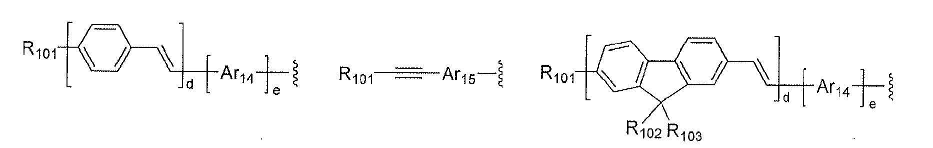 Ar₁₃ represents (C6-C60)arylene, (C4-C60)heteroarylene or arylene having one of the following structures, when c is 2: 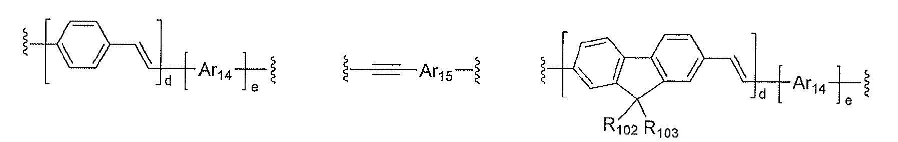 wherein
Ar₁₄ and Ar₁₅ independently represent (C6-C60)arylene or (C4-C60)heteroarylene;
R₁₀₁ through R₁₀₃ independently represent hydrogen, deuterium, (C1-C60)alkyl or (C6-C60)aryl;
d represents an integer from 1 to 4;
e represents an integer 0 or 1;
the alkyl, aryl, heteroaryl, arylamino, alkylamino, cycloalkyl or heterocycloalkyl of Ar₁₁ and Ar₁₂, the aryl, heteroaryl, arylene or heteroarylene of Ar₁₃, the arylene or heteroarylene of Ar₁₄ and Ar₁₅, or the alkyl or aryl of R₁₀₁ through R₁₀₃ may be further substituted by one or more substituent(s) selected from halogen, deuterium, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyi, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di-(C12-C60)alkylamino, mono- or di-(C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl; 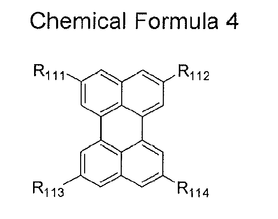 wherein
R₁₁₁ through R₁₁₄ independently represent hydrogen, deuterium, halogen, (C1-C60)alkyl, (C6-C60)aryl, (C4-C60)heteroaryl containing one or more heteroatom(s) selected from N, O and S, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, mono- or di-(C1-C60)alkylamino, mono- or di-(C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₁₁₁ through R₁₁₄ may be linked to an adjacent substituent via (C3-C60)alkylene or (C3-C60)alkenylene with or without a fused ring to form an alicyclic ring or a monocyclic or polycyclic aromatic ring; and
the alkyl, alkenyl, alkynyl, cycloalkyl, heterocycloalkyl, aryl, heteroaryl, arylsilyl, alkylsilyl, alkylamino or arylamino of R₁₁₁ through R₁₁₄, or the alicyclic ring or monocyclic or polycyclic aromatic ring formed as they are linked to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl containing one or more heteroatom(s) selected from N, O and S, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, mono- or di-(C1-C60)alkylamino, mono- or di-(C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl.

4. The organic electroluminescent device according to claim 3, which comprises a first electrode; a second electrode; and at least one organic layer(s) interposed between the first electrode and the second electrode, wherein the organic layer comprises one or more organic electroluminescent compound(s) according to claim 1 or 2 and one or more host(s) selected from the compounds represented by Chemical Formulas 5 and 6:
(Ar₂₁)_{f}L₂₁-(Ar₂₂)_{g} (5)
(Ar₂₃)ₕ-L₂₂-(Ar₂₄)ₗ (6)
wherein
L₂₁ represents (C6-C60)arylene or (C4-C60)heteroarylene;
L₂₂ represents anthracenylene;
Ar₂₁ through Ar₂₄ independently represent hydrogen, (C1-C60)alkyl, (C1-C60)alkoxy, halogen, (C4-C60)heteroaryl, (C5-C60)cycloalkyl or (C6-C60)aryl, and the cycloalkyl, aryl or heteroaryl of Ar₂₁ through Ar₂₄ may be further substituted by one or more substituent(s) selected from a group consisting of (C6-C60)aryl or (C4-C60)heteroaryl with or without one or more substituent(s) selected from a group consisting of deuterium, (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl, (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
f, g, h and i independently represent an integer from 0 to 4.

5. The organic electroluminescent device according to claim 3, wherein the organic layer comprises one or more compound(s) selected from a group consisting of arylamine compounds and styrylarylamine compounds.

6. The organic electroluminescent device according to claim 3, wherein the organic layer further comprises one or more metal(s) selected from a group consisting of organic metals of Group 1, Group 2, 4th period and 5th period transition metals, lanthanide metals and d-transition elements.

7. The organic electroluminescent device according to claim 3, wherein the organic layer comprises an electroluminescent layer and a charge generating layer.

8. A white electroluminescent device comprising the organic electroluminescent compound represented by Chemical Formula 1: 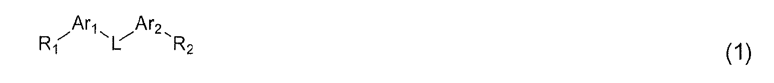 In Chemical Formula 1,
L is a substituent represented by the following structural formula: 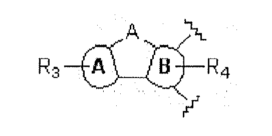 wherein
A represents -N(R₇₁)-, -S-, -O-, -Si(R₇₂)(R₇₃)-, -P(R₇₄)-, -C(=O)-, -B(R₇₅)-, -In(R₇₆)-, -Se-, -Ge(R₇₇)(R₇₈)-, -Sn(R₇₉)(R₈₀)- or -Ga(R₈₁)-;
ring A represents a monocyclic or polycyclic (C6-C60)aromatic ring;
ring B represents anthracene;
Ar₁ and Ar₂ independently represent a chemical bond, (C6-C60)arylene, (C3-C60)heteroarylene containing one or more heteroatom(s) selected from N, O and S, 5- or 6-membered heterocycloalkylene containing one or more heteroatom(s) selected from N, O and S, (C3-C60)cycloalkylene, (C2-C60)alkenylene, (C2-C60)alkynylene, (C1-C60)alkylenoxy, (C6-C60)arylenoxy or (C6-C60)arylenethio;
R₁ and R₂ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6- membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or a substituent selected from the following structures: 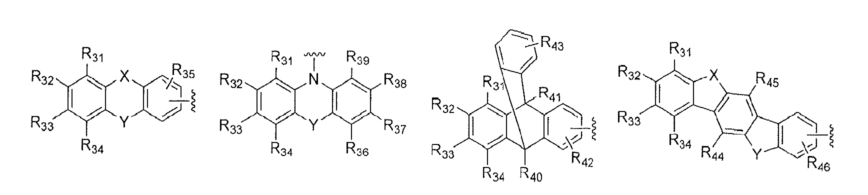 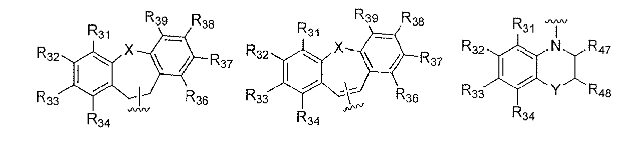 wherein
X and Y independently represent a chemical bond, -(CR₅₁R₅₂)ₘ-, -N(R₅₃)-, -S-, -O-, -Si(R₅₄)(R₆₅)-, -P(R₅₆)-, -C(=O)-, -B(R₅₇)-, -In(R₅₈)-, -Se-, -Ge(R₅₉)(R₆₀)-, -Sn(R₆₁)(R₆₂)-, -Ga(R₆₃)- or -(R₆₄)C=C(R₆₅)-, excluding the case where both X and Y are chemical bonds at the same time;
R₃, R₄ and R₃₁ through R₄₈ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₃₁ through R₄₃ may be linked to an adjacent substituent via (C3-C60)alkylene or (C3-C60)alkenylene with or without a fused ring to form an alicyclic ring or a monocyclic or polycyclic aromatic ring;
R₅₁ through R₆₅ and R₇₁ through R₈₁ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)aryisilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₅₁ and R₅₂, R₅₄ and R₅₅, R₅₉ and R₆₀, R₆₁ and R₆₂, R₆₄ and R₆₅, R₇₂ and R₇₃, R₇₇ and R₇₈ and R₇₉ and R₈₀ may be linked via (C3-C60)alkylene or (C3-C60)alkenylene with or without a fused ring to form an alicyclic ring or a monocyclic or polycyclic aromatic ring;
the arylene, heteroarylene, heterocycloalkylene, cycloalkylene or alkenylene of Ar₁ and Ar₂ or the alkyl, aryl, heteroaryl, heterocycloalkyl, cycloalkyl, trialkylsilyl, dialkylarylsilyl, triarylsilyl, adamantyl, alkenyl, alkynyl, amino, alkylamino or arylamino of R₁, R₂, R₃, R₄, R₃₁ through R₄₈, R₅₁ through R₆₅ and R₇₁ through R₈₁ may be further substituted by one or more substituent(s) selected from deuterium, halogen, halo(C1-C60)alkyl, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyi, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
m represents an integer from 1 to 4.

9. An organic solar cell comprising the organic electroluminescent compound represented by Chemical Formula 1: 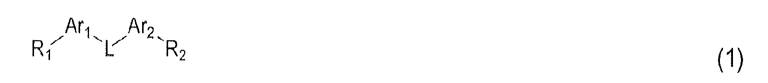 In Chemical Formula 1,
L is a substituent represented by the following structural formula: 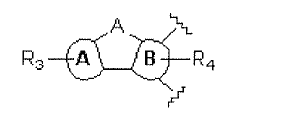 wherein
A represents -N(R₇₁)-, -S-, -O-, -Si(R₇₂)(R₇₃)-, -P(R₇₄)-, -C(=O)-, -B(R₇₅)-, -In(R₇₆)-, -Se-, -Ge(R₇₇)(R₇₈)-, -Sn(R₇₉)(R₈₀)-or-Ga(R₈₁)-;
ring A represents a monocyclic or polycyclic (C6-C60)aromatic ring;
ring B represents anthracene;
Ar₁ and Ar₂ independently represent a chemical bond, (C6-C60)arylene, (C3-C60)heteroarylene containing one or more heteroatom(s) selected from N, O and S, 5- or 6-membered heterocycloalkylene containing one or more heteroatom(s) selected from N, O and S, (C3-C60)cycloalkylene, (C2-C60)alkenylene, (C2-C60)alkynylene, (C1-C60)alkylenoxy, (C6-C60)arylenoxy or (C6-C60)arylenethio;
R₁ and R₂ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or a substituent selected from the following structures: 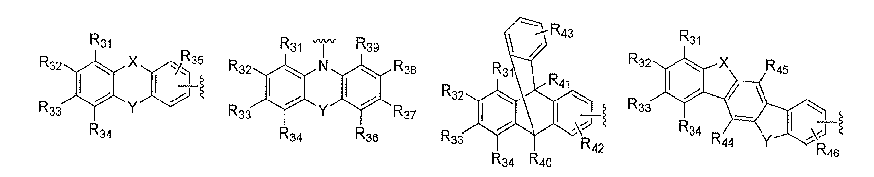 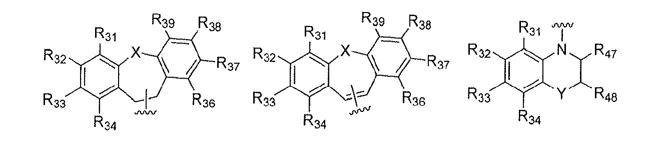 wherein
X and Y independently represent a chemical bond, -(CR₅₁R₅₂)ₘ-, -N(R₅₃)-, -S-, -O-, -Si(R₅₄)(R₅₅)-, -P(R₅₆)-, -C(=O)-, -B(R₅₇)-, -In(R₅₈)-, -Se-, -Ge(R₅₉)(R₆₀)-, -Sn(R₆₁)(R₆₂)-, -Ga(R₆₃)- or -(R₆₄)C=C(R₆₅)-, excluding the case where both X and Y are chemical bonds at the same time;
R₃, R₄ and R₃₁ through R₄₈ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)aryisilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₃₁ through R₄₃ may be linked to an adjacent substituent via (C3-C60)alkylene or (C3-C60)alkenylene with or without a fused ring to form an alicyclic ring or a monocyclic or polycyclic aromatic ring;
R₅₁ through R₆₅ and R₇₁ through R₈₁ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₅₁ and R₅₂, R₅₄ and R₅₅, R₅₉ and R₆₀, R₆₁ and R₆₂, R₆₄ and R₆₅, R₇₂ and R₇₃, R₇₇ and R₇₈ and R₇₉ and R₈₀ may be linked via (C3-C60)alkylene or (C3-C60)alkenylene with or without a fused ring to form an alicyclic ring or a monocyclic or polycyclic aromatic ring;
the arylene, heteroarylene, heterocycloalkylene, cycloalkylene or alkenylene of Ar₁ and Ar₂ or the alkyl, aryl, heteroaryl, heterocycloalkyl, cycloalkyl, trialkylsilyl, dialkylarylsilyl, triarylsilyl, adamantyl, alkenyl, alkynyl, amino, alkylamino or arylamino of R₁, R₂, R₃, R₄, R₃₁ through R₄₈, R₅₁ through R₆₅ and R₇₁ through R₈₁ may be further substituted by one or more substituent(s) selected from deuterium, halogen, halo(C1-C60)alkyl, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, amino, mono- or di-(C1-C60)alkylamino, mono- or di-(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl; and
m represents an integer from 1 to 4.
